(19) Europäisches Patentamt
European Patent Office
Office européen des brevets

(11) EP 4 317 287 A1

(12) EUROPEAN PATENT APPLICATION
published in accordance with Art. 153(4) EPC

(43) Date of publication:
**07.02.2024 Bulletin 2024/06**

(21) Application number: **22775435.5**

(22) Date of filing: **18.03.2022**

(51) International Patent Classification (IPC):
***C08K 5/28*** (2006.01) ***C08K 5/34*** (2006.01)
***C08K 5/5415*** (2006.01) ***C08L 101/02*** (2006.01)
***G03F 7/004*** (2006.01) ***G03F 7/031*** (2006.01)
***G03F 7/20*** (2006.01)

(52) Cooperative Patent Classification (CPC):
**C08K 5/28; C08K 5/34; C08K 5/5415;
C08L 101/02; G03F 7/004; G03F 7/031; G03F 7/20**

(86) International application number:
**PCT/JP2022/012523**

(87) International publication number:
**WO 2022/202647 (29.09.2022 Gazette 2022/39)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **22.03.2021 JP 2021046917**

(71) Applicant: **FUJIFILM Corporation**
**Tokyo 106-8620 (JP)**

(72) Inventors:
- **SAKITA Kyohei**
**Haibara-gun, Shizuoka 421-0396 (JP)**
- **YAMAZAKI Kenta**
**Haibara-gun, Shizuoka 421-0396 (JP)**

(74) Representative: **HGF**
**HGF Limited**
**1 City Walk**
**Leeds LS11 9DX (GB)**

# (54) NEGATIVE PHOTOSENSITIVE RESIN COMPOSITION, CURED PRODUCT, LAMINATE, METHOD FOR PRODUCING CURED PRODUCT, AND SEMICONDUCTOR DEVICE

(57) There are provided a negative-tone photosensitive resin composition containing a resin, a compound A of which an absorbance is reduced at an exposure wavelength upon exposure, and a photopolymerization initiator, where the negative-tone photosensitive resin composition satisfies at least one of the following condition i or condition ii; a cured substance which is obtained by curing the negative-tone photosensitive resin composition; a laminate including the cured substance, a manufacturing method for the cured substance; and a semiconductor device including the cured substance or the laminate.

The condition i: The composition further contains a nitrogen-containing cyclic compound as a component different from the resin, the naphthoquinone diazide compound, and the photopolymerization initiator.

The condition ii: The composition contains, as the resin, a resin having a nitrogen-containing heterocyclic structure that contains two or more nitrogen atoms as ring members.

EP 4 317 287 A1

## Description

## BACKGROUND OF THE INVENTION

1. Field of the Invention

The present invention relates to a negative-tone photosensitive resin composition, a cured substance, a laminate, a manufacturing method for a cured substance, and a semiconductor device.

2. Description of the Related Art

A cyclization resin such as polyimide is applied to various use applications since it has an excellent heat resistance and insulating properties. The above use applications are not particularly limited, and examples thereof in a semiconductor device for mounting include the use as a material for an insulating film or a sealing material, or as a protective film. In addition, such a resin can also be used as a base film or a cover lay for a flexible substrate.

For example, in the above-described use applications, a cyclization resin such as polyimide is used in the form of a negative-tone photosensitive resin composition containing at least one of a cyclization resin such as polyimide or a precursor of the cyclization resin.

Such a negative-tone photosensitive resin composition is applied onto a base material by coating or the like to form a photosensitive film, and then, as necessary, subjected to exposure, development, or heating, whereby a cured substance can be formed on the base material.

The precursor of the cyclization resin such as a polyimide precursor is cyclized by, for example, heating, and becomes a cyclization resin such as polyimide in the cured substance.

Since the negative-tone photosensitive resin composition can be applied by a known coating method or the like, it can be said that the negative-tone photosensitive resin composition is excellent in the manufacturing adaptability, for example, a high degree of freedom in a case of application in designing the shape, size, application position of the negative-tone photosensitive resin composition to be applied. From the viewpoint of such excellent manufacturing adaptability in addition to the high performance of the cyclization resin such as polyimide, the industrial application and development of the above-described negative-tone photosensitive resin composition are expected increasingly.

For example, JP1994-130664A (JP-H6-130664A) describes a negative-tone photosensitive resin composition containing, as essential components, (A) a polyamic acid ester having a specific structure, (B) a naphthoquinone diazide compound, and (C) a photopolymerization initiator.

JP2019-206689A describes a resin composition which contains (A) a resin having, in a side chain, a neutral functional group as a substituted group of an acidic functional group or a basic functional group, the resin being at least one selected from the group consisting of a polyimide precursor which is a polyamic acid and/or a polyamic acid ester, a polyoxazole precursor which is a polyhydroxyamide, a polyaminoamide, a polyamide, a polyamideimide, a polyimide, a polybenzoxazole, a polybenzimidazole, and a polybenzothiazole: 100 parts by mass, and contains (B) a compound having an aromatic sulfonic acid ester structure: 1 to 50 parts by mass.

## SUMMARY OF THE INVENTION

In a negative-tone photosensitive resin composition, it is required to achieve both the resolution of a pattern obtained by exposure and development and the suppression of a decrease in film thickness due to development (the improvement of the residual film ratio after development).

An object of the present invention is to provide a negative-tone photosensitive resin composition by which a pattern to be obtained has excellent resolution and a decrease in film thickness due to development is suppressed, a cured substance which is obtained by curing the negative-tone photosensitive resin composition, a laminate including the cured substance, a manufacturing method for the cured substance, and a semiconductor device including the cured substance or the laminate.

Examples of representative aspects according to the present invention are described below.

<1> A negative-tone photosensitive resin composition comprising:

a resin;
a compound A of which an absorbance is reduced at an exposure wavelength upon exposure; and
a photopolymerization initiator,
in which the negative-tone photosensitive resin composition satisfies at least one of the following condition i or condition ii,

the condition i: the composition further contains a nitrogen-containing cyclic compound as a component different from the resin, the compound A, and the photopolymerization initiator,
the condition ii: the composition contains, as the resin, a resin having a nitrogen-containing heterocyclic structure that contains two or more nitrogen atoms as ring members.

<2> The negative-tone photosensitive resin composition according to <1>, in which the compound A is a compound that does not generate a radical polymerization initiation species upon exposure.
<3> The negative-tone photosensitive resin composition according to <1> or <2>, in which the compound A includes a naphthoquinone diazide compound.
<4> The negative-tone photosensitive resin composition according to any one of <1> to <3>, in which a content of the nitrogen-containing cyclic compound is 0.5 to 200 parts by mass in a case where a content of the compound A is set to 100 parts by mass.
<5> A negative-tone photosensitive resin composition comprising:

a resin;
a naphthoquinone diazide compound; and
a photopolymerization initiator,
in which the negative-tone photosensitive resin composition satisfies at least one of the following condition iii or condition iv,
the condition iii: the composition further contains a nitrogen-containing cyclic compound as a component different from the resin, the naphthoquinone diazide compound, and the photopolymerization initiator,
the condition iv: the composition contains, as the resin, a resin having a nitrogen-containing heterocyclic structure that contains two or more nitrogen atoms as ring members.

<6> The negative-tone photosensitive resin composition according to any one of <1> to <5>, in which the resin is a cyclization resin or a precursor thereof.
<7> The negative-tone photosensitive resin composition according to any one of <1> to <6>, further comprising a polymerizable compound.
<8> The negative-tone photosensitive resin composition according to any one of <1> to <7>, further comprising a silane coupling agent.
<9> The negative-tone photosensitive resin composition according to any one of <1> to <8>, further comprising a polymerization inhibitor.
<10> The negative-tone photosensitive resin composition according to any one of <1> to <9>, further comprising a base generator.
<11> The negative-tone photosensitive resin composition according to any one of <1> to <10>, in which the photopolymerization initiator is a photoradical polymerization initiator.
<12> The negative-tone photosensitive resin composition according to any one of <1> to <11>, in which the negative-tone photosensitive resin composition is used for forming an interlayer insulating film for a re-distribution layer.
<13> A cured substance that is obtained by curing the negative-tone photosensitive resin composition according to any one of <1> to <12>.
<14> A laminate comprising:

two or more layers consisting of the cured substance according to <13>; and
a metal layer provided between any layers consisting of the cured substance.

<15> A manufacturing method for a cured substance, comprising: a film forming step of applying the negative-tone photosensitive resin composition according to any one of <1> to <12> onto a substrate to form a film;
an exposure step of selectively exposing the film; and
a development step of developing, by using a developer, the film exposed in the exposure step to form a pattern.
<16> The manufacturing method for a cured substance according to <15>, further comprising a heating step of heating the film at 50°C to 450°C.
<17> A semiconductor device comprising the cured substance according to <13> or the laminate according to <14>.

According to the present invention, there is provided a negative-tone photosensitive resin composition by which a pattern to be obtained has excellent resolution and a decrease in film thickness due to development is suppressed, a cured substance which is obtained by curing the negative-tone photosensitive resin composition, a laminate including the cured substance, a manufacturing method for the cured substance, and a semiconductor device including the cured substance or the laminate.

## DESCRIPTION OF THE PREFERRED EMBODIMENTS

Hereinafter, the main embodiments according to the present invention will be described. However, the present invention is not limited to the specified embodiments.

In the present specification, a numerical range described by using "to" means a range including numerical values described before and after the preposition "to" as a lower limit value and an upper limit value, respectively.

In the present specification, the term "step" means not only an independent step but also a step that cannot be clearly distinguished from other steps as long as the desired action of the step can be achieved.

In describing a group (an atomic group) in the present specification, in a case where a description of substitution and non-substitution is not provided, the description means the group includes a group (an atomic group) having a substituent as well as a group (an atomic group) having no substituent. For example, the "alkyl group" includes not only an alkyl group that does not have a substituent (an unsubstituted alkyl group) but also an alkyl group that has a substituent (a substituted alkyl group).

In the present specification, the "exposure" includes not only exposure using light but also exposure using particle beams such as an electron beam and an ion beam, unless otherwise specified. In addition, examples of the light that is used for exposure include an actinic ray such as an emission line spectrum of a mercury lamp, a far ultraviolet ray represented by an excimer laser, an extreme ultraviolet ray (EUV light), an X-ray, or an electron beam, and a radioactive ray.

In the present specification, "(meth)acrylate" means one or both of "acrylate" and "methacrylate", "(meth)acryl" means one or both of "acryl" and "methacryl", and "(meth)acryloyl" means one or both of "acryloyl" and "methacryloyl".

In the structural formulae of the present specification, Me represents a methyl group, Et represents an ethyl group, Bu represents a butyl group, and Ph represents a phenyl group.

In the present specification, the total solid content refers to the total mass of components excluding a solvent from the entire components of the composition. In addition, in the present specification, the concentration of solid contents is a mass percentage of other components excluding a solvent with respect to the total mass of the composition.

In the present specification, weight-average molecular weight (Mw) and number-average molecular weight (Mn) are each a value measured using gel permeation chromatography (GPC) unless otherwise specified, which are defined as a polystyrene equivalent value. In the present specification, the weight-average molecular weight (Mw) and the number-average molecular weight (Mn) can be determined, for example, by using HLC-8220 GPC(manufactured by Tosoh Corporation) and using GUARD COLUMN HZ-L, TSKgel Super HZM-M, TSK gel Super HZ4000, TSK gel Super HZ3000, and TSK gel Super HZ2000 (all of which are manufactured by Tosoh Corporation) as a column connected in series. The measurements of the above molecular weights are carried out using tetrahydrofuran (THF) as an eluent unless otherwise specified. However, N-methyl-2-pyrrolidone (NMP) can also be used in a case where THF is not suitable as the eluent, for example, in a case where the solubility is low. In addition, the detection in GPC measurement is carried out using a detector with an ultraviolet ray (a UV ray) of a wavelength of 254 nm unless otherwise specified.

In the present specification, in a case where the positional relationship of respective layers constituting the laminate is described as "upper" or "lower", it suffices that another layer is on the upper side or the lower side of the reference layer among the plurality of layers of interest. That is, a third layer or element may be further interposed between the reference layer and the other layer, and the reference layer and the other layer need not be in contact with each other. In addition, unless otherwise specified, the direction in which the layers are laminated on the base material is referred to as "upward", or in a case where a resin composition layer is present, the direction from the base material to the resin composition layer is referred to as "upper". The opposite direction thereof is referred to as "downward". Furthermore, such setting of upward and downward directions is for convenience in the present specification, and in a practical aspect, the "upward" direction in the present specification may be different from a vertically upward direction.

In the present specification, a composition may contain, as each component contained in the composition, two or more compounds corresponding to the component unless otherwise particularly specified. The content of each component in the composition means the total content of all the compounds corresponding to the component unless otherwise particularly specified.

In the present specification, unless otherwise specified, the temperature is 23°C, the atmospheric pressure is 101,325 Pa (1 atm), and the relative humidity is 50%RH.

In addition, in the present specification, a combination of preferred aspects is a more preferred aspect.

(Negative-tone photosensitive resin composition)

A negative-tone photosensitive resin composition in a first aspect according to the present invention contains a resin, a compound A of which an absorbance is reduced at an exposure wavelength upon exposure, and a photopolymerization initiator, where the negative-tone photosensitive resin composition satisfies at least one of the following condition i or condition ii.

The condition i: The composition further contains a nitrogen-containing cyclic compound as a component different from the resin, the compound A, and the photopolymerization initiator.

The condition ii: The composition contains, as the resin, a resin having a nitrogen-containing heterocyclic structure that contains two or more nitrogen atoms as ring members.

A negative-tone photosensitive resin composition in a second aspect according to the present invention contains a resin, a naphthoquinone diazide compound, and a photopolymerization initiator, where the negative-tone photosensitive resin composition satisfies at least one of the following condition iii or condition iv.

The condition iii: The composition further contains a nitrogen-containing cyclic compound as a component different from the resin, the naphthoquinone diazide compound, and the photopolymerization initiator.

The condition iv: The composition contains, as the resin, a resin having a nitrogen-containing heterocyclic structure that contains two or more nitrogen atoms as ring members.

Hereinafter, in a case of being simply described as "negative-tone photosensitive resin composition" or "resin composition", both the negative-tone photosensitive resin composition in the first aspect and the negative-tone photosensitive resin composition in the second aspect shall be included.

The negative-tone photosensitive resin composition according to the embodiment of the present invention is preferably used for forming a photosensitive film to be subjected to exposure and development, and it is more preferably used for forming a film to be subjected to exposure and development using a developer containing an organic solvent.

The resin composition according to the embodiment of the present invention can be used, for example, for forming an insulating film of a semiconductor device, an interlayer insulating film for a re-distribution layer, or a stress buffer film, and it is preferably used for forming an interlayer insulating film for a re-distribution layer.

In addition, the negative-tone photosensitive resin composition according to the embodiment of the present invention is used for forming a photosensitive film to be subjected to the negative tone development.

In the present invention, the negative tone development refers to development in which, in exposure and development, a non-exposed portion is removed by the development, and the positive tone development means a development in which an exposed portion is removed by the development.

As the exposure method, the developer, and the development method, for example, the following ones in the description of the manufacturing method for a cured substance, which will be described later, are used: an exposure method to be described in the exposure step, and a developer and a development method to be described in the development step.

According to the negative-tone photosensitive resin composition according to the embodiment of the present invention, the resolution of the pattern to be obtained is excellent, and the decrease in film thickness due to development is suppressed.

Although the mechanism by which the above effect is obtained is not revealed, it is presumed as follows.

In the related art, it has been carried out that a negative-tone photosensitive resin composition containing a resin and a photopolymerization initiator is used to form a photosensitive layer, and the photosensitive layer is exposed and developed to form a patterned cured substance on a metal layer.

Here, in the present invention, it was found that in a case where a compound A (a naphthoquinone diazide compound in the second aspect) in which absorbance at an exposure wavelength decreases upon exposure is contained, and at least one of the above-described condition i or condition ii (the condition iii and the condition iv in the second aspect) is satisfied, the resolution of a pattern on a metal substrate is improved.

This is presumed to be because the compound A (the naphthoquinone diazide compound in the second aspect) absorbs the exposure light, and thus the photopolymerization initiator is difficult to be photosensitized in a region where the exposure amount is small (for example, a region around a region to be actually exposed), and due to the decoloring (the decrease in absorbance at the exposure wavelength upon exposure) of the compound A (the naphthoquinone diazide compound in the second aspect), the photopolymerization initiator is difficult to be photosensitized in a region where the exposure amount is large.

Further, the negative-tone photosensitive resin composition according to the embodiment of the present invention contains a nitrogen-containing cyclic compound, contains, as the resin, a resin having a nitrogen-containing heterocyclic structure that contains two or more nitrogen atoms as ring members, or contains both the nitrogen-containing cyclic compound and the resin having a nitrogen-containing heterocyclic structure. It is conceived that this suppresses the migration of the metal from the metal layer to the photosensitive layer and makes it difficult for a development residue to be generated in the non-exposed portion. As a result, it is presumed that the effect due to the decoloring of the above-described compound A (the naphthoquinone diazide compound in the second aspect) is more remarkable, and the dissolution contrast between the exposed portion and the non-exposed portion is expanded, whereby the resolution of the pattern is excellent and the decrease in film thickness due to development is suppressed.

In addition, it is conceived that since the negative-tone photosensitive resin composition according to the embodiment of the present invention contains a nitrogen-containing cyclic compound, contains, as the resin, a resin having a nitrogen-containing heterocyclic structure that contains two or more nitrogen atoms as ring members, or contains

both the nitrogen-containing cyclic compound and the resin having a nitrogen-containing heterocyclic structure, the migration of the metal from the metal layer to the photosensitive layer is suppressed, the disturbance of the polymerization of the exposed portion by the metal is suppressed, and the curing easily proceeds sufficiently. Therefore, it is conceived that the cured substance to be obtained is also excellent in chemical resistance.

Further, it is conceived that the chemical resistance of the cured substance is also improved since a decomposition product generated through the decoloring of the compound A (for example, a decomposition product of the naphthoquinone diazide compound) is also incorporated into a crosslink of a resin or the like, and the crosslinking density is further increased. That is, the negative-tone photosensitive resin composition according to the second aspect according to the present invention is a composition that is more excellent in the chemical resistance of the cured substance to be obtained.

In particular, in a case where the resin is a cyclization resin or a precursor thereof and the compound A is a naphthoquinone diazide compound, the resin and a decomposition product of the naphthoquinone diazide compound may form a crosslinked structure, whereby the chemical resistance is greatly improved.

By the way, JP1994-130664A (JP-H6-130664A) and JP2019-206689A do not make a description regarding a negative-tone photosensitive resin composition that contains the compound A, contains, as the resin, a resin having a nitrogen-containing heterocyclic structure that contains two or more nitrogen atoms as ring members, or contains both the nitrogen-containing cyclic compound and the resin having a nitrogen-containing heterocyclic structure.

Hereinafter, the components contained in the resin composition according to the embodiment of the present invention will be described in detail.

<Resin>

The resin composition according to the embodiment of the present invention contains a resin.

In the present invention, the resin composition according to the embodiment of the present invention preferably satisfies at least one of the following (1) or (2).

(1) The resin contained in the resin composition has a polymerizable group.
(2) The resin composition further contains a polymerizable compound described below.

The resin is not particularly limited, and examples thereof include a resin that is used in a composition for pattern formation in the related art. However, it is preferable to include a cyclization resin or a precursor thereof (a specific resin), and it is more preferable to include a precursor of a cyclization resin.

In a case where the resin composition according to the embodiment of the present invention satisfies the above-described condition ii or condition iv, the resin composition according to the embodiment of the present invention contains, as the resin, a resin having a nitrogen-containing heterocyclic structure that contains two or more nitrogen atoms as ring members.

In a case where the resin composition according to the embodiment of the present invention satisfies the above-described condition i or condition iii, the resin composition according to the embodiment of the present invention may contain, as the resin, a resin having a nitrogen-containing heterocyclic structure that contains two or more nitrogen atoms as ring members.

The nitrogen-containing heterocyclic structure containing two or more nitrogen atoms as ring members may be a monocyclic ring or a may be a multicyclic ring, where it is preferably a monocyclic ring or a fused ring, more preferably a 5-membered or 6-membered monocyclic ring, or a fused ring between 5-membered rings, a fused ring between 6-membered rings, or a fused ring between a 5-membered ring and a 6-membered ring, and still more preferably a 5-membered monocyclic ring or a fused ring between a 5-membered ring and a 6-membered ring.

However, in a case where the nitrogen-containing heterocyclic structure is a multicyclic ring, it contains two or more nitrogen atoms as ring members in at least one monocyclic ring constituting the multicyclic ring. That is, for example, a benzimidazole ring corresponds to the nitrogen-containing heterocyclic structure referred to in the present invention, which contains two or more nitrogen atoms as ring members. However, a 7-azaindole ring shall correspond to the nitrogen-containing heterocyclic structure referred to in the present invention, which contains two or more nitrogen atoms as ring members.

In addition, like the purine ring structure, the nitrogen-containing heterocyclic structure may have a plurality of nitrogen-containing heterocyclic structures containing two or more nitrogen atoms as ring members in the multicyclic ring structure.

The nitrogen-containing heterocyclic structure may contain a heteroatom other than the nitrogen atom as a ring member. However, an aspect in which the nitrogen-containing heterocyclic structure does not contain a heteroatom other than the nitrogen atom as a ring member is also one of the preferred aspects of the present invention. Examples of the heteroatom other than the nitrogen atom include an oxygen atom and a sulfur atom.

The nitrogen-containing heterocyclic structure may be an aliphatic ring or may be an aromatic ring; however, it is preferably an aromatic ring.

Among the above, the nitrogen-containing heterocycle preferably contains an imidazole skeleton, a triazole skeleton, or a tetrazole skeleton, more preferably contains an imidazole ring, a triazole ring, a tetrazole ring, or a fused ring between each of these rings and another ring, and still more preferably a benzimidazole ring, a triazole ring, a benzotriazole ring, a tetrazole ring, or a purine ring, from the viewpoint of adhesion after a long period of time.

The other ring is preferably an aromatic ring, more preferably a 5-membered ring or a 6-membered ring, and still more preferably a benzene ring.

In a case where the resin composition according to the embodiment of the present invention contains a cyclization resin or a precursor thereof (a specific resin), the nitrogen-containing heterocyclic structure is preferably present at the terminal of the specific resin and more preferably present at the terminal of the main chain of the specific resin.

In the present invention, the main chain indicates the relatively longest bonding chain in the resin molecule.

It is preferable that at least one of the terminals of the main chain of the specific resin has the nitrogen-containing heterocyclic structure.

In a case where the specific resin contains the nitrogen-containing heterocyclic structure, the specific resin preferably contains a structure represented by Formula (1-1) or Formula (2-1).

In particular, in a case where the specific resin is any one of a polyimide, a polyimide precursor, a polyamideimide, or a polyamideimide precursor, it preferably contains a structure represented by Formula (1-1).

In addition, in a case where the specific resin is polybenzoxazole or a polybenzoxazole precursor, it preferably contains a structure represented by Formula (2-1).

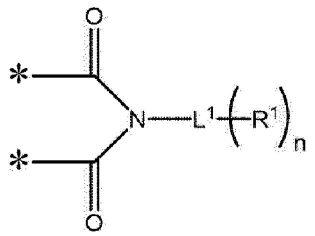 (1-1)

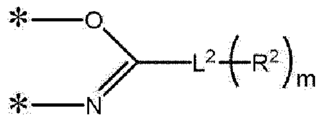 (2-1)

In Formula (1-1), $L^1$ represents an (n + 1)-valent linking group which does not contain a single bond or an imide ring structure, $R^1$ represents a nitrogen-containing heterocyclic structure which contains two or more nitrogen atoms as ring members, n represents an integer of 1 or more, and * represents a bonding site to another structure.

In Formula (2-1), $L^2$ represents an (m + 1)-valent linking group which does not contain a single bond or an oxazole ring structure, $R^2$ represents a nitrogen-containing heterocyclic structure which contains two or more nitrogen atoms as ring members, m represents an integer of 1 or more, and * represents a bonding site to another structure.

In Formula (1-1), $L^1$ is preferably a single bond, or an (n + 1)-valent hydrocarbon group, or a group containing, inside a hydrocarbon group, one or more structures, which are at least one kind of structure selected from the group consisting of -O-, -C(=O)-, $-NR^N-$, -S-, and $-S(=O)_2-$.

The $R^N$ represents a hydrogen atom or a monovalent substituent, and it is preferably a hydrogen atom or a hydrocarbon group and more preferably a hydrogen atom, an alkyl group, or an aromatic hydrocarbon group.

In addition, an aspect in which $L^1$ is a single bond is also one of the preferred aspects of the present invention.

In Formula (1-1), the preferred aspect of $R^1$ is the same as the preferred aspect of the nitrogen-containing heterocyclic structure described above.

In Formula (1-1), n is preferably an integer of 1 to 4, more preferably 1 or 2, and still more preferably 1.

In Formula (1-1), * represents a bonding site to another structure. Here, an aspect in which two pieces of * are respectively bonded to carbon atoms bonded by a covalent bond to form an imide ring structure including the imide structure described in Formula (1-1) is also one of the preferred aspects of the present invention. The imide ring structure is, for example, preferably a 5-membered ring structure.

In Formula (2-1), $L^2$ is preferably a single bond, or an (n + 1)-valent hydrocarbon group, or a group containing, inside a hydrocarbon group, one or more structures, which are at least one kind of structure selected from the group consisting of -O-, -C(=O)-, -S-, and $-S(=O)_2-$. In addition, an aspect in which $L^2$ is a single bond is also one of the preferred aspects of the present invention.

In Formula (2-1), the preferred aspect of $R^2$ is the same as the preferred aspect of the nitrogen-containing heterocyclic structure described above.

In Formula (2-1), m is preferably an integer of 1 to 4, more preferably 1 or 2, and still more preferably 1.

In Formula (2-1), * represents a bonding site to another structure. Here, an aspect in which two pieces of * are respectively bonded to carbon atoms bonded by a covalent bond to form the ring structure described in Formula (2-1),

which contains a nitrogen atom and an oxygen atom, is also one of the preferred aspects of the present invention. The ring structure is, for example, preferably an oxazole ring structure.

The specific resin preferably contains a structure represented by any one of Formula (1-2) or Formula (1-3) as the structure including the structure represented by Formula (1-1).

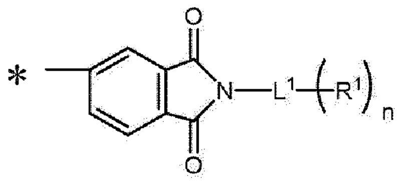

(1-2)

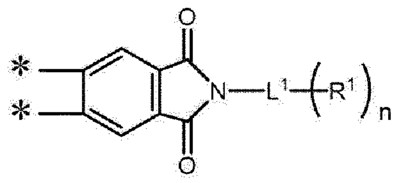

(1-3)

In Formula (1-2) or Formula (1-3), $L^1$ represents an (n + 1)-valent linking group which does not contain a single bond or an imide ring structure, $R^1$ represents a nitrogen-containing heterocyclic structure which contains two or more nitrogen atoms as ring members, n represents an integer of 1 or more, and * represents a bonding site to another structure.

In Formula (1-2) or Formula (1-3), $L^1$, $R^1$, and n respectively have the same meanings as $L^1$, $R^1$, and n in Formula (1-1), and the same applies to the preferred aspects thereof.

In addition, the specific resin preferably contains a structure represented by any one of Formula (2-2) or Formula (2-3) as the structure including the structure represented by Formula (2-1).

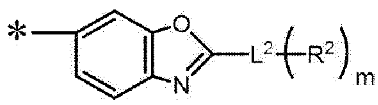

(2-3)

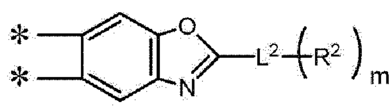

(2-2)

In Formula (2-2) or Formula (2-3), $L^2$ represents an (m + 1)-valent linking group which does not contain a single bond or an oxazole ring structure, $R^2$ represents a nitrogen-containing heterocyclic structure which contains two or more nitrogen atoms as ring members, m represents an integer of 1 or more, and * represents a bonding site to another structure.

In Formula (2-2) or Formula (2-3), $L^2$, $R^2$, and m respectively have the same meanings as $L^2$, $R^2$, and m in Formula (2-1), and the same applies to the preferred aspects thereof.

In a case where the specific resin contains the structure represented by Formula (1-1), it is also preferable that the specific resin contains a structure represented by Formula (1-4).

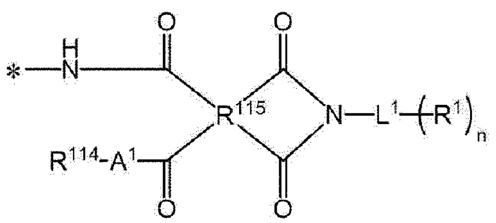

(1-4)

In Formula (1-4), $A^1$ represents an oxygen atom or -NH-, $R^{115}$ represents a tetravalent organic group, $R^{114}$ represents a hydrogen atom or a monovalent organic group, $L^1$ represents an (n + 1)-valent linking group which does not contain a single bond or an imide ring structure, $R^1$ represents a nitrogen-containing heterocyclic structure which contains two or more nitrogen atoms as ring members, n represents an integer of 1 or more, and * represents a bonding site to another structure.

In Formula (1-4), $A^1$, $R^{115}$, and $R^{114}$ respectively have the same meanings as $A^1$, $R^{115}$, and $R^{114}$ in Formula (2) described later, and the same applies to the preferred aspects thereof.

In Formula (1-4), $L^1$, $R^1$, and n respectively have the same meanings as $L^1$, $R^1$, and n in Formula (1-1) described above, and the same applies to the preferred aspect thereof.

In addition, in a case where the specific resin contains a structure represented by Formula (1-4), it is preferable that the specific resin contains a repeating unit represented by Formula (2) described later.

In a case where the specific resin contains a repeating unit represented by Formula (2) described later, it is also preferable that $A^1$, $R^{115}$, and $R^{114}$ in Formula (1-4) respectively have the same structures as those of $A^1$, $R^{115}$, and $R^{114}$ in any repeating unit which is contained in the specific resin and represented by Formula (2).

In addition, in a case where the specific resin contains a repeating unit represented by Formula (2) described later, it is also preferable that * in Formula (1-4) is a bonding site to $R^{111}$ in Formula (2).

In addition, in a case where the specific resin contains the structure represented by Formula (1-1), it is also preferable that the specific resin contains a structure represented by Formula (1-5).

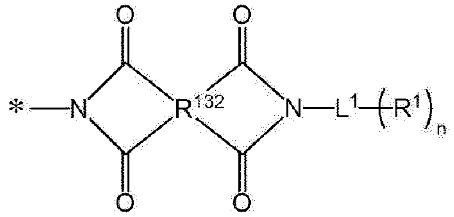

(1-5)

In Formula (1-5), $R^{132}$ represents a tetravalent organic group, $L^1$ represents an (n + 1)-valent linking group which does not contain a single bond or an imide ring structure, $R^1$ represents a nitrogen-containing heterocyclic structure which contains two or more nitrogen atoms as ring members, n represents an integer of 1 or more, and * represents a bonding site to another structure.

In Formula (1-5), $R^{132}$ has the same meaning as $R^{132}$ in Formula (4) described later, and the same applies to the preferred aspect thereof.

In Formula (1-5), $L^1$, $R^1$, and n respectively have the same meanings as $L^1$, $R^1$, and n in Formula (1-1) described above, and the same applies to the preferred aspect thereof.

In addition, in a case where the specific resin contains a structure represented by Formula (1-5), it is preferable that the specific resin contains a repeating unit represented by Formula (4) described later.

In a case where the specific resin contains a repeating unit represented by Formula (4) described later, it is also preferable that $R^{132}$ in Formula (1-5) has the same structure as that of $R^{132}$ in any repeating unit which is contained in the specific resin and represented by Formula (4).

In addition, in a case where the specific resin contains a repeating unit represented by Formula (4) described later, it is also preferable that * in Formula (1-5) is a bonding site to $R^{131}$ in Formula (4).

In a case where the specific resin contains the structure represented by Formula (2-1), it is also preferable that the specific resin contains a structure represented by Formula (2-4).

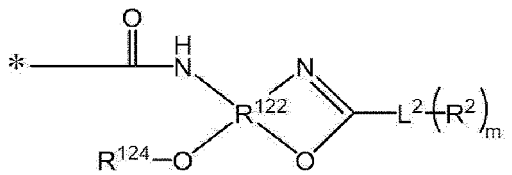

(2-4)

In Formula (2-4), $R^{122}$ represents a tetravalent organic group, $R^{124}$ represents a hydrogen atom or a monovalent organic group, $L^2$ is a single bond or an (m + 1)-valent linkage that does not contain an oxazole ring structure, $R^2$ represents a nitrogen-containing heterocyclic structure containing two or more nitrogen atoms as ring members, m represents an integer of 1 or more, and * represents a bonding site to another structure.

In Formula (2-4), $R^{122}$ and $R^{124}$ respectively have the same meanings as $R^{122}$ and $R^{124}$ in Formula (3) described later, and the same applies to the preferred aspects thereof.

In Formula (2-4), $L^2$, $R^2$, and m respectively have the same meanings as $L^2$, $R^2$, and m in Formula (2-1) described later, and the same applies to the preferred aspects thereof.

In addition, in a case where the specific resin contains a structure represented by Formula (2-4), it is preferable that the specific resin contains a repeating unit represented by Formula (3) described later.

In a case where the specific resin contains a repeating unit represented by Formula (3) described later, it is also preferable that $R^{122}$ and $R^{124}$ in Formula (2-4) respectively have the same structures as those of $R^{122}$ and $R^{124}$ in any repeating unit which is contained in the specific resin and represented by Formula (3).

In addition, in a case where the specific resin contains a repeating unit represented by Formula (3) described later, it is also preferable that * in Formula (2-4) is a bonding site to $R^{121}$ in Formula (3).

In a case where the specific resin contains the structure represented by Formula (2-1), it is also preferable that the specific resin contains a structure represented by Formula (2-5).

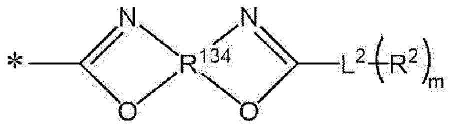

(2-5)

In Formula (2-5), $R^{134}$ represents a tetravalent organic group, $L^2$ represents an (m + 1)-valent linking group which does not contain a single bond or an oxazole ring structure, $R^2$ represents a nitrogen-containing heterocyclic structure which contains two or more nitrogen atoms as ring members, m represents an integer of 1 or more, and * represents a bonding site to another structure.

In Formula (2-5), $R^{134}$ has the same meaning as $R^{134}$ in Formula (X) described later, and the same applies to the preferred aspect thereof.

In Formula (2-5), $L^2$, $R^2$, and m respectively have the same meanings as $L^2$, $R^2$, and m in Formula (1-1) described later, and the same applies to the preferred aspects thereof.

In addition, in a case where the specific resin contains a structure represented by Formula (2-5), it is preferable that the specific resin contains a repeating unit represented by Formula (X) described later.

In a case where the specific resin contains a repeating unit represented by Formula (X) described later, it is also preferable that $R^{134}$ in Formula (2-5) has the same structure as that of $R^{134}$ in any repeating unit which is contained in the specific resin and represented by Formula (X).

In addition, in a case where the specific resin contains a repeating unit represented by Formula (X) described later, it is also preferable that * in Formula (1-5) is a bonding site to $R^{133}$ in Formula (X).

Hereinafter, specific examples of the structure which includes a nitrogen-containing heterocyclic structure containing two or more nitrogen atoms as ring members and is contained in the specific resin will be described, however, the present invention is not limited thereto. In the following structures, * represents a bonding site to another structure.

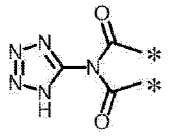
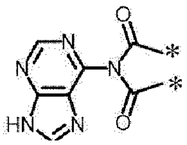
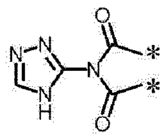
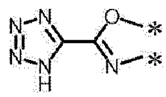

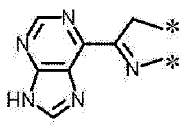
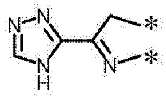
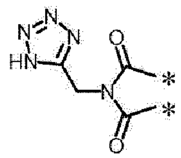
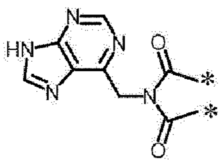

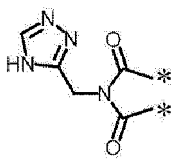
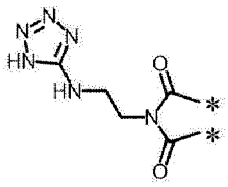
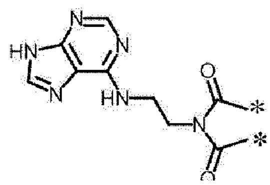

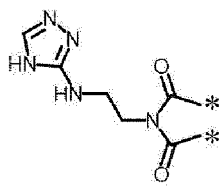
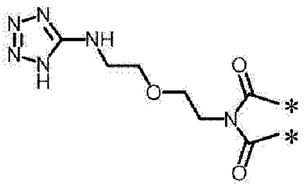

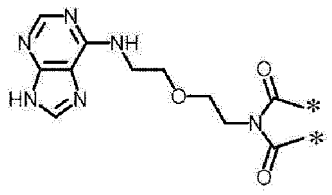

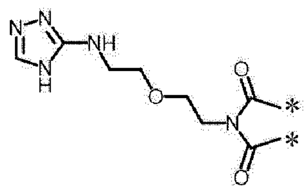

In addition, the above-described nitrogen-containing heterocyclic structure may be contained, for example, in $R^{113}$ and $R^{114}$ in Formula (2) described later, $R^{123}$ and $R^{124}$ in Formula (3) described later, and $R^{113}$ in Formula (PAI-2) described later.

The cyclization resin is preferably a resin containing an imide ring structure or an oxazole ring structure in the main chain structure.

In the present invention, the main chain indicates the relatively longest bonding chain in the resin molecule.

Examples of the cyclization resin include polyimide, polybenzoxazole, and polyamideimide.

The precursor of the cyclization resin refers to a resin of which the chemical structure changes by an external stimulus, thereby becoming a cyclization resin. It is preferably a resin of which the chemical structure changes by heat, thereby becoming a cyclization resin, and it is more preferably a resin which undergoes a ring closure reaction by heat to form a ring structure, thereby becoming a cyclization resin.

Examples of the precursor of the cyclization resin include a polyimide precursor, a polybenzoxazole precursor, and a polyamideimide precursor.

That is, the resin composition according to the embodiment of the present invention preferably contains, as the specific resin, at least one resin (specific resin) selected from the group consisting of a polyimide, a polyimide precursor, a polybenzoxazole, a polybenzoxazole precursor, a polyamideimide, and a polyamideimide precursor.

The resin composition according to the embodiment of the present invention preferably contains a polyimide or a polyimide precursor as the specific resin.

In addition, the specific resin preferably has a polymerizable group and more preferably contains a radically polymerizable group.

In a case where the specific resin has a radically polymerizable group, the resin composition according to the embodiment of the present invention preferably contains a radical polymerization initiator described later, and it more preferably contains a radical polymerization initiator described later and a radical crosslinking agent described later. Further, a sensitizing agent described later can be contained as necessary. From such a resin composition according to the embodiment of the present invention, for example, a negative-tone photosensitive film is formed.

[Polyimide precursor]

The kind or the like of the polyimide precursor that is used in the present invention is not particularly specified; however, it is preferable that the polyimide precursor contains a repeating unit represented by Formula (2).

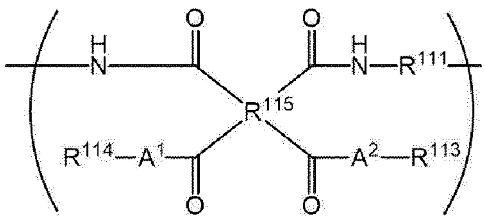

(2)

In Formula (2), $A^1$ and $A^2$ each independently represent an oxygen atom or -NH-, $R^{111}$ represents a divalent organic group, $R^{115}$ represents a tetravalent organic group, and $R^{113}$ and $R^{114}$ each independently represent a hydrogen atom or a monovalent organic group.

$A^1$ and $A^2$ in Formula (2) each independently represent an oxygen atom or -NH-, and an oxygen atom is preferable.

$R^{111}$ in Formula (2) represents a divalent organic group. Examples of the divalent organic group include a group having a linear or branched aliphatic group, a cyclic aliphatic group, or an aromatic group. A linear or branched aliphatic group having 2 to 20 carbon atoms, a cyclic aliphatic group having 3 to 20 carbon atoms, an aromatic group having 3 to 20 carbon atoms, or a group consisting of a combination of these groups is preferable, and a group containing an aromatic group having 6 to 20 carbon atoms is more preferable. In the linear or branched aliphatic group, the hydrocarbon group in the chain may be substituted with a group containing a heteroatom, and in the cyclic aliphatic group and the

aromatic group, the hydrocarbon group of the ring member may be substituted with a group containing a heteroatom. Examples of the preferred embodiment of the present invention include groups respectively represented by -Ar- and -Ar-L-Ar-, and where a group represented by -Ar-L-Ar- is particularly preferable. However, Ar's are each independently an aromatic group, and L is a single bond or an aliphatic hydrocarbon group having 1 to 10 carbon atoms, which may be substituted with a fluorine atom, -O-, -CO-, -S-, $-SO_2-$, or -NHCO-, or a group consisting of a combination of two or more of the above. The preferred ranges thereof are as described above.

$R^{111}$ is preferably derived from a diamine. Examples of the diamine that is used for producing the polyimide precursor include a linear aliphatic or branched aliphatic diamine, a cyclic aliphatic diamine, or an aromatic diamine. One kind of diamine may be used alone, or two or more kinds thereof may be used.

Specifically, the diamine is preferably a diamine containing a linear or branched aliphatic group having 2 to 20 carbon atoms, a cyclic aliphatic group having 3 to 20 carbon atoms, an aromatic group having 3 to 20 carbon atoms, or a group consisting of a combination thereof, and more preferably a diamine containing an aromatic group having 6 to 20 carbon atoms. In the linear or branched aliphatic group, the hydrocarbon group in the chain may be substituted with a group containing a heteroatom, and in the cyclic aliphatic group and the aromatic group, the hydrocarbon group of the ring member may be substituted with a group containing a heteroatom. Examples of the group containing an aromatic group include the following groups.

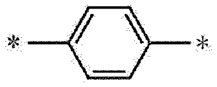
AR-1

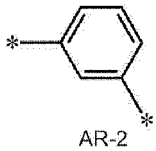
AR-2

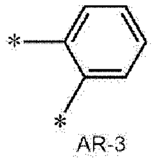
AR-3

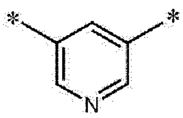
AR-4

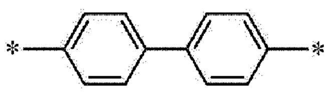
AR-5

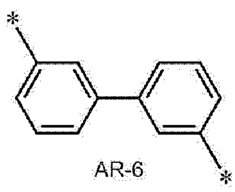
AR-6

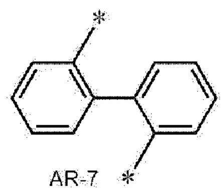
AR-7

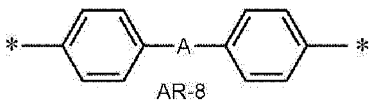
AR-8

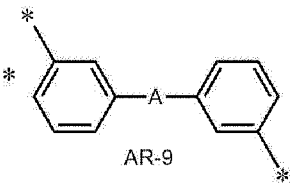
AR-9

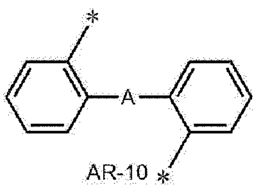
AR-10

In the formulae, A represents a single bond or a divalent linking group. It is preferably a single bond, or an aliphatic hydrocarbon group having 1 to 10 carbon atoms, which may be substituted with a fluorine atom, -O-, -C(=O)-, -S-, $-SO_2-$, -NHCO-, or a group selected from combinations thereof, more preferably a single bond or a group selected from an alkylene group having 1 to 3 carbon atoms, which may be substituted with a fluorine atom, -O-, -C(=O)-, -S-, or $-SO_2-$, and still more preferably $-CH_2-$, -O-, -S-, $-SO_2-$, $-C(CF_3)_2-$, or $-C(CH_3)_2-$.

In the formulae, * represents a bonding site to another structure.

Specific examples of the diamine include at least one diamine selected from 1,2-diaminoethane, 1,2-diaminopropane, 1,3-diaminopropane, 1,4-diaminobutane, or 1,6-diaminohexane; 1,2- or 1,3-diaminocyclopentane, 1,2-, 1,3-, or 1,4-diaminocyclohexane, 1,2-, 1,3-, or 1,4-bis(aminomethyl)cyclohexane, bis-(4-aminocyclohexyl)methane, bis-(3-aminocyclohexyl)methane, 4,4'-diamino-3,3'-dimethylcyclohexylmethane, or isophorone diamine; m- or p-phenylene diamine, diaminotoluene, 4,4'- or 3,3'-diaminobiphenyl, 4,4'-diaminodiphenyl ether, 3,3-diaminodiphenyl ether, 4,4'- or 3,3'-diaminodiphenylmethane, 4,4'- or 3,3'-diaminodiphenyl sulfone, 4,4'- or 3,3'-diaminodiphenyl sulfide, 4,4'- or 3,3'-diaminobenzophenone, 3,3'-dimethyl-4,4'-diaminobiphenyl, 2,2'-dimethyl-4,4'-diaminobiphenyl, 3,3'-dimethoxy-4,4'-diaminobiphenyl, 2,2-bis(4-aminophenyl)propane, 2,2-bis(4-aminophenyl)hexafluoropropane, 2,2-bis(3-hydroxy-4-aminophenyl)propane, 2,2-bis(3-hydroxy-4-aminophenyl)hexafluoropropane, 2,2-bis(3-amino-4-hydroxyphenyl)propane, 2,2-bis(3-amino-4-hydroxyphenyl)hexafluoropropane, bis(3-amino-4-hydroxyphenyl)sulfone, bis(4-amino-3-hydroxyphenyl)sulfone, 4,4'-diaminoparaterphenyl, 4,4-bis(4-aminophenoxy)biphenyl, bis[4-(4-aminophenoxy)phenyl]sulfone, bis[4-(3-aminophenoxy)phenyl]sulfone, bis[4-(2-aminophenoxy)phenyl]sulfone, 1,4-bis(4-aminophenoxy)benzene, 9,10-bis(4-aminophenyl)anthracene, 3,3'-dimethyl-4,4'-diaminodiphenyl sulfone, 1,3-bis(4-aminophenoxy)benzene,

1,3-bis(3 -aminophenoxy)benzene, 1,3-bis(4-aminophenyl)benzene, 3,3'-diethyl-4,4'-diaminodiphenylmethane, 3,3'-dimethyl-4,4'-diaminodiphenylmethane, 4,4'-diaminooctafluorobiphenyl, 2,2-bis[4-(4-aminophenoxy)phenyl]propane, 2,2-bis[4-(4-aminophenoxy)phenyl]hexafluoropropane, 9,9-bis(4-aminophenyl)-10-hydroanthracene, 3,3',4,4'-tetraaminobiphenyl, 3,3',4,4'-tetraaminodiphenyl ether, 1,4-diaminoanthraquinone, 1,5-diaminoanthraquinone, 3,3-dihydroxy-4,4'-diaminobiphenyl, 9,9'-bis(4-aminophenyl)fluorene, 4,4'-dimethyl-3,3'-diaminodiphenyl sulfone, 3,3',5,5'-tetramethyl-4,4'-diaminodiphenylmethane, 2,4- or, 2,5-diaminocumene, 2,5-dimethyl-p-phenylene diamine, acetoguanamine, 2,3,5,6-tetramethyl-p-phenylene diamine, 2,4,6-trimethyl-m-phenylene diamine, bis(3-aminopropyl)tetramethyl disiloxane, bis(p-aminophenyl)octamethylpentasiloxane, 2,7-diaminofluorene, 2,5-diaminopyridine, 1,2-bis(4-aminophenyl)ethane, diaminobenzanilide, esters of diaminobenzoic acid, 1,5-diaminonaphthalene, diaminobenzotrifluoride, 1,3-bis(4-aminophenyl)hexafluoropropane, 1,4-bis(4-aminophenyl)octafluorobutane, 1,5-bis(4-aminophenyl)decafluoropentane, 1,7-bis(4-aminophenyl)tetradecafluoroheptane, 2,2-bis[4-(3-aminophenoxy)phenyl]hexafluoropropane, 2,2-bis[4-(2-aminophenoxy)phenyl]hexafluoropropane, 2,2-bis[4-(4-aminophenoxy)-3,5-dimethylphenyl]hexafluoropropane, 2,2-bis[4-(4-aminophenoxy)-3,5-bis(trifluoromethyl)phenyl]hexafluoropropane, p-bis(4-amino-2-trifluoromethylphenoxy)benzene, 4,4'-bis(4-amino-2-trifluoromethylphenoxy)biphenyl, 4,4'-bis(4-amino-3-trifluoromethylphenoxy)biphenyl, 4,4'-bis(4-amino-2-trifluoromethylphenoxy)diphenyl sulfone, 4,4'-bis(3-amino-5-trifluoromethylphenoxy)diphenyl sulfone, 2,2-bis[4-(4-amino-3-trifluoromethylphenoxy)phenyl]hexafluoropropane, 3,3',5,5'-tetramethyl-4,4'-diaminobiphenyl, 4,4'-diamino-2,2'-bis(trifluoromethyl)biphenyl, 2,2',5,5',6,6'-hexafluorotolidine, or 4,4'-diaminoquaterphenyl.

Further, the diamines (DA-1) to (DA-18) described in paragraphs 0030 to 0031 of WO2017/038598A are also preferable.

Further, the diamine having two or more alkylene glycol units in the main chain, described in paragraphs 0032 to 0034 of WO2017/038598A, is also preferably used.

$R^{111}$ is preferably represented by -Ar-L-Ar- from the viewpoint of the flexibility of the organic film to be obtained. However, Ar's are each independently an aromatic group, and L is an aliphatic hydrocarbon group having 1 to 10 carbon atoms, which may be substituted with a fluorine atom, -O-, -CO-, -S-, $-SO_2-$, or -NHCO-, or a group consisting of a combination of two or more of the above. Ar is preferably a phenylene group, and L is preferably an aliphatic hydrocarbon group having 1 or 2 carbon atoms, which may be substituted with a fluorine atom, -O-, -CO-, -S-, or $-SO_2-$. The aliphatic hydrocarbon group here is preferably an alkylene group.

In addition, from the viewpoint of the i-line transmittance, $R^{111}$ is preferably a divalent organic group represented by Formula (51) or Formula (61) below. In particular, from the viewpoint of the i-line transmittance and ease of availability, a divalent organic group represented by Formula (61) is more preferable.

Formula (51)

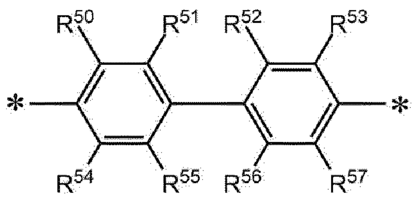

(51)

In Formula (51), $R^{50}$ to $R^{57}$ each independently represent a hydrogen atom, a fluorine atom, or a monovalent organic group, and at least one of $R^{50}$, ..., or $R^{57}$ represents a fluorine atom, a methyl group, or a trifluoromethyl group, and *'s each independently represent a bonding site to the nitrogen atom in Formula (2).

Examples of the monovalent organic group as $R^{50}$ to $R^{57}$ include an unsubstituted alkyl group having 1 to 10 (preferably 1 to 6) carbon atoms and a fluorinated alkyl group having 1 to 10 (preferably 1 to 6) carbon atoms.

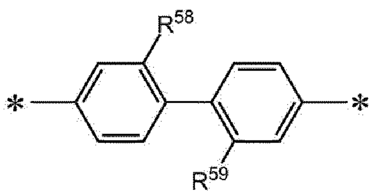

(61)

In Formula (61), $R^{58}$ and $R^{59}$ each independently represent a fluorine atom, a methyl group, or a trifluoromethyl group, and *'s each independently represent a bonding site to the nitrogen atom in Formula (2).

Examples of the diamine that provides a structure of Formula (51) or (61), 2,2'-dimethylbenzidine, 2,2'-bis(trifluoromethyl)-4,4'-diaminobiphenyl, and 2,2'-bis(fluoro)-4,4'-diaminobiphenyl, 4,4'-diaminooctafluorobiphenyl. These

may be used alone or in a combination of two or more thereof.

$R^{115}$ in Formula (2) represents a tetravalent organic group. The tetravalent organic group is preferably a tetravalent organic group containing an aromatic ring and more preferably a group represented by Formula (5) or Formula (6).

In Formula (5) or Formula (6), *'s each independently represent a bonding site to another structure.

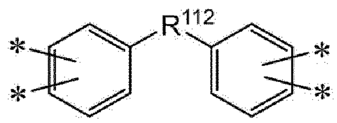 (5) 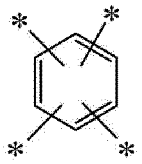 (6)

In Formula (5), $R^{112}$ is a single bond or a divalent linking group. It is preferably a single bond or a group selected from an aliphatic hydrocarbon group having 1 to 10 carbon atoms, which may be substituted with a fluorine atom, -O-, -CO-, -S-, $-SO_2-$, -NHCO-, or a combination thereof, more preferably a single bond or a group selected from an alkylene group having 1 to 3 carbon atoms, which may be substituted with a fluorine atom, -O-, -CO-, -S-, or $-SO_2-$, and still more preferably a divalent group selected from the group consisting of $-CH_2-$, $-C(CF_3)_2-$, $-C(CH_3)_2-$, -O-, -CO-, -S-, and $-SO_2-$.

Specific examples of $R^{115}$ include a tetracarboxylic acid residue that remains after the removal of the anhydride group from the tetracarboxylic acid dianhydride. The polyimide precursor may contain only one kind of tetracarboxylic acid dianhydride residue or may contain two or more kinds thereof, as a structure corresponding to $R^{115}$.

The tetracarboxylic acid dianhydride is preferably represented by Formula (O).

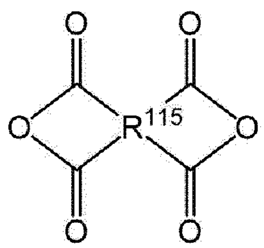 (O)

In Formula (O), $R^{115}$ represents a tetravalent organic group. The preferred range of $R^{115}$ has the same meaning as $R^{115}$ in Formula (2), and the same applies to the preferred range thereof.

Specific examples of the tetracarboxylic acid dianhydride include pyromellitic acid dianhydride (PMDA), 3,3',4,4'-biphenyltetracarboxylic acid dianhydride, 3,3',4,4'-diphenylsulfide tetracarboxylic acid dianhydride, 3,3',4,4'-diphenylsulfone tetracarboxylic acid dianhydride, 3,3',4,4'-benzophenone tetracarboxylic acid dianhydride, 3,3',4,4'-diphenylmethane tetracarboxylic acid dianhydride, 2,2',3,3'-diphenylmethane tetracarboxylic acid dianhydride, 2,3,3',4'-biphenyltetracarboxylic acid dianhydride, 2,3,3',4'-benzophenone tetracarboxylic acid dianhydride, 4,4'-oxydiphthalic acid dianhydride, 2,3,6,7-naphthalene tetracarboxylic acid dianhydride, 1,4,5,7-naphthalene tetracarboxylic acid dianhydride, 2,2-bis(3,4-dicarboxyphenyl)propane dianhydride, 2,2-bis(2,3-dicarboxyphenyl)propane dianhydride, 2,2-bis(3,4-dicarboxyphenyl) hexafluoropropane dianhydride, 1,3-diphenylhexafluoropropane-3,3,4,4-tetracarboxylic acid dianhydride, 1,4,5,6-naphthalene tetracarboxylic acid dianhydride, 2,2',3,3'-diphenyl tetracarboxylic acid dianhydride, 3,4,9,10-perylene tetracarboxylic acid dianhydride, 1,2,4,5-naphthalene tetracarboxylic acid dianhydride, 1,4,5,8-naphthalene tetracarboxylic acid dianhydride, 1,8,9,10-phenanthrene tetracarboxylic acid dianhydride, 1,1-bis(2,3-dicarboxyphenyl)ethane dianhydride, 1,1-bis(3,4-dicarboxyphenyl)ethane dianhydride, 1,2,3,4-benzene tetracarboxylic acid dianhydride, and alkyl derivatives having 1 to 6 carbon atoms thereof as well as alkoxy derivatives having 1 to 6 carbon atoms thereof.

In addition, preferred examples thereof include the tetracarboxylic acid dianhydrides (DAA-1) to (DAA-5) described in paragraph 0038 of WO2017/038598A.

In Formula (2), it is also possible that at least one of $R^{111}$ or $R^{115}$ has an OH group. More specifically, examples of $R^{111}$ include a residue of a bisaminophenol derivative.

$R^{113}$ and $R^{114}$ in Formula (2) each independently represent a hydrogen atom or a monovalent organic group. The monovalent organic group preferably includes a linear or branched alkyl group, a cyclic alkyl group, an aromatic group, or a polyalkyleneoxy group. In addition, at least one of $R^{113}$ or $R^{114}$ preferably contains a polymerizable group, and more preferably both of them contain a polymerizable group. It is also preferable that at least one of $R^{113}$ or $R^{114}$ contains two or more polymerizable groups. The polymerizable group is preferably a group capable of undergoing a crosslinking reaction under the action of heat, a radical, or the like, where the group is a radically polymerizable group. Specific examples of the polymerizable group include a group having an ethylenically unsaturated bond, an alkoxymethyl group, a hydroxymethyl group, an acyloxymethyl group, an epoxy group, an oxetanyl group, a benzoxazolyl group, a

blocked isocyanate group, and an amino group. The radically polymerizable group contained in the polyimide precursor is preferably a group having an ethylenically unsaturated bond.

Examples of the group having an ethylenically unsaturated bond include a vinyl group, an allyl group, an isoallyl group, a 2-methylallyl group, a group (for example, a vinylphenyl group) having an aromatic ring that is directly bonded to a vinyl group, a (meth)acrylamide group, a (meth)acryloyloxy group, and a group represented by Formula (III), where a group represented by Formula (III) is preferable.

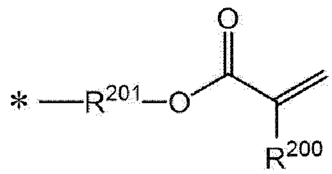

(III)

In Formula (III), $R^{200}$ represents a hydrogen atom, a methyl group, an ethyl group, or a methylol group, where a hydrogen atom or a methyl group is preferable.

In Formula (III), * represents a bonding site to another structure.

In Formula (III), $R^{201}$ represents an alkylene group having 2 to 12 carbon atoms, $-CH_2CH(OH)CH_2-$, a cycloalkylene group, or a polyalkyleneoxy group.

Suitable examples of $R^{201}$ include an alkylene group such as an ethylene group, a propylene group, a trimethylene group, a tetramethylene group, a pentamethylene group, a hexamethylene group, an octamethylene group, or a dodecamethylene group, a 1,2-butanediyl group, a 1,3-butanediyl group, $-CH_2CH(OH)CH_2-$, and a polyalkyleneoxy group, where an alkylene group such as an ethylene group or a propylene group, $-CH_2CH(OH)CH_2-$, a cyclohexyl group, or a polyalkyleneoxy group is more preferable, and an alkylene group such as an ethylene group or a propylene group, or a polyalkyleneoxy group is still more preferable.

In the present invention, the polyalkyleneoxy group refers to a group to which two or more alkyleneoxy groups are directly bonded. The alkylene group in the plurality of alkyleneoxy groups contained in the polyalkyleneoxy group may be the same or different from each other.

In a case where the polyalkyleneoxy group contains a plurality of kinds of alkyleneoxy groups having different alkylene groups, the sequence of the alkyleneoxy groups in the polyalkyleneoxy group may be a random sequence, may be a sequence having a block, or may be a sequence having an alternating pattern or the like.

The number of carbon atoms of the alkylene group (including the number of carbon atoms of the substituent in a case where the alkylene group has a substituent) is preferably 2 or more, more preferably 2 to 10, still more preferably 2 to 6, even still more preferably 2 to 5, even further still more preferably 2 to 4, particularly preferably 2 or 3, and most preferably 2.

In addition, the alkylene group may have a substituent. Examples of the preferred substituent include an alkyl group, an aryl group, and a halogen atom.

In addition, the number of alkyleneoxy groups contained in the polyalkyleneoxy group (the number of repetitions of the polyalkyleneoxy group) is preferably 2 to 20, more preferably 2 to 10, and still more preferably 2 to 6.

The polyalkyleneoxy group is preferably a polyethyleneoxy group, a polypropyleneoxy group, a polytrimethyleneoxy group, a polytetramethyleneoxy group, or a group obtained by bonding a plurality of ethyleneoxy groups with a plurality of propyleneoxy groups, more preferably a polypropyleneoxy group or a polyethyleneoxy group, and still more preferably a polyethyleneoxy group, from the viewpoint of solubility in a solvent and solvent resistance. In the group obtained by bonding a plurality of ethyleneoxy groups with a plurality of propyleneoxy groups, the ethyleneoxy groups and the propyleneoxy groups may be randomly arranged, may be arranged by forming a block, or may be arranged in an alternately patterned manner or the like. The preferred aspect of the number of repetitions of the ethyleneoxy group and the like in these groups is as described above.

In Formula (2), in a case where $R^{113}$ is a hydrogen atom, or in a case where $R^{114}$ is a hydrogen atom, the polyimide precursor may form a conjugate salt together with a tertiary amine compound having an ethylenically unsaturated bond. Examples of the tertiary amine compound having such an ethylenically unsaturated bond include N,N-dimethylaminopropyl methacrylate.

In addition, the polyimide precursor preferably has a fluorine atom in the structure thereof. The content of fluorine atoms in the polyimide precursor is preferably 10% by mass or more, and it is preferably 20% by mass or less.

In addition, for the purpose of improving adhesiveness to a substrate, the polyimide precursor may be copolymerized with an aliphatic group having a siloxane structure. Specifically, an aspect in which bis(3-aminopropyl)tetramethyldisiloxane, bis(p-aminophenyl)octamethyl pentasiloxane, or the like is used as the diamine can be mentioned.

The repeating unit represented by Formula (2) is preferably a repeating unit represented by Formula (2-A). That is, at least one polyimide precursor that is used in the present invention is preferably a precursor having a repeating

unit represented by Formula (2-A). In a case where the polyimide precursor contains a repeating unit represented by Formula (2-A), it is possible to further widen the width of the exposure latitude.

Formula (2-A)

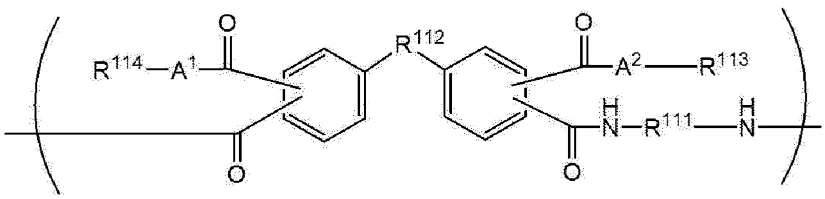

In Formula (2-A), $A^1$ and $A^2$ represent an oxygen atom, $R^{111}$ and $R^{112}$ each independently represent a divalent organic group, $R^{113}$ and $R^{114}$ each independently represent a hydrogen atom or a monovalent organic group, and at least one of $R^{113}$ or $R^{114}$ is a group containing a polymerizable group, where both of them are preferably a group containing a polymerizable group.

$A^1$, $A^2$, $R^{111}$, $R^{113}$, and $R^{114}$ are each independently have the same meaning as $A^1$, $A^2$, $R^{111}$, $R^{113}$, and $R^{114}$ in Formula (2), respectively, and the same applies to the preferred ranges thereof.

$R^{112}$ has the same meaning as $R^{112}$ in Formula (5), and the same applies to the preferred range thereof.

The polyimide precursor may contain one kind of repeating unit represented by Formula (2) or may contain two or more kinds thereof. In addition, the polyimide precursor may contain structural isomers of the repeating unit represented by Formula (2). In addition, it is needless to say that the polyimide precursor may also contain another kind of repeating unit in addition to the above repeating unit of Formula (2).

One embodiment of the polyimide precursor in the present invention includes an embodiment in which the content of the repeating unit represented by Formula (2) is 50% by mole or more of all the repeating units. The above-described total content is more preferably 70% by mole or more, still more preferably 90% by mole or more, and particularly preferably more than 90% by mole. The upper limit of the total content is not particularly limited, and all the repeating units in the polyimide precursor excluding the terminal may be the repeating unit represented by Formula (2).

The weight-average molecular weight (Mw) of the polyimide precursor is preferably 5,000 to 100,000, more preferably 10,000 to 50,000, and still more preferably 15,000 to 40,000. In addition, the number-average molecular weight (Mn) thereof is preferably 2,000 to 40,000, more preferably 3,000 to 30,000, and still more preferably 4,000 to 20,000.

The dispersivity of the molecular weight of the polyimide precursor is preferably 1.5 or more, more preferably 1.8 or more, and still more preferably 2.0 or more. The upper limit value of the dispersivity of the molecular weight of the polyimide precursor is not particularly limited; however, it is, for example, preferably 7.0 or less, more preferably 6.5 or less, and still more preferably 6.0 or less.

In the present specification, the dispersivity of the molecular weight is a value obtained by calculating "weight-average molecular weight/number-average molecular weight".

In addition, in a case where the resin composition contains a plurality of kinds of polyimide precursors as the specific resin, it is preferable that the weight-average molecular weight, the number-average molecular weight, and the dispersivity of at least one kind of polyimide precursor are in the above ranges. Further, it is also preferable that the weight-average molecular weight, the number-average molecular weight, and the dispersivity, calculated by using the plurality of kinds of polyimide precursors as one resin, are within the above ranges.

[Polyimide]

The polyimide that is used in the present invention may be an alkali-soluble polyimide or may be a polyimide soluble in a developer containing an organic solvent as a main component.

In the present specification, the alkali-soluble polyimide refers to a polyimide, 0.1 g or more of which is dissolved in 100 g of an aqueous solution of 2.38% by mass of tetramethylammonium at 23°C, and from the viewpoint of pattern formation properties, it is preferably a polyimide, 0.5 g or more of which is dissolved therein and still more preferably a polyimide, 1.0 g or more of which is dissolved therein. The upper limit of the dissolution amount is not particularly limited; however, it is preferably 100 g or less.

In addition, the polyimide is preferably a polyimide having a plurality of imide structures in the main chain from the viewpoint of the film hardness and the insulating properties of the organic film to be obtained.

In the present specification, the "main chain" refers to the relatively longest bonding chain in the molecule of the polymer compound that constitutes the resin, and the "side chain" refers to other bonding chains other than the main chain.

- Fluorine atom -

From the viewpoint of the film hardness of the organic film to be obtained, the polyimide preferably has a fluorine atom.

The fluorine atom is preferably contained in, for example, $R^{132}$ in a repeating unit represented by Formula (4) described later or $R^{131}$ in a repeating unit represented by Formula (4) described later, and it is more preferably contained, as a fluorinated alkyl group, in $R^{132}$ in a repeating unit represented by Formula (4) described later or $R^{131}$ in a repeating unit represented by Formula (4) described later.

The amount of fluorine atoms with respect to the total mass of the polyimide is preferably 5% by mass or more, and it is preferably 20% by mass or less.

- Silicon atom -

From the viewpoint of the film hardness of the organic film to be obtained, it is also preferable that the polyimide has a silicon atom.

The silicon atom is preferably contained in, for example, $R^{131}$ in a repeating unit represented by Formula (4) described later, and more preferably contained in $R^{131}$ in a repeating unit represented by Formula (4) described later as an organically modified (poly)siloxane structure.

In addition, the silicon atom or the organically modified (poly)siloxane structure may be contained in the side chain of the polyimide; however, it is preferably contained in the main chain of the polyimide.

The amount of silicon atoms with respect to the total mass of the polyimide is preferably 1% by mass or more and more preferably 20% by mass or less.

- Ethylenically unsaturated bond -

From the viewpoint of the film hardness of the organic film to be obtained, the polyimide preferably has an ethylenically unsaturated bond.

The polyimide may have an ethylenically unsaturated bond at the terminal of the main chain or the side chain; however, it preferably has an ethylenically unsaturated bond at the side chain.

The ethylenically unsaturated bond preferably has radical polymerizability.

The ethylenically unsaturated bond is preferably contained in $R^{132}$ in a repeating unit represented by Formula (4) described later or $R^{131}$ in a repeating unit represented by Formula (4) described later, and it is more preferably contained, as a group having an ethylenically unsaturated bond, in $R^{132}$ in a repeating unit represented by Formula (4) described later or $R^{131}$ in a repeating unit represented by Formula (4) described later.

Among the above, the ethylenically unsaturated bond is preferably contained in $R^{131}$ in a repeating unit represented by Formula (4) described later, and it is more preferably contained, as a group having an ethylenically unsaturated bond, in $R^{131}$ in a repeating unit represented by Formula (4) described later.

Examples of the group having an ethylenically unsaturated bond include a group having a vinyl group which may be substituted, which is directly bonded to an aromatic ring such as a vinyl group, an allyl group, or a vinylphenyl group, a (meth)acrylamide group, a (meth)acryloyloxy group, and a group represented by Formula (IV).

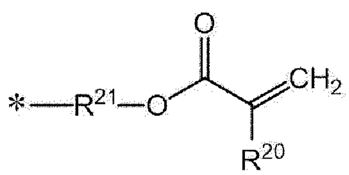

(IV)

In Formula (IV), $R^{20}$ represents a hydrogen atom, a methyl group, an ethyl group, or a methylol group, where a hydrogen atom or a methyl group is preferable.

In Formula (IV), $R^{21}$ represents an alkylene group having 2 to 12 carbon atoms, $-O-CH_2CH(OH)CH_2-$, -C(=O)O-, -O(C=O)NH-, a (poly)alkyleneoxy group having 2 to 30 carbon atoms (the alkylene group preferably has 2 to 12 carbon atoms, more preferably 2 to 6 carbon atoms, and particularly preferably 2 or 3 carbon atoms; the number of repetitions thereof is preferably 1 to 12, more preferably 1 to 6, and particularly preferably 1 to 3), or a group obtained by combining two or more of these.

In addition, the alkylene group having 2 to 12 carbon atoms may be a linear one, a branched one, or a cyclic one, or may be any an alkylene group represented by a combination of these.

The alkylene group having 2 to 12 carbon atoms is preferably an alkylene group having 2 to 8 carbon atoms

and more preferably an alkylene group having 2 to 4 carbon atoms.

Among the above, $R^{21}$ is preferably a group represented by any one of Formulae (R1) to (R3) and more preferably a group represented by Formula (R1).

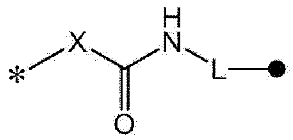
(R1)

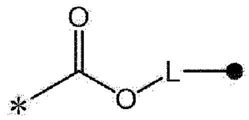
(R2)

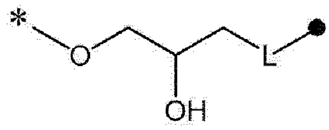
(R3)

In Formulae (R1) to (R3), L represents a single bond, an alkylene group having 2 to 12 carbon atoms, a (poly)alkyleneoxy group having 2 to 30 carbon atoms, or a group obtained by bonding two or more of these, X represents an oxygen atom or a sulfur atom, * represents a bonding site to another structure, and • represents a bonding site to an oxygen atom to which $R^{21}$ in Formula (IV) is bonded.

In Formulae (R1) to (R3), a preferred aspect of the alkylene group having 2 to 12 carbon atoms in L or the (poly)alkyleneoxy group having 2 to 30 carbon atoms is the same as the preferred aspect of the alkylene group having 2 to 12 carbon atoms or the (poly)alkyleneoxy group having 2 to 30 carbon atoms as $R^{21}$ described above.

In Formula (R1), X is preferably an oxygen atom.

In Formulae (R1) to (R3), * has the same meaning as * in Formula (IV), and the same applies to the preferred aspect thereof.

The structure represented by Formula (R1) is obtained, for example, by reacting a polyimide having a hydroxy group such as a phenolic hydroxy group with a compound (for example, 2-isocyanatoethyl methacrylate) having an isocyanato group and an ethylenically unsaturated bond.

The structure represented by Formula (R2) is obtained, for example, by reacting a polyimide having a carboxy group with a compound (for example, 2-hydroxyethyl methacrylate) having a hydroxy group and an ethylenically unsaturated bond.

The structure represented by Formula (R3) is obtained, for example, by reacting a polyimide having a hydroxy group such as a phenolic hydroxy group with a compound (for example, glycidyl methacrylate) having a glycidyl group and an ethylenically unsaturated bond.

In Formula (IV), * represents a bonding site to another structure, and it is preferably a bonding site to the main chain of the polyimide.

The amount of the ethylenically unsaturated bond with respect to the total mass of the polyimide is preferably 0.0001 to 0.1 mol/g and more preferably 0.0005 to 0.05 mol/g.

- Polymerizable group other than group having ethylenically unsaturated bond -

The polyimide may have a polymerizable group other than the group having an ethylenically unsaturated bond.

Examples of the polymerizable group other than the group having an ethylenically unsaturated bond include a cyclic ether group such as an epoxy group or an oxetanyl group, an alkoxymethyl group such as a methoxymethyl group, and a methylol group.

The polymerizable group other than the group having an ethylenically unsaturated bond is preferably contained in, for example, $R^{131}$ in a repeating unit represented by Formula (4) described later.

The amount of the polymerizable group other than the group having an ethylenically unsaturated bond with respect to the total mass of the polyimide is preferably 0.0001 to 0.1 mol/g and more preferably 0.001 to 0.05 mol/g.

- Acid value -

In a case where the polyimide is subjected to alkaline development, the acid value of the polyimide is preferably 30 mgKOH/g or more, more preferably 50 mgKOH/g or more, and still more preferably 70 mgKOH/g or more, from the viewpoint of improving developability.

In addition, the acid value thereof is preferably 500 mgKOH/g or less, more preferably 400 mgKOH/g or less, and still more preferably 200 mgKOH/g or less.

Further, in a case where the polyimide is subjected to the development (for example, the "solvent development" described later) using a developer containing an organic solvent as a main component, the acid value of the polyimide is preferably 1 to 35 mgKOH/g, more preferably 2 to 30 mgKOH/g, and still more preferably 5 to 20 mgKOH/g.

The acid value is measured by a known method, for example, by the method described in JIS K0070: 1992.

In addition, the acid group contained in the polyimide is preferably an acid group having a pKa of 0 to 10 and more preferably an acid group having a pKa of 3 to 8 from the viewpoint of achieving both storage stability and developability.

The "pKa" is represented by the negative common logarithm pKa of the equilibrium constant Ka of a dissociation reaction, in a case of assuming that hydrogen ions are released from the acid in the dissociation reaction. In the present specification, unless otherwise specified, pKa is a value calculated by ACD/ChemSketch (registered trade name). Alternatively, the values published in "Handbook of Chemistry, Pure Chemistry, 5th Edition" edited by the Chemical Society of Japan may be referred to.

In addition, in a case where the acid group is a polyvalent acid such as phosphoric acid, the pKa is the first dissociation constant.

As such an acid group, the polyimide preferably contains at least one selected from the group consisting of a carboxy group and a phenolic hydroxy group and more preferably contains a phenolic hydroxy group.

- Phenolic hydroxy group -

From the viewpoint of allowing the speed of development with an alkaline developer to be proper, the polyimide preferably has a phenolic hydroxy group.

The polyimide may have a phenolic hydroxy group at the terminal of the main chain or the side chain.

The phenolic hydroxy group is preferably contained in, for example, $R^{132}$ in a repeating unit represented by Formula (4) described later or $R^{131}$ in a repeating unit represented by Formula (4) described later.

The amount of the phenolic hydroxy group with respect to the total mass of the polyimide is preferably 0.1 to 30 mol/g and more preferably 1 to 20 mol/g.

The polyimide that is used in the present invention is not particularly limited as long as it is a polymer compound having an imide structure; however, it is preferable that the polyimide contains a repeating unit represented by Formula (4).

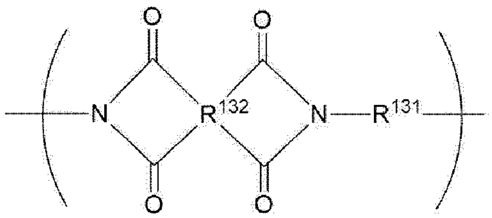

(4)

In Formula (4), $R^{131}$ represents a divalent organic group, and $R^{132}$ represents a tetravalent organic group.

In a case where a polymerizable group is contained, the polymerizable group may be located at at least one of $R^{131}$ or $R^{132}$ or may be located at the terminal of the polyimide as shown in Formula (4-1) or Formula (4-2).

Formula (4-1)

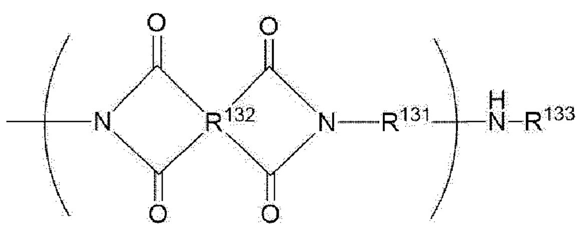

In Formula (4-1), $R^{133}$ is a polymerizable group, and the other groups respectively have the same meanings as those in Formula (4).

Formula (4-2)

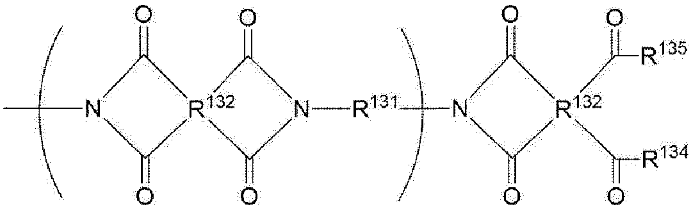

At least one of $R^{134}$ or $R^{135}$ is a polymerizable group, where it is an organic group in a case of not being a polymerizable group, and the other groups respectively have the same meanings as those in Formula (4).

Examples of the polymerizable group include the above-described group having an ethylenically unsaturated bond or a crosslinkable group other than the above-described group having an ethylenically unsaturated bond.

$R^{131}$ represents a divalent organic group. Examples of the divalent organic group include the same one as $R^{111}$ in Formula (2), and the same applies to the preferred range thereof.

In addition, examples of $R^{131}$ include a diamine residue that remains after the removal of an amino group of a diamine. Examples of the diamine include an aliphatic, a cyclic aliphatic, and an aromatic diamine. Specific examples thereof include the example of $R^{111}$ in Formula (2) which is contained in the polyimide precursor.

It is preferable that $R^{131}$ is a diamine residue having at least two alkylene glycol units in the main chain from the viewpoint of more effectively suppressing the occurrence of warping during baking. It is more preferably a diamine residue containing, in one molecule, a total of two or more chains of any one or both of the ethylene glycol chain and the propylene glycol chain, and it is still more preferably the above-described diamine which is a diamine residue containing no aromatic ring.

Examples of the diamine containing, in one molecule, a total of two or more chains of any one or both of the ethylene glycol chain and the propylene glycol chain include JEFFAMINE (registered trade name) KH-511, ED-600, ED-900, ED-2003, EDR-148, EDR-176, D-200, D-400, D-2000, D-4000 (all product names, manufactured by HUNTSMAN Corporation), 1-(2-(2-(2-aminopropoxy)ethoxy)propoxy)propane-2-amine, and 1-(1-(1-(2-aminopropoxy)propan-2-yl)oxy)propane-2-amine, which are not limited thereto.

$R^{132}$ represents a tetravalent organic group. Examples of the tetravalent organic group include the same one as $R^{115}$ in Formula (2), and the same applies to the preferred range thereof.

For example, four bonding partners of the tetravalent organic group exemplified as $R^{115}$ are bonded to four -C(=O)- moieties in Formula (4) to form a fused ring.

In addition, examples of $R^{132}$ include a tetracarboxylic acid residue that remains after the removal of the anhydride group from the tetracarboxylic acid dianhydride. Specific examples thereof include the example of $R^{115}$ in Formula (2) which is contained in the polyimide precursor. From the viewpoint of the hardness of the organic film, $R^{132}$ is preferably an aromatic diamine residue having 1 to 4 aromatic rings.

It is also preferable that an OH group is contained in at least one of $R^{131}$ or $R^{132}$. More specifically, preferred examples of $R^{131}$ include 2,2-bis(3-hydroxy-4-aminophenyl)propane, 2,2-bis(3-hydroxy-4-aminophenyl)hexafluoropropane, 2,2-bis(3-amino-4-hydroxyphenyl)propane, 2,2-bis(3-amino-4-hydroxyphenyl)hexafluoropropane, and the above (DA-1) to (DA-18), and more preferred examples of $R^{132}$ include the above (DAA-1) to (DAA-5).

In addition, the polyimide preferably has a fluorine atom in the structure thereof. The content of fluorine atoms in the polyimide is preferably 10% by mass or more, and it is preferably 20% by mass or less.

In addition, for intended the purpose of improving adhesiveness to a substrate, an aliphatic group having a siloxane structure may be copolymerized with the polyimide. Specific examples of the diamine component include bis(3-aminopropyl)tetramethyldisiloxane, and bis(p-aminophenyl)octamethyl pentasiloxane.

In addition, in order to improve the storage stability of the resin composition, the terminal of the main chain of the polyimide is preferably blocked with a terminal blocking agent such as a monoamine, an acid anhydride, a monocarboxylic acid, a monoacid chloride compound, or a monoactive ester compound. Among these, it is more preferable to use monoamine. Examples of the preferred monoamine compound include aniline, 2-ethynyl aniline, 3-ethynyl aniline, 4-ethynyl aniline, 5-amino-8-hydroxyquinoline, 1-hydroxy-7-aminonaphthalene, 1-hydroxy-6-aminonaphthalene, 1-hydroxy-5-aminonaphthalene, 1-hydroxy-4-aminonaphthalene, 2-hydroxy-7-aminonaphthalene, 2-hydroxy-6-aminonaphthalene, 2-hydroxy-5-aminonaphthalene, 1-carboxy-7-aminonaphthalene, 1-carboxy-6-aminonaphthalene, 1-carboxy-5-aminonaphthalene, 2-carboxy-7-aminonaphthalene, 2-carboxy-6-aminonaphthalene, 2-carboxy-5-aminonaphthalene, 2-aminobenzoic acid, 3-aminobenzoic acid, 4-aminobenzoic acid, 4-aminosalicylic acid, 5-aminosalicylic acid, 6-aminosalicylic acid, 2-aminobenzenesulfonic acid, 3-aminobenzenesulfonic acid, 4-aminobenzenesulfonic acid, 3-amino-4,6-dihydroxypyrimidine, 2-aminophenol, 3-aminophenol, 4-aminophenol, 2-aminothiophenol, 3-aminothiophenol, and 4-aminothiophenol. Two or more of these may be used, and a plurality of different terminal groups may be introduced by reacting a plurality of terminal blocking agents.

- Imidization rate (ring closure rate) -

The imidization rate (also referred to as the "ring closure rate") of the polyimide is preferably 70% or more, more preferably 80% or more, and still more preferably 90% or more, from the viewpoint of the film hardness, the insulating properties, or the like of the organic film to be obtained.
The upper limit of the imidization rate is not particularly limited, and it may be any imidization rate of 100% or less.
The imidization rate is measured by, for example, the following method.
The infrared absorption spectrum of polyimide is measured, and a peak intensity P1 in the vicinity of 1,377 $cm^{-1}$, which is the absorption peak derived from the imide structure, is obtained. Next, the polyimide is heat-treated at 350°C for 1 hour, and then the infrared absorption spectrum is measured again to obtain a peak intensity P2 in the vicinity of 1,377 $cm^{-1}$. Using the obtained peak intensities P1 and P2, the imidization rate of the polyimide can be determined based on the following expression.

$$\text{Imidization rate (\%)} = (\text{peak intensity P1}/\text{peak intensity P2}) \times 100$$

The polyimide may contain the repeating unit of Formula (4), the whole of which contains one kind of $R^{131}$ or $R^{132}$, or it may contain the repeating unit of Formula (4), in which two or more different kinds of $R^{131}$ or $R^{132}$ are contained. In addition, the polyimide may also contain another kind of repeating unit in addition to the above repeating unit represented by Formula (4). Examples of the other kind of repeating unit include the repeating unit represented by Formula (2) described above.
The polyimide can be synthesized by utilizing, for example, a method in which a tetracarboxylic acid dianhydride is reacted with a diamine (a part thereof is substituted with a terminal blocking agent which is a monoamine) at a low temperature, a method in which a tetracarboxylic acid dianhydride (a part thereof is substituted with a terminal blocking agent which is an acid anhydride, a monoacid chloride compound, or a monoactive ester compound) is reacted with a diamine at a low temperature, a method in which a diester is obtained from a tetracarboxylic acid dianhydride and alcohol and then reacted with a diamine (a part thereof is substituted with a terminal blocking agent which is a monoamine) in the presence of a condensing agent, a method in which a polyimide precursor is obtained, for example, by using a method in which a diester is obtained from a tetracarboxylic acid dianhydride and an alcohol, the remaining dicarboxylic acid is subjected to acid chloride modification and reacted with a diamine (a part thereof is substituted with a terminal blocking agent which is a monoamine), and the polyimide precursor is subjected to full imidization using a known imidization reaction method, or, a method in which the imidization reaction is stopped in the middle of the reaction and the imide structure is partially introduced, or furthermore a method in which a fully imidized polymer is blended with the polyimide precursor, whereby the imide structure is partially introduced. In addition, another known method for synthesizing polyimide can also be applied.
The weight-average molecular weight (Mw) of the polyimide is preferably 5,000 to 100,000, more preferably 10,000 to 50,000, and still more preferably 15,000 to 40,000. In a case where the weight-average molecular weight is set to 5,000 or more, it is possible to improve the breakage resistance of the film after curing. In order to obtain an organic film having excellent mechanical properties (for example, breaking elongation), the weight-average molecular weight is particularly preferably 15,000 or more.
In addition, the number-average molecular weight (Mn) of the polyimide is preferably 2,000 to 40,000, more preferably 3,000 to 30,000, and still more preferably 4,000 to 20,000.
The dispersivity of the molecular weight of the polyimide is preferably 1.5 or more, more preferably 1.8 or more, and still more preferably 2.0 or more. The upper limit value of the dispersivity of the molecular weight of the polyimide is not particularly limited; however, it is, for example, preferably 7.0 or less, more preferably 6.5 or less, and still more preferably 6.0 or less.
In addition, in a case where the resin composition contains a plurality of kinds of polyimides as the specific resin, it is preferable that the weight-average molecular weight, the number-average molecular weight, and the dispersivity of at least one kind of polyimide are in the above ranges. Further, it is also preferable that the weight-average molecular weight, the number-average molecular weight, and the dispersivity, calculated by using the plurality of kinds of polyimides as one resin, are within the above ranges.

[Polybenzoxazole precursor]

The structure or the like of the polybenzoxazole precursor that is used in the present invention is not particularly determined; however, it preferably includes a repeating unit represented by Formula (3).

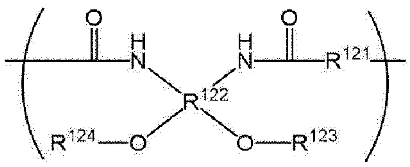
(3)

In Formula (3), $R^{121}$ represents a divalent organic group, $R^{122}$ represents a tetravalent organic group, and $R^{123}$ and $R^{124}$ each independently represent a hydrogen atom or a monovalent organic group.

In Formula (3), $R^{123}$ and $R^{124}$ have the same meanings as $R^{113}$ in Formula (2), and the same applies to the preferred ranges thereof. That is, it is preferable that at least one of them is a polymerizable group.

In Formula (3), $R^{121}$ represents a divalent organic group. The divalent organic group is preferably a group containing at least one of an aliphatic group or an aromatic group. The aliphatic group is preferably a linear aliphatic group. $R^{121}$ is preferably a dicarboxylic acid residue. One kind of dicarboxylic acid residue may be used alone, or two or more kinds thereof may be used.

The dicarboxylic acid residue is preferably a dicarboxylic acid containing an aliphatic group or a dicarboxylic acid residue containing an aromatic group, and more preferably a dicarboxylic acid residue containing an aromatic group.

The dicarboxylic acid containing an aliphatic group is preferably a dicarboxylic acid containing a linear or branched (preferably linear) aliphatic group, and more preferably a dicarboxylic acid consisting of a linear or branched (preferably linear) aliphatic group and two -COOH. The linear or branched (preferably linear) aliphatic group preferably has 2 to 30 carbon atoms, more preferably 2 to 25 carbon atoms, still more preferably 3 to 20 carbon atoms, even still more preferably 4 to 15 carbon atoms, particularly preferably 5 to 10 carbon atoms. The linear aliphatic group is preferably an alkylene group.

Examples of the dicarboxylic acid containing a linear aliphatic group include malonic acid, dimethylmalonic acid, ethylmalonic acid, isopropylmalonic acid, di-n-butylmalonic acid, succinic acid, tetrafluorosuccinic acid, methylsuccinic acid, 2,2-dimethylsuccinic acid, 2,3-dimethylsuccinic acid, dimethylmethylsuccinic acid, glutaric acid, hexafluoroglutaric acid, 2-methylglutaric acid, 3-methylglutaric acid, 2,2-dimethylglutaric acid, 3,3-dimethylglutaric acid, 3-ethyl-3-methylglutaric acid, adipic acid, octafluoroadipic acid, 3-methyladipic acid, pimelic acid, 2,2,6,6-tetramethylpimelic acid, suberic acid, dodecafluorosuberic acid, azelaic acid, sebacic acid, hexadecafluorosebacic acid, 1,9-nonanedioic acid, dodecanedioic acid, tridecanedioic acid, tetradecanedioic acid, pentadecanedioic acid, hexadecanedioic acid, heptadecanedioic acid, octadecanedioic acid, nonadecanedioic acid, eicosanedioic acid, heneicosanedioic acid, docosanedioic acid, tricosanedioic acid, tetracosanedioic acid, pentacosanedioic acid, hexacosanedioic acid, heptacosanedioic acid, octacosanedioic acid, nonacosanedioic acid, triacontanedioic acid, hentriacontanedioic acid, dotriacontanedioic acid, diglycolic acid, and furthermore, dicarboxylic acids represented by the following formulae.

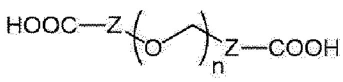
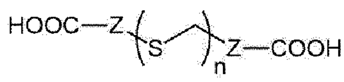

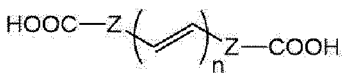
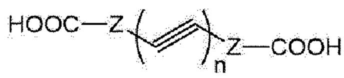

(In the formulae, Z is a hydrocarbon group having 1 to 6 carbon atoms, and n is an integer of 1 to 6).

The dicarboxylic acid containing an aromatic group is preferably a dicarboxylic acid having the following aromatic group and more preferably a dicarboxylic acid consisting of only the following group having an aromatic group and two pieces of -COOH.

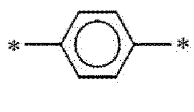
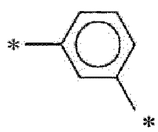
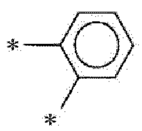
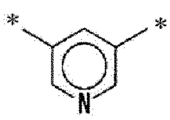

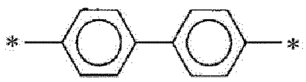 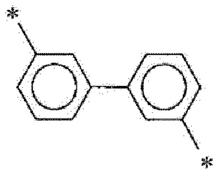 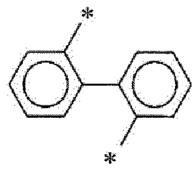

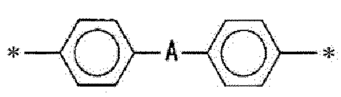 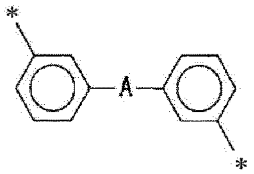 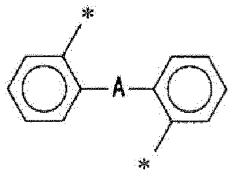

In the formulae, A represents a divalent group selected from the group consisting of $-CH_2-$, -O-, -S-, $-SO_2-$, -CO-, -NHCO-, $-C(CF_3)_2-$, and $-C(CH_3)_2-$, and *'s each independently represent a bonding site to another structure.

Specific examples of the dicarboxylic acid containing an aromatic group include 4,4'-carbonyldibenzoic acid, 4,4'-dicarboxydiphenyl ether, and terephthalic acid.

In Formula (3), $R^{122}$ represents a tetravalent organic group. The tetravalent organic group has the same meaning as $R^{115}$ in Formula (2) described above, and the same applies to the preferred range thereof.

In addition, $R^{122}$ is preferably a group derived from a bisaminophenol derivative. Examples of the group derived from the bisaminophenol derivative include 3,3'-diamino-4,4'-dihydroxybiphenyl, 4,4'-diamino-3,3'-dihydroxybiphenyl, 3,3'-diamino-4,4'-dihydroxydiphenylsulfone, 4,4'-diamino-3,3'-dihydroxydiphenylsulfone, bis-(3-amino-4-hydroxyphenyl)methane, 2,2-bis(3-amino-4-hydroxyphenyl)propane, 2,2-bis-(3-amino-4-hydroxyphenyl)hexafluoropropane, 2,2-bis-(4-amino-3-hydroxyphenyl)hexafluoropropane, bis-(4-amino-3-hydroxyphenyl)methane, 2,2-bis-(4-amino-3-hydroxyphenyl)propane, 4,4'-diamino-3,3'-dihydroxybenzophenone, 3,3'-diamino-4,4'-dihydroxybenzophenone, 4,4'-diamino-3,3'-dihydroxydiphenyl ether, 3,3'-diamino-4,4'-dihydroxydiphenyl ether, 1,4-diamino-2,5-dihydroxybenzene, 1,3-diamino-2,4-dihydroxybenzene, and 1,3-diamino-4,6-dihydroxybenzene. These bisaminophenols may be used alone or may be mixedly used.

Among the bisaminophenol derivatives, the bisaminophenol derivative having the following aromatic group is preferable.

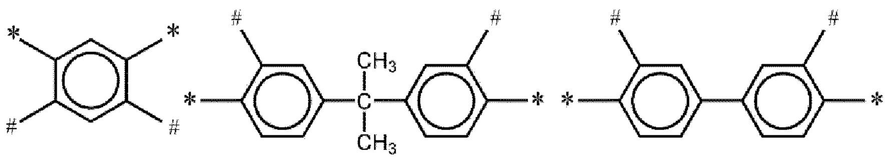

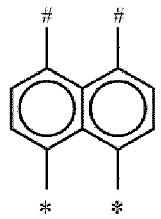 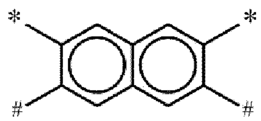 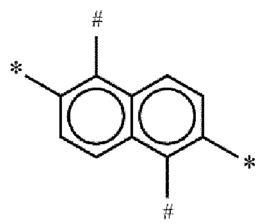

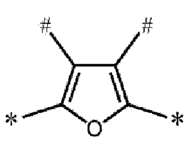 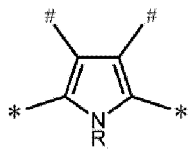 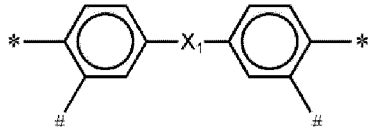

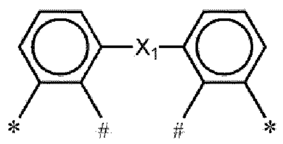

In the formulae, $X_1$ represents -O-, -S-, $-C(CF_3)_2-$, $-CH_2-$, $-SO_2-$, or -NHCO-, and * and # each represent a bonding site to another structure. R represents a hydrogen atom or a monovalent substituent, where a hydrogen atom or a hydrocarbon group is preferable, and a hydrogen atom or an alkyl group is more preferable. In addition, it is also preferable that $R^{122}$ has a structure represented by the above formula. In a case where $R^{122}$ has a structure represented by the above formula, it is preferable that any two of a total of four of *'s and #'s are bonding sites to the nitrogen atom to which $R^{122}$ in Formula (3) is bonded and the other two are bonding sites to the oxygen atom to which $R^{122}$ Formula (3) is bonded, it is more preferable that two *'s are bonding sites to the oxygen atom to which $R^{122}$ in Formula (3) is bonded and two #'s are bonding sites to the nitrogen atom to which $R^{122}$ Formula (3) is bonded or that two *'s are bonding sites to the nitrogen atom to which $R^{122}$ in Formula (3) is bonded and two #'s are bonding sites to the oxygen atom to which $R^{122}$ Formula (3) is bonded, and it is still more preferable that two *'s are bonding sites to the oxygen atom to which $R^{122}$ in Formula (3) is bonded and two #'s are bonding sites to the nitrogen atom to which $R^{122}$ Formula (3) is bonded.

The bisaminophenol derivative is also preferably a compound represented by Formula (A-s).

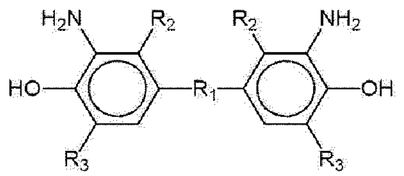
(A-s)

In Formula (A-s), $R_1$ is a hydrogen atom, an alkylene, a substituted alkylene, -O-, -S-, $-SO_2-$, -CO-, -NHCO-, a single bond, or an organic group selected from the group of Formula (A-sc). $R_2$'s are any one of a hydrogen atom, an alkyl group, an alkoxy group, an acyloxy group, or a cyclic alkyl group, and may be the same or different from each other. $R_3$'s are any one of a hydrogen atom, a linear or branched alkyl group, an alkoxy group, an acyloxy group, or a cyclic alkyl group, and may be the same or different from each other.

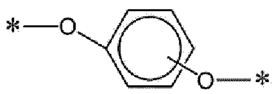
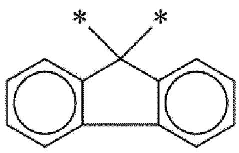
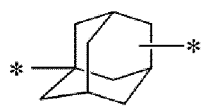
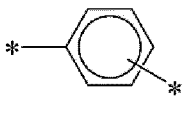
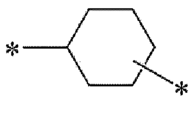
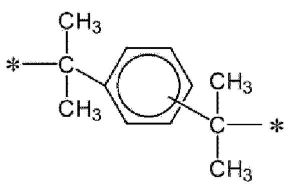
(A − s c)

(In Formula (A-sc), * indicates bonding to the aromatic ring of the aminophenol group of the bisaminophenol derivative represented by Formula (A-s).)

In Formula (A-s), it is conceived that in a case where a substituent is also provided at the ortho position of the phenolic hydroxy group, that is, $R_3$, the distance between the carbonyl carbon of the amide bond and the hydroxy group becomes closer, and such a case is particularly preferable since the effect that the cyclization rate becomes high in a case where curing is carried out at a low temperature is further enhanced.

In addition, in Formula (A-s), in a case where $R_2$ is an alkyl group and $R_3$ is an alkyl group, it is possible to maintain the high transparency to the i-line and the effect that the cyclization rate is high in a case where curing is carried out at a low temperature, which is preferable.

In addition, in Formula (A-s), it is more preferable that $R_1$ is an alkylene or a substituted alkylene. Specific examples of the alkylene and the substituted alkylene, which is involved in $R_1$ include linear or branched alkyl groups having 1 to 8 carbon atoms. However, among them, $-CH_2-$, $-CH(CH_3)-$, or $-C(CH_3)_2-$ is more preferable since it is possible

to obtain a polybenzoxazole precursor excellent in balance in terms of having sufficient solubility in a solvent while maintaining the high transparency to the i-line and the effect that the cyclization rate is high in a case where curing is carried out at a low temperature.

As a method of producing the bisaminophenol derivative represented by Formula (A-s), for example, paragraph Nos. 0085 to 0094 and Example 1 (paragraph Nos. 0189 to 0190) of JP2013-256506A can be referenced, the content of which is incorporated in the present specification by reference.

Specific examples of the structure of the bisaminophenol derivative represented by Formula (A-s) include those described in paragraph Nos. 0070 to 0080 of JP2013-256506A, the content of which is incorporated in the present specification. Needless to say, it is not limited to these.

The polybenzoxazole precursor may contain another kind of repeating unit in addition to the repeating unit of Formula (3).

From the viewpoint that the occurrence of warping associated with ring closure can be suppressed, the polybenzoxazole precursor preferably contains a diamine residue represented by Formula (SL) as another kind of repeating unit.

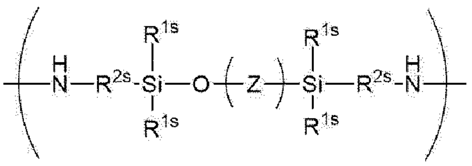

(SL)

a: 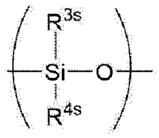 b: 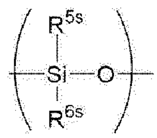

In Formula (SL), Z has a structure and a b structure, $R^{1s}$ is a hydrogen atom or a hydrocarbon group having 1 to 10 carbon atoms, $R^{2s}$ is a hydrocarbon group having 1 to 10 carbon atoms, and at least one of $R^{3s}$, $R^{4s}$, $R^{5s}$, or $R^{6s}$ is an aromatic group, where the rest are a hydrogen atom or an organic group having 1 to 30 carbon atoms and may be the same or different from each other. The polymerization of the a structure and the b structure may be block polymerization or random polymerization. Regarding the contents of the structures in the Z portion in terms of "% by mole", the content of the a structure is 5% to 95% by mole and the content of the b structure is 95% to 5% by mole, the sum (the content of the a structure + the content of the b structure) is 100% by mole.

In Formula (SL), examples of the preferred Z include one in which $R^{5s}$ and $R^{6s}$ in the b structure are a phenyl group. In addition, the molecular weight of the a structure represented by Formula (SL) is preferably 400 to 4,000 and more preferably 500 to 3,000. In a case where the molecular weight is within the above-described range, it is possible to more effectively decrease an elastic modulus of a polybenzoxazole precursor after the dehydration ring closure and to achieve both effects of suppressing warping and improving solubility in a solvent.

In a case where a diamine residue represented by Formula (SL) is contained as another kind of repeating unit, it is also preferable that a tetracarboxylic acid residue that has remained after removing an anhydride group from the tetracarboxylic acid dianhydride is further contained as a repeating unit. Examples of such a tetracarboxylic acid residue include the examples of $R^{115}$ in Formula (2).

The weight-average molecular weight (Mw) of the polybenzoxazole precursor is preferably 18,000 to 30,000, more preferably 20,000 to 29,000, and still more preferably 22,000 to 28,000. In addition, the number-average molecular weight (Mn) thereof is preferably 7,200 to 14,000, more preferably 8,000 to 12,000, and still more preferably 9,200 to 11,200.

The dispersivity of the molecular weight of the polybenzoxazole precursor is preferably 1.4 or more, more preferably 1.5 or more, and still more preferably 1.6 or more. The upper limit value of the dispersivity of the molecular weight of the polybenzoxazole precursor is not particularly determined; however, it is, for example, preferably 2.6 or less, more preferably 2.5 or less, still more preferably 2.4 or less, even still more preferably 2.3 or less, and even further still more preferably 2.2 or less.

In addition, in a case where the resin composition contains a plurality of kinds of polybenzoxazole precursors as the specific resin, it is preferable that the weight-average molecular weight, the number-average molecular weight, and the dispersivity of at least one kind of polybenzoxazole precursor are in the above ranges. Further, it is also preferable that the weight-average molecular weight, the number-average molecular weight, and the dispersivity, calculated by using the plurality of kinds of polybenzoxazole precursors as one resin, are within the above ranges.

[Polybenzoxazole]

The polybenzoxazole is not particularly limited as long as it is a polymer compound having a benzoxazole ring; however, it is preferably a compound represented by Formula (X), and it is more preferably a compound represented by Formula (X), which is a compound having a polymerizable group. The polymerizable group is preferably a radically polymerizable group.

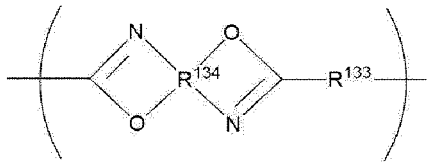

(X)

In Formula (X), $R^{133}$ represents a divalent organic group, and $R^{134}$ represents a tetravalent organic group.

In a case where a polymerizable group is contained, the polymerizable group may be located at at least one of $R^{133}$ or $R^{134}$, or it may be located at the terminal of the polybenzoxazole as shown in Formula (X-1) or Formula (X-2).

Formula (X-1)

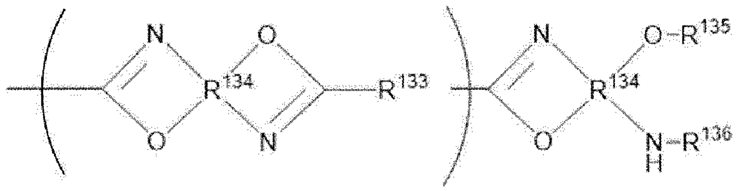

In Formula (X-1), At least one of $R^{135}$ or $R^{136}$ is a polymerizable group, where it is an organic group in a case of not being a polymerizable group, it, and the other groups respectively have the same meanings as those in Formula (X).

Formula (X-2)

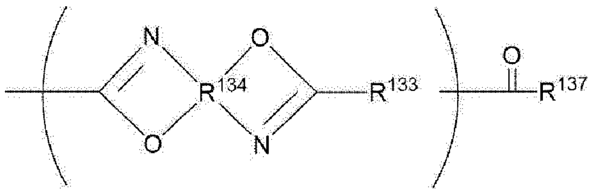

In Formula (X-2), $R^{137}$ is a group having a polymerizable group, other groups are a substituent, and the other groups respectively have the same meanings as those in Formula (X).

The polymerizable group has the same meaning as the polymerizable group described in the above-described polymerizable group contained in the polyimide precursor.

$R^{133}$ represents a divalent organic group. Examples of the divalent organic group include an aliphatic group and an aromatic group. Specific examples thereof include the example of $R^{121}$ in Formula (3) in the polybenzoxazole precursor. In addition, the preferred example thereof is the same as that of $R^{121}$.

$R^{134}$ represents a tetravalent organic group. Examples of the tetravalent organic group include the example of $R^{122}$ in Formula (3) in the polybenzoxazole precursor. In addition, the preferred example thereof is the same as that of $R^{122}$.

For example, four bonding partners of the tetravalent organic group exemplified as $R^{122}$ are bonded to the nitrogen atom and the oxygen atom in Formula (X) to form a fused ring. For example, in a case where $R^{134}$ is the following organic group, the following structure is formed. In the following structure, each * represents a bonding site to a nitrogen atom or an oxygen atom in Formula (X).

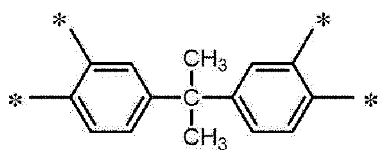

The oxazole modification rate of the polybenzoxazole is preferably 85% or more and more preferably 90% or more. The lower limit thereof is not particularly limited and may be 100%. In a case where the oxazole modification rate is 85% or more, the film shrinkage based on the ring closure, which occurs when oxazole modification occurs due to heating, is reduced, and thus the occurrence of warping can be more effectively suppressed.

The oxazole modification rate is measured, for example, according to the following method.

An infrared absorption spectrum of polybenzoxazole is measured, and a peak intensity Q1 in the vicinity of 1,650 $cm^{-1}$, which is an absorption peak derived from the amide structure of the precursor, is determined. Next, the absorption intensity of the aromatic ring observed in the vicinity of 1,490 $cm^{-1}$ is standardized. The polybenzoxazole is heat-treated at 350°C for 1 hour, and then the infrared absorption spectrum is measured again to determine a peak intensity Q2 in the vicinity of 1,650 $cm^{-1}$, followed by standardization with the absorption intensity of the aromatic ring observed in the vicinity of 1,490 $cm^{-1}$. Using the obtained standard values of the peak intensities Q1 and Q2, it is possible to determine the oxazole modification rate of the polybenzoxazole based on the following expression.

Oxazole modification rate (%) = (standard value of peak intensity Q1/standard value of peak intensity Q2) $\times$ 100

The polybenzoxazole may contain the repeating unit of Formula (X), the whole of which contains one kind of $R^{133}$ or $R^{134}$, or it may contain the repeating unit of Formula (X), which contains two or more different kinds of $R^{133}$ or $R^{134}$. In addition, the polybenzoxazole may contain another kind of repeating unit in addition to the repeating unit of Formula (X).

The polybenzoxazole can be obtained by, for example, reacting a bisaminophenol derivative with a compound selected from a dicarboxylic acid dichloride, a dicarboxylic acid derivative, and the like of a dicarboxylic acid containing $R^{133}$ or the above dicarboxylic acid, to obtain a polybenzoxazole precursor, and subjecting it to the oxazole modification with a known oxazole reaction method.

In a case of a dicarboxylic acid, an active ester-type dicarboxylic acid derivative subjected to reaction in advance with 1-hydroxy-1,2,3-benzotriazole or the like may be used in order to increase the reaction yield or the like.

The weight-average molecular weight(Mw) of polybenzoxazole is preferably 5,000 to 70,000, more preferably 8,000 to 50,000, and still more preferably 10,000 to 30,000. In a case where the weight-average molecular weight is set to 5,000 or more, it is possible to improve the breakage resistance of the film after curing. In order to obtain an organic film having excellent mechanical properties, the weight-average molecular weight is particularly preferably 20,000 or more. In a case where two or more kinds of polybenzoxazole are contained, it is preferable that the weight-average molecular weight of at least one kind of polybenzoxazole is in the above range.

In addition, the number-average molecular weight (Mn) of the polybenzoxazole is preferably 7,200 to 14,000, more preferably 8,000 to 12,000, and still more preferably 9,200 to 11,200.

The dispersivity of the molecular weight of the polybenzoxazole is preferably 1.4 or more, more preferably 1.5 or more, and still more preferably 1.6 or more. The upper limit value of the dispersivity of the molecular weight of the polybenzoxazole is not particularly determined; however, it is, for example, preferably 2.6 or less, more preferably 2.5 or less, still more preferably 2.4 or less, even still more preferably 2.3 or less, and even further still more preferably 2.2 or less.

In addition, in a case where the resin composition contains a plurality of kinds of polybenzoxazoles as the specific resin, it is preferable that the weight-average molecular weight, the number-average molecular weight, and the dispersivity of at least one kind of polybenzoxazole are in the above ranges. Further, it is also preferable that the weight-average molecular weight, the number-average molecular weight, and the dispersivity, calculated by using the plurality of kinds of polybenzoxazoles as one resin, are within the above ranges.

[Polyamideimide precursor]

The polyamideimide precursor preferably contains a repeating unit represented by Formula (PAI-2).

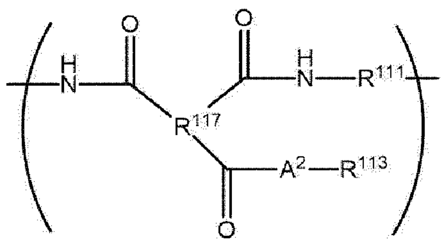

(PAI-2)

In Formula (PAI-2), $R^{117}$ represents a trivalent organic group, $R^{111}$ represents a divalent organic group, $A^2$ represents an oxygen atom or -NH-, and $R^{113}$ represents a hydrogen atom or a monovalent organic group.

In Formula (PAI-2), examples of $R^{117}$ include a linear or branched aliphatic group, a cyclic aliphatic group, an

aromatic group, a heteroaromatic group, and a group obtained by linking two or more of these groups through a single bond or a linking group, where $R^{117}$ is preferably a linear aliphatic group having 2 to 20 carbon atoms, a branched aliphatic group having 3 to 20 carbon atoms, a cyclic aliphatic group having 3 to 20 carbon atoms, an aromatic group having 6 to 20 carbon atoms, or a group obtained by combining two or more of these groups through a single bond or a linking group, and $R^{117}$ is more preferably an aromatic group having 6 to 20 carbon atoms or a group obtained by combining two or more aromatic groups having 6 to 20 carbon atoms through a single bond or a linking group.

The linking group is preferably -O-, -S-, -C(=O)-,-S(=O)$_2$-, an alkylene group, a halogenated alkylene group, an arylene group, or a linking group obtained by bonding two or more these, and it is more preferably -O-, -S-, an alkylene group, a halogenated alkylene group, an arylene group, or a linking group obtained by bonding two or more these.

The alkylene group is preferably an alkylene group having 1 to 20 carbon atoms, more preferably an alkylene group having 1 to 10 carbon atoms, and still more preferably an alkylene group having 1 to 4 carbon atoms.

The halogenated alkylene group is preferably a halogenated alkylene group having 1 to 20 carbon atoms, more preferably a halogenated alkylene group having 1 to 10 carbon atoms, and still more preferably a halogenated alkylene group having 1 to 4 carbon atoms. In addition, examples of the halogen atom in the halogenated alkylene group include a fluorine atom, a chlorine atom, a bromine atom, and an iodine atom, where a fluorine atom is preferable. The halogenated alkylene group may have a hydrogen atom, or all hydrogen atoms in the halogenated alkylene group may be substituted with a halogen atom. However, it is preferable that all hydrogen atoms are substituted with a halogen atom. Examples of the preferred halogenated alkylene group include a (ditrifluoromethyl)methylene group.

The arylene group is preferably a phenylene group or a naphthylene group, more preferably a phenylene group, and still more preferably a 1,3-phenylene group or a 1,4-phenylene group.

In addition, $R^{117}$ is preferably derived from a tricarboxylic acid compound in which at least one carboxy group may be subjected to halogenation. Here, the halogenation is preferably chlorination.

In the present invention, a compound having three carboxy groups is referred to as a tricarboxylic acid compound.

Two carboxy groups of the three carboxy groups of the tricarboxylic acid compound may be subjected to acid anhydrization.

Examples of the tricarboxylic acid compound which may be halogenated, which is used in the production of the polyamideimide precursor, include a branched aliphatic, cyclic aliphatic, or aromatic tricarboxylic acid compound.

One kind of these tricarboxylic acid compounds may be used alone, or two or more kinds thereof may be used.

Specifically, the tricarboxylic acid compound is preferably a tricarboxylic acid compound containing a linear aliphatic group having 2 to 20 carbon atoms, a branched aliphatic group having 3 to 20 carbon atoms, a cyclic aliphatic group having 3 to 20 carbon atoms, an aromatic group having 6 to 20 carbon atoms, or a group obtained by combining two or more of these groups through a single bond or a linking group, and more preferably a tricarboxylic acid compound containing an aromatic group having 6 to 20 carbon atoms or a group obtained by combining two or more aromatic groups having 6 to 20 carbon atoms through a single bond or a linking group.

Specific examples of the tricarboxylic acid compound include 1,2,3-propanetricarboxylic acid, 1,3,5-pentanetricarboxylic acid, citric acid, trimellitic acid, 2,3,6-naphthalenetricarboxylic acid, and a compound in which phthalic acid (or phthalic anhydride) and benzoic acid are linked through a single bond, -O-, $-CH_2-$, $-C(CH_3)_2-$, $-C(CF_3)_2-$, $-SO_2-$, or a phenylene group.

These compounds may be a compound (for example, a trimellitic acid anhydride) in which two carboxy groups have been subjected to anhydrization or may be a compound (for example, trimellitic anhydride chloride) in which at least one carboxy group has been halogenated.

In Formula (PAI-2), $R^{111}$, $A^2$, and $R^{113}$ respectively have the same meanings as $R^{111}$, $A^2$, and $R^{113}$ in Formula (2) described above, and the same applies to the preferred aspects thereof.

The polyamideimide precursor may further contain other repeating units.

Examples of the other repeating units include the above-described repeating unit represented by Formula (2) and a repeating unit represented by Formula (PAI-1).

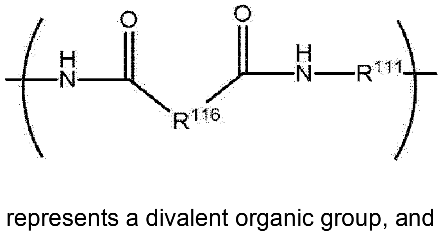
(PAI-1)

In Formula (PAI-1), $R^{116}$ represents a divalent organic group, and $R^{111}$ represents a divalent organic group.

In Formula (PAI-1), examples of $R^{116}$ include a linear or branched aliphatic group, a cyclic aliphatic group, an aromatic group, a heteroaromatic group, and a group obtained by linking two or more of these groups through a single bond or a linking group, where $R^{116}$ is preferably a linear aliphatic group having 2 to 20 carbon atoms, a branched

aliphatic group having 3 to 20 carbon atoms, a cyclic aliphatic group having 3 to 20 carbon atoms, an aromatic group having 6 to 20 carbon atoms, or a group obtained by combining two or more of these groups through a single bond or a linking group, and $R^{116}$ is more preferably an aromatic group having 6 to 20 carbon atoms or a group obtained by combining two or more aromatic groups having 6 to 20 carbon atoms through a single bond or a linking group.

The linking group is preferably -O-, -S-, -C(=O)-,-$S(=O)_2$-, an alkylene group, a halogenated alkylene group, an arylene group, or a linking group obtained by bonding two or more these, and it is more preferably -O-, -S-, an alkylene group, a halogenated alkylene group, an arylene group, or a linking group obtained by bonding two or more these.

The alkylene group is preferably an alkylene group having 1 to 20 carbon atoms, more preferably an alkylene group having 1 to 10 carbon atoms, and still more preferably an alkylene group having 1 to 4 carbon atoms.

The halogenated alkylene group is preferably a halogenated alkylene group having 1 to 20 carbon atoms, more preferably a halogenated alkylene group having 1 to 10 carbon atoms, and still more preferably a halogenated alkylene group having 1 to 4 carbon atoms. In addition, examples of the halogen atom in the halogenated alkylene group include a fluorine atom, a chlorine atom, a bromine atom, and an iodine atom, where a fluorine atom is preferable. The halogenated alkylene group may have a hydrogen atom, or all hydrogen atoms in the halogenated alkylene group may be substituted with a halogen atom. However, it is preferable that all hydrogen atoms are substituted with a halogen atom. Examples of the preferred halogenated alkylene group include a (ditrifluoromethyl)methylene group.

The arylene group is preferably a phenylene group or a naphthylene group, more preferably a phenylene group, and still more preferably a 1,3-phenylene group or a 1,4-phenylene group.

In addition, $R^{116}$ is preferably derived from a dicarboxylic acid compound or a dicarboxylic acid dihalide compound.

In the present invention, a compound having two carboxy groups is referred to as a dicarboxylic acid compound, and a compound having two halogenated carboxy groups is referred to as a dicarboxylic acid dihalide compound.

The carboxy group in the dicarboxylic acid dihalide compound may be halogenated; however, it is, for example, preferably chlorinated. That is, the dicarboxylic acid dihalide compound is preferably a dicarboxylic acid dichloride compound.

Examples of the dicarboxylic acid compound which may be halogenated or the dicarboxylic acid dihalide compound, which is used in the production of the polyamideimide precursor, include a linear or branched aliphatic, cyclic aliphatic, or aromatic dicarboxylic acid compound, and a dicarboxylic acid dihalide compound.

One kind of these dicarboxylic acid compounds or dicarboxylic acid dihalide compounds may be used alone, or two or more kinds thereof may be used.

Specifically, the dicarboxylic acid compound or the dicarboxylic acid dihalide compound is preferably a dicarboxylic acid compound or dicarboxylic acid dihalide compound containing a linear aliphatic group having 2 to 20 carbon atoms, a branched aliphatic group having 3 to 20 carbon atoms, a cyclic aliphatic group having 3 to 20 carbon atoms, an aromatic group having 6 to 20 carbon atoms, or a group obtained by combining two or more of these groups through a single bond or a linking group, and more preferably a dicarboxylic acid compound or dicarboxylic acid dihalide compound containing an aromatic group having 6 to 20 carbon atoms or a group obtained by combining two or more aromatic groups having 6 to 20 carbon atoms through a single bond or a linking group.

In addition, specific example of the dicarboxylic acid compound include malonic acid, dimethylmalonic acid, ethylmalonic acid, isopropylmalonic acid, di-n-butylmalonic acid, succinic acid, tetrafluorosuccinic acid, methylsuccinic acid, 2,2-dimethylsuccinic acid, 2,3-dimethylsuccinic acid, dimethylmethylsuccinic acid, glutaric acid, hexafluoroglutaric acid, 2-methylglutaric acid, 3-methylglutaric acid, 2,2-dimethylglutaric acid, 3,3-dimethylglutaric acid, 3-ethyl-3-methylglutaric acid, adipic acid, octafluoroadipic acid, 3-methyladipic acid, pimelic acid, 2,2,6,6-tetramethylpimelic acid, suberic acid, dodecafluorosuberic acid, azelaic acid, sebacic acid, hexadecafluorosebacic acid, 1,9-nonanedioic acid, dodecanedioic acid, tridecanedioic acid, tetradecanedioic acid, pentadecanedioic acid, hexadecanedioic acid, heptadecanedioic acid, octadecanedioic acid, nonadecanedioic acid, eicosanedioic acid, heneicosanedioic acid, docosanedioic acid, tricosanedioic acid, tetracosanedioic acid, pentacosanedioic acid, hexacosanedioic acid, heptacosanedioic acid, octacosanedioic acid, nonacosanedioic acid, triacontanedioic acid, hentriacontanedioic acid, dotriacontanedioic acid, diglycolic acid, phthalic acid, isophthalic acid, terephthalic acid, 4,4'-biphenylcarboxylic acid, 4,4'-biphenylcarboxylic acid, 4,4'-dicarboxydiphenyl ether, and benzophenone-4,4'-dicarboxylic acid.

Specific examples of the dicarboxylic acid dihalide compound include a compound having a structure in which two carboxy groups in the specific examples of the dicarboxylic acid compound are halogenated.

In Formula (PAI-1), $R^{111}$ has the same meaning as $R^{111}$ in Formula (2) described above, and the same applies to the preferred aspect thereof.

In addition, the polyamideimide precursor preferably has a fluorine atom in the structure thereof. The content of fluorine atoms in the polyamideimide precursor is preferably 10% by mass or more, and it is preferably 20% by mass or less.

In addition, for the purpose of improving adhesiveness to a substrate, the polyamideimide precursor may be copolymerized with an aliphatic group having a siloxane structure. Specifically, an aspect in which bis(3-aminopropyl)tetramethyldisiloxane, bis(p-aminophenyl)octamethyl pentasiloxane, or the like is used as the diamine component can be mentioned.

One embodiment of the polyamideimide precursor in the present invention includes an embodiment in which the total content of the repeating unit represented by Formula (PAI-2), the repeating unit represented by Formula (PAI-1), and the repeating unit represented by Formula (2) is 50% by mole or more of all the repeating units. The above-described total content is more preferably 70% by mole or more, still more preferably 90% by mole or more, and particularly preferably more than 90% by mole. The upper limit of the total content is not particularly limited, and all the repeating units in the polyamideimide precursor excluding the terminal may be any one of the repeating unit represented by Formula (PAI-2), the repeating unit represented by Formula (PAI-1), or the repeating unit represented by Formula (2).

In addition, another embodiment of the polyamideimide precursor in the present invention includes an embodiment in which the total content of the repeating unit represented by Formula (PAI-2) and the repeating unit represented by Formula (PAI-1) is 50% by mole or more of all the repeating units. The above-described total content is more preferably 70% by mole or more, still more preferably 90% by mole or more, and particularly preferably more than 90% by mole. The upper limit of the total content is not particularly limited, and all the repeating units in the polyamideimide precursor excluding the terminal may be any one of the repeating units represented by Formula (PAI-2) or the repeating unit represented by Formula (PAI-1).

The weight-average molecular weight (Mw) of the polyamideimide precursor is preferably 2,000 to 500,000, more preferably 5,000 to 100,000, and still more preferably 10,000 to 50,000. In addition, the number-average molecular weight (Mn) thereof is preferably 800 to 250,000, more preferably 2,000 to 50,000, and still more preferably 4,000 to 25,000.

The dispersivity of the molecular weight of the polyamideimide precursor is preferably 1.5 or more, more preferably 1.8 or more, and still more preferably 2.0 or more. The upper limit value of the dispersivity of the molecular weight of the polyamideimide precursor is not particularly limited; however, it is, for example, preferably 7.0 or less, more preferably 6.5 or less, and still more preferably 6.0 or less. In addition, in a case where the resin composition contains a plurality of kinds of polyamideimide precursors as the specific resin, it is preferable that the weight-average molecular weight, the number-average molecular weight, and the dispersivity of at least one kind of polyamideimide precursor are in the above ranges. Further, it is also preferable that the weight-average molecular weight, the number-average molecular weight, and the dispersivity, calculated by using the plurality of kinds of polyamideimide precursors as one resin, are within the above ranges.

[Polyamideimide]

The polyamideimide that is used in the present invention may be an alkali-soluble polyamideimide or may be a polyamideimide soluble in a developer containing an organic solvent as a main component.

In the present specification, the alkali-soluble polyamideimide refers to a polyamideimide, 0.1 g or more of which is dissolved in 100 g of an aqueous solution of 2.38% by mass of tetramethylammonium at 23°C, and from the viewpoint of pattern formation properties, it is preferably a polyamideimide, 0.5 g or more of which is dissolved therein and still more preferably a polyamideimide, 1.0 g or more of which is dissolved therein. The upper limit of the dissolution amount is not particularly limited; however, it is preferably 100 g or less.

In addition, the polyamideimide is preferably a polyamideimide having a plurality of amide bonds and a plurality of imide structures in the main chain from the viewpoint of the film hardness and the insulating properties of the organic film to be obtained.

- Fluorine atom -

From the viewpoint of the film hardness of the organic film to be obtained, the polyamideimide preferably has a fluorine atom.

The fluorine atom is preferably contained in, for example, $R^{117}$ or $R^{111}$ in a repeating unit represented by Formula (PAI-3) described later, and it is more preferably contained, as a fluorinated alkyl group, in $R^{117}$ or $R^{111}$ in the repeating unit represented by Formula (PAI-3) described later.

The amount of fluorine atoms with respect to the total mass of the polyamideimide is preferably 5% by mass or more, and it is preferably 20% by mass or less.

- Ethylenically unsaturated bond -

From the viewpoint of the film hardness of the organic film to be obtained, the polyamideimide may have an ethylenically unsaturated bond.

The polyamideimide may have an ethylenically unsaturated bond at the terminal of the main chain or the side

chain; however, it preferably has an ethylenically unsaturated bond at the side chain.

The ethylenically unsaturated bond preferably has radical polymerizability.

The ethylenically unsaturated bond is preferably contained in $R^{117}$ or $R^{111}$ in a repeating unit represented by Formula (PAI-3) described later, and it is more preferably contained, as a group having an ethylenically unsaturated bond, in $R^{117}$ or $R^{111}$ in a repeating unit represented by Formula (PAI-3) described later.

The preferred aspect of the group having an ethylenically unsaturated bond is the same as the preferred aspect of the group having an ethylenically unsaturated bond in the above-described polyimide.

The amount of the ethylenically unsaturated bond with respect to the total mass of the polyamideimide is preferably 0.0001 to 0.1 mol/g and more preferably 0.001 to 0.05 mol/g.

- Polymerizable group other than ethylenically unsaturated bond -

The polyamideimide may have a polymerizable group other than the ethylenically unsaturated bond.

Examples of the polymerizable group other than the ethylenically unsaturated bond in the polyamideimide include the same group as the polymerizable group other than the ethylenically unsaturated bond in the above-described polyimide.

The polymerizable group other than the ethylenically unsaturated bond is preferably contained in, for example, $R^{111}$ in a repeating unit represented by Formula (PAI-3) described later.

The amount of the polymerizable group other than the ethylenically unsaturated bond with respect to the total mass of the polyamideimide is preferably 0.05 to 10 mol/g and more preferably 0.1 to 5 mol/g.

- Acid value -

In a case where the polyamideimide is subjected to alkaline development, the acid value of the polyamideimide is preferably 30 mgKOH/g or more, more preferably 50 mgKOH/g or more, and still more preferably 70 mgKOH/g or more, from the viewpoint of improving developability.

In addition, the acid value thereof is preferably 500 mgKOH/g or less, more preferably 400 mgKOH/g or less, and still more preferably 200 mgKOH/g or less.

Further, in a case where the polyamideimide is subjected to the development (for example, the "solvent development" described later) using a developer containing an organic solvent as a main component, the acid value of the polyamideimide is preferably 2 to 35 mgKOH/g, more preferably 3 to 30 mgKOH/g, and still more preferably 5 to 20 mgKOH/g.

The acid value is measured by a known method, for example, by the method described in JIS K0070: 1992.

In addition, examples of the acid group contained in the polyamideimide include the same group as the acid group in the above-described polyimide, and the same applies to the preferred aspect thereof.

- Phenolic hydroxy group -

From the viewpoint of allowing the speed of development with an alkaline developer to be proper, the polyamideimide preferably has a phenolic hydroxy group.

The polyamideimide may have a phenolic hydroxy group at the terminal of the main chain or the side chain.

The phenolic hydroxy group is preferably contained in, for example, $R^{117}$ or $R^{111}$ in a repeating unit represented by Formula (PAI-3) described later.

The amount of the phenolic hydroxy group with respect to the total mass of the polyamideimide is preferably 0.1 to 30 mol/g and more preferably 1 to 20 mol/g.

The polyamideimide that is used in the present invention is not particularly limited as long as it is a polymer compound having an imide structure and an amide bond; however, it is preferable that the polyamideimide contains a repeating unit represented by Formula (PAI-3).

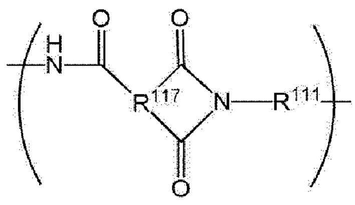

(PAI-3)

In Formula (PAI-3), $R^{111}$ and $R^{117}$ respectively have the same meanings as $R^{111}$ and $R^{117}$ in Formula (PAI-2), and the same applies to the preferred aspects thereof.

In a case where a polymerizable group is contained, the polymerizable group may be located at at least one of $R^{111}$ or $R^{117}$, or may be located at the terminal of the polyamideimide.

In addition, in order to improve the storage stability of the resin composition, the terminal of the main chain of the polyamideimide is preferably blocked with a terminal blocking agent such as a monoamine, an acid anhydride, a monocarboxylic acid, a monoacid chloride compound, or a monoactive ester compound. The preferred aspect of the terminal blocking agent is the same as the preferred aspect of the terminal blocking agent in the above-described polyimide.

- Imidization rate (ring closure rate) -

The imidization rate (also referred to as the "ring closure rate") of the polyamideimide is preferably 70% or more, more preferably 80% or more, and still more preferably 90% or more, from the viewpoint of the film hardness, the insulating properties, or the like of the organic film to be obtained.

The upper limit of the imidization rate is not particularly limited, and it may be any imidization rate of 100% or less.

The imidization rate is measured according to the same method as the above-described ring closure rate of the polyimide.

The polyamideimide may contain the repeating unit of Formula (PAI-3), the whole of which contains one kind of $R^{111}$ or $R^{117}$, or it may contain the repeating unit of Formula (PAI-3), in which two or more different kinds of $R^{111}$ or $R^{117}$ are contained. In addition, the polyamideimide may also contain another kind of repeating unit in addition to the above repeating unit represented by Formula (PAI-3). Examples of the other kind of repeating unit include the repeating unit represented by Formula (PAI-1) or the repeating unit represented by Formula (PAI-2), which are described above.

The polyamideimide can be synthesized, for example, by using a method in which a polyamideimide precursor is obtained according to a known method, and the obtained polyamideimide precursor is completely imidized by using a known imidization reaction method, or a method in which the imidization reaction is stopped in the middle of the reaction and the imide structure is partially introduced, or furthermore, a method in which a fully imidized polymer is blended with the polyamideimide precursor, whereby the imide structure is partially introduced.

The weight-average molecular weight(Mw) of the polyamideimide is preferably 5,000 to 70,000, more preferably 8,000 to 50,000, and still more preferably 10,000 to 30,000. In a case where the weight-average molecular weight is set to 5,000 or more, it is possible to improve the breakage resistance of the film after curing. In order to obtain an organic film having excellent mechanical properties, the weight-average molecular weight is particularly preferably 20,000 or more.

In addition, the number-average molecular weight (Mn) of the polyamideimide is preferably 800 to 250,000, more preferably 2,000 to 50,000, and still more preferably 4,000 to 25,000.

The dispersivity of the molecular weight of the polyamideimide is preferably 1.5 or more, more preferably 1.8 or more, and still more preferably 2.0 or more. The upper limit value of the dispersivity of the molecular weight of the polyamideimide is not particularly limited; however, it is, for example, preferably 7.0 or less, more preferably 6.5 or less, and still more preferably 6.0 or less.

In addition, in a case where the resin composition contains a plurality of kinds of polyamideimides as the specific resin, it is preferable that the weight-average molecular weight, the number-average molecular weight, and the dispersivity of at least one kind of polyamideimide are in the above ranges. Further, it is also preferable that the weight-average molecular weight, the number-average molecular weight, and the dispersivity, calculated by using the plurality of kinds of polyamideimides as one resin, are within the above ranges.

[Production method for polyimide precursor and like]

The polyimide precursor the like can be obtained, for example, by a method of reacting a tetracarboxylic acid dianhydride with a diamine at a low temperature, a method of reacting a tetracarboxylic acid dianhydride with a diamine at a low temperature to obtain a polyamic acid and subjecting the polyamic acid to esterification by using a condensing agent or an alkylating agent, a method of obtaining a diester with a tetracarboxylic acid dianhydride and alcohol and then reacting the diester with a diamine in the presence of a condensing agent, and a method of obtaining a diester with a tetracarboxylic acid dianhydride and alcohol, subsequently subjecting the rest dicarboxylic acid to acid-halogenation using a halogenating agent, and carrying out reaction with a diamine. Among the above production method, a method of obtaining a diester with a tetracarboxylic acid dianhydride and alcohol, subsequently subjecting the rest dicarboxylic acid to acid-halogenation using a halogenating agent, and carrying out a reaction with a diamine is more preferable.

Examples of the condensing agent include dicyclohexylcarbodiimide, diisopropylcarbodiimide, 1-ethoxycarbonyl-2-ethoxy-1,2-dihydroquinoline, 1,1-carbonyldioxy-di-1,2,3-benzotriazole, N,N'-disuccinimidyl carbonate, and trifluoroacetic anhydride.

Examples of the alkylating agent include N,N-dimethylformamide dimethyl acetal, N,N-dimethylformamide diethyl acetal, N,N-dialkylformamide dialkyl acetal, trimethyl orthoformate, triethyl orthoformate.

Examples of the halogenating agent include thionyl chloride, oxalyl chloride, and phosphorus oxychloride.

In the production method for a polyimide precursor the like, it is preferable to use an organic solvent in a caase of carrying out the reaction. One kind of organic solvent may be used, or two or more kinds thereof may be used.

The organic solvent can be appropriately determined depending on the raw material; however, examples thereof include pyridine, diethylene glycol dimethyl ether (diglyme), N-methylpyrrolidone, N-ethylpyrrolidone, ethyl propionate, dimethylacetamide, dimethylformamide, tetrahydrofuran, and γ-butyrolactone.

In the production method for a polyimide precursor the like, it is preferable to add a basic compound in a caase of carrying out the reaction. One kind of basic compound may be used, or two or more kinds thereof may be used.

The basic compound can be appropriately determined depending on the raw material; however, examples thereof include triethylamine, diisopropylethylamine, pyridine, 1,8-diazabicyclo[5.4.0]undec-7-ene, and N,N-dimethyl-4-aminopyridine.

- Terminal blocking agent -

In the production method for a polyimide precursor the like, it is preferable to block the carboxylic acid anhydride, the acid anhydride derivative, or the amino group, remaining at the terminal of the resin such as the polyimide precursor, in order to further improve the storage stability. In a case of blocking the carboxylic acid anhydride and the acid anhydride derivative, remaining at the resin terminal, examples of the terminal blocking agent include a monoalcohol, phenol, thiol, thiophenol, and a monoamine. It is more preferable to use a monoalcohol, phenols, or a monoamine from the viewpoint of reactivity and film stability. Examples of the preferred monoalcohol compound include primary alcohol such as methanol, ethanol, propanol, butanol, hexanol, octanol, dodecanol, benzyl alcohol, 2-phenylethanol, 2-methoxyethanol, 2-chloromethanol, and furfuryl alcohol; secondary alcohol such as isopropanol, 2-butanol, cyclohexyl alcohol, cyclopentanol, and 1-methoxy-2-propanol; and tertiary alcohol such as t-butyl alcohol and adamantane alcohol. Examples of the preferred compounds of phenols include phenols such as phenol, methoxyphenol, methylphenol, naphthalene-1-ol, naphthalene-2-ol, and hydroxystyrene. In addition, examples of the preferred monoamine compound include aniline, 2-ethynyl aniline, 3-ethynyl aniline, 4-ethynyl aniline, 5-amino-8-hydroxyquinoline, 1-hydroxy-7-aminonaphthalene, 1-hydroxy-6-aminonaphthalene, 1-hydroxy-5-aminonaphthalene, 1-hydroxy-4-aminonaphthalene, 2-hydroxy-7-aminonaphthalene, 2-hydroxy-6-aminonaphthalene, 2-hydroxy-5-aminonaphthalene, 1-carboxy-7-aminonaphthalene, 1-carboxy-6-aminonaphthalene, 1-carboxy-5-aminonaphthalene, 2-carboxy-7-aminonaphthalene, 2-carboxy-6-aminonaphthalene, 2-carboxy-5-aminonaphthalene, 2-aminobenzoic acid, 3-aminobenzoic acid, 4-aminobenzoic acid, 4-aminosalicylic acid, 5-aminosalicylic acid, 6-aminosalicylic acid, 2-aminobenzenesulfonic acid, 3-aminobenzenesulfonic acid, 4-aminobenzenesulfonic acid, 3-amino-4,6-dihydroxypyrimidine, 2-aminophenol, 3-aminophenol, 4-aminophenol, 2-aminothiophenol, 3-aminothiophenol, and 4-aminothiophenol. Two or more of these may be used, and a plurality of different terminal groups may be introduced by reacting a plurality of terminal blocking agents.

In addition, in a case of blocking the amino group at the terminal of the resin, it is possible to carry out blocking with a compound having a functional group capable of reacting with the amino group. The preferred blocking agent for the amino group is preferably a carboxylic acid anhydride, a carboxylic acid chloride, a carboxylic acid bromide, a sulfonic acid chloride, sulfonic acid anhydride, or a sulfonic acid carboxylic acid anhydride, and more preferably a carboxylic acid anhydride or a carboxylic acid chloride. Examples of the preferred carboxylic acid anhydride compound include acetic anhydride, propionic anhydride, oxalic anhydride, succinic anhydride, maleic acid anhydride, phthalic anhydride, and benzoic anhydride, 5-norbornen-2,3-dicarboxylic acid anhydride. Examples of the preferred carboxylic acid chloride compound include acetyl chloride, acrylic acid chloride, propionyl chloride, methacrylic acid chloride, pivaloyl chloride, cyclohexanecarbonyl chloride, 2-ethylhexanoyl chloride, cinnamoyl chloride, 1-adamantanecarbonyl chloride, heptafluorobutyryl chloride, stearic acid chloride, and benzoyl chloride.

- Solid precipitation -

In a case of producing a polyimide precursor the like, a step of precipitating a solid may be included. Specifically, it is possible to obtain a polyimide precursor by filtering out a water-absorbing by-product of the dehydration condensing agent that is present together in the reaction solution as necessary, subsequently putting the obtained polymer component in a poor solvent such as water, an aliphatic lower alcohol, or a mixed solution thereof, precipitating the polymer component to be precipitated as a solid, and then carrying out drying. In order to improve the degree of purification, operations such as redissolution, reprecipitation, and drying of the polyimide precursor may be repeated. Further, a step of removing ionic impurities using an ion exchange resin may be included.

[Content]

The content of the specific resin in the resin composition according to the embodiment of the present invention is preferably 20% by mass or more, more preferably 30% by mass or more, still more preferably 40% by mass or more, and even still more preferably 50% by mass or more, with respect to the total solid content of the resin composition. In addition, the content of the resin in the resin composition according to the embodiment of the present invention is preferably 99.5% by mass or less, more preferably 99% by mass or less, still more preferably 98% by mass or less, still more preferably 97% by mass or less, and even still more preferably 95% by mass or less, with respect to the total solid content of the resin composition.

The resin composition according to the embodiment of the present invention may contain only one kind of specific resin or may contain two or more kinds thereof. In a case where two or more kinds thereof are contained, the total amount thereof is preferably within the above range.

In addition, it is also preferable that the resin composition according to the embodiment of the present invention contains at least two kinds of resins.

Specifically, the resin composition according to the embodiment of the present invention may contain in total two or more kinds of the specific resins and other resins described later or may contain two or more kinds of the specific resins; however, it is preferable to include two or more kinds of the specific resins.

In a case where the resin composition according to the embodiment of the present invention contains two or more kinds of the specific resins, it is preferable to contain, for example, two or more kinds of polyimide precursors which are polyimide precursors in which the structure ($R^{115}$ in Formula (2) described above) derived from the dianhydride is different.

<Another resin>

The resin composition according to the embodiment of the present invention may contain, in addition to the above-described specific resin or instead of the above-described specific resin, another resin (hereinafter, also simply referred to as "the other resin") that is different from the specific resin.

Examples of the other resin include a phenol resin, polyamide, an epoxy resin, polysiloxane, a resin containing a siloxane structure, a (meth)acrylic resin, a (meth)acrylamide resin, a urethane resin, a butyral resin, a styryl resin, a polyether resin, and a polyester resin.

For example, in a case where a (meth)acrylic resin is further added, it is possible to obtain a resin composition having excellent coatability, and it is possible to obtain a pattern (a cured substance) having excellent solvent resistance.

For example, in a case where a (meth)acrylic resin having a high polymerizable base value and having a weight-average molecular weight of 20,000 or less (for example, a molar amount of a polymerizable group contained in 1 g of a resin is $1 \times 10^{-3}$ mol/g or more) is added to the resin composition instead of a polymerizable compound described later or in addition to a polymerizable compound described later, it is possible to improve the coatability of the resin composition, the solvent resistance of the pattern (the cured substance).

In a case where the resin composition according to the embodiment of the present invention contains the other resin, the content of the other resin is preferably 0.01% by mass or more, more preferably 0.05% by mass or more, still more preferably 1% by mass or more, even still more preferably 2% by mass or more, even still more preferably 5% by mass or more, and even further still more preferably 10% by mass or more, with respect to the total solid content of the resin composition.

In addition, the content of the other resin in the resin composition according to the embodiment of the present invention is preferably 80% by mass or less, more preferably 75% by mass or less, still more preferably 70% by mass or less, still more preferably 60% by mass or less, and even still more preferably 50% by mass or less, with respect to the total solid content of the resin composition.

In addition, as the preferred aspect of the resin composition according to the aspect of the present invention, an aspect in which the content of the other resin is a low content can be adopted. In the above aspect, the content of the other resin is preferably 20% by mass or less, more preferably 15% by mass or less, still more preferably 10% by mass or less, still more preferably 5% by mass or less, and even still more preferably 1% by mass or less, with respect to the total solid content of the resin composition. The lower limit of the content is not particularly limited, and it may be any content of 0% by mass or more.

The resin composition according to the embodiment of the present invention may contain only one kind of the other resin or may contain two or more kinds thereof. In a case where two or more kinds thereof are contained, the total amount thereof is preferably within the above range.

<Compound A>

The negative-tone photosensitive resin composition in the first aspect according to the present invention a compound A of which an absorbance is reduced at an exposure wavelength upon exposure.

Whether or not a compound a contained in the negative-tone photosensitive resin composition corresponds to the compound A (that is, whether or not the absorbance at the exposure wavelength decreases upon exposure) can be determined according to the following method.

First, a solution of the compound a having the same concentration as the concentration of the compound a contained in the negative-tone photosensitive resin composition is prepared, and the molar absorption coefficient of the compound a at the wavelength of the exposure light ($mol^{-1}\cdot L\cdot cm^{-1}$; also referred to as a "molar absorption coefficient 1") is measured. The above measurement is carried out quickly so that an influence of a change such as a decrease in the molar absorption coefficient of the compound a is small. As a solvent in the above solution, a solvent of the negative-tone photosensitive resin composition is used in a case where the negative-tone photosensitive resin composition contains a solvent, and N-methyl-2-pyrrolidone is used in a case where the negative-tone photosensitive resin composition does not contain a solvent.

Next, the solution of the compound a is irradiated with exposure light. The exposure amount is 500 mJ, in terms of the integrated amount, with respect to 1 mol of the compound a.

Then, using the exposed solution of the compound a, the molar absorption coefficient of the compound a at the wavelength of the exposure light (($mol^{-1}\cdot L\cdot cm^{-1}$; also referred to as a "molar absorption coefficient 2") is measured.

An attenuation rate (%) is calculated from the molar absorption coefficient 1 and the molar absorption coefficient 2 based on the following expression, and in a case where the attenuation rate (%) is 5% or more, it is determined that the compound a is a compound of which an absorbance is reduced at an exposure wavelength upon exposure (that is, the compound A).

$$\text{Attenuation rate (\%)} = 1 - \text{molar absorption coefficient 2/molar absorption coefficient 1} \times 100$$

The attenuation rate is preferably 10% or more and more preferably 20% or more. In addition, the lower limit of the attenuation rate is not particularly limited, and it may be any attenuation rate of 0% by mass or more.

In a case where the negative-tone photosensitive resin composition is used for forming a photosensitive film, the wavelength of the exposure light may be any wavelength at which the photosensitive film is exposed.

In addition, the wavelength of the exposure light is preferably a wavelength at which the photopolymerization initiator contained in the negative-tone photosensitive resin composition has sensitivity. The fact that the photopolymerization initiator has sensitivity to a certain wavelength refers to that a polymerization initiation species is generated in a case where the photopolymerization initiator is exposed at a certain wavelength.

Examples of the wavelength of the exposure light, which are mentioned in the relationship with the light source, include (1) a semiconductor laser (wavelength: 830 nm, 532 nm, 488 nm, 405 nm, 375 nm, 355 nm, etc); (2) a metal halide lamp; (3) a high-pressure mercury lamp, a g-line (wavelength: 436 nm), an h-line (wavelength: 405 nm), an i-line (wavelength: 365 nm), or Broad (three wavelengths of the g, h, and i-line); (4) an excimer laser, a KrF excimer laser (wavelength: 248 nm), an ArF excimer laser (wavelength: 193 nm), or an $F_2$ excimer laser (wavelength: 157 nm); (5) an extreme ultraviolet (EUV) ray (wavelength: 13.6 nm); (6) an electron beam; and (7) a second harmonic wave of 532 nm and a third harmonic wave of 355 nm of a YAG laser.

As the wavelength of the exposure light, for example, any wavelength at which the photopolymerization initiator has sensitivity may be selected; however, an h-line (wavelength: 405 nm) or an i-line (wavelength: 365 nm) is preferable, and an i-line (wavelength: 365 nm) is more preferable.

The compound A may be a compound that generates a radical polymerization initiation species upon exposure; however, it is preferably a compound that does not generate a radical polymerization initiation species upon exposure from the viewpoint of resolution and chemical resistance.

Whether or not the compound A is a compound that generates a radical polymerization initiation species upon exposure is determined according to the following method.

A solution, which contains the compound A having the same concentration as the concentration of the compound A contained in the negative-tone photosensitive resin composition and contains a radical crosslinking agent, is prepared. In a case where the negative-tone photosensitive resin composition contains a radical crosslinking agent, as the radical crosslinking agent in the solution, the same compound as the radical crosslinking agent contained in the negative-tone photosensitive resin composition is used at the same concentration. In a case where the negative-tone photosensitive resin composition does not contain a radical crosslinking agent, methyl methacrylate is used at a concentration 5 times that of the compound A.

Then, the irradiation with the exposure light is carried out. The exposure amount is 500 mJ in terms of the integrated amount.

After the exposure, the polymerization of the polymerizable compound is determined by, for example, high performance liquid chromatography, and in a case where the proportion of the molar amount of the polymerized polymerizable compound to the total molar amount of the polymerizable compound is 10% or less, it is determined that the compound A is a compound that does not generate a radical polymerization initiation species upon exposure.

The proportion of the molar amount is preferably 5% or less and more preferably 3% or less. In addition, the lower limit of the proportion of the molar amount is not particularly limited and may be 0%.

In a case where the negative-tone photosensitive resin composition is used for forming a photosensitive film, the wavelength of the exposure light may be any wavelength at which the photosensitive film is exposed.

In addition, the wavelength of the exposure light is preferably a wavelength at which the photopolymerization initiator contained in the negative-tone photosensitive resin composition has sensitivity.

In addition, the wavelength of the exposure light is preferably a wavelength at which the photopolymerization initiator contained in the negative-tone photosensitive resin composition has sensitivity.

Examples of the compound that generates a radical polymerization initiation species upon exposure include the same compound as the photoradical polymerization initiator described below. In a case where the composition contains a photoradical polymerization initiator as the compound A, the compound A shall be a compound, where a radical species generated from the compound has the lowest polymerization initiation ability, and the photopolymerization initiator shall be the other ones.

Examples of the compound that does not generate a radical polymerization initiation species upon exposure include a photoacid generator, a photobase generator, and a coloring agent having a changed absorption wavelength upon exposure.

Among these, the compound A is preferably a naphthoquinone diazide compound or a coloring agent having a changed absorbance upon exposure, and it is more preferably a naphthoquinone diazide compound.

In addition, for example, it is also conceivable to use, as the compound A, a photoacid generator or photobase generator in combination with a compound of which an absorbnace is reduced at the exposure wavelength depending on the pH.

The negative-tone photosensitive resin composition in the second aspect according to the present invention contains a naphthoquinone diazide compound.

The naphthoquinone diazide compound in the second aspect has the same meaning as the naphthoquinone diazide compound contained as the preferred aspect in the first aspect, and the same applies to the preferred aspect thereof.

The naphthoquinone diazide compound in the second aspect is preferably a compound of which an absorbance is reduced at an exposure wavelength upon exposure. The method of determining whether or not the compound of which the absorbance is reduced at the exposure wavelength upon exposure and the preferred range of the attenuation rate respectively are the same as the determination method and the attenuation rate for the compound A in the first aspect described above.

[Naphthoquinone diazide compound]

Examples of the naphthoquinone diazide compound include a compound of which an absorbance is reduced at an exposure wavelength due to generation of an indene carboxylic acid upon exposure, where a compound having a 1,2-naphthoquinone diazide structure is preferable.

The naphthoquinone diazide compound is preferably a naphthoquinone diazide sulfonic acid ester of a hydroxy compound.

The hydroxy compound is preferably a compound represented by any one of Formulae (H1) to (H6).

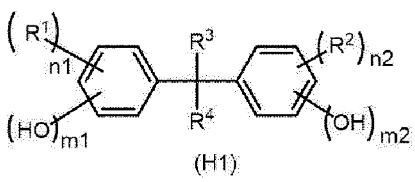

(H1)

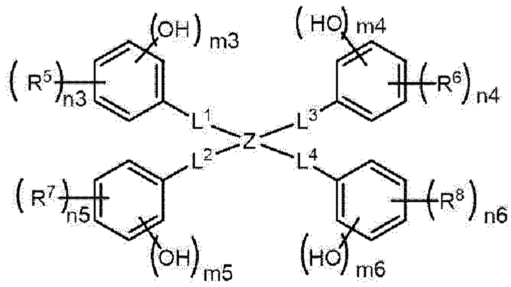

(H2)

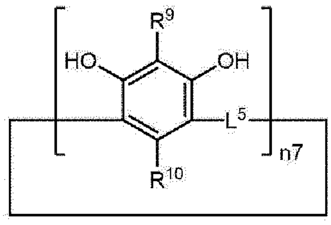

(H3)

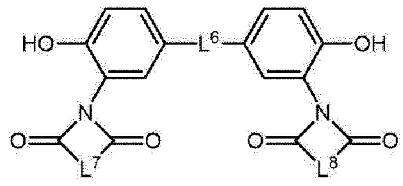

(H4)

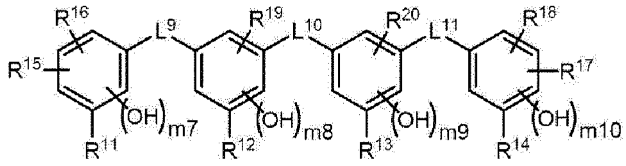

(H5)

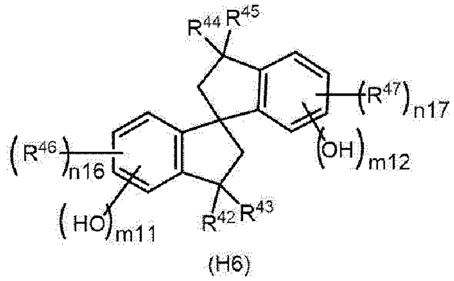

(H6)

In Formula (H1), $R^1$ and $R^2$ each independently represent a monovalent organic group, $R^3$ and $R^4$ each independently represent a hydrogen atom or a monovalent organic group, and n1, n2, m1, and m2 are each independently an integer of 0 to 5, where at least one of m1 or m2 is an integer of 1 to 5.

In Formula (H2), Z represents a tetravalent organic group, $L^1$, $L^2$, $L^3$, and $L^4$ each independently represent a single bond or a divalent organic group, $R^5$, $R^6$, and $R^7$ and $R^8$ each independently represent a monovalent organic group, n3, n4, n5, and n6 are each independently an integer of 0 to 3, and m3, m4, m5, and m6 are each independently an integer of 0 to 2 where at least one of m3, m4, m5, or m6 is 1 or 2.

In Formula (H3), $R^9$ and $R^{10}$ each independently represent a hydrogen atom or a monovalent organic group, $L^5$'s each independently represent a divalent organic group, and n7 represents an integer of 3 to 8.

In Formula (H4), $L^6$ represents a divalent organic group, and $L^7$ and $L^8$ each independently represent a divalent organic group containing an aliphatic tertiary or quaternary carbon.

In Formula (H5), $R^{11}$, $R^{12}$, $R^{13}$, $R^{14}$, $R^{15}$, $R^{16}$, $R^{17}$, $R^{18}$, $R^{19}$, and $R^{20}$ each independently represent a hydrogen atom, a halogen atom, or a monovalent organic group, $L^9$, $L^{10}$, and $L^{11}$ each independently represent a single bond or a divalent organic group, and m7, m8, m9, and m10 each independently represent an integer of 0 to 2, where at least one of m7, m8, m9, or m10 is 1 or 2.

In Formula (H6), $R^{42}$, $R^{43}$, $R^{44}$, and $R^{45}$ each independently represent a hydrogen atom or a monovalent organic group, $R^{46}$ and $R^{47}$ each independently represent a monovalent organic group, n16 and n17 each independently represent an integer of 0 to 4, and m11 and m12 each independently represent an integer of 0 to 4, where at least one of m11 or m12 is an integer of 1 to 4.

In Formula (H1), $R^1$ and $R^2$ are each independently preferably a monovalent organic group having 1 to 60 carbon atoms, and more preferably a monovalent organic group having 1 to 30 carbon atoms. Examples of the monovalent organic group as $R^1$ and $R^2$ include a hydrocarbon group which may have a substituent, and examples of the hydrocarbon group include an aromatic hydrocarbon group which may have a substituent such as a hydroxy group.

In Formula (H1), $R^3$ and $R^4$ are each independently preferably a monovalent organic group having 1 to 60 carbon atoms, and more preferably a monovalent organic group having 1 to 30 carbon atoms. Examples of the monovalent organic group as $R^3$ and $R^4$ include a hydrocarbon group which may have a substituent, and examples of the hydrocarbon group include a hydrocarbon group which may have a substituent such as a hydroxy group.

In Formula (H1), n1 and n2 are each independently preferably 0 or 1, and more preferably 0.

In Formula (H1), both m1 and m2 are preferably 1.

The compound represented by Formula (H1) is preferably a compound represented by any one of Formula

(H1-1) to (H1-5).

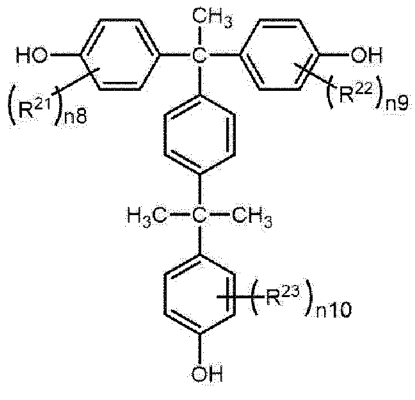

(H1-1)

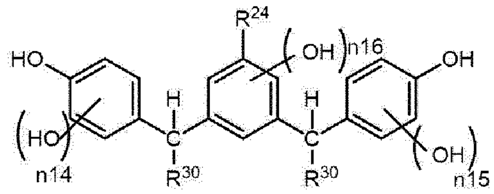

(H1-2)

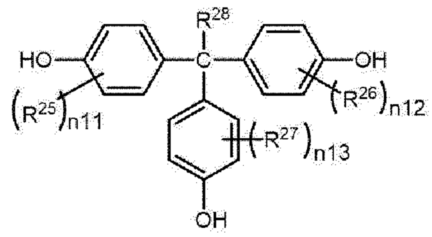

(H1-3)

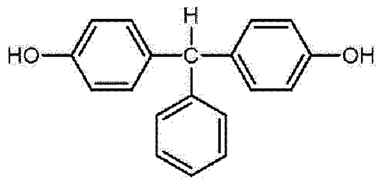

(H1-4)

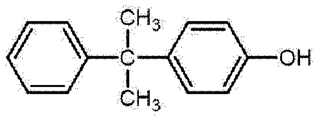

(H1-5)

In Formula (H1-1), $R^{21}$, $R^{22}$, and $R^{23}$ each independently represent a hydrogen atom or a monovalent organic group, and it is preferably a hydrogen atom or a monovalent organic group having 1 to 20 carbon atoms, and more preferably a hydrogen atom or a group represented by Formula (R-1).

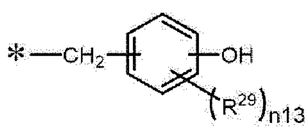

(R-1)

In Formula (R-1), $R^{29}$ represents a hydrogen atom, an alkyl group, or an alkoxy group, n13 represents an integer of 0 to 2, and * represents a bonding site to another structure.

In (H1-1), n8, n9, and n10 each independently represent an integer of 0 to 2, where 0 or 1 is preferable.

In Formula (H1-2), $R^{24}$ represents a hydrogen atom or a monovalent organic group, and it is preferably a hydrogen atom, an alkyl group having 1 to 20 carbon atoms, or an alkoxy group having 1 to 20 carbon atoms. n14, n15, and n16 each independently represent an integer of 0 to 2. $R^{30}$ represents a hydrogen atom or an alkyl group.

In Formula (H1-3), $R^{25}$, $R^{26}$, $R^{27}$, and $R^{28}$ each independently represent a monovalent organic group, and they are preferably a hydrogen atom, an alkyl group, or a group represented by Formula (R-1).

In Formula (H1-3), n11, n12, and n13 each independently represent an integer of 0 to 2, where 0 or 1 is preferable.

The compound represented by Formula (H1-1) is preferably a compound represented by any one of Formulae (H1-1-1) to (H1-1-4).

The compound represented by Formula (H1-2) is preferably a compound represented by Formula (H1-2-1) or

(H1-2-2).

The compound represented by Formula (H1-3) is preferably a compound represented by Formulae (H1-3-1) to (H1-3-3).

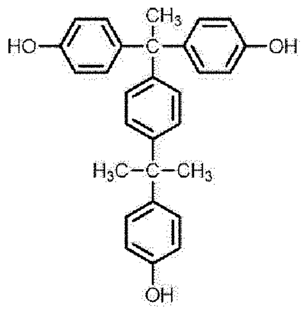

(H1-1-1)

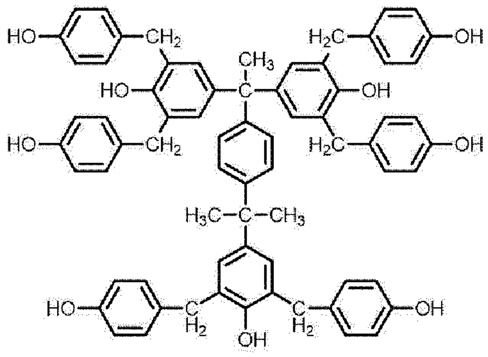

(H1-1-2)

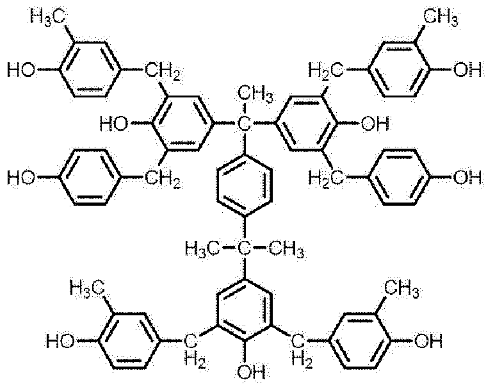

(H1-1-3)

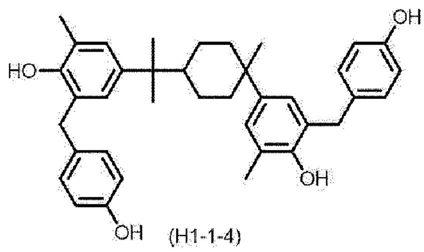

(H1-1-4)

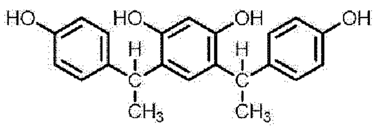

(H1-2-1)

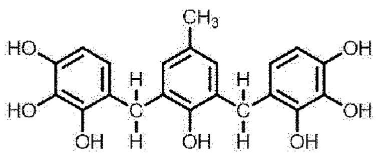

(H1-2-2)

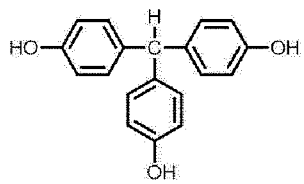

(H1-3-1)

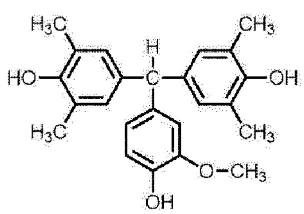

(H1-3-2)

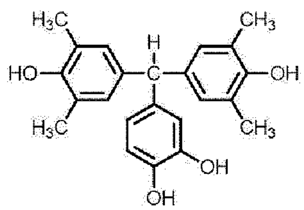

(H1-3-3)

In Formula (H2), Z is preferably a tetravalent group having 1 to 20 carbon atoms, and more preferably a group represented by any one of Formula (Z-1) to (Z-4). In Formulae (Z-1) to (Z-4), * represents a bonding site to another structure.

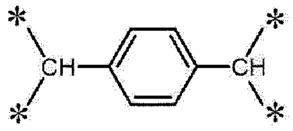

(Z-1)

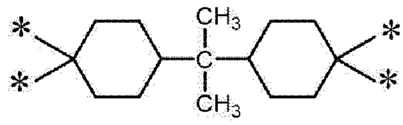

(Z-2)

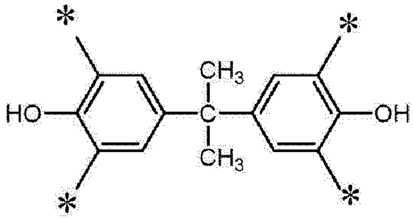

(Z-3)

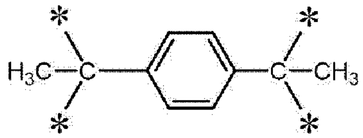

(Z-4)

In Formula (H2), $L^1$, $L^2$, $L^3$, and $L^4$ are each independently preferably a single bond or a methylene group.

In Formula (H2), $R^5$, $R^6$, $R^7$, and $R^8$ are each independently preferably an organic group having 1 to 30 carbon atoms.

In Formula (H2), n3, n4, n5, and n6 are each independently preferably an integer of 0 to 2, and more preferably 0 or 1.

In Formula (H2), m3, m4, m5, and m6 are each independently preferably 1 or 2, and more preferably 1.

Examples of the compound represented by Formula (H2) include compounds having the following structures.

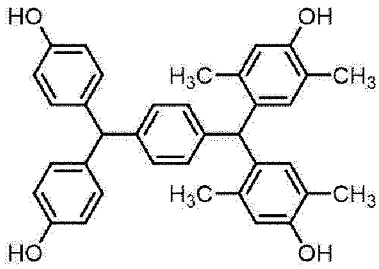

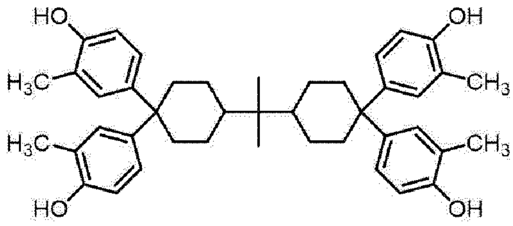

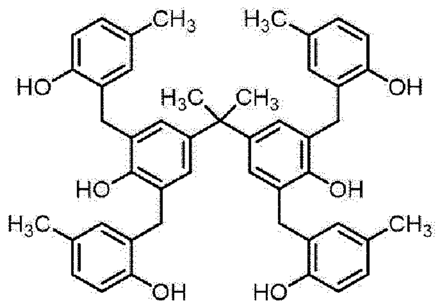

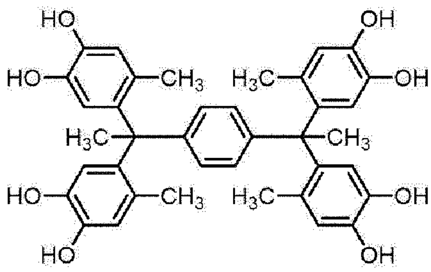

In Formula (H3), $R^9$ and $R^{10}$ each independently preferably represent a hydrogen atom or a monovalent organic group having 1 to 20 carbon atoms.

In Formula (H3), $L^5$'s are each independently preferably a group represented by

Formula (L-1).

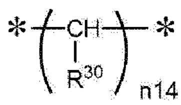

(L-1)

In Formula (L-1), $R^{30}$ represents a monovalent organic group having 1 to 20 carbon atoms, n14 represents an integer of 1 to 5, and * represents a bonding site to another structure.

In Formula (H3), n7 is preferably an integer of 4 to 6.

Examples of the compound represented by Formula (H3) include the following compounds. In the following formula, n's each independently represent an integer of 0 to 9.

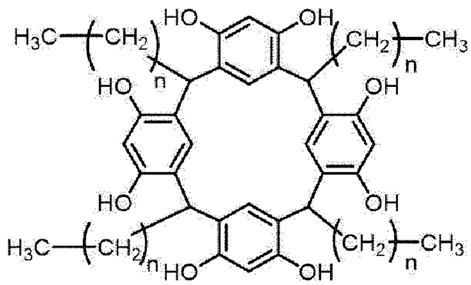

In Formula (H4), $L^6$ is preferably $-C(CF_3)_2-$, $-S(=O)_2-$, or $-C(=O)-$.

In Formula (H4), $L^7$ and $L^8$ are each independently preferably a divalent organic group having 2 to 20 carbon atoms.

Examples of the compound represented by Formula (H4) include the following compounds.

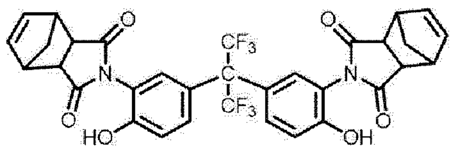

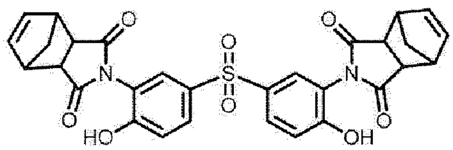

In Formula (H5), $R^{11}$, $R^{12}$, $R^{13}$, $R^{14}$, $R^{15}$, $R^{16}$, $R^{17}$, $R^{18}$, $R^{19}$, and $R^{20}$ are each independently preferably a hydrogen atom, a halogen atom, an alkyl group, an alkenyl group, an alkoxy group, an allyl group, or an acyl group.

In Formula (H5), $L^9$, $L^{10}$, and $L^{11}$ are each independently preferably a single bond, -O-, -S-, $-S(=O)_2-$,-C(=O)-,-C(=O)O-, cyclopentylidene, cyclohexylidene, phenylene, or a divalent organic group having 1 to 20 carbon atoms, and they are more preferably a group represented by any one of Formula (L-2) to (L-4).

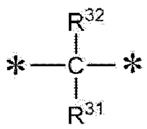

(L-2)

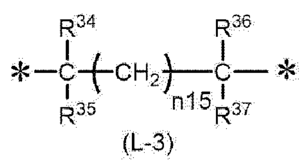

(L-3)

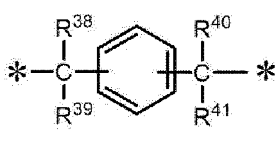

(L-4)

In Formulae (L-2) to (L-4), $R^{31}$ and $R^{32}$ each independently represent a hydrogen atom, an alkyl group, an alkenyl group, or an aryl group, $R^{34}$, $R^{35}$, $R^{36}$, and $R^{37}$ each independently represents a hydrogen atom or an alkyl group, n15 is an integer of 1 to 5, $R^{38}$, $R^{39}$, $R^{40}$, and $R^{41}$ each independently represent a hydrogen atom or an alkyl group, and * represents a bonding site to another structure.

Examples of the compound represented by Formula (H5) include the following compounds.

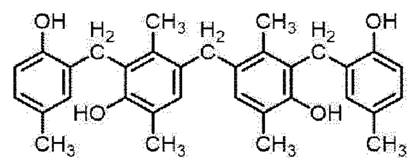

In Formula (H6), $R^{42}$, $R^{43}$, $R^{44}$, and $R^{45}$ each independently represent a hydrogen atom or a monovalent organic group and are preferably a hydrogen atom or a monovalent organic group having 1 to 20 carbon atoms, more preferably a hydrogen atom or an alkyl group having 1 to 20 carbon atoms, and still more preferably an alkyl group having 1 to 4 carbon atoms.

In Formula (H6), $R^{46}$ and $R^{47}$ are each independently preferably an alkyl group, an alkoxy group, or an aryl

group, and more preferably an alkyl group.

In Formula (H6), n16 and n17 are each independently preferably an integer of 0 to 2, and more preferably 0 or 1.

In Formula (H6), n16 and n17 are each independently preferably an integer of 1 to 3, and more preferably 2 or 3.

Examples of the compound represented by Formula (H6) include the following compounds.

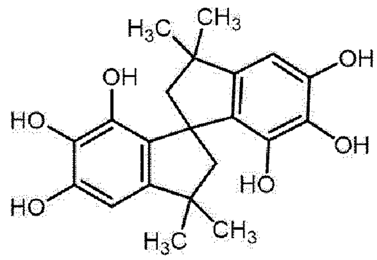

In addition, examples of the hydroxy compound include the following compound: polyhydroxybenzophenones such as 2,3,4-trihydroxybenzophenone, 2,4,4'-trihydroxybenzophenone, 2,4,6-trihydroxybenzophenone, 2,3,4-trihydroxy-2'-methylbenzophenone, 2,3,4,4'-tetrahydroxybenzophenone, 2,2',4,4'-tetrahydroxybenzophenone, 2,4,6,3',4'-pentahydroxybenzophenone, 2,3,4,2',4'-pentahydroxybenzophenone, 2,3,4,2',5'-pentahydroxybenzophenone, 2,4,6,3',4',5'-hexahydroxybenzophenone, and 2,3,4,3',4',5'-hexahydroxybenzophenone, polyhydroxyphenylalkyl ketones such as 2,3,4-trihydroxyacetophenone, 2,3,4-trihydroxyphenylpentylketone, and 2,3,4-trihydroxyphenylhexylketone, bis((poly)hydroxyphenyl) alkanes such as bis(2,4-dihydroxyphenyl)methane, bis(2,3,4-trihydroxyphenyl)methane, bis(2,4-dihydroxyphenyl)propane-1, bis(2,3,4-trihydroxyphenyl)propane-1, nordihydroguaiaretic acid, and 1,1-bis(4-hydroxyphenyl)cyclohexane, polyhydroxybenzoic acid esters such as propyl 3,4,5-trihydroxybenzoate, phenyl 2,3,4-trihydroxybenzoate, and phenyl 3,4,5-trihydroxybenzoate, bis(polyhydroxybenzoyl) alkanes or bis(polyhydroxybenzoyl) aryls such as bis(2,3,4-trihydroxybenzoyl)methane, bis(3-acetyl-4,5,6-trihydroxyphenyl)-methane, bis(2,3,4-trihydroxybenzoyl)benzene, and bis(2,4,6-trihydroxybenzoyl)benzene, alkylene-di(polyhydroxybenzoate) such as ethylene glycol-di (3,5-dihydroxybenzoate) and ethylene glycol-di (3,4,5-trihydroxybenzoate), polyhydroxybiphenyls such as 2,3,4-biphenyltriol, 3,4,5-biphenyltriol, 3,5,3',5'-biphenyltetrol, 2,4,2',4'-biphenyltetrol, 2,4,6,3',5'-biphenylpentol, 2,4,6,2',4',6'-biphenylhexol, and 2,3,4,2',3',4'-biphenylhexol, bis(polyhydroxy) sulfides such as 4,4'-thiobis(1,3-dihydroxy)benzene, bis(polyhydroxyphenyl) ethers such as 2,2',4,4'-tetrahydroxydiphenyl ether, bis(polyhydroxyphenyl) sulfoxides such as 2,2',4,4'-tetrahydroxydiphenyl sulfoxide, bis(polyhydroxyphenyl) sulfones such as 2,2',4,4'-diphenyl sulfone, polyhydroxytriphenylmethanes, such as tris(4-hydroxyphenyl)methane, 4,4',4"-trihydroxy-3,5,3',5'-tetramethyltriphenylmethane, 4,4',3",4"-tetrahydroxy-3,5,3',5'-tetramethyltriphenylmethane, 4-[bis(3,5-dimethyl-4-hydroxyphenyl)methyl]-2-methoxyphenol, 4,4'-(3,4'-diol-benzylidene) bis[2,6-dimethylphenol], 4,4'-[(2-hydroxy-phenyl)methylene] bis[2-cyclohexyl-5-methylphenol, 4,4',2",3",4"-pentahydroxy-3,5,3',5'-tetramethyltriphenylmethane, 2,3,4,2',3',4'-hexahydroxy-5,5'-diacetyltriphenylmethane, 2,3,4,2',3',4',3",4"-octahydroxy-5,5'-diacetyltriphenylmethane, and 2,4,6,2',4',6'-hexahydroxy-5,5'-dipropionyltriphenylmethane, polyhydroxytriphenylethanes such as 4,4'-(phenylmethylene)bisphenol, 4,4'-(1-phenyl-ethylidene) bis[2-methylphenol], and 4,4',4"-ethylidene-trisphenol, polyhydroxyspiro-bi-indanes such as 3,3,3',3'-tetramethyl-1,1'-spiro-bi-indan-5,6,5',6'-tetrol, 3,3,3',3'-tetramethyl-1,1'-spiro-bi-indan-5,6,7,5',6',7'-hexol, 3,3,3',3'-tetramethyl-1,1'-spiro-bi-indan-4,5,6,4',5',6'-hexol, and 3,3,3',3'-tetramethyl-1,1'-spiro-bi-indan-4,5,6,5',6',7'-hexol, polyhydroxyflavans such as 2,4,4-trimethyl-2',4',7'-trihydroxyflavan, polyhydroxyphthalides such as 3,3-bis(3,4-dihydroxyphenyl)phthalide, 3,3-bis(2,3,4-trihydroxyphenyl)phthalide, and 3',4',5', 6'-tetrahydroxyspiro[phthalide-3,9'-xanthene], flavonoid coloring agents such as morin, quercetin, and rutin, the polyhydroxy compounds described in JP1992-253058A (JP-H4-253058A), such as α,α',α"-tris(4-hydroxyphenyl) 1,3,5-triisopropylbenzene, α,α',α"-tris(3,5-dimethyl-4-hydroxyphenyl) 1,3, 5-triisopropylbenzene, α,α',α"-tris(3,5-diethyl-4-hydroxyphenyl) 1,3,5-triisopropylbenzene, α,α', α"-tris(3,5)-di-n-propyl-4-hydroxyphenyl) 1,3,5-triisopropylbenzene, α,α',α"-tris(3,5-diisopropyl-4-hydroxyphenyl) 1,3, 5-triisopropylbenzene, α,α',α"-tris(3,5-di-n-butyl-4-hydroxyphenyl) 1,3,5-triisopropylbenzene, α,α',α"-tris(3-methyl-4-hydroxyphenyl) 1,3, 5-triisopropylbenzene, α,α',α"-tris(3 -methoxy-4-hydroxyphenyl) 1,3, 5-triisopropylbenzene, α,α',α"-tris(2,4-dihydroxyphenyl) 1,3,5-triisopropylbenzene, 1,3, 5-tris(3, 5-dimethyl-4-hydroxyphenyl)benzene, 1,3,5-tris(5-methyl-2-hydroxyphenyl)benzene, 2,4,6-tris(3,5-dimethyl-4-hydroxyphenylthiomethyl)mesitylene, 1-[α-methyl-α-(4'-hydroxyphenyl))ethyl]-4-[α,α'-bis(4"-hydroxyphenyl)ethyl]benzene, 1-[α-methyl (4'-hydroxyphenyl)ethyl]-3-[α,α'-bis(4"-hydroxyphenyl)ethyl]benzene, 1-[α-methyl-α-(3',5'-dimethyl-4'-hydroxyphenyl)ethyl]-4-[α,α'-bis(3",5"-dimethyl-4"-hydroxy phenyl)ethyl]benzene, 1-[α-methyl(3'-methyl-4'-hydroxyphenyl)ethyl]-4-[α',α'-bis(3"-methyl-4"-hydroxyphenyl)ethyl ]benzene, 1-[α-methyl-α-(3'-methoxy-4'-hydroxyphenyl)ethyl]-4-[α',α'-bis(3"-methoxy-4"-hydroxypheny l)ethyl]benzene, 1-[α-methyl-α-(2',4'-dihydroxyphenyl)ethyl]-4-[α',α'-bis(4"-hydroxyphenyl)ethyl]benzene, and 1-[α-methyl(2',4'-dihydroxyphenyl)ethyl]-3-[α',α'-bis(4"-hydroxyphenyl)ethyl]benzene, the polyhydroxy compound described in JP1993-224410A (JP-H5-224410A), such as α,α,α',α',α",α"-hexakis-(4-hydroxyphenyl)-1,3,5-triethylbenzene, the poly(hydroxyphenyl) alkanes described in JP1993-303200A (JP-H5-303200A) and EP-530148, such as 1,2,2,3-tetra(p-hydroxyphenyl)propane and 1,3,3,5-tetra(p-hydroxyphenyl)pentane, p-bis(2,3,4-trihydroxybenzoyl)benzene, p-bis(2,4,6-trihydroxybenzoyl)benzene, m-bis(2,3,4-trihydroxybenzoyl)benzene, m-bis(2,4,6-trihydroxybenzoyl)benzene, p-bis(2,5-dihydroxy-3-brombenzoyl)benzene, p-bis(2,3,4-trihydroxy-5-methylbenzoyl)benzene, p-bis(2,3,4-trihydroxy-5-methoxybenzoyl)benzene, p-bis(2,3,4-trihydroxy-5-nitrobenzoyl)benzene, p-bis(2,3,4-trihydroxy-5-cyanobenzoyl)benzene, 1,3,5-tris(2,5-dihydroxybenzoyl)benzene, 1,3,5-tris(2,3,4-trihydroxybenzoyl)benzene, 1,2,3-tris(2,3,4-trihydroxybenzoyl)benzene, 1,2,4-tris(2,3,4-trihydroxybenzoyl)benzene, 1,2,4,5-tetrakis(2,3,4-trihydroxybenzoyl)benzene, $\alpha,\alpha'$-bis(2,3,4-trihydroxybenzoyl)-p-xylene, $\alpha,\alpha'\alpha'$-tris(2,3,4-trihydroxybenzoyl)mesitylene, 2,6-bis-(2-hydroxy-3,5-dimethylbenzyl)-p-cresol, 2,6-bis-(2-hydroxy-5'-methylbenzyl)-p-cresol, 2,6-bis-(2,4,6-trihydroxybenzyl)-p-cresol, 2,6-bis-(2,3,4-trihydroxybenzyl)-p-cresol, 2, 6-bis(2,3,4-trihydroxybenzyl)-3, 5-dimethyl-phenol, 4,6-bis-(4-hydroxy-3,5-dimethylbenzyl)-pyrogallol, 2,6-bis-(4-hydroxy-3,5-dimethylbenzyl)-1,3,4-trihydroxy-phenol, 4,6-bis-(2,4,6-trihydroxybenzyl)-2,4-dimethyl-phenol, 4,6-bis-(2,3,4-trihydroxybenzyl)-2,5-dimethyl-phenol, 2,6-bis-(4-hydroxybenzyl)-p-cresol, 2,6-bis(4-hydroxybenzyl)-4-cyclohexylphenol, 2,6-bis(4-hydroxy-3-methylbenzyl)-p-cresol, 2,6-bis(4-hydroxy-3,5-dimethylbenzyl)-p-cresol, 2,6-bis(4-hydroxy-2,5-dimethylbenzyl)-p-cresol, 2,6-bis(4-hydroxy-3-methylbenzyl)-4-phenylphenol, 2,2',6,6'-tetrakis[(4-hydroxyphenyl)methyl]-4,4'-methylenediphenol, 2,2',6,6'-tetrakis[(4-hydroxy-3,5-dimethylphenyl)methyl]-4,4'-methylenediphenol, 2,2',6,6'-tetrakis[(4-hydroxy-3-methylphenyl)methyl]-4,4'-methylenediphenol, 2,2'-bis[(4-hydroxy-3,5-dimethylphenyl)methyl] 6,6'-dimethyl-4,4'-methylenediphenol, 2,2',3,3'-tetrahydro-3,3,3',3'-tetramethyl-1,1'-spiro-bi(1H-indene)-5,5',6,6',7,7'-hexanol, and bis(4-hydroxy-3,5-dimethylphenyl)-(4-hydroxy-3-methoxyphenyl)methane.

In addition, a hyponuclear form of a phenol resin, such as a novolak resin, can also be used.

Examples of the naphthoquinone diazide sulfonic acid include 6-diazo 5,6-dihydro-5-oxo-1-naphthalenesulfonic acid and 1,2-naphthoquinone-(2)-diazo-5-sulfonic acid, where these may be mixedly used.

A production method for a naphthoquinone diazide sulfonic acid ester of a hydroxy compound is not particularly limited. However, it is obtained, for example, by converting naphthoquinone diazide sulfonic acid into a sulfonyl chloride with chlorosulfonic acid or thionyl chloride, and subjecting the obtained naphthoquinone diazide sulfonyl chloride to a condensation reaction with the hydroxy compound.

For example, it can be obtained by subjecting a hydroxy compound and a predetermined amount of naphthoquinone diazide sulfonyl chloride to a reaction in a solvent such as dioxane, acetone, or tetrahydrofuran, in the presence of a basic catalyst such as triethylamine to carry out esterification, washing the obtained product with water, and carrying out drying.

The esterification rate for the naphthoquinone diazide sulfonic acid ester is not particularly limited; however, it is preferably 10% or more, and more preferably 20% or more. The upper limit of the esterification rate is not particularly limited and may be 100%.

The esterification rate can be checked by $^1$H-NMR or the like as a proportion of the esterified groups among the hydroxy groups contained in the hydroxy compound.

[Coloring agent having changed absorbance upon exposure]

The coloring agent having a changed absorbance upon exposure is not particularly limited, and for example, a known photochromic material can be used. However, examples thereof include a leuco coloring agent, a diarylethene coloring agent, fulgides, spiroxazines, spiropirans, and an azobenzene-based compound.

Examples of the leuco coloring agent include leuco coloring agents which are triarylmethane-based (for example, triphenylmethane-based), spiropyran-based, fluoran-based, diphenylmethane-based, rhodamine lactam-based, indolyl phthalide-based, and leucoauramine-based. Among these, a triarylmethane-based leuco coloring agent is preferable.

In addition, the leuco coloring agent is preferably a leuco coloring agent which has a lactone ring, a sultine ring, or a sultone ring, and in which the absorbance changes by the ring opening or ring closure of the lactone ring, the sultine ring, or the sultone ring.

As the leuco coloring agent, a commercially available product may be used, examples of which include Victoria Pure Blue NAPS.

The diarylethene compound is, for example, preferably a diarylethene compound in which the absorbance changes by undergoing ring closure as described below. It is noted that the steric conformation in the following formula is an example, which is not limited thereto.

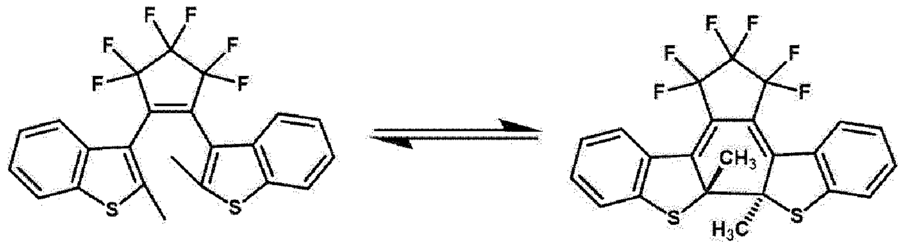

The diarylethene compound is not particularly limited, and a known compound can be used. However, examples thereof include the compounds described in paragraphs 0049 to 0056 of JP2004-91638A.

[Content]

The content of the compound A with respect to the total solid content of the negative-tone photosensitive resin composition in the first aspect according to the present invention is not particularly limited; however, it is preferably 0.1% to 20% by mass, more preferably 0.5% to 10% by mass, and still more preferably 1% to 5% by mass.

The content of the naphthoquinone diazide compound with respect to the total solid content of the negative-tone photosensitive resin composition in the second aspect according to the present invention is not particularly limited; however, it is preferably 0.1% to 20% by mass, more preferably 0.5% to 10% by mass, and still more preferably 1% to 5% by mass.

<Photopolymerization initiator>

The resin composition according to the embodiment of the present invention contains a photopolymerization initiator.

The photopolymerization initiator is preferably a photoradical polymerization initiator. The photoradical polymerization initiator is not particularly limited and can be appropriately selected from known photoradical polymerization initiators. For example, a photoradical polymerization initiator having photosensitivity to rays ranging from an ultraviolet ray range to a visible light range is preferable. In addition, the photoradical polymerization initiator may be an activator that produces an active radical by any action with a photo-excited sensitizing agent.

The photoradical polymerization initiator preferably contains at least one compound having a molar absorption coefficient of at least about 50 $L \cdot mol^{1} \cdot cm^{-1}$ within a range of a wavelength of about 240 to 800 nm (preferably 330 to 500 nm). The molar absorption coefficient of a compound can be measured using a well-known method. For example, it is preferable to carry out a measurement at a concentration of 0.01 g/L using an ethyl acetate solvent with an ultraviolet-visible spectrophotometer (Cary-5 spectrophotometer manufactured by Varian Medical Systems, Inc.).

As a photoradical polymerization initiator, well-known compounds can be optionally used. Examples thereof include a halogenated hydrocarbon derivative (for example, a compound having a triazine skeleton, a compound having an oxadiazole skeleton, or a compound having a trihalomethyl group), an acylphosphine compound such as an acylphosphine oxide, hexaarylbiimidazole, an oxime compound such as an oxime derivative, an organic peroxide, a thio compound, a ketone compound, an aromatic onium salt, a keto oxime ether, an $\alpha$-amino ketone compound such as aminoacetophenone, an $\alpha$-hydroxy ketone compound such as hydroxyacetophenone, an azo-based compound, an azide compound, a metallocene compound, an organic boron compound, and an iron arene complex. With regard to details thereof, reference can be made to the description of paragraphs 0165 to 0182 of JP2016-027357A and paragraphs 0138 to 0151 of WO2015/199219A, the contents of which are incorporated in the present specification. In addition, examples thereof include the compounds described in paragraphs 0065 to 0111 of JP2014-130173A and JP6301489B, the peroxide-based photopolymerization initiator described in MATERIAL STAGE 37 to 60 p, vol. 19, No. 3, 2019, the photopolymerization initiator described in WO2018/221177A, the photopolymerization initiator described in WO2018/110179A, the photopolymerization initiator described in JP2019-043864A, the photopolymerization initiator described in JP2019-044030A, and the peroxide-based initiator described in JP2019-167313AA, the contents of which are also incorporated in the present specification.

Examples of the ketone compound include compounds described in paragraph 0087 of JP2015-087611A, the content of which is incorporated in the present specification. As a commercially available product thereof, KAYACURE DETX-S (manufactured by Nippon Kayaku Co., Ltd.) is also suitably used.

In one embodimen of the present invention, a hydroxyacetophenone compound, an aminoacetophenone compound, and an acylphosphine compound can be suitably used as the photoradical polymerization initiator. More specifically, for example, the aminoacetophenone-based initiator described in JP1998-291969A (JP-H10-291969A) and the acylphosphine oxide-based initiator described in JP4225898B can be used, the contents of which are incorporated in

the present specification.

As the α-hydroxy ketone-based initiator, Omnirad 184, Omnirad 1173, Omnirad 2959, Omnirad 127 (all of which manufactured by IGM Resins B.V.), IRGACURE 184 (IRGACURE is a registered trade name), DAROCUR 1173, IRGACURE 500, and IRGACURE-2959, and IRGACURE 127 (product names: all of which manufactured by BASF) can be used.

As the α-amino ketone-based initiator, Omnirad 907, Omnirad 369, Omnirad 369E, Omnirad 379EG (all of which are manufactured by IGM Resins B.V), IRGACURE 907, IRGACURE 369, and IRGACURE 379 (product names: all of which are manufactured by BASF SE) can be used.

As the aminoacetophenone-based initiator, the compound described in JP2009-191179A, a maximal absorption wavelength of which is matched to a light source having a wavelength such as 365 nm or 405 nm, can also be used, the content of which is incorporated in the present specification.

Examples of the acylphosphine oxide-based initiator include 2,4,6-trimethylbenzoyl-diphenyl-phosphine oxide. In addition, Omnirad 819 and Omnirad TPO (all of which are manufactured by IGM Resins B.V.), IRGACURE-819, and IRGACURE-TPO (product names: all of which are manufactured by BASF SE) can be used.

Examples of the metallocene compound include IRGACURE-784 and IRGACURE-784EG (all of which are manufactured by BASF), and Keycure VIS 813 (manufactured by King Brother Chem Co., Ltd.).

Examples of the more preferred photoradical polymerization initiator include an oxime compound. In a case where an oxime compound is used, exposure latitude can be more effectively improved. The oxime compound is particularly preferable since the oxime compound has a wide exposure latitude (a wide exposure margin) and also works as a photocuring accelerator.

Specific examples of the oxime compound include the compounds described in JP2001-233842A, the compounds described in JP2000-080068A, the compounds described in JP2006-342166A, the compounds described in J. C. S. Perkin II (1979, pp. 1653-1660), the compounds described in J. C. S. Perkin II (1979, pp. 156-162), the compounds described in Journal of Photopolymer Science and Technology (1995, pp. 202-232), the compounds described in JP2000-066385A, the compounds described in JP2004-534797A, the compounds described in JP2017-019766A, the compounds described in JP6065596B, the compounds described in WO2015/152153A, the compounds described in WO2017/051680A, the compounds described in JP2017-198865A, the compounds described in paragraph Nos. 0025 to 0038 of WO2017/164127A, and the compounds described in WO2013/167515A, the content of which is incorporated in the present specification.

Examples of the preferred oxime compound include compounds having the following structures, 3-(benzoyloxy(imino))butan-2-one, 3-(acetoxy(imino))butan-2-one, 3-(propionyloxy(imino))butan-2-one, 2-(acetoxy(imino))pentan-3-one, 2-(acetoxy(imino))-1-phenylpropan-1-one, 2-(benzoyloxy(imino))-1-phenylpropan-1-one, 3-((4-toluenesulfonyloxy)(imino))butan-2-one, and 2-(ethoxycarbonyloxy(imino))-1-phenylpropan-1-one. In the resin composition according to the embodiment of the present invention, it is particularly preferable to use an oxime compound (an oxime-based photoradical polymerization initiator) as the photoradical polymerization initiator. The oxime-based photoradical polymerization initiator has a linking group of >C=N-O-C(=O)- in the molecule.

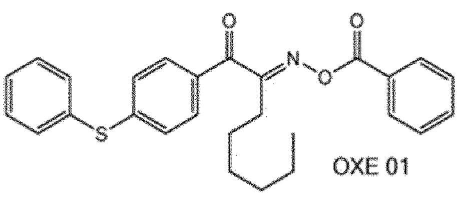
OXE 01

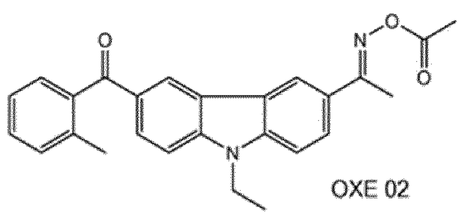
OXE 02

As commercially available products, IRGACURE OXE 01, IRGACURE OXE 02, IRGACURE OXE 03, IRGACURE OXE 04 (all of which are manufactured by BASF SE), ADEKA OPTOMERN-1919 (manufactured by ADEKA Corporation, the photoradical polymerization initiator 2 disclosed in JP2012-014052A) are also suitably used. In addition, TR-PBG-304 and TR-PBG-305 (manufactured by Changzhou Tronly New Electronic Materials Co., Ltd.), ADEKA ARKLS NCI-730, NCI-831, and ADEKA ARKLS NCI-930 (manufactured by ADEKA Corporation) can also be used. In addition, DFI-091 (manufactured by DAITO CHEMIX Co., Ltd.) and SpeedCure PDO (manufactured by SARTOMER ARKEMA) can be used. In addition, oxime compounds having the following structures can also be used.

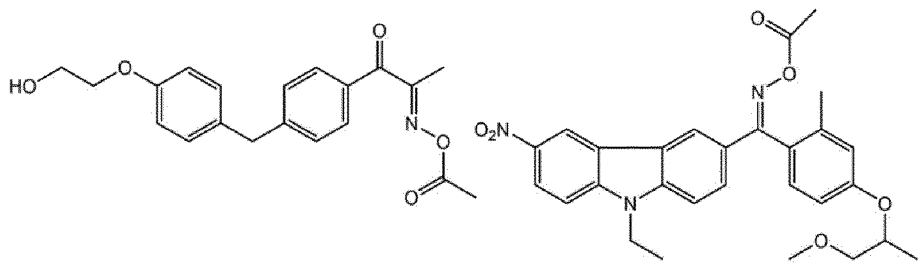

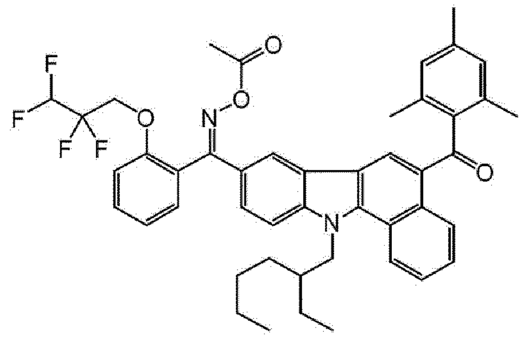

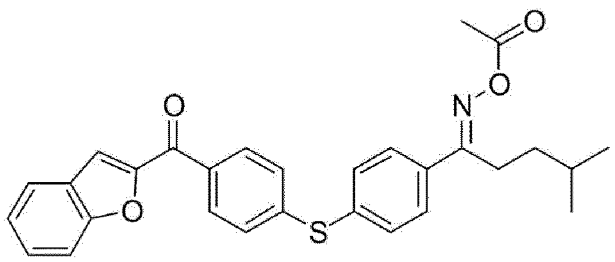

As the photoradical polymerization initiator, an oxime compound having a fluorene ring can also be used. Specific examples of the oxime compound having a fluorene ring include the compound described in JP2014-137466A and the compound disclosed in JP06636081B, the content of which is incorporated in the present specification.

As the photoradical polymerization initiator, an oxime compound having a skeleton in which at least one benzene ring of the carbazole ring is a naphthalene ring can also be used. Specific examples of such an oxime compound include the compound described in WO2013/083505A, the content of which is incorporated in the present specification.

It is also possible to use an oxime compound having a fluorine atom. Specific examples of such oxime compounds include the compounds described in JP2010-262028A, compounds 24, and 36 to 40 described in paragraph 0345 of JP2014-500852A, and a compound (C-3) described in paragraph 0101 of JP2013-164471A, the contents of which are incorporated in the present specification.

An oxime compound having a nitro group can be used as the photopolymerization initiator. It is also preferable that the oxime compound having a nitro group is a dimer. Specific examples of the oxime compound having a nitro group include the compounds described in paragraph Nos. 0031 to 0047 of JP2013-114249A and paragraph Nos. 0008 to 0012 and 0070 to 0079 of JP2014-137466A, the compounds described in paragraph Nos. 0007 to 0025 of JP4223071B, the contents of which are incorporated in the present specification. In addition, examples of the oxime compound having a nitro group include ADEKA ARKLS NCI-831 (manufactured by ADEKA Corporation).

As the photoradical polymerization initiator, an oxime compound having a benzofuran skeleton can also be used. Specific examples thereof include OE-01 to OE-75 described in WO2015/036910A.

As the photoradical polymerization initiator, an oxime compound in which a substituent having a hydroxy group is bonded to a carbazole skeleton can also be used. Examples of such a photopolymerization initiator include the compound described in WO2019/088055A, the content of which is incorporated in the present specification.

As the photopolymerization initiator, an oxime compound having an aromatic ring group $Ar^{OX1}$ in which an electron withdrawing group is introduced into an aromatic ring (hereinafter, also referred to as an oxime compound OX) can also be used. Examples of the electron withdrawing group contained in the aromatic ring group $Ar^{OX1}$ include an acyl group, a nitro group, a trifluoromethyl group, an alkylsulfinyl group, an arylsulfinyl group, an alkylsulfonyl group, an arylsulfonyl group, and a cyano group. Here, an acyl group or a nitro group is preferable, and due to the reason that a

film having excellent light resistance is easily formed, an acyl group is more preferable, and a benzoyl group is still more preferable. The benzoyl group may have a substituent. The substituent is preferably a halogen atom, a cyano group, a nitro group, a hydroxy group, an alkyl group, an alkoxy group, an aryl group, an aryloxy group, a heterocyclic group, a heterocyclic oxy group, an alkenyl group, an alkylsulfanyl group, an arylsulfanyl group, an acyl group, or an amino group, more preferably an alkyl group, an alkoxy group, an aryl group, an aryloxy group, a heterocyclic oxy group, an alkylsulfanyl group, an arylsulfanyl group, or an amino group, and still more preferably an alkoxy group, an alkylsulfanyl group, or an amino group.

The oxime compound OX is preferably at least one selected from a compound represented by Formula (OX1) or a compound represented by Formula (OX2), and more preferably a compound represented by Formula (OX2).

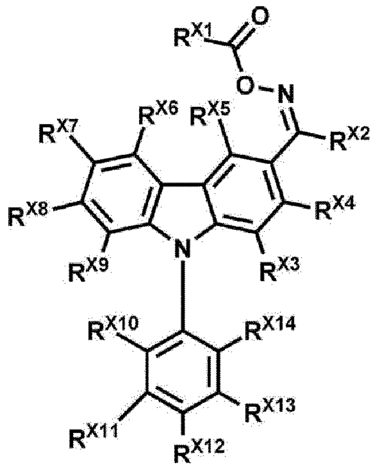

(OX1)

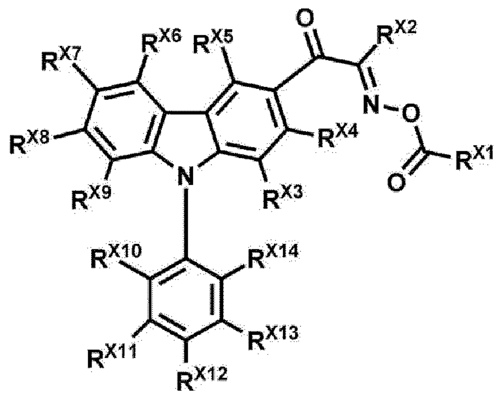

(OX2)

In the formulae, $R^{X1}$ represents an alkyl group, an alkenyl group, an alkoxy group, an aryl group, an aryloxy group, a heterocyclic group, a heterocyclic oxy group, an alkylsulfanyl group, an arylsulfanyl group, an alkylsulfinyl group, an arylsulfinyl group, an alkylsulfonyl group, an arylsulfonyl group, an acyl group, an acyloxy group, an amino group, a phosphinoyl group, a carbamoyl group, or a sulfamoyl group,

$R^{X2}$ represents an alkyl group, an alkenyl group, an alkoxy group, an aryl group, an aryloxy group, a heterocyclic group, or a heterocyclic oxy group, an alkylsulfanyl group, an arylsulfanyl group, an alkylsulfinyl group, an arylsulfinyl group, an alkylsulfonyl group, an arylsulfonyl group, an acyloxy group, or an amino group, and
$R^{X3}$ to $R^{X14}$ each independently represent a hydrogen atom or a substituent.

However, at least one of $R^{X10}$, ..., or $R^{X14}$ is an electron withdrawing group.

In the above formulae, it is preferable that $R^{X12}$ is an electron withdrawing group, and $R^{X10}$, $R^{X11}$, $R^{X13}$, and $R^{X14}$ are a hydrogen atom.

Specific examples of the oxime compound OX include the compounds described in paragraph Nos. 0083 to 0105 of JP4600600B, the content of which is incorporated in the present specification.

Examples of the most preferred oxime compound include the oxime compound having a specific substituent described in JP2007-269779A and the oxime compound having a thioaryl group described in JP2009-191061A, the contents of which are incorporated in the present specification.

From the viewpoint of exposure sensitivity, the photoradical polymerization initiator is preferably a compound selected from the group consisting of a trihalomethyltriazine compound, a benzyl dimethyl ketal compound, an α-hydroxy ketone compound, an α-amino ketone compound, an acylphosphine compound, a phosphine oxide compound, a metallocene compound, an oxime compound, a triaryl imidazole dimer, an onium salt compound, a benzothiazole compound, a benzophenone compound, an acetophenone compound and a derivative thereof, a cyclopentadiene-benzene-iron complex and a salt thereof, a halomethyl oxadiazole compound, and a 3-aryl substituted coumarin compound.

The photoradical polymerization initiator is more preferably a trihalomethyltriazine compound, an α-amino ketone compound, an acylphosphine compound, a phosphine oxide compound, a metallocene compound, an oxime compound, a triaryl imidazole dimer, an onium salt compound, a benzophenone compound, or an acetophenone compound, still more preferably at least one compound selected from the group consisting of a trihalomethyltriazine compound, an α-amino ketone compound, a metallocene compound, an oxime compound, a triaryl imidazole dimer, and a

benzophenone compound. A metallocene compound or an oxime compound is still more preferably used.

In addition, as the photoradical polymerization initiator, it is possible to use benzophenone, an N,N'-tetraalkyl-4,4'-diaminobenzophenone such as N,N'-tetramethyl-4,4'-diaminobenzophenone (Michler's ketone), an aromatic ketone such as 2-benzyl-2-dimethylamino-1-(4-morpholinophenyl)-butanone-1,2-methyl-1-[4-(methylthio)ph enyl]-2-morpholino-propanone-1, quinones fused with an aromatic ring such as an alkylanthraquinone, a benzoin ether compound such as a benzoin alkyl ether, a benzoin compound such as benzoin or an alkyl benzoin, a benzyl derivative such as benzyl dimethyl ketal, or the like. In addition, a compound represented by Formula (I) may also be used.

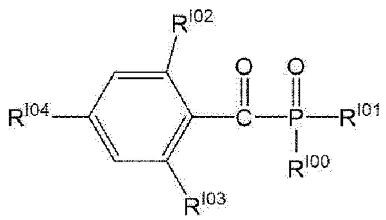
(I)

In Formula (I), $R^{I00}$ represents an alkyl group having 1 to 20 carbon atoms, an alkyl group having 2 to 20 carbon atoms, which is interrupted by one or more oxygen atoms, an alkoxy group having 1 to 12 carbon atoms, a phenyl group, or a phenyl group substituted with at least one of an alkyl group having 1 to 20 carbon atoms, an alkoxy group having 1 to 12 carbon atoms, a halogen atom, a cyclopentyl group, a cyclohexyl group, an alkenyl group having 2 to 12 carbon atoms, an alkyl group having 2 to 18 carbon atoms, which is interrupted by one or more oxygen atoms, or an alkyl group having 1 to 4 carbon atoms, or a biphenyl group, $R^{I01}$ is a group represented by Formula (II) or a group which is the same as $R^{I00}$, and $R^{I02}$ to $R^{I04}$ each independently represent an alkyl group having 1 to 12 carbon atoms, an alkoxy group having 1 to 12 carbon atoms, or a halogen atom.

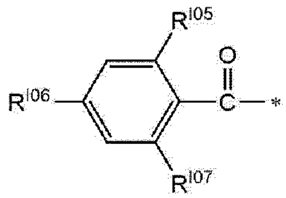
(II)

In the formula, $R^{I05}$ to $R^{I07}$ are respectively the same as $R^{I02}$ to $R^{I04}$ in Formula (I).

In addition, as the photoradical polymerization initiator, the compounds described in paragraphs 0048 to 0055 of WO2015/125469A can also be used, the content of which is incorporated in the present specification.

As the photoradical polymerization initiator, a photoradical polymerization initiator which is difunctional or trifunctional or higher functional may be used. In a case where such a photoradical polymerization initiator is used, two or more radicals are generated from one molecule of the photoradical polymerization initiator, and thus good sensitivity is obtained. Further, in a case where a compound having an asymmetric structure is used, the crystallinity is reduced, the solubility in a solvent or the like is improved, and the compound is hardly precipitated over time, and the temporal stability of the resin composition can be improved. Specific examples of the photoradical polymerization initiator which is difunctional or trifunctional or higher functional include dimers of the oxime compounds described in JP2010-527339A, JP2011-524436A, WO2015/004565A, paragraph Nos. 0407 to 0412 of JP2016-532675A, and paragraph Nos. 0039 to 0055 of WO2017/033680A, the compound (E) and compound (G) described in JP2013-522445A, Cmpd 1 to 7 described in WO2016/034963A; the oxime ester photoinitiators described in paragraph No. 0007 of JP2017-523465A, the photoinitiators described in paragraph Nos. 0020 to 0033 of JP2017-167399A, the photopolymerization initiator (A) described in paragraph Nos. 0017 to 0026 of JP2017-151342A, the oxime ester photoinitiator described in JP6469669B, the contents of which are incorporated in the present specification.

In a case where a photopolymerization initiator is contained, the content thereof is preferably 0.1% to 30% by mass, more preferably 0.1% to 20% by mass, still more preferably 0.5% to 15% by mass, and still more preferably 1.0% to 10% by mass, with respect to the total solid content of the resin composition according to the embodiment of the present invention. Only one kind of photopolymerization initiator may be contained, or two or more kinds thereof may be contained. In a case where two or more kinds of photopolymerization initiators are contained, the total amount thereof is preferably within the above-described range.

Since the photopolymerization initiator may also function as a thermal polymerization initiator, crosslinking with the photopolymerization initiator may be further promoted by heating an oven, a hot plate, or the like.

[Sensitizing agent]

The resin composition may contain a sensitizing agent. The sensitizing agent absorbs a specific radioactive ray to be in an electronically excited state. The sensitizing agent in the electronically excited state is brought into contact with a thermal radical polymerization initiator, a photoradical polymerization initiator, or the like, to cause actions such as electron migration, energy transfer, and heat generation. As a result, the thermal radical polymerization initiator the photoradical polymerization initiator undergoes a chemical change and decomposes to generate a radical, an acid, or a base.

In addition, as a usable sensitizing agent, a benzophenone-based, a Michler's ketone-based, a coumarin-based, a pyrazole azo-based, an anilino azo-based, a triphenylmethane-based, an anthraquinone-based, an anthracene-based, an anthrapylidene-based, a benzylidene-based, an oxonol-based, a pyrazolotriazole azo-based, a pyridone azo-based, a cyanine-based, a phenothiazine-based, a pyrrolopyrazole azomethine-based, a xanthene-based, a phthalocyanine-based, a benzopyran-based, and an indigo-based compound can be used.

Examples of the sensitizing agent include, Michler's ketone, 4,4'-bis(diethylamino)benzophenone, 2,5-bis(4'-diethylaminobenzal)cyclopentane, 2,6-bis(4'-diethylaminobenzal)cyclohexanone, 2,6-bis(4'-diethylaminobenzal)-4-methylcyclohexanone, 4,4'-bis(dimethylamino)chalcone, 4,4'-bis(diethylamino)chalcone, p-dimethylaminocinnamylidene indanone, p-dimethylamino benzylidene indanone, 2-(p-dimethylaminophenylbiphenylene)-benzothiazole, 2-(p-dimethylaminophenylvinylene)benzothiazole, 2-(p-dimethylaminophenylvinylene)isonaphtothiazole, 1,3-bis(4'-dimethylaminobenzal)acetone, 1,3-bis(4'-diethylaminobenzal)acetone, 3,3'-carbonyl-bis(7-diethylaminocoumarin), 3-acetyl-7-dimethylaminocoumarin, 3-ethoxycarbonyl-7-dimethylaminocoumarin, 3-benzyloxycarbonyl-7-dimethylaminocoumarin, 3-methoxycarbonyl-7-diethylaminocoumarin, 3-ethoxycarbonyl-7-diethylaminocoumarin (ethyl 7-(diethylamino)coumarin-3-carboxylate), N-phenyl-N'-ethylethanolamine, N-phenyldiethanolamine, N-p-tolyldiethanolamine, N-phenylethanolamine, 4-morpholinobenzophenone, isoamyl dimethylaminobenzoate, isoamyl diethylaminobenzoate, 2-mercaptobenzimidazole, 1-phenyl-5-mercaptotetrazole, 2-mercaptobenzothiazole, 2-(p-dimethylaminostyryl)benzoxazole, 2-(p-dimethylaminostyryl)benzothiazole, 2-(p-dimethylaminostyryl)naphtho (1,2-d)thiazole, 2-(p-dimethylaminobenzoyl)styrene, diphenylacetamide, benzanilide, N-methylacetanilide, and 3',4'-dimethylacetanilide.

In addition, other sensitizing coloring agents may be used.

For details of the sensitizing coloring agent, reference can be made to the description in paragraphs 0161 to 0163 of JP2016-027357A, the content of which is incorporated in the present specification.

In a case where the resin composition contains a sensitizing agent, the content of the sensitizing agent is preferably 0.01% to 20% by mass, more preferably 0.1% to 15% by mass, and still more preferably 0.5% to 10% by mass, with respect to the total solid content of the resin composition. One kind of sensitizing agent may be used alone, or two or more kinds thereof may be used in combination.

[Chain transfer agent]

The resin composition according to the embodiment of the present invention may contain a chain transfer agent. The chain transfer agent is defined, for example, in Polymer Dictionary, 3rd Edition, pp. 683 to 684 (edited by The Society of Polymer Science, 2005). As the chain transfer agent, for example, the following compound is used; a group of compounds having -S-S-, $-SO_2-S-$, -N-O-, SH, PH, SiH, or GeH in the molecule, or a dithiobenzoate compound, a trithiocarbonate compound, dithiocarbamate, or a xanthate compound, which has a thiocarbonylthio group that is used for the reversible addition fragmentation chain transfer (RAFT) polymerization. These can donate hydrogen to a low active radical to generate a radical or can be oxidized and then deprotonated to generate a radical. In particular, a thiol compound can be preferably used.

In addition, as the chain transfer agent, the compounds described in paragraphs 0152 and 0153 of WO2015/199219A can also be used, the content of which is incorporated in the present specification.

In a case where the resin composition according to the embodiment of the present invention has a chain transfer agent, the content of the chain transfer agent is preferably 0.01 to 20 parts by mass, more preferably 0.1 to 10 parts by mass, and still more preferably 0.5 to 5 parts by mass, with respect to 100 parts by mass of the total solid content of the resin composition according to the embodiment of the present invention. One kind of chain transfer agent may be used, or two or more kinds thereof may be used. In a case where two or more kinds of chain transfer agents are used, the total thereof is preferably within the above-described range.

<Nitrogen-containing cyclic compound>

In a case where the resin composition according to the embodiment of the present invention satisfies the condition i, the resin composition according to the embodiment of the present invention further contains a nitrogen-containing cyclic compound as a component different from the resin, the compound A, and the photopolymerization

initiator.

In a case where the resin composition according to the embodiment of the present invention satisfies the condition iii, the resin composition according to the embodiment of the present invention further contains a nitrogen-containing cyclic compound as a component different from the resin, the naphthoquinone diazide compound, and the photopolymerization initiator.

In a case where the resin composition according to the embodiment of the present invention satisfies the condition ii or the condition iv, the resin composition according to the embodiment of the present invention may further contain a nitrogen-containing cyclic compound.

The nitrogen-containing cyclic compound is a compound having a ring structure containing a nitrogen atom as a ring member. The ring structure may be an aliphatic ring structure or may be an aromatic ring structure; however, it is preferably an aromatic ring structure.

In addition, the nitrogen-containing cyclic compound may be any compound having a ring structure containing one or more nitrogen atoms as ring members; however, it is preferably a compound having a ring structure containing two or more nitrogen atoms as ring members.

The ring structure containing a nitrogen atom as a ring member is not particularly limited. However, examples thereof include a pyrrole ring, a furan ring, a thiophene ring, an imidazole ring, an oxazole ring, a thiazole ring, a pyrazole ring, an isoxazole ring, an isothiazole ring, a tetrazole ring, a pyridine ring, a pyridazine ring, a pyrimidine ring, a pyrazine ring, a piperidine ring, a piperazine ring, a morpholine ring, a 2H-pyran ring and a 6H-pyran ring, a triazine ring, and an isocyanurate ring.

These ring structures may form a multicyclic ring with another ring structure. Examples thereof include an aspect in which a fused ring is formed with a ring structure such as a benzene ring, such as a benzimidazole structure or a benzotriazole structure.

Among these, it is possible to preferably use a compound having a triazole structure such as 1,2,4-triazole, benzotriazole, 3-amino-1,2,4-triazole, or 3,5-diamino-1,2,4-triazole, or a tetrazole structure such as 1H-tetrazole, 5-phenyltetrazole or 5-amino-tetrazole.

Specific examples of the nitrogen-containing cyclic compound include the following compounds, which are not limited thereto.

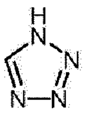

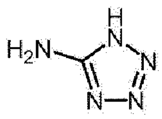

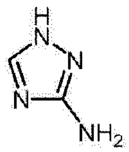

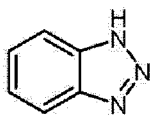

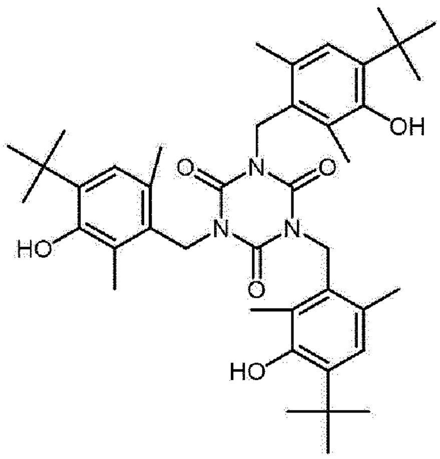

The molecular weight of the nitrogen-containing cyclic compound is preferably 60 to 1000, and more preferably 70 to 700.

In a case where the resin composition according to the embodiment of the present invention has a nitrogen-containing cyclic compound, the content of the nitrogen-containing cyclic compound is preferably 0.01% to 5.0% by mass, more preferably 0.05% to 2.0% by mass, and still more preferably 0.1% to 1.0% by mass, with respect to the total solid content of the resin composition according to the embodiment of the present invention.

In a case where the content of the compound A in the resin composition in the first aspect according to the present invention is set to 100 parts by mass, the content of the nitrogen-containing cyclic compound is preferably 0.5

to 200 parts by mass, more preferably 0.8 to 100 parts by mass, and still more preferably 0.1 to 40 parts by mass.

In a case where the content of the naphthoquinone diazide compound in the resin composition in the second aspect according to the present invention is set to 100 parts by mass, the content of the nitrogen-containing cyclic compound is preferably 0.5 to 200 parts by mass, more preferably 0.8 to 100 parts by mass, and still more preferably 0.1 to 40 parts by mass.

The resin composition according to the embodiment of the present invention may contain only one kind of nitrogen-containing cyclic compound or may contain two or more kinds thereof. In a case where two or more kinds of nitrogen-containing cyclic compounds are contained, the total amount thereof is preferably in the above range.

<Polymerizable compound>

The resin composition according to the embodiment of the present invention preferably contains a polymerizable compound.

Examples of the polymerizable compound include a radical crosslinking agent and another crosslinking agent. It is noted that although cyclic compounds containing nitrogen are present in the polymerizable compounds exemplified below, these shall not be included in the above-described "nitrogen-containing cyclic compound".

[Radical crosslinking agent]

The resin composition according to the embodiment of the present invention preferably contains a radical crosslinking agent.

The radical crosslinking agent is a compound having a radically polymerizable group. The radically polymerizable group is preferably a group containing an ethylenically unsaturated bond. Examples of the group containing the ethylenically unsaturated bond include groups having an ethylenically unsaturated bond, such as a vinyl group, an allyl group, a vinylphenyl group, a (meth)acryloyl group, a maleimide group, and a (meth)acrylamide group.

Among these, the group containing an ethylenically unsaturated bond is preferably a (meth)acryloyl group, a (meth)acrylamide group, or a vinylphenyl group, and more preferably a (meth)acryloyl group from the viewpoint of reactivity.

The radical crosslinking agent is preferably a compound having one or more ethylenically unsaturated bonds; however, a compound having two or more ethylenically unsaturated bonds is more preferable. The radical crosslinking agent may have three or more ethylenically unsaturated bonds.

The compound having 2 or more ethylenically unsaturated bonds is preferably a compound having 2 to 15 ethylenically unsaturated bonds, more preferably a compound having 2 to 10 ethylenically unsaturated bonds, and still more preferably a compound having 2 to 6 ethylenically unsaturated bonds.

In addition, from the viewpoint of the film hardness of the pattern (cured substance) to be obtained, the photocurable resin composition according to the embodiment of the present invention preferably contains a compound having two ethylenically unsaturated bonds and a compound having three or more ethylenically unsaturated bonds.

The molecular weight of the radical crosslinking agent is preferably 2,000 or less, more preferably 1,500 or less, and still more preferably 900 or less. The lower limit of the molecular weight of the radical crosslinking agent is preferably 100 or more.

Specific examples of the radical crosslinking agent include unsaturated carboxylic acids (for example, acrylic acid, methacrylic acid, itaconic acid, crotonic acid, isocrotonic acid, and maleic acid), and esters and amides thereof, where esters between unsaturated carboxylic acids and polyhydric alcohol compounds or amides between unsaturated carboxylic acids and polyvalent amine compounds are preferable. In addition, addition reaction products produced by reacting unsaturated carboxylic acid esters or amides, having a nucleophilic substituent such as a hydroxy group, an amino group, or a sulfanyl group, with monofunctional or polyfunctional isocyanates or epoxies, dehydration condensation reaction products produced by reacting the above esters or amides with a monofunctional or polyfunctional carboxylic acid, or the like are also suitably used. In addition, an addition reaction product produced by reacting unsaturated carboxylic acid esters or amides, having an electrophilic substituent such as an isocyanate group or an epoxy group, with monofunctional or polyfunctional alcohols, amines, or thiols, and further, a substitution reaction product produced by reacting unsaturated carboxylic acid esters or amides, having an eliminable substituent such as a halogeno group or a tosyloxy group, with monofunctional or polyfunctional alcohols, amines, or thiols is also suitable. In addition, as other examples, it is also possible to use a group of compounds in which the unsaturated carboxylic acid described above is replaced with an unsaturated phosphonic acid, a vinylbenzene derivative such as styrene, a vinyl ether, an allyl ether, or the like. Regarding the specific examples thereof, reference can be made to the description of paragraphs 0113 to 0122 of JP2016-027357A, the content of which is incorporated in the present specification.

In addition, the radical crosslinking agent is also preferably a compound having a boiling point of 100°C or higher under atmospheric pressure. Examples thereof include a compound obtained by adding ethylene oxide or propylene oxide to a polyfunctional alcohol such as polyethylene glycol di(meth)acrylate, trimethylolethane tri(meth)acrylate, neopentyl glycol di(meth)acrylate, pentaerythritol tri(meth)acrylate, pentaerythritol tetra(meth)acrylate, dipentaerythritol penta(meth)acrylate, dipentaerythritol hexa(meth)acrylate, hexanediol di(meth)acrylate, trimethylolpropane tri(acryloyloxypropyl)ether, tri(acryloyloxyethyl)isocyanurate, glycerin, and trimethylolethane, and then being subjected to (meth)acrylation, urethane (meth)acrylates respectively described in JP1973-041708B (JP-S48-041708B), JP1975-006034B (JP-S50-006034B), and JP1976-037193A (JP-S51-037193A), polyester acrylates respectively described in JP1973-064183A (JP-S48-064183A), JP1974-043191B (JP-S49-043191B), and JP1977-030490B (JP-S52-030490B), polyfunctional acrylates or methacrylates such as epoxy acrylates which are reaction products of epoxy resins and (meth)acrylic acid, and mixtures thereof. In addition, the compounds described in paragraphs 0254 to 0257 of JP2008-292970A are also suitable. Further, the polyfunctional (meth)acrylate or the like obtained by reacting a compound having a cyclic ether group with an ethylenically unsaturated bond, such as glycidyl (meth)acrylate, with polyfunctional carboxylic acid can also be mentioned.

In addition, as the preferred radical crosslinking agent other than those described above, a compound having two or more groups containing a fluorene ring and an ethylenically unsaturated bond and a cardo resin, which are described in JP2010-160418A, JP2010-129825A, and JP4364216B, can also be used.

Further, other examples thereof include the specific unsaturated compounds described in JP1971-043946B (JP-S46-043946B), JP1989-040337B (JP-H01-040337B), and JP1989-040336B (JP-H01-040336B), and the vinylphosphonic acid-based compound described in JP1990-025493A (JP-H02-025493A). In addition, the compounds containing a perfluoroalkyl group described in JP1986-022048A (JP-S61-022048A) can also be used. Furthermore, photopolymerizable monomers and oligomers which are described in Journal of the Adhesion Society of Japan, Vol. 20, No. 7, pages 300 to 308 (1984) can also be used.

In addition to the above, the compounds described in paragraphs 0048 to 0051 of JP2015-034964A and the compounds described in paragraphs 0087 to 0131 of WO2015/199219A can also be preferably used, the contents of which are incorporated in the present specification.

In addition, the compounds which are represented as Formula (1) and Formula (2) in JP1998-062986A (JP-H10-062986A), described together with the specific examples thereof, which are obtained by adding ethylene oxide or propylene oxide to a polyfunctional alcohol and then being subjected to (meth)acrylation can be used as a radical crosslinking agent.

Further, the compounds described in paragraphs 0104 to 0131 of JP2015-187211A can also be used as the radical crosslinking agent, the content of which is incorporated in the present specification.

As the radical crosslinking agent, dipentaerythritol triacrylate (as a commercially available product, KAYARAD D-330 (manufactured by Nippon Kayaku Co., Ltd.), dipentaerythritol tetraacrylate (as a commercially available product, KAYARAD D-320 (manufactured by Nippon Kayaku Co., Ltd.), A-TMMT (manufactured by Shin-Nakamura Chemical Co., Ltd.), dipentaerythritol penta(meth)acrylate (as a commercially available product, KAYARAD D-310 (manufactured by Nippon Kayaku Co., Ltd.), dipentaerythritol hexa(meth)acrylate (as a commercially available product, KAYARAD DPHA (manufactured by Nippon Kayaku Co., Ltd.), A-DPH (manufactured by Shin-Nakamura Chemical Co., Ltd.), or a structure in which a (meth)acryloyl group thereof is bonded through an ethylene glycol residue or a propylene glycol residue is preferable. Oligomer types thereof can also be used.

Examples of the commercially available product of the radical crosslinking agent include SR-494 which is a tetrafunctional acrylate having four ethyleneoxy chains, manufactured by Sartomer Company Inc., SR-209, 231, and 239 which are a difunctional methacrylate having four ethyleneoxy chains, manufactured by Sartomer Company Inc., DPCA-60 which is a hexafunctional acrylate having six pentyleneoxy chains, manufactured by Nippon Kayaku Co., Ltd., TPA-330 which is a trifunctional acrylate having three isobutylene oxy chains, a urethane oligomer UAS-10, UAB-140 (manufactured by Nippon Paper Industries Co., Ltd.), NK Ester M-40G, NK Ester 4G, NK Ester M-9300, NK Ester A-9300, UA-7200 (manufactured by Shin-Nakamura Chemical Co., Ltd.), DPHA-40H (manufactured by Nippon Kayaku Co., Ltd.), UA-306H, UA-306T, UA-306I, AH-600, T-600, AI-600 (all of which are manufactured by KYOEISHA CHEMICAL Co., Ltd.), and Brenmer PME400 (manufactured by NOF Corporation).

As the radical crosslinking agent, the urethane acrylates as described in JP1973-041708B (JP-S48-041708B), JP1976-037193A (JP-S51-037193A), JP1990-032293B (JP-H02-032293B), and JP1990-016765B (JP-H02-016765B), and the urethane compounds having an ethylene oxide-based skeleton described in JP1983-049860B (JP-S58-049860B), JP1981-017654B (JP-S56-017654B), JP1987-039417B (JP-S62-039417B), and JP1987-039418B (JP-S62-039418B) are also suitable. Further, as the radical crosslinking agent, the compounds having an amino structure or a sulfide structure in a molecule as described in JP1988-277653A (JP-S63-277653A), JP1988-260909A (JP-S63-260909A), and JP1989-105238A (JP-H01-105238A) can also be used.

The radical crosslinking agent may be a radical crosslinking agent having an acid group such as a carboxy group or a phosphoric acid group. The radical crosslinking agent having an acid group is preferably an ester between an aliphatic polyhydroxy compound and an unsaturated carboxylic acid and more preferably a radical crosslinking agent obtained by reacting an unreacted hydroxy group of an aliphatic polyhydroxy compound with a non-aromatic carboxylic

acid anhydride to have an acid group. The radical crosslinking agent is particularly preferably a compound in which an aliphatic polyhydroxy compound is pentaerythritol or dipentaerythritol in a radical crosslinking agent having an acid group obtained by reacting an unreacted hydroxy group of the aliphatic polyhydroxy compound with a non-aromatic carboxylic acid anhydride. Examples of the commercially available product thereof include M-510 and M-520 as polybasic acid-modified acrylic oligomers which are manufactured by Toagosei Co., Ltd.

The acid value of the radical crosslinking agent having an acid group is preferably 0.1 to 300 mgKOH/g, and particularly preferably 1 to 100 mgKOH/g. In a case where the acid value of the radical crosslinking agent is within the above-described range, excellent manufacturing handleability is exhibited, and furthermore, excellent developability is exhibited. In addition, good polymerization properties are exhibited. The acid value is measured according to the description of JIS K 0070: 1992.

In the resin composition, it is preferable to use difunctional methacrylate or acrylate from the viewpoint of pattern resolution and film elasticity.

As the specific compound, the following compound can be used; triethylene glycol diacrylate, triethylene glycol dimethacrylate, tetraethylene glycol dimethacrylate, tetraethylene glycol diacrylate, and polyethylene glycol (PEG) 200 diacrylate, PEG 200 dimethacrylate, PEG 600 diacrylate, PEG 600 dimethacrylate, polytetraethylene glycol diacrylate, polytetraethylene glycol dimethacrylate, neopentyl glycol diacrylate, neopentyl glycol dimethacrylate, 3-methyl-1, 5-pentanediol diacrylate, 1,6-hexanediol diacrylate, 1,6 hexanediol dimethacrylate, dimethylol-tricyclodecanediacrylate, dimethylol-tricyclodecanedimethacrylate, a diacrylate of an ethylene oxide (EO) adduct of bisphenol A, a dimethacrylate of an EO adduct of bisphenol A, a diacrylate of a propylene oxide (PO) adduct of bisphenol A, a dimethacrylate of a PO adduct of bisphenol A, 2-hydroxy-3-acryloyloxypropyl methacrylate, isocyanuric acid EO-modified diacrylate, isocyanuric acid-modified dimethacrylate, another difunctional acrylate having a urethane bond, and difunctional methacrylate having a urethane bond. As necessary, two or more of these can be mixedly used.

It is noted that, for example, the PEG 200 diacrylate refers to a polyethylene glycol diacrylate having a polyethylene glycol chain formula weight of about 200.

In the photocurable resin composition according to the embodiment of the present invention, a monofunctional radical crosslinking agent can be preferably used as the radical crosslinking agent from the viewpoint of suppressing warping associated with the control of the elastic modulus of the pattern (cured substance). As the monofunctional radical crosslinking agent, (meth)acrylic acid derivatives such as n-butyl (meth)acrylate, 2-ethylhexyl (meth)acrylate, 2-hydroxyethyl (meth)acrylate, butoxyethyl (meth)acrylate, carbitol (meth)acrylate, cyclohexyl (meth)acrylate, benzyl (meth)acrylate, phenoxyethyl (meth)acrylate, N-methylol (meth)acrylamide, glycidyl (meth)acrylate, polyethylene glycol mono(meth)acrylate, and polypropylene glycol mono(meth)acrylate, N-vinyl compounds such as N-vinylpyrrolidone and N-vinylcaprolactam, allyl glycidyl ethers, and the like are preferably used. As the monofunctional radical crosslinking agent, a compound having a boiling point of 100°C or higher under atmospheric pressure is also preferable in order to suppress volatilization before exposure.

In addition, examples of the difunctional or higher functional radical crosslinking agent include allyl compounds such as diallyl phthalate and triallyl trimellitate.

In a case where a radical crosslinking agent is contained, the content thereof is preferably more than 0% by mass and 60% by mass or less with respect to the total solid content of the photocurable resin composition according to the embodiment of the present invention. The lower limit thereof is more preferably 5% by mass or more. An upper limit is more preferably 50% by mass or less and still more preferably 30% by mass or less.

One kind of radical crosslinking agent may be used alone, or two or more kinds thereof may be mixedly used. In a case where two or more kinds thereof are used in combination, the total amount thereof is preferably in the above range.

[Another crosslinking agent]

The photocurable resin composition according to the embodiment of the present invention also preferably contains another crosslinking agent different from the radical crosslinking agent described above.

In the present invention, the other crosslinking agent refers to a crosslinking agent other than the above-described radical crosslinking agent, where it is preferably a compound having a plurality of groups, in the molecule, which accelerates a reaction of forming a covalent bond between other compounds in the composition or reaction products thereof, by the photosensitization of the photoacid generator or photobase generator, and it is more preferably a compound having a plurality of groups, in the molecule, which accelerates a reaction of forming a covalent bond between other compounds in the composition or reaction products thereof, by the action of the acid or the base.

The acid or base is preferably an acid or a base, which is generated from a photoacid generator or a photobase generator in the exposure step.

The other crosslinking agent is preferably a compound having at least one group selected from the group consisting of an acyloxymethyl group, a methylol group, and an alkoxymethyl group, and more preferably a compound

having a structure in which at least one group selected from the group consisting of an acyloxymethyl group, a methylol group, and an alkoxymethyl group is directly bonded to a nitrogen atom.

Examples of the other crosslinking agent include a compound having a structure in which formaldehyde, or formaldehyde and alcohol are reacted with an amino group-containing compound such as melamine, glycoluril, urea, an alkylene urea, or benzoguanamine to substitute a hydrogen atom of the amino group with an acyloxymethyl group, a methylol group, or an alkoxymethyl group. The production method for these compounds is not particularly limited, and any compound having the same structure as the compound produced by the above method may be used. In addition, oligomers formed by the self-fusion of the methylol groups of these compounds may be used.

As the above amino group-containing compound, the crosslinking agent in which melamine is used is referred to as a melamine-based crosslinking agent, the crosslinking agent in which glycoluril, urea, or an alkylene urea is used is referred to a urea-based crosslinking agent, the crosslinking agent in which an alkylene urea is used is referred to as an alkylene urea-based crosslinking agent, and the crosslinking agent in which benzoguanamine is used is referred to as a benzoguanamine-based crosslinking agent.

Among these, the photocurable resin composition according to the embodiment of the present invention preferably contains at least one compound selected from the group consisting of a urea-based crosslinking agent and a melamine-based crosslinking agent and more preferably contains at least one compound selected from the group consisting of a glycoluril-based crosslinking agent described later and a melamine-based crosslinking agent.

Examples of the compound containing at least one of the alkoxymethyl group or the acyloxymethyl group in the present invention include, as a structural example, a compound in which an alkoxymethyl group or an acyloxymethyl group is directly substituted on an aromatic group or the nitrogen atom of the following urea structure, or on triazine.

The alkoxymethyl group or acyloxymethyl group contained in the above compound preferably has 2 to 5 carbon atoms, more preferably 2 or 3 carbon atoms, and still more preferably 2 carbon atoms.

The total number of alkoxymethyl groups and acyloxymethyl groups contained in the above compound is preferably 1 to 10, more preferably 2 to 8, and particularly preferably 3 to 6.

The molecular weight of the above compound is preferably 1,500 or less and preferably 180 to 1,200.

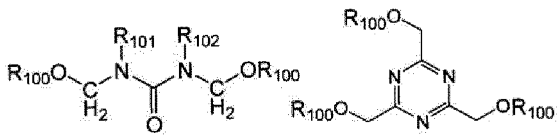

$R_{100}$ represents an alkyl group or an acyl group.

$R_{101}$ and $R_{102}$ each independently represent a monovalent organic group, and they may be bonded to each other to form a ring.

Examples of the compound in which an alkoxymethyl group or an acyloxymethyl group is directly substituted on an aromatic group include compounds such as those represented by the following general formulae.

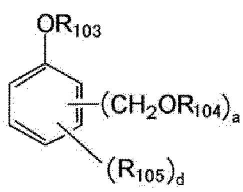

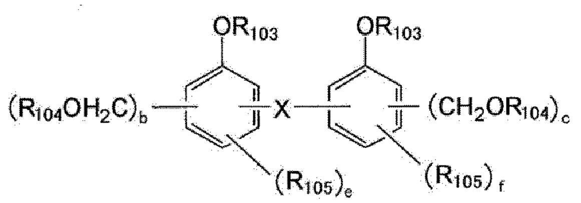

In the formula, X represents a single-bonded or divalent organic group, $R_{104}$'s each independently represent an alkyl or acyl group, and $R_{103}$ represents a hydrogen atom, an alkyl group, an alkenyl group, an aryl group, an aralkyl group, or a group that decomposes under the action of acid and generates an alkali-soluble group (for example, a group that is eliminated by under the action of acid, a group represented by $-C(R^4)_2COOR^5$ (each $R^4$ independently represents a hydrogen atom or an alkyl group having 1 to 4 carbon atoms, and $R^5$ represents a group eliminated under the action of acid)). $R_{105}$'s each independently represents an alkyl group or an alkenyl group, a, b, and c are each independently 1 to 3, d is 0 to 4, e is 0 to 3, and f is 0 to 3, where a + d is 5 or less, b + e is 4 or less, and c + f is 4 or less. Examples of $R^5$ in the group that decomposes under the action of an acid to generate an alkali-soluble group, a group that is eliminated under the action of acid, and a group represented by $-C(R^4)_2COOR^5$, include $-C(R_{36})(R_{37})(R_{38})$, $-C(R_{36})(R_{37})(OR_{39})$, and $-C(R_{01})(R_{02})(OR_{39})$.

In the formulae, $R_{36}$ to $R_{39}$ each independently an alkyl group, a cycloalkyl group, an aryl group, an aralkyl group, or an alkenyl group. $R_{36}$ and $R_{37}$ may be bonded to each other to form a ring.

The alkyl group is preferably an alkyl group having 1 to 10 carbon atoms and more preferably an alkyl group having 1 to 5 carbon atoms.

The alkyl group may be either linear or branched.

The cycloalkyl group is preferably a cycloalkyl group having 3 to 12 carbon atoms and more preferably a cycloalkyl group having 3 to 8 carbon atoms.

The cycloalkyl group may have a monocyclic structure or a polycyclic structure such as a fused ring.

The aryl group is preferably an aromatic hydrocarbon group having 6 to 30 carbon atoms and more preferably a phenyl group.

As the aralkyl group, an aralkyl group having 7 to 20 carbon atoms is preferable, and an aralkyl group having 7 to 16 carbon atoms is more preferable.

The above-described aralkyl group is intended to be an aryl group substituted with an alkyl group, and preferred aspects of these alkyl group and aryl group are respectively the same as the above-described preferred aspects of the alkyl group and the aryl group.

The alkenyl group is preferably an alkenyl group having 3 to 20 carbon atoms and more preferably an alkenyl group having 3 to 16 carbon atoms.

Further, these groups may further have a known substituent within the scope in which the effect of the present invention is obtained.

$R_{01}$ and $R_{02}$ each independently represent a hydrogen atom, an alkyl group, a cycloalkyl group, an aryl group, an aralkyl group, or an alkenyl group.

The group that decomposes under the action of an acid to generate an alkali-soluble group or the group that is eliminated under the action of an acid is preferably a tertiary alkyl ester group, an acetal group, a cumyl ester group, an enol ester group, or the like. It is more preferably a tertiary alkyl ester group or an acetal group.

Specific examples of the compound having an alkoxymethyl group include the following structures. Examples of the compound having an acyloxymethyl group include compounds in which the alkoxymethyl group of the following compounds is changed to an acyloxymethyl group. Examples of the compound having an alkoxymethyl group or an acyloxymethyl group in the molecule include, but are not limited to, the following compounds.

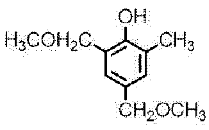
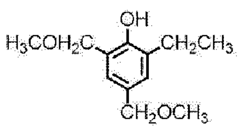
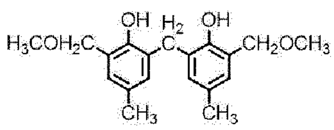

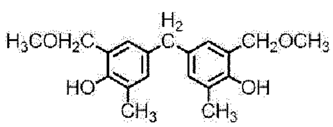
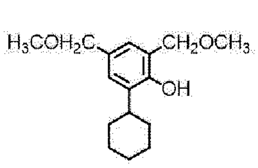
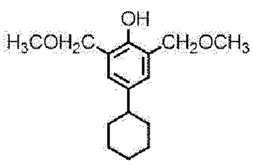

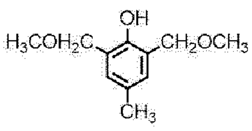
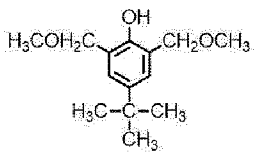
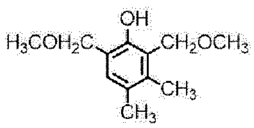

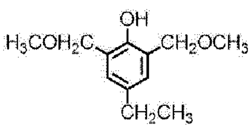
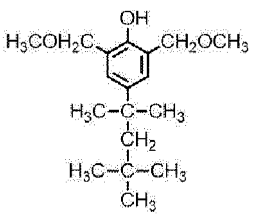
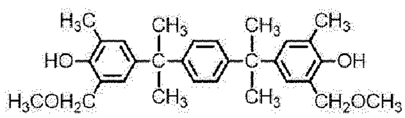

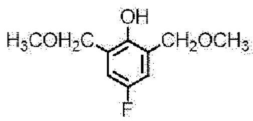 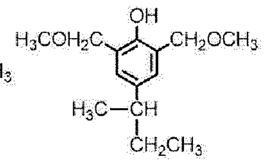 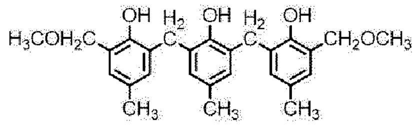

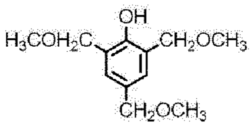 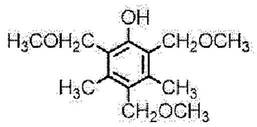 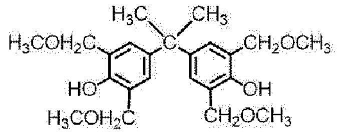

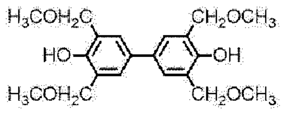 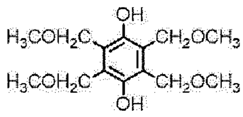 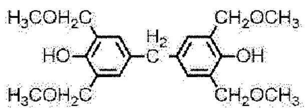

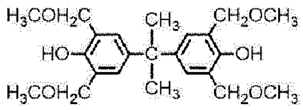 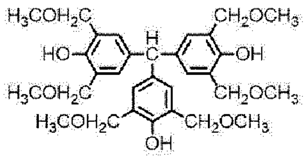 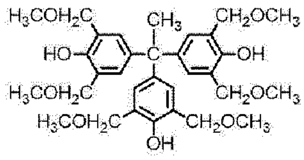

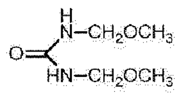 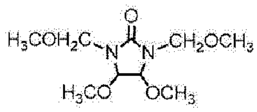 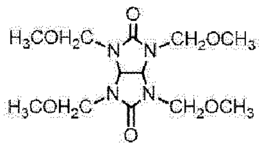

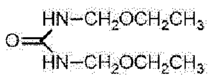 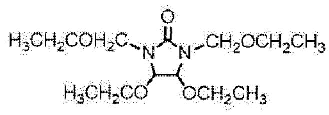 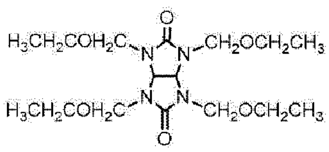

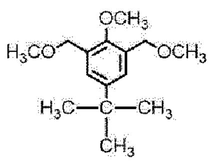 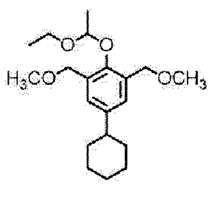 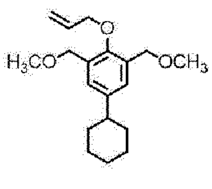 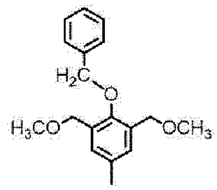

As the compound containing at least one of an alkoxymethyl group and an acyloxymethyl group, a commercially available compound may be used, or a compound synthesized by a known method may be used.

From the viewpoint of heat resistance, a compound in which an alkoxymethyl group or an acyloxymethyl group is directly substituted on an aromatic ring or a triazine ring is preferable.

Specific examples of the melamine-based crosslinking agent include hexamethoxymethylmelamine, hexaethoxymethylmelamine, hexapropoxymethylmelamine, and hexabutoxybutylmelamine.

Specific examples of the urea-based crosslinking agent include glycoluril-based crosslinking agents such as monohydroxymethylated glycoluril, dihydroxymethylated glycoluril, trihydroxymethylated glycoluril, tetrahydroxymethylated glycoluril, monomethoxymethylated glycoluril, dimethoxymethylated glycoluril, trimethoxymethylated glycoluril, tetramethoxymethylated glycoluril, monoethoxymethylated glycoluril, diethoxymethylated glycoluril, triethoxymethylated glycoluril, tetraethoxymethylated glycoluril, monopropoxymethylated glycoluril, dipropoxymethylated glycoluril, tripropoxymethylated glycoluril, tetrapropoxymethylated glycoluril, monobutoxymethylated glycoluril, dibutoxymethylated glycoluril, tributoxymethylated glycoluril, and tetrabutoxymethylated glycoluril, urea-based crosslinking agents such as bismethoxymethylurea, bisethoxymethylurea, bispropoxymethylurea, and bisbutoxymethylurea, ethyleneurea-based crosslinking agents such as monohydroxymethylated ethylene urea or dihydroxymethylated ethylene urea, monomethoxymethylated ethylene urea, dimethoxymethylated ethylene urea, monoethoxymethylated ethylene urea, diethoxymethylated ethylene urea, monopropoxymethylated ethylene urea, dipropoxymethylated ethylene urea, monobutoxymethylated ethylene urea, and dibutoxymethylated ethylene urea, propylene urea-based crosslinking agents such as monohydroxymethylated propylene urea, dihydroxymethylated propylene urea, monomethoxymethylated propylene urea, dimethoxymethylated propylene urea, monodiethoxymethylated propylene urea, diethoxymethylated propylene urea, monopropoxymethylated propylene urea, dipropoxymethylated propylene urea, monobutoxymethylated propylene urea, and dibutoxymethylated propylene urea, and 1,3-di(methoxymethyl)-4,5-dihydroxy-2-imidazolidinone, and 1,3-di(methoxymethyl)-4, 5-dimethoxy-2-imidazolidinone.

Specific examples of the benzoguanamine-based crosslinking agent include monohydroxymethylated benzoguanamine, dihydroxymethylated benzoguanamine, trihydroxymethylated benzoguanamine, tetrahydroxymethylated benzoguanamine, monoethoxymethylated benzoguanamine, diethoxymethylated benzoguanamine, triethoxymethylated benzoguanamine, tetramethoxymethylated benzoguanamine, monoethoxymethylated benzoguanamine, diethoxymethylated benzoguanamine, triethoxymethylated benzoguanamine, tetraethoxymethylated benzoguanamine, monopropoxymethylated benzoguanamine, dipropoxymethylated benzoguanamine, tripropoxymethylated benzoguanamine, tetrapropoxymethylated benzoguanamine, monobutoxymethylated benzoguanamine, dibutoxymethylated benzoguanamine, tributoxymethylated benzoguanamine, and tetrabutoxymethylated benzoguanamine.

In addition, as the compound having at least one group selected from the group consisting of a methylol group and an alkoxymethyl group, a compound in which at least one group selected from the group consisting of a methylol group and an alkoxymethyl group is directly bonded to an aromatic ring (preferably a benzene ring) can also be suitably used.

Specific examples of such compounds include benzenedimethanol, bis(hydroxymethyl)cresol, bis(hydroxymethyl)dimethoxybenzene, bis(hydroxymethyl)diphenyl ether, bis(hydroxymethyl)benzophenone, hydroxymethylphenyl hydroxymethylbenzoate, bis(hydroxymethyl)biphenyl, dimethylbis(hydroxymethyl)biphenyl, bis(methoxymethyl)benzene, bis(methoxymethyl)cresol, bis(methoxymethyl)dimethoxybenzene, bis(methoxymethyl)diphenyl ether, bis(methoxymethyl)benzophenone, methoxymethylphenyl methoxymethylbenzoate, bis(methoxymethyl)biphenyl, dimethylbis(methoxymethyl)biphenyl, 4,4',4"-ethylidenetris[2,6-bis(methoxymethyl)phenol], 5, 5'-[2,2,2-trifluoro-1-(trifluoromethyl)ethylidene]bis[2-hydroxy-1,3-benzenedimethanol], and 3,3',5,5'-tetrakis(methoxymethyl)-1,1'-biphenyl-4,4'-diol.

As the other crosslinking agent, a commercially available product may be used, and examples of the suitable commercially available product include 46DMOC and 46DMOEP (all of which are manufactured by ASAHI YUKIZAI Corporation), DML-PC, DML-PEP, DML-OC, DML-OEP, DML-34X, DML-PTBP, DML-PCHP, DML-OCHP, DML-PFP, DML-PSBP, DML-POP, DML-MBOC, DML-MBPC, DML-MTrisPC, DML-BisOC-Z, DML-BisOCHP-Z, DML-BPC, DML-BisOC-P, DMOM-PC, DMOM-PTBP, DMOM-MBPC, TriML-P, TriML-35XL, TML-HQ, TML-BP, TML-pp-BPF, TML-BPE, TML-BPA, TML-BPAF, TML-BPAP, TMOM-BP, TMOM-BPE, TMOM-BPA, TMOM-BPAF, TMOM-BPAP, HML-TPPHBA, HML-TPHAP, HMOM-TPPHBA, and HMOM-TPHAP (all of which are manufactured by Honshu Chemical Industry Co., Ltd.), and NIKALAC (registered trade name, the same applies hereinafter) MX-290, NIKALAC MX-280, NIKALAC MX-270, NIKALAC MX-279, NIKALAC MW-100LM, and NIKALAC MX-750LM (all of which are manufactured by Sanwa Chemical Co., Ltd.).

In addition, the resin composition according to the embodiment of the present invention preferably contains, as the other crosslinking agent, at least one compound selected from the group consisting of an epoxy compound, an oxetane compound, and a benzoxazine compound.

- Epoxy compound (compound having epoxy group) -

The epoxy compound is preferably a compound having two or more epoxy groups in one molecule. Since the epoxy group undergoes a crosslinking reaction at 200°C or lower and a dehydration reaction derived from crosslinking does not occur, film shrinkage hardly occurs. Therefore, containing an epoxy compound is effective for the low-temperature curing of the resin composition according to the embodiment of the present invention and the suppression of warping.

The epoxy compound preferably contains a polyethylene oxide group. As a result, it is possible to further decrease the elastic modulus and suppress the warping. The polyethylene oxide group means a group in which the number of repeating units of ethylene oxide is 2 or higher, and the number of repeating units is preferably 2 to 15.

Examples of the epoxy compound include a bisphenol A type epoxy resin; a bisphenol F type epoxy resin; an alkylene glycol type epoxy resin or a polyhydric alcohol hydrocarbon type epoxy resin, such as propylene glycol diglycidyl ether, neopentyl glycol diglycidyl ether, ethylene glycol diglycidyl ether, butylene glycol diglycidyl ether, hexamethylene glycol diglycidyl ether, or trimethylolpropane triglycidyl ether; a polyalkylene glycol type epoxy resin such as polypropylene glycol diglycidyl ether; and an epoxy group-containing silicone such as polymethyl (glycidyloxypropyl)siloxane; however, the epoxy compound is not limited thereto. Specific examples thereof include EPICLON (registered trade name) 850-S, EPICLON (registered trade name) HP-4032, EPICLON (registered trade name) HP-7200, EPICLON (registered trade name) HP-820, EPICLON (registered trade name) HP-4700, EPICLON (registered trade name) HP-4770, EPICLON (registered trade name) EXA-830LVP, EPICLON (registered trade name) EXA-8183, EPICLON (registered trade name) EXA-8169, EPICLON (registered trade name) N-660, EPICLON (registered trade name) N-665-EXP-S, EPICLON (registered trade name) N-740 (all, product names, manufactured by DIC Corporation); RIKARESIN (registered trade name) BEO-20E, RIKARESIN (registered trade name) BEO-60E, RIKARESIN (registered trade name) HBE-100, RIKARESIN (registered trade name) DME-100, and RIKARESIN (registered trade name) L-200 (registered trade name, manufactured by New Japan Chemical Co., Ltd.); EP-4003S, EP-4000S, EP-4088S, EP-3950S (all, product names, manufactured by ADEKA Corporation); CELLOXIDE (registered trade name) 2021P, CELLOXIDE (registered trade name) 2081, CELLOXIDE (registered trade name) 2000, EHPE3150, EPOLEAD (registered trade name) GT401, EPOLEAD (registered trade name) PB4700, EPOLEAD (registered trade name) PB3600 (all product names, manufactured by Daicel Corporation); and NC-3000, NC-3000-L, NC-3000-H, NC-3000-FH-75M, NC-3100, CER-3000-L, NC-2000-L, XD-1000, NC-7000L, NC-7300L, EPPN-501H, EPPN-501HY, EPPN-502H, EOCN-1020, EOCN-102S, EOCN-103S, EOCN-104S, CER-1020, EPPN-201, BREN-S, and BREN-10S (all product names, manufactured by Nippon Kayaku Co., Ltd.). In addition, the following compounds are also suitably used.

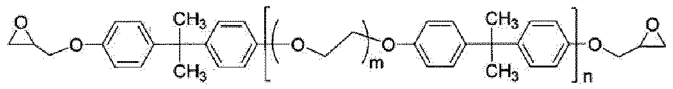

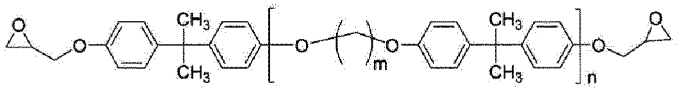

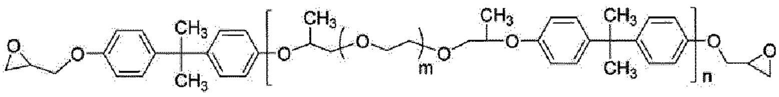

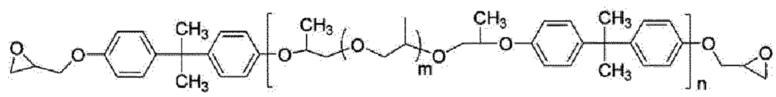

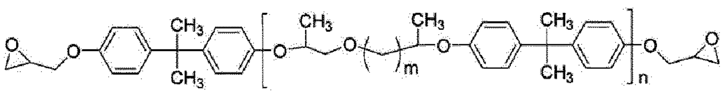

In the formulae, n is an integer of 1 to 5, and m is an integer of 1 to 20.

Among the above structures, n is preferably 1 to 2, and m is preferably 3 to 7 from the viewpoint of achieving both heat resistance and improvement in elongation.

- Oxetane compound (compound having oxetanyl group) -

Examples of the oxetane compound include a compound having two or more oxetane rings in one molecule, 3-ethyl-3-hydroxymethyloxetane, 1,4-bis{[(3-ethyl-3-oxetanyl)methoxy]methyl}benzene, 3 -ethyl-3 -(2-ethylhexylmethyl)oxetane, and 1,4-benzenedicarboxylic acid-bis[(3-ethyl-3-oxetanyl)methyl]ester. As specific examples thereof, ARON OXETANE series (for example, OXT-121 and OXT-221) manufactured by Toagosei Co., Ltd., can be suitably used, and these can be used alone or two or more thereof may be mixedly used.

- Benzoxazine compound (compound having benzoxazolyl group) -

Due to a crosslinking reaction derived from a ring-opening addition reaction, the benzoxazine compound does not result in degassing during curing and results in decreased thermal contraction, and thus the occurrence of warping is suppressed, which is preferable.

Preferred examples of the benzoxazine compound include P-d type benzoxazine, F-a type benzoxazine (product names, all of which are manufactured by Shikoku Chemicals Corporation), a benzoxazine adduct of polyhydroxystyrene resin, and a phenol novolak type dihydrobenzoxazine compound. These may be used alone, or two or more thereof

may be mixed and used.

The content of the other crosslinking agent is preferably 0.1% to 30% by mass, more preferably 0.1% to 20% by mass, still more preferably 0.5% to 15% by mass, and particularly preferably 1.0% to 10% by mass, with respect to the total solid content of the resin composition according to the embodiment of the present invention. One kind of the other crosslinking agent may be contained, or two or more kinds thereof may be contained. In a case where two or more kinds of the other crosslinking agents are contained, the total thereof is preferably within the above-described range.

<Base generator>

The resin composition according to the embodiment of the present invention may contain a base generator. Here, the base generator is a compound that is capable of generating a base under a physical or chemical action. Examples of the preferred base generator for the resin composition according to the embodiment of the present invention include a thermal-base generator and a photobase generator.

In particular, in a case where the resin composition contains a precursor of a cyclization resin, it is preferable that the resin composition contains a base generator. In a case where the resin composition contains a thermal-base generator, it is possible to, for example, accelerate the cyclization reaction of the precursor by heating, whereby the mechanical properties and chemical resistance of the cured substance are improved and for example, the performance as an interlayer insulating film for a re-distribution layer, included in a semiconductor package, is improved.

The base generator may be an ionic base generator a nonionic base generator. Examples of the base that is generated from the base generator include a secondary amine and a tertiary amine.

The base generator according to the embodiment of the present invention is not particularly limited, and a known base generator can be used. It is possible to use a known base generator, for example, a carbamoyloxime compound, a carbamoylhydroxylamine compound, a carbamic acid compound, a formamide compound, an acetoamide compound, a carbamate compound, a benzylcarbamate compound, a nitrobenzylcarbamate compound, a sulfonamide compound, an imidazole derivative compound, an aminimide compound, a pyridine derivative compound, an $\alpha$-aminoacetophenone derivative compound, a quaternary ammonium salt derivative compound, a pyridinium salt, an $\alpha$-lactone ring derivative compound, an aminimide compound, a phthalimide derivative compound, or an acyloxyimino compound.

Specific examples of the compound of the nonionic base generator include compounds represented by Formula (B1), Formula (B2), or Formula (B3).

It is noted that although cyclic compounds containing nitrogen are present in the base generators exemplified below, these shall not be included in the above-described "nitrogen-containing cyclic compound".

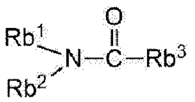 (B1) 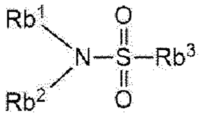 (B2)

In Formulae (B1) and (B2), $Rb^1$, $Rb^2$, and $Rb^3$ are each independently an organic group that does not have a tertiary amine structure, a halogen atom, or a hydrogen atom. However, $Rb^1$ and $Rb^2$ are not hydrogen atoms at the same time. Further, none of $Rb^1$, $Rb^2$, and $Rb^3$ have a carboxy group. In the present specification, the tertiary amine structure refers to a structure in which all three bonding sites of a trivalent nitrogen atom are covalently bonded to hydrocarbon-based carbon atoms. For this reason, this is not applied in a case where the carbon atom to which the bonding site bonded is a carbon atom forming a carbonyl group, that is, in a case where an amide group is formed by bonding together with a nitrogen atom.

In Formulae (B1) and (B2), a cyclic structure is preferably contained in at least one of $Rb^1$, $Rb^2$, or $Rb^3$ and is more preferably contained in at least two thereof. The cyclic structure may be any one of a monocyclic ring or a fused ring and is preferably a monocyclic ring or a fused ring in which two monocyclic rings are fused. The monocyclic ring is preferably a 5-membered ring or a 6-membered ring, and more preferably a 6-membered ring. The monocyclic ring is preferably a cyclohexane ring or a benzene ring, and more preferably a cyclohexane ring.

More specifically, $Rb^1$ and $Rb^2$ are preferably a hydrogen atom, an alkyl group (preferably having 1 to 24 carbon atoms, more preferably having 2 to 18 carbon atoms, and still more preferably having 3 to 12 carbon atoms), an alkenyl group (preferably having 2 to 24 carbon atoms, more preferably having 2 to 18 carbon atoms, and still more preferably having 3 to 12 carbon atoms), an aryl group (preferably having 6 to 22 carbon atoms, more preferably having 6 to 18 carbon atoms, and still more preferably having 6 to 10 carbon atoms), or an arylalkyl group (preferably having 7 to 25 carbon atoms, more preferably having 7 to 19 carbon atoms, and still more preferably having 7 to 12 carbon atoms). These groups may have substituents as long as the effect of the present invention is exhibited. $Rb^1$ and $Rb^2$ may be bonded to each other to form a ring. The ring to be formed is preferably a 4- to 7-membered nitrogen-containing heterocycle. Particularly, $Rb^1$ and $Rb^2$ are preferably a linear, branched, or cyclic alkyl groups (preferably having 1 to 24

carbon atoms, more preferably 2 to 18 carbon atoms, and still more preferably having 3 to 12 carbon atoms) which may have a substituent, more preferably a cycloalkyl group (preferably having 3 to 24 carbon atoms, more preferably having 3 to 18 carbon atoms, and still more preferably having 3 to 12 carbon atoms) which may have a substituent, and still more preferably a cyclohexyl group which may have a substituent.

Examples of $Rb^3$ include an alkyl group (preferably having 1 to 24 carbon atoms, more preferably having 2 to 18 carbon atoms, and still more preferably having 3 to 12 carbon atoms), an aryl group (preferably having 6 to 22 carbon atoms, more preferably having 6 to 18 carbon atoms, and still more preferably having 6 to 10 carbon atoms), an alkenyl group (preferably having 2 to 24 carbon atoms, more preferably having 2 to 12 carbon atoms, and still more preferably having 2 to 6 carbon atoms), an arylalkyl group (preferably having 7 to 23 carbon atoms, more preferably having 7 to 19 carbon atoms, and still more preferably having 7 to 12 carbon atoms), an arylalkenyl group (preferably having 8 to 24 carbon atoms, more preferably having 8 to 20 carbon atoms, and still more preferably having 8 to 16 carbon atoms), an alkoxyl group (preferably having 1 to 24 carbon atoms, more preferably having 2 to 18 carbon atoms, and still more preferably having 3 to 12 carbon atoms), an aryloxy group (preferably having 6 to 22 carbon atoms, more preferably having 6 to 18 carbon atoms, and still more preferably having 6 to 12 carbon atoms), and an arylalkyloxy group (preferably having 7 to 23 carbon atoms, more preferably having 7 to 19 carbon atoms, and still more preferably having 7 to 12 carbon atoms). Among the above, a cycloalkyl group (preferably having 3 to 24 carbon atoms, more preferably 3 to 18 carbon atoms, and still more preferably 3 to 12 carbon atoms), an arylalkenyl group, or an arylalkyloxy group is preferable. $Rb^3$ may further have a substituent as long as the effect of the present invention is exhibited.

The compound represented by Formula (B1) is preferably a compound represented by Formula (B1-1) or Formula (B1-2).

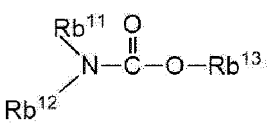 (B1-1) 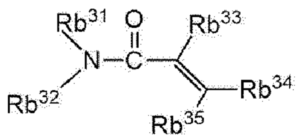 (B1-2)

In the formula, $Rb^{11}$ and $Rb^{12}$, and $Rb^{31}$ and $Rb^{32}$ are each the same as $Rb^1$ and $Rb^2$ in Formula (B1).

$Rb^{13}$ is an alkyl group (preferably having 1 to 24 carbon atoms, more preferably having 2 to 18 carbon atoms, and still more preferably having 3 to 12 carbon atoms), an alkenyl group (preferably having 2 to 24 carbon atoms, more preferably having 2 to 18 carbon atoms, and still more preferably having 3 to 12 carbon atoms), an aryl group (preferably having 6 to 22 carbon atoms, more preferably having 6 to 18 carbon atoms, and still more preferably having 6 to 12 carbon atoms), or an arylalkyl group (preferably having 7 to 23 carbon atoms, more preferably having 7 to 19 carbon atoms, and still more preferably having 7 to 12 carbon atoms), and may have a substituent as long as the effect of the present invention is exhibited. Among the above, $Rb^{13}$ is preferably an arylalkyl group.

$Rb^{33}$ and $Rb^{34}$ are each independently a hydrogen atom, an alkyl group (preferably having 1 to 12 carbon atoms, more preferably having 1 to 8 carbon atoms, and still more preferably having 1 to 3 carbon atoms), an alkenyl group (preferably having 2 to 12 carbon atoms, more preferably having 2 to 8 carbon atoms, and still more preferably having 2 or 3 carbon atoms), an aryl group (preferably having 6 to 22 carbon atoms, more preferably having 6 to 18 carbon atoms, and still more preferably having 6 to 10 carbon atoms), or an arylalkyl group (preferably having 7 to 23 carbon atoms, more preferably having 7 to 19 carbon atoms, and still more preferably having 7 to 11 carbon atoms), and preferably a hydrogen atom.

$Rb^{35}$ is an alkyl group (preferably having 1 to 24 carbon atoms, more preferably having 1 to 12 carbon atoms, and still more preferably having 3 to 8 carbon atoms), an alkenyl group (preferably having 2 to 12 carbon atoms, more preferably having 2 to 10 carbon atoms, and still more preferably having 3 to 8 carbon atoms), an aryl group (preferably having 6 to 22 carbon atoms, more preferably having 6 to 18 carbon atoms, and still more preferably having 6 to 12 carbon atoms), or an arylalkyl group (preferably having 7 to 23 carbon atoms, more preferably having 7 to 19 carbon atoms, and still more preferably having 7 to 12 carbon atoms), and is preferably an aryl group.

The compound represented by Formula (B1-1) is preferably a compound represented by Formula (B1-1a) as well.

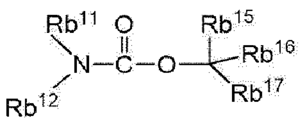 (B1-1a)

$Rb^{11}$ and $Rb^{12}$ are respectively have the same meanings as $Rb^{11}$ and $Rb^{12}$ in Formula (B1-1).
$Rb^{15}$ and $Rb^{16}$ are a hydrogen atom, an alkyl group (preferably having 1 to 12 carbon atoms, more preferably having 1

to 6 carbon atoms, and still more preferably having 1 to 3 carbon atoms), an alkenyl group (preferably having 2 to 12 carbon atoms, more preferably having 2 to 6 carbon atoms, and still more preferably having 2 or 3 carbon atoms), an aryl group (preferably having 6 to 22 carbon atoms, more preferably having 6 to 18 carbon atoms, and still more preferably having 6 to 10 carbon atoms), or an arylalkyl group (preferably having 7 to 23 carbon atoms, more preferably having 7 to 19 carbon atoms, and still more preferably having 7 to 11 carbon atoms), and preferably a hydrogen atom or a methyl group.

$Rb^{17}$ is an alkyl group (preferably having 1 to 24 carbon atoms, more preferably having 1 to 12 carbon atoms, and still more preferably having 3 to 8 carbon atoms), an alkenyl group (preferably having 2 to 12 carbon atoms, more preferably having 2 to 10 carbon atoms, and still more preferably having 3 to 8 carbon atoms), an aryl group (preferably having 6 to 22 carbon atoms, more preferably having 6 to 18 carbon atoms, and still more preferably having 6 to 12 carbon atoms), or an arylalkyl group (preferably having 7 to 23 carbon atoms, more preferably having 7 to 19 carbon atoms, and still more preferably having 7 to 12 carbon atoms), and among the above, is preferably an aryl group.

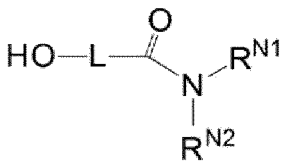

(B3)

In Formula (B3), L represents a hydrocarbon group which is a divalent hydrocarbon group having a saturated hydrocarbon group on a path of a linking chain that links adjacent oxygen atom and carbon atom and in which the number of the atoms on the path of the linking chain is 3 or more. Further, $R^{N1}$ and $R^{N2}$ each independently represent a monovalent organic group.

In the present specification, the "linking chain" refers to an atomic chain which interconnects linking targets shortest (with the minimum number of atoms) among the atomic chains on the path, which interconnects two atoms or a group of atoms to be linked. For example, in the compound represented by the following formula, L is composed of a phenylene ethylene group, has an ethylene group as a saturated hydrocarbon group, and the linking chain is composed of four carbon atoms, and the number of atoms (that is, the number of atoms constituting the linking chain, and hereinafter, also referred to as the "linking chain length" or the "length of linking chain") on the path of the linking chain is 4.

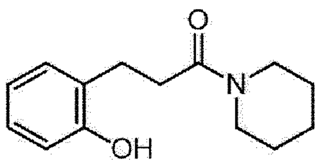

The number of carbon atoms in L in Formula (B3) (including carbon atoms other than the carbon atoms in the linking chain) is preferably 3 to 24. The upper limit thereof is more preferably 12 or less, still more preferably 10 or less, and particularly preferably 8 or less. The lower limit thereof is more preferably 4 or more. From the viewpoint of rapidly advancing the intramolecular cyclization reaction, the upper limit of the linking chain length of L is preferably 12 or less, more preferably 8 or less, still more preferably 6 or less, and particularly preferably 5 or less. In particular, the linking chain length of L is preferably 4 or 5 and most preferably 4. Specific preferred compounds of the base generator include the compounds described in paragraphs 0102 to 0168 of WO2020/066416A and the compounds described in paragraphs 0143 to 0177 of WO2018/038002A.

In addition, it is also preferable that the base generator includes a compound represented by Formula (N1).

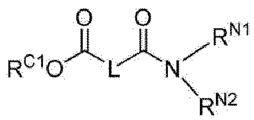

(N1)

In Formula (N1), $R^{N1}$ and $R^{N2}$ each independently represent a monovalent organic group, $R^{C1}$ represents a hydrogen atom or a protective group, and L represents a divalent linking group.

L is a divalent linking group, and it is preferably a divalent organic group. The linking chain length of the linking group is preferably 1 or more and more preferably 2 or more. The upper limit thereof is preferably 12 or less, more preferably 8 or less, and still more preferably 5 or less. The linking chain length is the number of atoms present in the

atom sequence that is the shortest route between the two carbonyl groups in the formula.

$R^{N1}$ and $R^{N2}$ in Formula (N1) each independently represent a monovalent organic group (preferably having 1 to 24 carbon atoms, more preferably 2 to 18 carbon atoms, and still more preferably 3 to 12 carbon atoms), more preferably a hydrocarbon group (preferably having 1 to 24 carbon atoms, more preferably 1 to 12 carbon atoms, and still more preferably 1 to 10 carbon atoms), and specific examples thereof include an aliphatic hydrocarbon group (preferably having 1 to 24 carbon atoms, more preferably 1 to 12 carbon atoms, and still more preferably 1 to 10 carbon atoms) and an aromatic hydrocarbon group (preferably having 6 to 22 carbon atoms, more preferably 6 to 18 carbon atoms, and still more preferably 6 to 10 carbon atoms), and an aliphatic hydrocarbon group is preferable. As $R^{N1}$ and $R^{N2}$, an aliphatic hydrocarbon group is preferably used since the basicity of the base to be generated is high. It is noted that the aliphatic hydrocarbon group and the aromatic hydrocarbon group may have a substituent, and the aliphatic hydrocarbon group and the aromatic hydrocarbon group may have an oxygen atom in an aliphatic hydrocarbon chain, in an aromatic ring, or in a substituent. In particular, an aspect in which the aliphatic hydrocarbon group has an oxygen atom in a hydrocarbon chain is exemplified.

Examples of the aliphatic hydrocarbon group constituting $R^{N1}$ and $R^{N2}$ include a linear or branched chain-like alkyl group, a cyclic alkyl group, a group involved in the combination of a chain-like alkyl group and a cyclic alkyl group, and an alkyl group having an oxygen atom are contained in the chain. The linear or branched chain-like alkyl group preferably has 1 to 24 carbon atoms, more preferably 2 to 18, and still more preferably 3 to 12 carbon atoms. Examples of the linear or branched chain-like alkyl group include a methyl group, an ethyl group, a propyl group, a butyl group, a pentyl group, a hexyl group, a heptyl group, an octyl group, a nonyl group, a decyl group, an undecyl group, a dodecyl group, an isopropyl group, an isobutyl group, a secondary butyl group, a tertiary butyl group, an isopentyl group, a neopentyl group, a tertiary pentyl group, and an isohexyl group.

The cyclic alkyl group preferably has 3 to 12 carbon atoms and more preferably 3 to 6 carbon atoms. Examples of the cyclic alkyl group include a cyclopropyl group, a cyclobutyl group, a cyclopentyl group, a cyclohexyl group, and a cyclooctyl group.

The group involved in the combination of the chain-like alkyl group and the cyclic alkyl group is preferably a group having 4 to 24 carbon atoms, more preferably 4 to 18 carbon atoms, and still more preferably 4 to 12 carbon atoms. Examples of the group involved in the combination of the chain-like alkyl group and the cyclic alkyl group include a cyclohexylmethyl group, a cyclohexylethyl group, a cyclohexylpropyl group, a methylcyclohexylmethyl group, and an ethylcyclohexylethyl group.

The alkyl group having an oxygen atom in the chain preferably has 2 to 12 carbon atoms, more preferably 2 to 6 carbon atoms, and still more preferably 2 to 4 carbon atoms. The alkyl group having an oxygen atom in the chain may be chain-like or cyclic or may be linear or branched.

Among the above, from the viewpoint of increasing the boiling point of the decomposition-generated base described later, $R^{N1}$ and $R^{N2}$ are preferably an alkyl group having 5 to 12 carbon atoms. However, in a prescription in which adhesiveness in a case of carrying out lamination with a metal (for example, copper) layer is important, a group having a cyclic alkyl group or an alkyl group having 1 to 8 carbon atoms is preferable.

$R^{N1}$ and $R^{N2}$ may be linked to each other to form a cyclic structure. In forming the cyclic structure, an oxygen atom or the like may be contained in the chain. The cyclic structure formed by $R^{N1}$ and $R^{N2}$ can be a monocyclic ring or may be a fused ring, but is preferably a monocyclic ring. The cyclic structure to be formed is preferably a 5-membered ring or a 6-membered ring containing a nitrogen atom in Formula (N1), examples thereof include a pyrrole ring, an imidazole ring, a pyrazole ring, a pyrroline ring, a pyrrolidine ring, an imidazolidine ring, a pyrazolidine ring, a piperidine ring, a piperazine ring, and a morpholine ring, and preferred examples thereof include a pyrroline ring, a pyrrolidine ring, a piperidine ring, a piperazine ring, and a morpholine ring.

$R^{C1}$ represents a hydrogen atom or a protective group, and it is preferably a hydrogen atom.

The protective group is preferably a protective group that decomposes under the action of an acid or a base, and examples thereof preferably include a protective group that decomposes by an acid.

Specific examples of the protective group include a chain-like or cyclic alkyl group and a chain-like or cyclic alkyl group having an oxygen atom in the chain. Examples of the chain-like or cyclic alkyl group include a methyl group, an ethyl group, an isopropyl group, a tert-butyl group, and a cyclohexyl group. Specific examples of the chain-like alkyl group having an oxygen atom in the chain include an alkyloxyalkyl group, and more specific examples thereof include a methyloxymethyl (MOM) group and an ethyloxyethyl (EE) group. Examples of the cyclic alkyl group having an oxygen atom in the chain include an epoxy group, a glycidyl group, an oxetanyl group, a tetrahydrofuranyl group, and a tetrahydropyranyl (THP) group.

The divalent linking group constituting L is not particularly determined; however, it is preferably a hydrocarbon group and more preferably an aliphatic hydrocarbon group. The hydrocarbon group may have a substituent or may have an atom of a kind other than the carbon atom in the hydrocarbon chain. More specifically, it is preferably a divalent hydrocarbon linking group which may have an oxygen atom in the chain, more preferably a divalent aliphatic hydrocarbon group which may have an oxygen atom in the chain, a divalent aromatic hydrocarbon group, or a group involved in the

combination of the divalent aliphatic hydrocarbon group which may have an oxygen atom in the chain and the divalent aromatic hydrocarbon group, and still more preferably a divalent aliphatic hydrocarbon group which may have an oxygen atom in the chain. It is preferable that these groups do not have an oxygen atom.

The divalent hydrocarbon linking group preferably has 1 to 24 carbon atoms, more preferably 2 to 12 carbon atoms, and still more preferably 2 to 6 carbon atoms. The divalent aliphatic hydrocarbon group preferably has 1 to 12 carbon atoms, more preferably 2 to 6 carbon atoms, and still more preferably 2 to 4 carbon atoms. The divalent aromatic hydrocarbon group preferably has 6 to 22 carbon atoms, more preferably 6 to 18 carbon atoms, and still more preferably 6 to 10 carbon atoms. The group (for example, the arylene alkyl group) involved in the combination of the divalent aliphatic hydrocarbon group and the divalent aromatic hydrocarbon group preferably has 7 to 22 carbon atoms, more preferably 7 to 18, and still more preferably 7 to 10 carbon atoms.

Specifically, the linking group L is preferably a linear or branched chain-like alkylene group, a cyclic alkylene group, a group involved in the combination of a chain-like alkylene group and a cyclic alkylene group, an alkylene group having an oxygen atom in the chain, a linear or branched chain-like alkenylene group, a cyclic alkenylene group, an arylene group, or an arylene alkylene group.

The linear or branched chain-like alkylene group preferably has 1 to 12 carbon atoms, more preferably 2 to 6 carbon atoms, and still more preferably 2 to 4 carbon atoms.

The cyclic alkylene group preferably has 3 to 12 carbon atoms and more preferably 3 to 6 carbon atoms.

The group involved in the combination of the chain-like alkylene group and the cyclic alkylene group is preferably a group having 4 to 24 carbon atoms, more preferably 4 to 12 carbon atoms, and still more preferably 4 to 6 carbon atoms.

The alkylene group having an oxygen atom in the chain may be chain-like or cyclic or may be linear or branched. The alkylene group having an oxygen atom in the chain preferably has 1 to 12 carbon atoms, more preferably 1 to 6 carbon atoms, and still more preferably 1 to 3 carbon atoms.

The linear or branched chain-like alkenylene group preferably has 2 to 12 carbon atoms, more preferably 2 to 6 carbon atoms, and still more preferably 2 to 3 carbon atoms. The number of C=C bonds in the linear or branched chain-like alkenylene group is preferably 1 to 10, more preferably 1 to 6, and still more preferably 1 to 3. The cyclic alkenylene group preferably has 3 to 12 carbon atoms and more preferably 3 to 6 carbon atoms. In the cyclic alkenylene group, the number of C=C bonds is preferably 1 to 6, more preferably 1 to 4, and still more preferably 1 to 2.

The arylene group preferably has 6 to 22 carbon atoms, more preferably 6 to 18 carbon atoms, and still more preferably 6 to 10 carbon atoms.

The arylene alkylene group preferably has 7 to 23 carbon atoms, more preferably 7 to 19, and still more preferably 7 to 11 carbon atoms.

Among the above, a preferred one is a chain-like alkylene group, a cyclic alkylene group, an alkylene group having an oxygen atom in the chain, a chain-like alkenylene group, an arylene group, or an arylene alkylene group, and more preferred one is a 1,2-ethylene group, a propanediyl group (particularly a 1,3-propanediyl group), a cyclohexanediyl group (particularly a 1,2-cyclohexanediyl group), a vinylene group (particularly a cisvinylene group), a phenylene group (a 1,2-phenylene group), a phenylene methylene group (particularly a 1,2-phenylene methylene group) or an ethyleneoxyethylene group (particularly a 1,2-ethyleneoxy-1,2-ethylene group).

Examples of the thermal base generator include the following examples, but the present invention is not construed as being limited thereto.

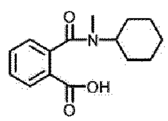
(B-1)

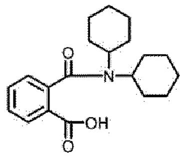
(B-2)

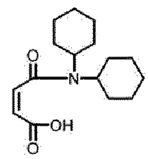
(B-3)

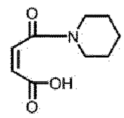
(B-4)

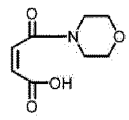
(B-5)

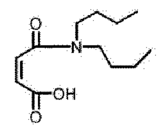
(B-6)

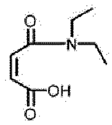
(B-7)

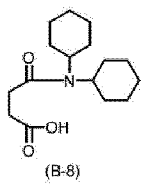
(B-8)

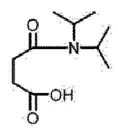
(B-9)

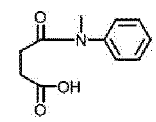
(B-10)

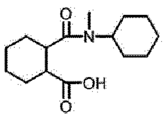
(B-11)

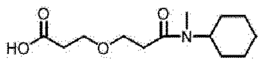
(B-12)

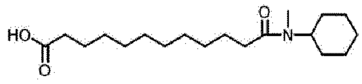
(B-13)

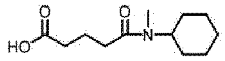
(B-14)

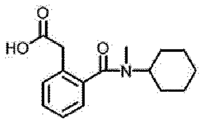
(B-15)

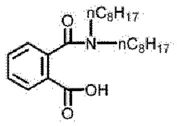
(B-16)

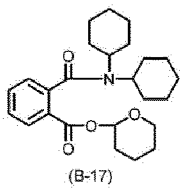
(B-17)

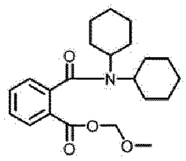
(B-18)

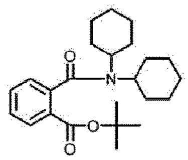
(B-19)

The molecular weight of the nonionic base generator is preferably 800 or less, more preferably 600 or less, and still more preferably 500 or less. The lower limit thereof is preferably 100 or more, more preferably 200 or more, and still more preferably 300 or more.

Examples of the specific preferred compound of the ionic base generator include the compounds described in paragraphs 0148 to 0163 of WO2018/03 8002A.

Specific examples of the ammonium salt include compounds shown below; however, the present invention is not limited thereto.

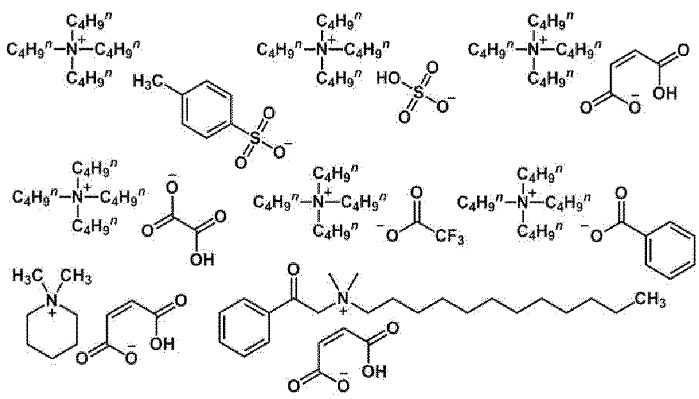

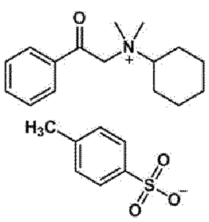

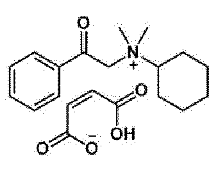

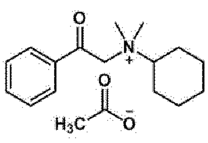

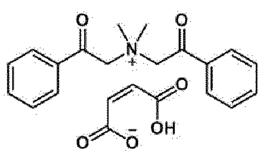

Specific examples of the iminium salt include compounds shown below; however, the present invention is not limited thereto.

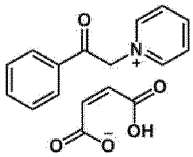

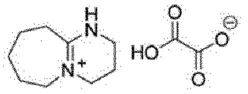

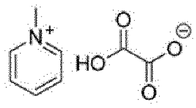

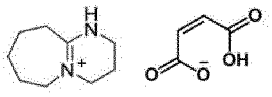

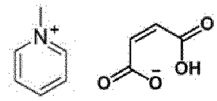

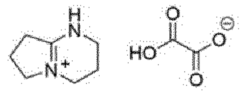

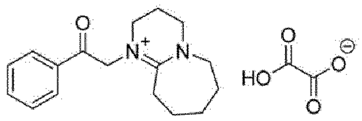

In a case where the resin composition according to the embodiment of the present invention contains a base generator, the content of the base generator is preferably 0.1 to 50 parts by mass with respect to 100 parts by mass of the resin in the resin composition according to the embodiment of the present invention. The lower limit thereof is preferably 0.3 parts by mass or more and more preferably 0.5 parts by mass or more. The upper limit thereof is more preferably 30 parts by mass or less, still more preferably 20 parts by mass or less, and even still more preferably 10 parts by mass or less, and it may be 5 parts by mass or less or may be 4 parts by mass or less.

One kind or two or more kinds of base generators can be used. In a case where two or more kinds thereof are used, the total amount is preferably within the above-described range.

<Solvent>

The resin composition according to the embodiment of the present invention preferably contains a solvent.

As the solvent, any known solvent can be used. The solvent is preferably an organic solvent. Examples of the organic solvent include compounds such as esters, ethers, ketones, cyclic hydrocarbons, sulfoxides, amides, ureas, and alcohols.

Suitable examples of the esters include ethyl acetate, n-butyl acetate, isobutyl acetate, hexyl acetate, amyl formate, isoamyl acetate, butyl propionate, isopropyl butyrate, ethyl butyrate, butyl butyrate, methyl lactate, ethyl lactate, γ-butyrolactone, ε-caprolactone, δ-valerolactone, alkyl alkyloxyacetate (for example, methyl alkyloxyacetate, ethyl alkyloxyacetate, and butyl alkyloxyacetate (for example, methyl methoxyacetate, ethyl methoxyacetate, butyl methoxyacetate, methyl ethoxyacetate, and ethyl ethoxyacetate)), 3-alkyloxypropionic acid alkyl esters (for example, methyl 3-alkyloxypropionate, and ethyl 3-alkyloxypropionate (for example, methyl 3-methoxypropionate, ethyl 3-methoxypropionate, methyl 3-ethoxypropionate, and ethyl 3-ethoxypropionate)), 2-alkyloxypropionic acid alkyl esters (for example, methyl 2-alkyloxypropionate, ethyl 2-alkyloxypropionate, and propyl 2-alkyloxypropionate (for example, methyl 2-methoxypropionate, ethyl 2-methoxypropionate, propyl 2-methoxypropionate, methyl 2-ethoxypropionate, and ethyl 2-ethoxypropionate)), methyl 2-alkyloxy-2-methylpropionate and ethyl 2-alkyloxy-2-methylpropionate (for example, methyl 2-methoxy-2-methylpropionate and ethyl 2-ethoxy-2-methylpropionate), methyl pyruvate, ethyl pyruvate, propyl pyruvate, methyl acetoacetate, ethyl acetoacetate, methyl 2-oxobutanoate, ethyl 2-oxobutanoate, ethyl hexanoate, ethyl heptanoate, dimethyl malonate, and diethyl malonate.

Suitable examples of ethers include ethylene glycol dimethyl ether, diethylene glycol dimethyl ether, diethylene glycol diethyl ether, diethylene glycol ethyl methyl ether, diethylene glycol butyl methyl ether, triethylene glycol dimethyl ether, tetraethylene glycol dimethyl ether, tetrahydrofuran, ethylene glycol monomethyl ether, ethylene glycol monoethyl ether, methyl cellosolve acetate, ethyl cellosolve acetate, diethylene glycol monomethyl ether, diethylene glycol monoethyl ether, diethylene glycol monobutyl ether, propylene glycol monomethyl ether, propylene glycol dimethyl ether, propylene glycol monomethyl ether acetate, propylene glycol monoethyl ether acetate, ethylene glycol monobutyl ether, ethylene glycol monobutyl ether acetate, diethylene glycol ethyl methyl ether, propylene glycol monopropyl ether acetate, and dipropylene glycol dimethyl ether.

Suitable examples of the ketones include methyl ethyl ketone, cyclohexanone, cyclopentanone, 2-heptanone, 3-heptanone, 3-methylcyclohexanone, levoglucosenone, and dihydrolevoglucosenone.

Suitable examples of the cyclic hydrocarbon include aromatic hydrocarbons such as toluene, xylene, and anisole, and cyclic terpenes such as limonene.

Suitable examples of the sulfoxides include dimethyl sulfoxide.

Suitable examples of the amide include N-methyl-2-pyrrolidone, N-ethyl-2-pyrrolidone, N-cyclohexyl-2-pyrrolidone, N,N-dimethylacetamide, N,N-dimethylformamide, N,N-dimethylisobutylamide, 3-methoxy-N,N-dimethylpropionamide, 3-butoxy-N,N-dimethylpropionamide, N-formylmorpholine, and N-acetylmorpholine.

Suitable examples of the urea include N,N,N',N'-tetramethylurea and 1,3-dimethyl-2-imidazolidinone.

Examples of the alcohols include methanol, ethanol, 1-propanol, 2-propanol, 1-butanol, 1-pentanol, 1-hexanol, benzyl alcohol, ethylene glycol monomethyl ether, 1-methoxy-2-propanol, 2-ethoxyethanol, diethylene glycol monoethyl ether, diethylene glycol monohexyl ether, triethylene glycol monomethyl ether, propylene glycol monoethyl ether, propylene glycol monomethyl ether, polyethylene glycol monomethyl ether, polypropylene glycol, tetraethylene glycol, ethylene glycol monobutyl ether, ethylene glycol monobenzyl ether, ethylene glycol monophenyl ether, methylphenyl carbinol, n-amyl alcohol, methylamyl alcohol, and diacetone alcohol.

From the viewpoint of improving the properties of a coated surface or the like, it is also preferable to mix two or more kinds of solvents.

In the present invention, the solvent is preferably one solvent selected from methyl 3-ethoxypropionate, ethyl 3-ethoxypropionate, ethyl cellosolve acetate, ethyl lactate, diethylene glycol dimethyl ether, butyl acetate, methyl 3-methoxypropionate, 2-heptanone, cyclohexanone, cyclopentanone, γ-butyrolactone, dimethyl sulfoxide, ethyl carbitol acetate, butyl carbitol acetate, N-methyl-2-pyrrolidone, propylene glycol methyl ether, and propylene glycol methyl ether acetate, levoglucosenone, or dihydrolevoglucosenone, or a mixed solvent composed of two or more solvents selected therefrom. It is particularly preferable to use dimethyl sulfoxide and γ-butyrolactone in combination, or N-methyl-2-pyrrolidone and ethyl lactate in combination.

From the viewpoint of coatability, the content of the solvent is such that the concentration of the total solid contents of the resin composition according to the embodiment of the present invention is preferably 5% to 80% by mass, more preferably 5% to 75% by mass, still more preferably 10% to 70% by mass, and even still more preferably 20% to 70% by mass. The content of the solvent may be adjusted depending on the desired thickness of the coating film and the coating method.

The resin composition according to the embodiment of the present invention may contain only one kind of solvent or two or more kinds thereof. In a case where two or more kinds of solvents are contained, the total thereof is preferably within the above-described range.

<Metal adhesiveness improving agent>

The resin composition according to the embodiment of the present invention preferably contains a metal adhesiveness improving agent for improving adhesiveness to a metal material used for an electrode or a wire. Examples of the metal adhesiveness improving agent include a silane coupling agent having an alkoxysilyl group, an aluminum-based auxiliary adhesive agent, a titanium-based auxiliary adhesive agent, a compound having a sulfonamide structure and a compound having a thiourea structure, a phosphoric acid derivative compound, a β-ketoester compound, and an amino compound.

Among these, the resin composition according to the embodiment of the present invention preferably contains a silane coupling agent.

It is noted that although cyclic compounds containing nitrogen are present in the metal adhesiveness improvers exemplified below, these shall not be included in the above-described "nitrogen-containing cyclic compound".

[Silane coupling agent]

Examples of the silane coupling agent include the compounds described in paragraph 0167 of WO2015/199219A, the compounds described in paragraphs 0062 to 0073 of JP2014-191002A, the compounds described in paragraphs 0063 to 0071 of WO2011/080992A, the compounds described in paragraphs 0060 and 0061 of JP2014-191252A, the compounds described in paragraphs 0045 to 0052 of JP2014-041264A, the compounds described in paragraph 0055 of WO2014/097594A, and the compounds described in paragraphs 0067 to 0078 of JP2018-173573A, the contents of which are incorporated in the present specification. In addition, it is also preferable to use two or more kinds of different silane coupling agents as described in paragraphs 0050 to 0058 of JP2011-128358A. In addition, as the silane coupling agent, the following compounds are also preferably used. In the following formulae, Me represents a methyl group, and Et represents an ethyl group.

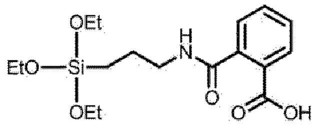
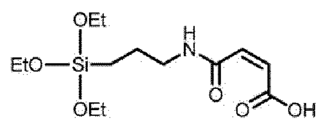

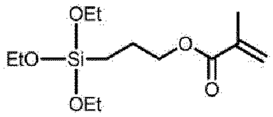
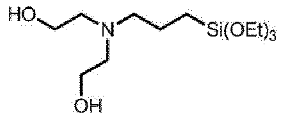
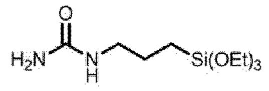

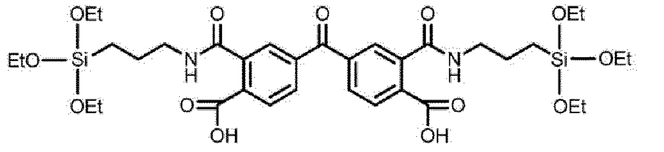

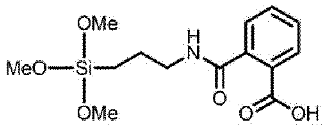
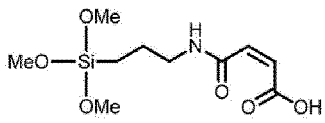

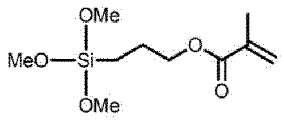
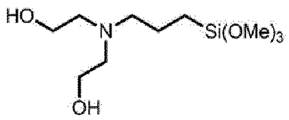
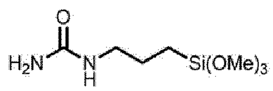

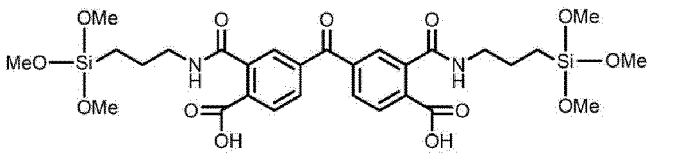

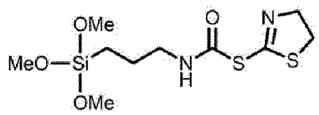
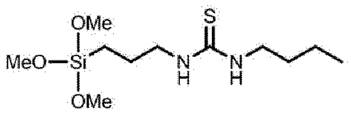

Examples of the other silane coupling agent include vinyltrimethoxysilane, vinyltriethoxysilane, 2-(3,4-epoxycyclohexyl)ethyltrimethoxysilane, 3-glycidoxypropylmethyldimethoxysilane, 3-glycidoxypropyltrimethoxysilane, 3-glycidoxypropylmethyldiethoxysilane, 3-glycidoxypropyltriethoxysilane, p-styryltrimethoxysilane, 3-methacryloxypropylmethyldimethoxysilane, 3-methacryloxypropyltrimethoxysilane, 3-methacryloxypropylmethyldiethoxysilane, 3-methacryloxypropyltriethoxysilane, 3-acryloxypropyltrimethoxysilane, N-2-(aminoethyl)-3-aminopropylmethyldimethoxysilane, N-2-(aminoethyl)-3-aminopropyltrimethoxysilane, 3-aminopropyltrimethoxysilane, 3-aminopropyltriethoxysilane, 3-triethoxysilyl-N-(1,3-dimethyl-butylidene)propylamine, N-phenyl-3-aminopropyltrimethoxysilane, tris-(trimethoxysilylpropyl)isocyanurate, 3-ureidopropyltrialkoxysilane, 3-mercaptopropylmethyldimethoxysilane, 3-mercaptopropyltrimethoxysilane, 3-isocyanatepropyltriethoxysilane, and 3-trimethoxysilylpropylsuccinic acid anhydride. These can be used alone or in a combination of two or more thereof.

[Aluminum-based auxiliary adhesive agent]

Examples of the aluminum-based auxiliary adhesive agent include aluminum tris(ethyl acetoacetate), aluminum tris(acetyl acetate), and ethyl acetoacetate aluminum diisopropylate.

In addition, as another metal adhesiveness improving agent, the compounds described in paragraphs 0046 to 0049 of JP2014-186186A, and the sulfide-based compounds described in paragraphs 0032 to 0043 of JP2013-072935A can also be used, the contents of which are incorporated in the present specification.

The content of the metal adhesiveness improving agent is preferably in a range of 0.01 to 30 parts by mass,

more preferably in a range of 0.1 to 10 parts by mass, and still more preferably in a range of 0.5 to 5 parts by mass, with respect to 100 parts by mass of the specific resin. In a case where the content is set to be equal to or higher than the above lower limit value, good adhesiveness between a pattern and a metal layer is exhibited, and in a case where the content is set to be equal to or lower than the above upper limit value, good heat resistance of the pattern and good mechanical properties are exhibited. One kind of metal adhesiveness improving agent may be used, or two or more kinds thereof may be used. In a case where two or more kinds thereof are used, the total content thereof is preferably within the above-described range.

<Migration suppressing agent>

The resin composition according to the embodiment of the present invention preferably further contains a migration suppressing agent. The incorporation of the migration suppressing agent makes it possible to effectively inhibit the movement of metal ions derived from a metal layer (a metal wire) into a film.

The migration suppressing agent is not particularly limited; however, examples thereof include thioureas, a compound having a sulfanyl group, a hindered phenol-based compound, a salicylic acid derivative-based compound, and a hydrazide derivative-based compound.

Alternatively, an ion trapping agent that captures an anion such as a halogen ion can also be used.

As other migration suppressing agents, the rust inhibitors described in paragraph 0094 of JP2013-015701A, the compounds described in paragraphs 0073 to 0076 of JP2009-283711A, the compounds described in paragraph 0052 of JP2011-059656A, the compounds described in paragraphs 0114, 0116, and 0118 of JP2012-194520A, the compounds described in paragraph 0166 of WO2015/199219A, or the like can be used, the contents of which are incorporated in the present specification.

However, among these, the compound contained in the above-described nitrogen-containing cyclic compound is not included in the migration suppressing agent.

In a case where the resin composition according to the embodiment of the present invention contains the migration suppressing agent, the content of the migration suppressing agent is preferably 0.01% to 5.0% by mass, more preferably 0.05% to 2.0% by mass, and still more preferably 0.1% to 1.0% by mass, with respect to the total solid content of the resin composition according to the embodiment of the present invention.

One kind of migration suppressing agent may be used alone, or two or more kinds thereof may be used. In a case where two or more kinds of migration suppressing agents are used, the total thereof is preferably within the above-described range.

<Polymerization Inhibitor>

The resin composition according to the embodiment of the present invention preferably contains a polymerization inhibitor. Examples of the polymerization inhibitor include a phenol-based compound, a quinone-based compound, an amino-based compound, an N-oxyl-free radical compound-based compound, a nitro-based compound, a nitroso-based compound, a heteroaromatic ring-based compound, and a metal compound.

As the specific compound of the polymerization inhibitor, p-hydroquinone, o-hydroquinone, o-methoxyphenol, p-methoxyphenol, di-tert-butyl-p-cresol, pyrogallol, p-tert-butylcatechol, 1,4-benzoquinone, diphenyl-p-benzoquinone, 4,4'-thiobis(3-methyl-6-tert-butylphenol), 2,2'-methylenebis(4-methyl-6-tert-butylphenol), an N-nitrosophenylhydroxyamine cerium (III) salt, an N-nitroso-N-phenylhydroxyamine aluminum salt, N-nitrosodiphenylamine, N-phenyl naphthylamine, ethylenediamine tetraacetic acid, 1,2-cyclohexanediamine tetraacetic acid, glycol ether diamine tetraacetic acid, 2,6-di-tert-butyl-4-methyl phenol, 5-nitroso-8-hydroxyquinoline, 1-nitroso-2-naphthol, 2-nitroso-1-naphthol, 2-nitroso-5-(N-ethyl-N-sulfopropylamino)phenol, an N-nitroso-N-(1-naphthyl)hydroxyamine ammonium salt, bis(4-hydroxy-3,5-tert-butyl)phenylmethane, 1,3,5-tris(4-t-butyl-3-hydroxy-2,6-dimethylbenzyl)-1,3,5-triazine-2,4,6-(1H,3H,5H)-trione, a 4-hydroxy-2,2,6,6-tetramethylpiperidin-1-oxyl free radical, 2,2,6,6-tetramethylpiperidin-1-oxyl free radical, phenothiazine, phenoxazine, 1,1-diphenyl-2-picrylhydrazyl, dibutyldithiocarbanate copper (II), nitrobenzene, an N-nitroso-N-phenylhydroxylamine aluminum salt, an N-nitroso-N-phenylhydroxylamine ammonium salt, or the like is suitably used. In addition, the polymerization inhibitors described in paragraph 0060 of JP2015-127817A and the compounds described in paragraphs 0031 to 0046 of WO2015/125469A can also be used, the contents of which are incorporated in the present specification.

In a case where the resin composition according to the embodiment of the present invention has a polymerization inhibitor, the content of the polymerization inhibitor is preferably 0.01% to 20% by mass, more preferably 0.02% to 15% by mass, and still more preferably 0.05% to 10% by mass, with respect to the total solid content of the resin composition according to the embodiment of the present invention.

One kind of polymerization inhibitor may be used, or two or more kinds thereof may be used. In a case where two or more kinds of polymerization inhibitors are used, the total thereof is preferably within the above-described range.

<Other additives>

The resin composition according to the embodiment of the present invention can be blended with various additives as necessary, for example, a surfactant, a higher fatty acid derivative, a thermal polymerization initiator, inorganic particles, an ultraviolet absorbing agent, an organic titanium compounds, an antioxidant, an aggregation preventing agent, a phenol-based compound, another polymer compound, a plasticizer, and other auxiliary agents (for example, an antifoaming agent, and a flame retardant) within the scope in which the effect of the present invention is obtained. By appropriately containing these components, properties such as film properties can be adjusted. The details of the components can be found in, for example, paragraphs "0183" and later of JP2012-003225A (corresponding to paragraph "0237" of US2013/0034812A) and paragraphs "0101" to "0104" and "0107" to "0109" of JP2008-250074A, the contents of which are incorporated in the present specification. In a case where these additives are blended, the total blending amount thereof is preferably 3% by mass or less of the solid content of the resin composition according to the embodiment of the present invention.

[Surfactant]

As the surfactant, various surfactants such as a fluorine-based surfactant, a silicone-based surfactant, and a hydrocarbon-based surfactant can be used. The surfactant may be a nonionic surfactant, a cationic surfactant, or an anionic surfactant.

In a case where a surfactant is contained in the photosensitive resin composition according to the embodiment of the present invention, the liquid characteristics (particularly, the fluidity) in a case of being prepared as a coating liquid are further improved, and thus the uniformity of the coating thickness and the liquid saving property can be further improved. That is, in a case where a film is formed using a coating liquid to which a composition containing a surfactant is applied, the interfacial tension between a surface to be coated and a coating liquid is reduced, the wettability to the surface to be coated is improved, and thus the coatability to the surface to be coated is improved. Therefore, a film having a uniform thickness with reduced unevenness in thickness can be formed more suitably.

Examples of the fluorine-based surfactant include MEGAFACE F171, MEGAFACE F172, MEGAFACE F173, MEGAFACE F176, MEGAFACE F177, MEGAFACE F141, MEGAFACE F142, MEGAFACE F143, MEGAFACE F144, MEGAFACE R30, MEGAFACE F437, MEGAFACE F475, MEGAFACE F479, MEGAFACE F482, MEGAFACE F554, MEGAFACE F780, RS-72-K (all of which manufactured by DIC Corporation); Fluorad FC430, Fluorad FC431, Fluorad FC171, Novec FC4430, and Novec FC4432 (all of which manufactured by 3M Japan Limited); Surflon S-382, Surflon SC-101, Surflon SC-103, Surflon SC-104, Surflon SC-105, Surflon SC1068, Surflon SC-381, Surflon SC-383, Surflon S393, and Surflon KH-40 (all of which manufactured by AGC Inc.); and PF636, PF656, PF6320, PF6520, and PF7002 (manufactured by OMNOVA Solutions Inc.). As the fluorine-based surfactant, the compounds described in paragraphs 0015 to 0158 of JP2015-117327A and the compounds described in paragraphs 0117 to 0132 of JP2011-132503A can also be used, the contents of which are incorporated in the present specification. A block polymer can also be used as the fluorine-based surfactant, and specific examples thereof include the compound described in JP2011-89090A, the content of which is incorporated in the present specification.

As the fluorine-based surfactant, a fluorine-containing polymer compound containing a repeating unit derived from a (meth)acrylate compound having a fluorine atom and a repeating unit derived from a (meth)acrylate compound having 2 or more (preferably 5 or more) alkyleneoxy groups (preferably ethyleneoxy groups or propyleneoxy groups) can also be preferably used, and examples of the fluorine-based surfactant that is used in the present invention include the following compounds as well.

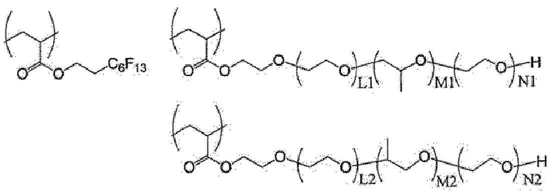

L1+N1+L2+N2=14
M1+M2=17

62% 38%

The weight-average molecular weight of the compounds is preferably 3,000 to 50,000 and more preferably 5,000 to 30,000.

Regarding the fluorine-based surfactant, a fluorine-containing polymer having an ethylenically unsaturated group in the side chain can also be used as the fluorine-based surfactant. Specific examples thereof include the compounds described in paragraphs "0050" to "0090" and "0289" to "0295" of JP2010-164965A, the content of which is

incorporated in the present specification. Further, examples of the commercially available product thereof include MEGAFACE RS-101, RS-102, and RS-718-K, all manufactured by DIC Corporation.

The fluorine content in the fluorine-based surfactant is suitably 3 to 40% by mass, more preferably 5 to 30% by mass, and particularly preferably 7 to 25% by mass. The fluorine-based surfactant in which the fluorine content is in the above-described range is effective from the viewpoints of the uniformity in the thickness of the coating film and liquid saving properties, and the solubility thereof in the composition is also excellent.

Examples of the silicone-based surfactant include TORAY SILICONE DC3PA, TORAY SILICONE SH7PA, TORAY SILICONE DC11PA, TORAY SILICONE SH21PA, TORAY SILICONE SH28PA, TORAY SILICONE SH29PA, TORAY SILICONE SH30PA, TORAY SILICONE SH8400 (all, manufactured by DuPont Toray Specialty Materials K.K.), TSF-4440, TSF-4300, TSF-4445, TSF-4460, TSF-4452 (all of which manufactured by Momentive Performance Materials Inc.), KP341, KF6001, KF6002 (all of which manufactured by Shin-Etsu Silicone Co., Ltd.), and BYK307, BYK323, and BYK330 (all of which manufactured by BYK Additives & Instruments).

Examples of the hydrocarbon-based surfactant include Pionin A-76, Newkalgen FS-3PG, Pionin B-709, Pionin B-811-N, Pionin D-1004, Pionin D-3104, Pionin D-3605, Pionin, D-6112, Pionin D-2104-D, Pionin D-212, Pionin D-931, Pionin D-941, Pionin D-951, Pionin E-5310, Pionin P-1050-B, Pionin P-1028-P, Pionin P-4050-T (all of which are manufactured by TAKEMOTO OIL & FAT Co., Ltd.).

Examples of the nonionic surfactant include glycerol, trimethylolpropane, and trimethylolethane, and an ethoxylate and propoxylate thereof (for example, glycerol propoxylate, glycerol ethoxylate, or the like), polyoxyethylene lauryl ether, polyoxyethylene stearyl ether, polyoxyethylene oleyl ether, polyoxyethylene octylphenyl ether, polyoxyethylene nonylphenyl ether, polyethylene glycol dilaurate, polyethylene glycol distearate, and sorbitan fatty acid ester. Examples of the commercially available product include Pluronic (registered trade name) L10, L31, L61, L62, 10R5, 17R2, and 25R2 (manufactured by BASF SE), Tetronic 304, 701, 704, 901, 904, and 150R1 (manufactured by BASF SE), Solsperse 20000 (Lubrizol Japan Limited), NCW-101, NCW-1001, and NCW-1002 (manufactured by FUJIFILM Wako Pure Chemical Corporation), Pionin D-6112, D-6112-W, and D-6315 (manufactured by TAKEMOTO OIL & FAT Co., Ltd.), and OLFINE E1010, SURFYNOL 104, 400, and 440 (manufactured by Nissin Chemical Co., Ltd.).

Specific examples of the cationic surfactant include an organosiloxane polymer KP341 (manufactured by Shin-Etsu Chemical Co., Ltd.), a (meth)acrylic acid-based (co)polymer POLYFLOW No. 75, No. 77, No. 90, or No. 95 (manufactured by Kyoeisha Chemical Co., Ltd.), W001 (manufactured by Yusho Co., Ltd.).

Specific examples of the anionic surfactant include W004, W005, W017 (manufactured by Yusho Co., Ltd.), and SANDET BL (manufactured by Sanyo Chemical Industries, Ltd.).

Only one kind of surfactant may be used, or two or more kinds thereof may be used in combination.

The content of the surfactant is preferably 0.001% to 2.0% by mass and more preferably 0.005% to 1.0% by mass with respect to the total solid content of the composition.

[Higher fatty acid derivative]

In the resin composition according to the embodiment of the present invention, in order to prevent polymerization inhibition due to oxygen, a higher fatty acid derivative such as behenic acid or behenic acid amide may be added and be caused to be localized on a surface of the resin composition according to the embodiment of the present invention in the process of drying after coating.

In addition, as the higher fatty acid derivative, the compounds described in paragraph 0155 of WO2015/199219A can also be used, the content of which is incorporated in the present specification.

In a case where the resin composition according to the embodiment of the present invention has a higher fatty acid derivative, the content of the higher fatty acid derivative is preferably 0.1% to 10% by mass with respect to the total solid content of the resin composition according to the embodiment of the present invention. One kind of higher fatty acid derivative may be used, or two or more kinds thereof may be used. In a case where two or more kinds of higher fatty acid derivatives are used, the total thereof is preferably within the above-described range.

[Thermal polymerization initiator]

The resin composition according to the embodiment of the present invention may contain a thermal polymerization initiator and particularly may contain a thermal radical polymerization initiator. The thermal radical polymerization initiator is a compound that generates a radical by heat energy and initiates or accelerates a polymerization reaction of a compound having polymerization properties. In a case where a thermal radical polymerization initiator is added, the polymerization reaction of the resin and the polymerizable compound can be allowed to proceed, and thus the solvent resistance can be further improved. In addition, there is a case where the above-described photopolymerization initiator also has a function of initiating polymerization by heat, and thus there is a case where it can be added as a thermal polymerization initiator.

Specific examples of thermal radical polymerization initiator include compounds described in paragraphs 0074 to 0118 of JP2008-063554A, the content of which is incorporated in the present specification.
In a case where thermal polymerization initiator is contained, the content thereof is preferably 0.1% to 30% by mass, with respect to the total solid content of the resin composition according to the embodiment of the present invention, more preferably 0.1% to 20% by mass, and still more preferably 0.5% to 15% by mass. Only one kind of thermal polymerization initiator may be contained, or two or more kinds thereof may be contained. In a case where two or more kinds of thermal polymerization initiators are contained, the total amount thereof is preferably within the above-described range.

[Inorganic particle]

The resin composition according to the embodiment of the present invention may contain inorganic fine particles. Specific examples of the inorganic particle include calcium carbonate, calcium phosphate, silica, kaolin, talc, titanium dioxide, alumina, barium sulfate, calcium fluoride, lithium fluoride, zeolite, molybdenum sulfide, and glass.
The average particle diameter of the inorganic particles is preferably 0.01 to 2.0 μm, more preferably 0.02 to 1.5 μm, still more preferably 0.03 to 1.0 μm, and particularly preferably 0.04 to 0.5 μm.
The average particle diameter of the fine particles is the primary particle diameter and the volume average particle diameter. The volume average particle diameter can be measured by a dynamic light scattering method with Nanotrac WAVE II EX-150 (manufactured by Nikkiso Co., Ltd.).
In a case where the above measurement is difficult, the measurement can also be carried out by a centrifugal sedimentation light transmission method, an X-ray transmission method, or a laser diffraction/light scattering method.

[Ultraviolet absorbing agent]

The composition according to the embodiment of the present invention may contain an ultraviolet absorbing agent. As the ultraviolet absorbing agent, an ultraviolet absorbing agent such as a salicylate-based, a benzophenone-based, a benzotriazole-based, a substituted acrylonitrile-based, or a triazine-based ultraviolet absorbing agent can be used.
It is noted that although cyclic compounds containing nitrogen are present in the ultraviolet absorbing agents exemplified below, these shall not be included in the above-described "nitrogen-containing cyclic compound".
Examples of the salicylate-based ultraviolet absorbing agent include phenyl salicylate, p-octylphenyl salicylate, and p-t-butylphenyl salicylate, and examples of the benzophenone-based ultraviolet absorbing agent include 2,2'-dihydroxy-4-methoxybenzophenone, 2,2'-dihydroxy-4,4'-dimethoxybenzophenone, 2,2',4,4'-tetrahydroxybenzophenone, 2-hydroxy-4-methoxybenzophenone, 2,4-dihydroxybenzophenone, and 2-hydroxy-4-octoxybenzophenone. Examples of the benzotriazole-based ultraviolet absorbing agents include 2-(2'-hydroxy-3',5'-di-tert-butylphenyl)-5-chlorobenzotriazole, 2-(2'-hydroxy-3'-tert-butyl-5'-methylphenyl)-5-chlorobenzotriazole, 2-(2'-hydroxy-3'-tert-amyl-5'-isobutylphenyl)-5-chlorobenzotriazole, 2-(2'-hydroxy-3'-isobutyl-5'-methylphenyl)-5-chlorobenzotriazole, 2-(2'-hydroxy-3'-isobutyl-5'-propylphenyl)-5-chlorobenzotriazole, 2-(2'-hydroxy-3',5'-di-tert-butylphenyl)benzotriazole, 2-(2'-hydroxy-5'-methylphenyl)benzotriazole, and 2-[2'-hydroxy-5'-(1,1,3,3-tetramethyl)phenyl]benzotriazole.
Examples of the substituted acrylonitrile-based ultraviolet absorbing agent include ethyl 2-cyano-3,3-diphenylacrylate and 2-ethylhexyl 2-cyano-3,3-diphenylacrylate. Further, examples of the triazine-based ultraviolet absorbing agent include mono(hydroxyphenyl)triazine compounds such as 2-[4-[(2-hydroxy-3-dodecyloxypropyl)oxy]-2-hydroxyphenyl]-4,6-bis(2,4-dimethylphenyl)-1, 3,5-triazine, 2-[4-[(2-hydroxy-3-tridecyloxypropyl)oxy]-2-hydroxyphenyl]-4,6-bis(2,4-dimethylphenyl)-1, 3,5-triazine, and 2-(2,4-dihydroxyphenyl)-4,6-bis(2,4-dimethylphenyl)-1,3,5-triazine; bis(hydroxyphenyl)triazine compounds such as 2,4-bis(2-hydroxy-4-propyloxyphenyl)-6-(2,4-dimethylphenyl)-1,3, 5-triazine, 2,4-bis(2-hydroxy-3-methyl)-4-propyloxyphenyl)-6-(4-methylphenyl)-1,3,5-triazine, and 2,4-bis(2-hydroxy-3-methyl-4-hexyloxyphenyl)-6-(2,4-dimethylphenyl)-1,1,3,5-triazine; and tris(hydroxyphenyl)triazine compounds such as 2,4-bis(2-hydroxy-4-butoxyphenyl)-6-(2,4-dibutoxyphenyl))-1,3,5-triazine, 2,4,6-tris(2-hydroxy-4-octyloxyphenyl)-1,3,5-triazine, and 2,4,6-tris[2-hydroxy-4-(3-butoxy-2-hydroxypropyloxy)phenyl]-1,3,5-triazine.
In the present invention, the above-described various ultraviolet absorbing agents may be used alone, or two or more thereof may be used in combination.
The composition according to the embodiment of the present invention may contain or may not contain an ultraviolet absorbing agent. However, in a case of being contained, the content of the ultraviolet absorbing agent is preferably 0.001% by mass or more and 1% by mass or less, and more preferably 0.01% by mass or more and 0.1% by mass or less, with respect to the total solid content mass of the composition according to the embodiment of the present invention.

[Organic titanium compound]

The resin composition of the present embodiment may contain an organic titanium compound. In a case where the resin composition contains an organic titanium compound, it is possible to form a resin layer having excellent chemical resistance even in a case where curing is carried out at a low temperature.
Examples of the usable organic titanium compound include those in which an organic group is bonded to a titanium atom through a covalent bond or an ionic bond.
Specific examples of the organic titanium compound are described in I) to VII) below:

I) Titanium chelate compounds: among them, a titanium chelate compound having two or more alkoxy groups is more preferable since the resin composition has good storage stability and a good curing pattern can be obtained. Specific examples thereof include titanium bis(triethanolamine)diisopropoxide, titanium di(n-butoxide) bis(2,4-pentanedionate), titanium diisopropoxide bis(2,4-pentanedionate), titanium diisopropoxide bis(tetramethylheptandionate), and titanium diisopropoxide bis(ethyl acetoacetate).
II) Tetraalkoxy titanium compounds: examples thereof include titanium tetra(n-butoxide), titanium tetraethoxide, titanium tetra(2-ethylhexoxide), titanium tetraisobutoxide, titanium tetraisopropoxide, titanium tetramethoxide, titanium tetramethoxypropoxide, titanium tetramethylphenoxide, titanium tetra(n-nonyloxide), titanium tetra(n-propoxide), and titanium tetrastearyloxide, titanium tetrakis[bis{2,2-(aryloxymethyl)butoxide}].
III) Titanocene compounds: examples thereof include pentamethylcyclopentadienyl titanium trimethoxide, bis(η5-2,4-cyclopentadien-1-yl)bis(2,6-difluorophenyl)titanium, and bis(η5-2,4-cyclopentadien-1-yl)bis(2,6-difluoro-3-(1H-pyrrol-1-yl)phenyl)titanium.
IV) Monoalkoxytitanium compounds: examples thereof include titanium tris(dioctyl phosphate)isopropoxide, and titanium tris(dodecylbenzene sulfonate)isopropoxide.
V) Titanium oxide compounds: examples thereof include titanium oxide bis(pentanedionate), titanium oxide bis(tetramethylheptandionate), and phthalocyanine titanium oxide.
VI) Titanium tetraacetylacetonate compounds: examples thereof include titanium tetraacetylacetonate.
VII) Titanate coupling agents: examples thereof include isopropyltridodecylbenzenesulfonyl titanate.

Among them, it is preferable that the organic titanium compound is at least one compound selected from the group consisting of the above-described I) titanium chelate compound, II) tetraalkoxytitanium compound, and III) titanocene compound, from the viewpoint that better chemical resistance is exhibited. In particular, titanium diisopropoxide bis(ethyl acetoacetate), titanium tetra(n-butoxide), or bis(η5-2,4-cyclopentadiene-1-yl) bis(2,6-difluoro-3-(1H-pyrrole-1-yl)phenyl)titanium is preferable.
In a case where an organic titanium compound is blended, the blending amount thereof is preferably 0.05 to 10 parts by mass and more preferably 0.1 to 2 parts by mass with respect to 100 parts by mass of the specific resin. In a case where the blending amount is 0.05 parts by mass or more, good heat resistance and good chemical resistance are more effectively exhibited in the curing pattern to be obtained. On the other hand, in a case where it is 10 parts by mass or less, the storage stability of the composition is more excellent.

[Antioxidant]

The composition according to the embodiment of the present invention may contain an antioxidant. In a case where an antioxidant is contained as an additive, it is possible to improve the elongation characteristics of the film after curing and the adhesiveness to the metal material. Examples of the antioxidant include a phenol compound, a phosphorous acid ester compound, and a thioether compound. As the phenol compound, any phenol compound known as the phenolic antioxidant can be used. Examples of the preferred phenol compound include a hindered phenol compound. A compound having a substituent at a site (ortho position) adjacent to a phenolic hydroxy group is preferable. As the substituent described above, a substituted or unsubstituted alkyl group having 1 to 22 carbon atoms is preferable. In addition, as the antioxidant, a compound having a phenol group and a phosphite ester group in the same molecule is also preferable. In addition, as the antioxidant, a phosphorus-based antioxidant can also be suitably used. Examples of the phosphorus-based antioxidant include tris[2-[[2,4,8,10-tetrakis(1,1-dimethylethyl)dibenzo[d, f][1,3,2]dioxaphosphepin-6-yl]oxy]ethyl]amine, tris[2-[(4,6,9,11-tetra-tert-butyldibenzo[d, f][1,3,2]dioxaphosphepin-2-yl)oxy]ethyl]amine, and ethyl phosphite bis(2,4-di-tert-butyl-6-methylphenyl). Examples of the commercially available product of the antioxidant include ADK STAB AO-20, ADK STAB AO-30, ADK STAB AO-40, ADK STAB AO-50, ADK STAB AO-50F, ADK STAB AO-60, ADK STAB AO-60G, ADK STAB AO-80, and ADK STAB AO-330 (all of which are manufactured by ADEKA Corporation). In addition, as the antioxidant, the compounds described in paragraph Nos. 0023 to 0048 of JP6268967B can also be used, the content of which is incorporated in the present specification. Further, the composition of the embodiment of the present invention may contain a potential antioxidant, as necessary. Examples of the potential

antioxidant include a compound in which a portion that functions as the antioxidant is protected by a protective group and the protective group is desorbed by heating the compound at 100°C to 250°C or by heating the compound at 80°C to 200°C in the presence of an acid/a base catalyst. Examples of the potential antioxidant include the compounds described in WO2014/021023A, WO2017/030005A, and JP2017-008219A, the contents of which are incorporated in the present specification. Examples of the commercially available product of the potential antioxidant include ADEKA ARKLS GPA-5001 (manufactured by ADEKA Corporation).

Examples of the preferred antioxidant include 2,2-thiobis(4-methyl-6-t-butylphenol), 2,6-di-t-butylphenol, and a compound represented by Formula (3).

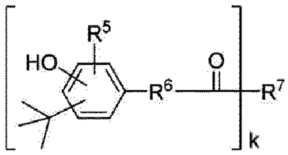

(3)

In General Formula (3), $R^5$ represents a hydrogen atom or an alkyl group having 2 or more carbon atoms (preferably 2 to 10 carbon atoms), and $R^6$ represents an alkylene group having 2 or more carbon atoms (preferably 2 to 10 carbon atoms). $R^7$ represents a monovalent to tetravalent organic group containing at least any one of an alkylene group having 2 or more carbon atoms (preferably having 2 to 10 carbon atoms), an oxygen atom, or a nitrogen atom. k represents an integer of 1 to 4.

The compound represented by Formula (3) suppresses the oxidative deterioration of the aliphatic group or the phenolic hydroxy group, contained in the resin. In addition, metal oxidation can be suppressed by the rust prevention action on the metal material.

Since the above compound can act on the resin and the metal material at the same time, k is more preferably an integer of 2 to 4. Examples of $R^7$ include an alkyl group, a cycloalkyl group, an alkoxy group, an alkyl ether group, an alkylsilyl group, an alkoxysilyl group, an aryl group, an aryl ether group, a carboxy group, a carbonyl group, an allyl group, a vinyl group, a heterocyclic group, -O-, -NH-, -NHNH-, and combinations thereof, and R7 may further have a substituent. Among these, an alkyl ether group or -NH- is preferably contained from the viewpoints of solubility in a developer and metal adhesiveness, and -NH- is more preferably contained from the viewpoints of the metal adhesiveness due to interaction with a resin and the metal complex formation.

Examples of the compound represented by General Formula (3) include the following compounds; however, the structure thereof is not limited to the following structure.

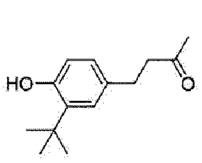

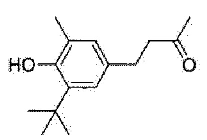

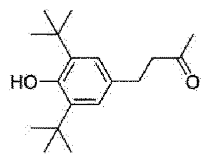

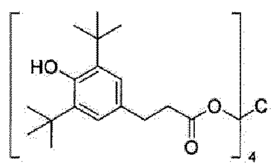

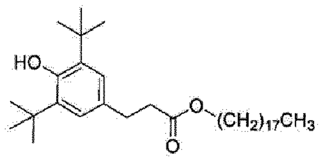

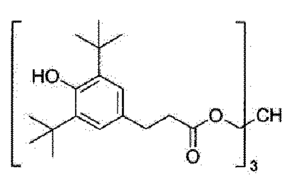

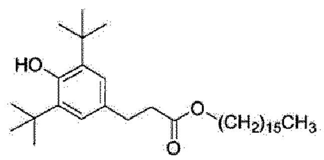

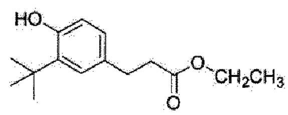

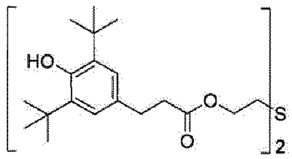

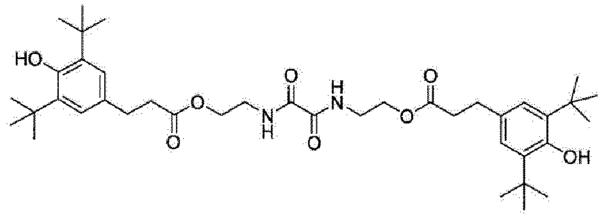

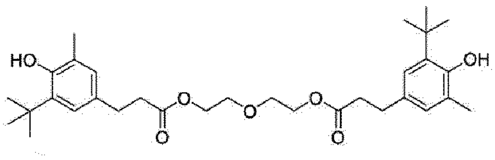

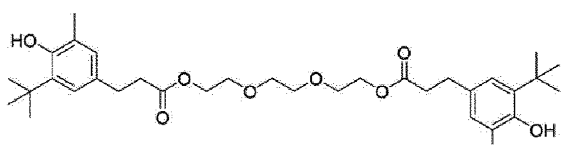

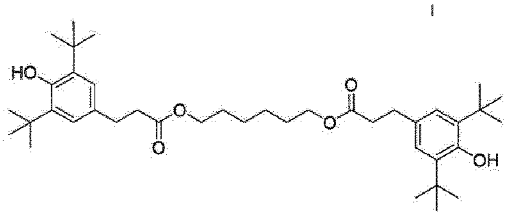

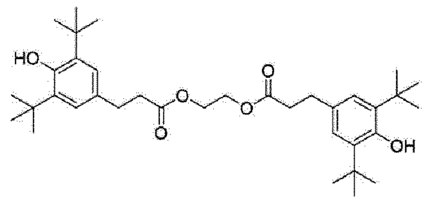

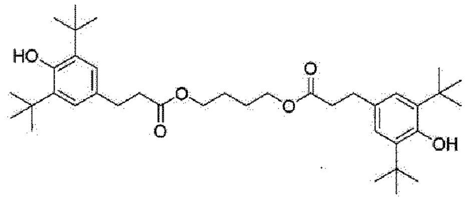

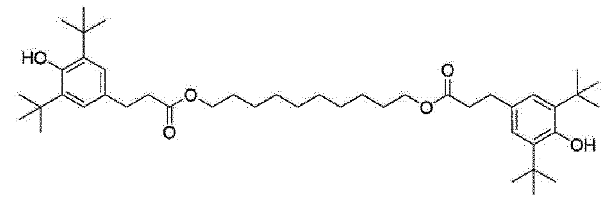

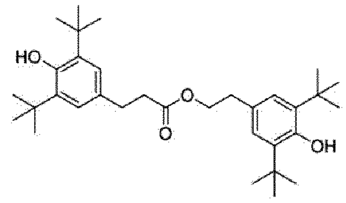

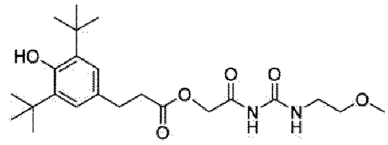

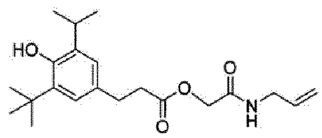

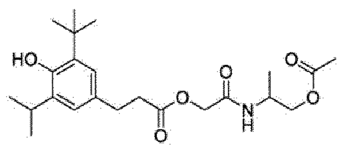

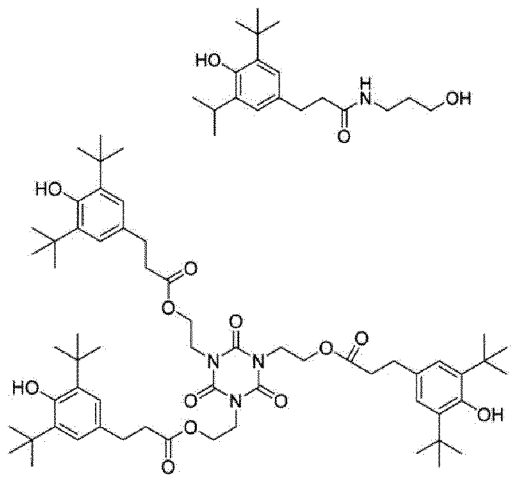

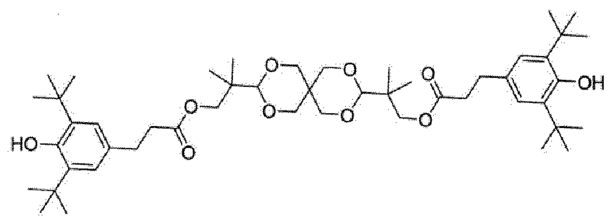

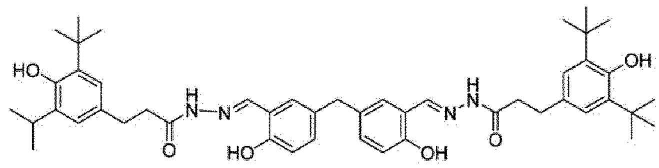

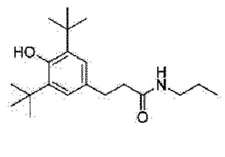

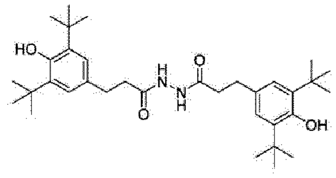

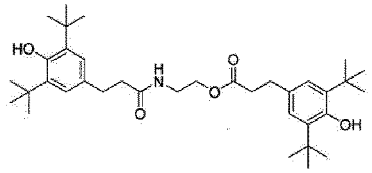

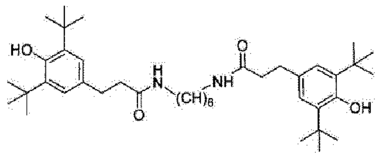

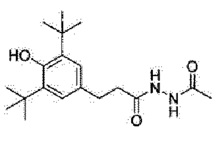

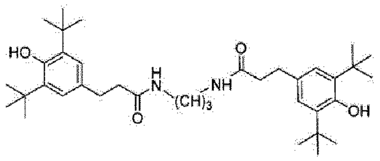

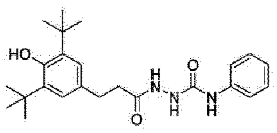

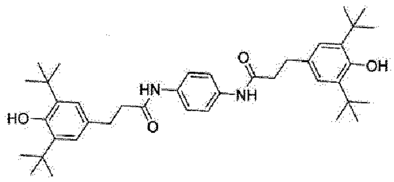

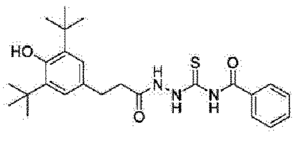

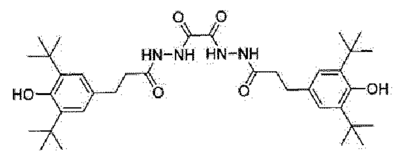

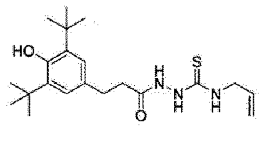

The adding amount of the antioxidant is preferably 0.1 to 10 parts by mass and more preferably 0.5 to 5 parts by mass with respect to 100% parts by mass of the specific resin. In a case where the adding amount is set to 0.1 parts by mass or more, the effect of improving the elongation characteristics and the adhesiveness to the metal material can be easily obtained even in a high temperature and high humidity environment, and in a case where the adding amount is set to 10 parts by mass or less, the sensitivity of the resin composition is improved, for example, by the interaction with the photosensitizing agent. In the present invention, the antioxidant may be used singly or in a combination of two or more kinds thereof. In a case where two or more kinds thereof are used, the total amount thereof is preferably within the above-described range.

[Aggregation preventing agent]

The resin composition of the present embodiment may contain an aggregation preventing agent, as necessary. Examples of the aggregation preventing agent include sodium polyacrylate.

In the present invention, one kind of aggregation preventing agent may be used alone, or two or more thereof may be used in combination.

The composition according to the embodiment of the present invention may contain or may not contain an aggregation preventing agent. However, in a case of being contained, the content of the aggregation preventing agent is preferably 0.01% by mass or more and 10% by mass or less, and more preferably 0.02% by mass or more and 5% by mass or less, with respect to the total solid content mass of the composition according to the embodiment of the present invention.

[Phenol-based compound]

The resin composition of the present embodiment may contain a phenol-based compound, as necessary. Examples of the phenol-based compound include Bis-Z, BisP-EZ, TekP-4HBPA, TrisP-HAP, TrisP-PA, BisOCHP-Z, BisP-MZ, BisP-PZ, BisP-IPZ, BisOCP-IPZ, BisP-CP, BisRS-2P, BisRS-3P, BisP-OCHP, Methylene tris-FR-CR, BisRS-26X (all, product names, manufactured by Honshu Chemical Industry Co., Ltd.), BIP-PC, BIR-PC, BIR-PTBP, and BIR-BIPC-F (all, product names, manufactured by ASAHI YUKIZAI Corporation).

In the present invention, one kind of phenol-based compound may be used alone, or two or more thereof may be used in combination.

The composition according to the embodiment of the present invention may contain or may not contain a phenol-based compound. However, in a case of being contained, the content of the phenol-based compound is preferably 0.01% by mass or more and 30% by mass or less, and more preferably 0.02% by mass or more and 20% by mass or less, with respect to the total solid content mass of the composition according to the embodiment of the present invention.

[Polymer compound A]

Examples of the other polymer compound include a siloxane resin, a (meth)acrylic polymer obtained by copolymerizing (meth)acrylic acid, a novolak resin, a resol resin, a polyhydroxystyrene resin, and a copolymer thereof. The other polymer compound may be a modified polymer into which a crosslinking group such as a methylol group, an alkoxymethyl group, or an epoxy group has been introduced.

In the present invention, one kind of the other polymer compound may be used alone, or two or more thereof may be used in combination.

The composition according to the embodiment of the present invention may contain or may not contain another polymer compound. However, in a case of being contained, the content of the other polymer compound is preferably 0.01% by mass or more and 30% by mass or less, and more preferably 0.02% by mass or more and 20% by mass or less, with respect to the total solid content mass of the composition according to the embodiment of the present invention.

<Characteristics of resin composition>

The viscosity of the resin composition according to the embodiment of the present invention can be adjusted by adjusting the concentration of solid contents of the resin composition. From the viewpoint of the coating film thickness, it is preferably 20 $mm^2$/s to 12,000 $mm^2$/s, more preferably 30 $mm^2$/s to 10,000 $mm^2$/s, and still more preferably 50 $mm^2$/s to 8,000 $mm^2$/s. Within the above range, it is easy to obtain a coating film having high uniformity. In a case of being 20 $mm^2$/s or more and further 1,000 $mm^2$/s or more, it is easy to carry out coating at a film thickness to be required as, for example, an insulating film for a re-distribution, and in a case of being 12,000 $mm^2$/s or less, a coating film having an excellent coating surface shape is obtained.

<Restrictions on substances contained in resin composition>

The moisture content of the resin composition according to the embodiment of the present invention is preferably less than 2.0% by mass, more preferably less than 1.5% by mass, and still more preferably less than 1.0% by mass. In a case of being less than 2.0%, the storage stability of the resin composition is improved.

Examples of the method of maintaining the water content include adjusting the humidity under storage conditions and reducing the void volume of the storage container during storage.

From the viewpoint of insulating properties, the metal content of the resin composition according to the embodiment of the present invention is preferably less than 5 parts per million (ppm) by mass, more preferably less than 1 ppm by mass, and still more preferably less than 0.5 ppm by mass. Examples of the metal include sodium, potassium, magnesium, calcium, iron, copper chromium, and nickel, however, a metal contained as a complex of an organic compound and a metal is excluded. In a case where a plurality of metals are contained, the total of these metals is preferably within the above-described range.

In addition, as a method of reducing metal impurities which are unintentionally contained in the resin composition according to the embodiment of the present invention, a method of selecting a raw material containing a low metal content as the raw material that constitutes the resin composition according to the embodiment of the present invention, a method of filtering a raw material constituting the resin composition according to the embodiment of the present invention, a method of distilling under the conditions in which the inside of the device is lined with polytetrafluoroethylene or the like to suppress the contamination as little as possible, and the like can be mentioned.

In the resin composition according to the embodiment of the present invention, in a case of considering the use application as a semiconductor material, the content of halogen atoms is preferably less than 500 ppm by mass,

more preferably less than 300 ppm by mass, and still more preferably less than 200 ppm by mass, from the viewpoint of wire corrosiveness. Among these, in a case of being present in a halogen ion state, the content is preferably less than 5 ppm by mass, more preferably less than 1 ppm by mass, and still more preferably less than 0.5 ppm by mass. Examples of the halogen atom include a chlorine atom and a bromine atom. It is preferable that the total content of the chlorine atom and the bromine atom, or the total content of the chlorine ion and the bromine ion is within the above-described range.

Preferred examples of the method of adjusting the content of halogen atoms include ion exchange treatment.

A conventionally known storage container can be used as a storage container for the resin composition according to the embodiment of the present invention. In addition, as the storage container, for the intended purpose of suppressing the incorporation of impurities into the raw materials and the resin composition according to the embodiment of the present invention, a multilayer bottle in which an inner wall of a container is composed of six kinds of six layers of resin, and a bottle with six kinds of resin being made as a seven-layer structure are preferably used. Examples of such a container include the container described in JP2015-123351A.

<Cured substance of resin composition>

In a case of curing the resin composition according to the embodiment of the present invention, it is possible to obtain a cured substance of this resin composition.

The cured substance according to the embodiment of the present invention is a cured substance formed by curing the resin composition according to the embodiment of the present invention.

The curing of the resin composition is preferably by heating, more preferably by heating at a heating temperature within a range of 120°C to 400°C, still more preferably by heating at a heating temperature within a range of 140°C to 380°C, and particularly preferably by heating at a heating temperature within a range of 170°C to 350°C. The form of the cured substance of the resin composition is not particularly limited and can be selected depending on the use application, where the form includes a film shape, a rod shape, a spherical shape, a pellet shape, and the like. In the present invention, the cured substance preferably has a film shape. In addition, the shape of this cured substance can also be selected depending on the use application by the pattern processing of the resin composition, where the use application includes formation of a protective film on a wall surface, formation of via holes for conduction, adjustment of impedance, capacitance, or internal stress, and impartment of heat radiation function. The film thickness of the cured substance (the film consisting of the cured substance) is preferably 0.5 μm or more and 150 μm or less.

The shrinkage ratio of the resin composition according to the embodiment of the present invention after curing is preferably 50% or less, more preferably 45% or less, and still more preferably 40% or less. Here, the shrinkage ratio refers to a percentage of a change in the volume of the resin composition before and after curing, and it can be calculated according to the following expression.

$$\text{Shrinkage ratio [\%]} = 100 - (\text{volume after curing}/\text{volume before curing}) \times 100$$

<Characteristics of cured substance of resin composition>

The imidization reaction rate of the cured substance of the resin composition according to the embodiment of the present invention is preferably 70% or more, more preferably 80% or more, and still more preferably 90% or more. In a case of being 70% or more, a cured substance having excellent mechanical properties may be obtained.

The breaking elongation of the cured substance of the resin composition according to the embodiment of the present invention is preferably 30% or more, more preferably 40% or more, and still more preferably 50% or more.

The glass transition temperature (Tg) of the cured substance of the resin composition according to the embodiment of the present invention is preferably 180°C or higher, more preferably 210°C or higher, and still more preferably 230°C or higher.

<Preparation of resin composition>

The resin composition according to the embodiment of the present invention can be prepared by mixing the above-described components. The mixing method is not particularly limited, and mixing can be carried out by methods conventionally known in the related art.

For mixing, it is possible to employ mixing with a stirring blade, mixing with a ball mill, mixing by rotating the tank itself, or the like.

The temperature during the mixing is preferably 10°C to 30°C, and more preferably 15°C to 25°C.

In addition, for the intended purpose of removing foreign substances such as dust and fine particles in the resin composition according to the embodiment of the present invention, it is preferable to carry out filtration using a filter.

Examples of the pore diameter of the filter include an aspect of 5 μm or less, and the pore diameter thereof is preferably 1 μm or less, more preferably 0.5 μm or less, and still more preferably 0.1 μm or less. The material of the filter is preferably polytetrafluoroethylene, polyethylene, or nylon. In a case where the material of the filter is polyethylene, it is more preferable to use high density polyethylene (HDPE). As the filter, a filter which has been washed with an organic solvent in advance may be used. In the filtration step using the filter, a plurality of kinds of filters may be connected in series or in parallel and used. In a case where a plurality of kinds of filters are used, filters having different pore diameters or different materials may be used in combination. Examples of the connection aspect include an aspect in which an HDPE filter having a pore diameter of 1 μm is connected in series as the first stage and an HDPE filter having a pore diameter of 0.2 μm is connected in series as the second stage. In addition, various materials may be filtered a plurality of times. In a case of being filtered a plurality of times, circulation filtration may be used. In addition, filtration may be carried out under pressure. In a case where filtration is carried out under pressure, an aspect in which the pressure to be applied is, for example, 0.01 MPa or more and 1.0 MPa or less is mentioned, and the pressure is preferably 0.03 MPa or more and 0.9 MPa or less, more preferably 0.05 MPa or more and 0.7 MPa or less, and still more preferably 0.05 MPa or more and 0.5 MPa or less.

In addition to filtration using a filter, impurity removal treatment using an adsorbing material may be carried out. The filtration using a filter and the impurity removal treatment using an adsorbing material may be combined. As the adsorbing material, a conventionally known adsorbing material can be used. Examples thereof include an inorganic adsorbing material such as silica gel and zeolite and an organic adsorbing material such as activated carbon.

Furthermore, after filtration using a filter, a step of placing a bottle filled with the resin composition under reduced pressure to carry out degassing may be provided.

(Manufacturing method for cured substance)

It is preferable that the manufacturing method for a cured substance according to the embodiment of the present invention includes a film forming step of applying the resin composition onto a base material to form a film, an exposure step of selectively exposing the film, and a development step of developing, by using a developer, the film exposed in the exposure step to form a pattern.

It is more preferable that the manufacturing method for a cured substance according to the embodiment of the present invention includes the film forming step, the exposure step, the development step, and at least one of a heating step of heating a pattern obtained by the development step or a post-development exposure step of exposing the pattern obtained by the development step.

In addition, it is also preferable that the manufacturing method according to the embodiment of the present invention includes the film forming step and a step of heating the film.

Hereinafter, details of each step will be described.

<Film forming step>

The resin composition according to the embodiment of the present invention can be applied onto a base material, thereby being used in a film forming step of forming a film.

The manufacturing method for a cured substance according to the embodiment of the present invention preferably includes a film forming step of applying a resin composition onto a base material to form a film.

[Base material]

The kind of base material can be appropriately determined depending on the use application, and examples thereof are a base material for semiconductor production, such as silicon, silicon nitride, polysilicon, silicon oxide, or amorphous silicon, quartz, glass, an optical film, a ceramic material, a vapor-deposited film, a magnetic film, a reflective film, a metal base material (for example, it may be any one of a base material formed from a metal or a base material having a metal layer formed by plating, vapor deposition, or the like) such as Ni, Cu, Cr, or Fe, paper, spin-on-glass (SOG), a thin film transistor (TFT) array base material, a mold base material, and an electrode plate of a plasma display panel (PDP), which are not particularly limited. In the present invention, in particular, a base material for semiconductor production is preferable, and a silicon base material, a Cu base material, or a mold base material is more preferable.

In addition, a layer such as an adhesion layer made of hexamethyl disilazane (HMDS) or the like, or an oxide layer may be provided on the surface of these base materials.

In addition, the shape of the base material is not particularly limited, and it may be a circular shape or may be a rectangular shape.

Regarding the size of the base material, for example in a case of a circular shape, the diameter thereof is 100 to 450 mm and preferably 200 to 450 mm. In a case where the shape is rectangular, for example, the length of the short

side is 100 to 1,000 mm and preferably 200 to 700 mm.

Further, as the base material, for example, a base material having a plate shape and preferably a base material (a substrate) having a panel shape are used.

In a case where the resin composition is applied to form a film on a surface of a resin layer (for example, a layer consisting of a cured substance) or on a surface of a metal layer, the resin layer or the metal layer serves as the base material.

The means for applying the resin composition according to the embodiment of the present invention onto a base material is preferably coating.

Specific examples of the means for application include a dip coating method, an air knife coating method, a curtain coating method, a wire bar coating method, a gravure coating method, an extrusion coating method, a spray coating method, a spin coating method, a slit coating method, and an ink jet method. From the viewpoint of the uniformity of the film thickness, the spin coating method, the slit coating method, the spray coating method, or the ink jet method is more preferable, and from the viewpoint of the uniformity of the film thickness and the viewpoint of productivity, a spin coating method or a slit coating method is preferable. A film having a desired thickness can be obtained by adjusting the concentration of solid contents of the resin composition and application conditions according to the method. In addition, the coating method can be appropriately selected depending on the shape of the base material. In a case where a circular base material such as a wafer is used, the spin coating method, the spray coating method, the ink jet method, and the like are preferable, and in a case where a rectangular base material is used, the slit coating method, the spray coating method, the ink jet method, and the like are preferable. For example, the spin coating method can be applied at a rotation speed of 500 to 3,500 rpm for about 10 seconds to 3 minutes.

In addition, it is also possible to apply a method of transferring a coating film formed in advance on a temporary support by the above-described coating method, onto a base material.

Regarding the transfer method, the production methods described in paragraphs 0023 and 0036 to 0051 of JP2006-023696A and paragraphs 0096 to 0108 of JP2006-047592A can also be suitably used in the present invention.

In addition, a step of removing an unnecessary film at the end part of the base material may be carried out. Examples of such a step include edge bead rinsing (EBR) and back rinsing.

Further, a pre-wetting step of applying various solvents onto the base material before applying the resin composition onto the base material to improve the wettability of the base material and then applying the resin composition may be adopted.

<Drying step>

The above film may be subjected to a step (a drying step) of drying the film (or the layer) formed for removing the solvent, after the film forming step (the layer forming step).

That is, the manufacturing method for a cured substance according to the embodiment of the present invention may include a drying step of drying the film formed by the film forming step.

In addition, it is preferable that the drying step is carried out after the film forming step and before the exposure step.

The drying temperature of the film in the drying step is preferably 50°C to 150°C, more preferably 70°C to 130°C, and still more preferably 90°C to 110°C. In addition, the drying may be carried out by reducing the pressure. Examples of the drying time include 30 seconds to 20 minutes, and the drying time is preferably 1 minute to 10 minutes and more preferably 2 minutes to 7 minutes.

<Exposure step>

The film may be subjected to an exposure step of selectively exposing the film.

That is, the manufacturing method for a cured substance according to the embodiment of the present invention may include an exposure step of selectively exposing the film formed by the film forming step.

The selective exposure means that a part of the film is exposed. In addition, by selectively exposing the film, an exposed region (an exposed portion) and an unexposed region (a non-exposed portion) are formed in the film.

The exposure amount is not particularly specified as long as the resin composition according to the embodiment of the present invention can be cured; however, it is, for example, preferably 50 to 10,000 $mJ/cm^2$ and more preferably 200 to 8,000 $mJ/cm^2$ in terms of conversion of exposure energy at a wavelength of 365 nm.

The exposure wavelength can be appropriately determined in a range of 190 to 1,000 nm and preferably in a range of 240 to 550 nm.

Examples of the exposure wavelength, which are mentioned in the relationship with the light source, include (1) a semiconductor laser (wavelength: 830 nm, 532 nm, 488 nm, 405 nm, 375 nm, 355 nm, or the like); (2) a metal halide lamp; (3) a high-pressure mercury lamp, a g-line (wavelength: 436 nm), an h-line (wavelength: 405 nm), an i-line

(wavelength: 365 nm), or Broad (three wavelengths of the g, h, and i-line); (4) an excimer laser, a KrF excimer laser (wavelength: 248 nm), an ArF excimer laser (wavelength: 193 nm), or an $F_2$ excimer laser (wavelength: 157 nm); (5) an extreme ultraviolet ray; EUV (wavelength: 13.6 nm); (6) an electron beam; and (7) a second harmonic wave of 532 nm and a third harmonic wave of 355 nm of a YAG laser. Regarding the resin composition according to the embodiment of the present invention, the exposure with a high-pressure mercury lamp is particularly preferable, and the exposure with an i-line is particularly preferable. In this case, particularly high exposure sensitivity can be obtained.

In addition, the exposure method is not particularly limited as long as at least a part of the film consisting of the resin composition according to the embodiment of the present invention is exposed; however, examples thereof include exposure using a photo mask and exposure by a laser direct imaging method.

<Post-exposure heating step>

The film may be subjected to a step of carrying out heating after the exposure (a post-exposure heating step).

That is, the manufacturing method for a cured substance according to the embodiment of the present invention may include a post-exposure heating step of heating the film exposed in the exposure step.

The post-exposure heating step can be carried out after the exposure step and before the development step.

The heating temperature in the post-exposure heating step is preferably 50°C to 140°C and more preferably 60°C to 120°C.

The heating time in the post-exposure heating step is preferably 30 seconds to 300 minutes and more preferably 1 minute to 10 minutes.

In the post-exposure heating step, the temperature rising rate from the temperature at the start of heating to the maximum heating temperature is preferably 1 to 12 °C/min, more preferably 2 to 10 °C/min, and still more preferably 3 to 10 °C/min.

In addition, the temperature rising rate may be appropriately changed during heating. The heating means in the post-exposure heating step is not particularly limited, and a known hot plate, oven, infrared heater, or the like can be used.

In addition, it is also preferable to carry out the heating in an atmosphere having a low oxygen concentration by allowing an inert gas such as nitrogen, helium, argon, or the like to flow.

<Development step>

The exposed film may be subjected to a development step of carrying out development using a developer to form a pattern.

That is, the manufacturing method for a cured substance according to the embodiment of the present invention may include a development step of developing the film exposed in the exposure step using a developer to form a pattern. By carrying out the development, one of the exposed portion and the non-exposed portion of the film is removed, and a pattern is formed.

Here, the development in which the non-exposed portion of the film is removed by the development step is referred to as negative tone development, and the development in which the exposed portion of the film is removed by the development step is referred to as positive tone development.

[Developer]

Examples of the developer that is used in the development step include a developer containing an alkaline aqueous solution or an organic solvent.

In a case where the developer is an alkaline aqueous solution, examples of the basic compound that can be contained in the alkaline aqueous solution include inorganic alkalis, primary amines, secondary amines, tertiary amines, and a quaternary ammonium salt. It is preferably hydroxylated tetramethylammonium hydroxide (TMAH), potassium hydroxide, sodium carbonate, sodium hydroxide, sodium silicate, sodium metasilicate, ammonia, ethylamine, n-propylamine, diethylamine, di-n-butylamine, triethylamine, methyldiethylamine, dimethylethanolamine, triethanolamine, tetraethylammonium hydroxide, tetrapropylammonium hydroxide, tetrabutylammonium hydroxide, tetrapentylammonium hydroxide, tetrahexylammonium hydroxide, tetraoctylammonium hydroxide, ethyltrimethylammonium hydroxide, butyltrimethylammonium hydroxide, methyltriamylammonium hydroxide, and dibutyldipentylammonium hydroxide, dimethylbis(2-hydroxyethyl)ammonium hydroxide, trimethylphenylammonium hydroxide, trimethylbenzylammonium hydroxide, triethylbenzylammonium hydroxide, pyrrole, or piperidine, and more preferably TMAH. For example, in a case where TMAH is used, the content of the basic compound in the developer is preferably 0.01% to 10% by mass, more preferably 0.1% to 5% by mass, and still more preferably 0.3% to 3% by mass with respect to the total mass of the developer.

In a case where the developer contains an organic solvent, suitable examples of the organic solvent include esters such as ethyl acetate, n-butyl acetate, amyl formate, isoamyl acetate, isobutyl acetate, butyl propionate, isopropyl butyrate, ethyl butyrate, butyl butyrate, methyl lactate, ethyl lactate, γ-butyrolactone, ε-caprolactone, δ-valerolactone, an alkyl alkyloxyacetate (example: a methyl alkyloxyacetate, an ethyl alkyloxyacetate, and a butyl alkyloxyacetate (for example, methyl methoxyacetate, ethyl methoxyacetate, butyl methoxyacetate, methyl ethoxyacetate, and ethyl ethoxyacetate)), 3-alkyloxypropionic acid alkyl esters (example: a methyl 3-alkyloxypropionate and an ethyl 3-alkyloxypropionate (for example, methyl 3-methoxypropionate, ethyl 3-methoxypropionate, methyl 3-ethoxypropionate, and ethyl 3-ethoxypropionate)), 2-alkyloxypropionic acid alkyl esters (example: a methyl 2-alkyloxypropionate, an ethyl 2-alkyloxypropionate, and a propyl 2-alkyloxypropionate (for example, methyl 2-methoxypropionate, ethyl 2-methoxypropionate, propyl 2-methoxypropionate, methyl 2-ethoxypropionate, and ethyl 2-ethoxypropionate)), a methyl 2-alkyloxy-2-methylpropionate and an ethyl 2-alkyloxy-2-methylpropionate (for example, methyl 2-methoxy-2-methylpropionate and ethyl 2-ethoxy-2-methylpropionate), methyl pyruvate, ethyl pyruvate, propyl pyruvate, methyl acetoacetate, ethyl acetoacetate, methyl 2-oxobutanoate, and ethyl 2-oxobutanoate; ethers such as diethylene glycol dimethyl ether, tetrahydrofuran, ethylene glycol monomethyl ether, ethylene glycol monoethyl ether, methyl cellosolve acetate, ethyl cellosolve acetate, diethylene glycol monomethyl ether, diethylene glycol monoethyl ether, diethylene glycol monobutyl ether, propylene glycol monomethyl ether (PGME), propylene glycol monomethyl ether acetate (PGMEA), propylene glycol monoethyl ether acetate, and propylene glycol monopropyl ether acetate; ketones such as methyl ethyl ketone, cyclohexanone, cyclopentanone, 2-heptanone, 3-heptanone, and N-methyl-2-pyrrolidone; cyclic hydrocarbons, for example, aromatic hydrocarbons such as toluene, xylene, and anisole, and cyclic terpenes such as limonene; sulfoxides such as dimethyl sulfoxide; and alcohols such as methanol, ethanol, propanol, isopropanol, butanol, pentanol, octanol, diethylene glycol, propylene glycol, methylisobutyl carbinol, and triethylene glycol; and amides such as N-methylpyrrolidone, N-ethylpyrrolidone, and dimethylformamide.

In a case where the developer contains an organic solvent, one kind of organic solvent can be used, or two or more kinds thereof can be mixedly used. In the present invention, in particular, a developer containing at least one selected from the group consisting of cyclopentanone, γ-butyrolactone, dimethyl sulfoxide, N-methyl-2-pyrrolidone, and cyclohexanone is preferable, a developer containing at least one selected from the group consisting of cyclopentanone, γ-butyrolactone, and dimethyl sulfoxide is more preferable, and a developer containing cyclopentanone is most preferable.

In a case where the developer contains an organic solvent, the content of the organic solvent with respect to the total mass of the developer is preferably 50% by mass or more, more preferably 70% by mass or more, still more preferably 80% by mass or more, and particularly preferably 90% by mass or more. In addition, the above content may be 100% by mass.

The developer may further contain another component.

Examples of the other component include a known surfactant and a known anti-foaming agent.

[Method of supplying developer]

The method of supplying a developer is not particularly limited as long as a desired pattern can be formed, and it includes a method of immersing a base material on which a film has been formed in a developer, puddle development of supplying a developer to a film formed on a base material using a nozzle, and a method of continuously supplying a developer. The kind of nozzle is not particularly limited, and examples thereof include a straight nozzle, a shower nozzle, and a spray nozzle.

From the viewpoint of the permeability of the developer, the removability of the non-image area, and the manufacturing efficiency, a method of supplying a developer with a straight nozzle or a method of continuously supplying a developer with a spray nozzle is preferable, and from the viewpoint of the permeability of the developer into the image area, a method of supplying a developer with a spray nozzle is more preferable.

In addition, after the continuous supply by a straight nozzle, the base material is spun to remove the developer from the base material, and then the developer is continuously supplied by the straight nozzle again after the spin drying, a step of spinning the base material to remove the developer from the base material may be adopted, and this step may be repeated a plurality of times.

In addition, in the method of supplying a developer in the development step, a step of continuously supplying a developer to a base material, a step of keeping a developer in a substantially stationary state on a base material, a step of vibrating a developer on a base material by ultrasonic waves or the like, and a step obtained by combining these steps can be adopted.

The development time is preferably 10 seconds to 10 minutes and more preferably 20 seconds to 5 minutes. The temperature of the developer during the development is not particularly specified; however, rinsing can be preferably carried out at 10°C to 45°C and more preferably 18°C to 30°C.

In the development step, washing (rinsing) of the pattern with a rinsing liquid may be further carried out after the treatment with the developer. In addition, a method such as supplying a rinsing liquid before the developer which is in contact with the pattern is completely dried may be adopted.

[Rinsing liquid]

In a case where the developer is an alkaline aqueous solution, it is possible to use, for example, water as the rinsing liquid. In a case where the developer is a developer containing an organic solvent, it is possible to use as the rinsing liquid, for example, a solvent (for example, water, an organic solvent different from the organic solvent contained in the developer) different from the solvent contained in the developer.

In a case where the rinsing liquid contains an organic solvent, suitable examples of the organic solvent include esters such as ethyl acetate, n-butyl acetate, amyl formate, isoamyl acetate, isobutyl acetate, butyl propionate, isopropyl butyrate, ethyl butyrate, butyl butyrate, methyl lactate, ethyl lactate, γ-butyrolactone, ε-caprolactone, δ-valerolactone, an alkyl alkyloxyacetate (example: a methyl alkyloxyacetate, an ethyl alkyloxyacetate, and a butyl alkyloxyacetate (for example, methyl methoxyacetate, ethyl methoxyacetate, butyl methoxyacetate, methyl ethoxyacetate, and ethyl ethoxyacetate)), 3-alkyloxypropionic acid alkyl esters (example: a methyl 3-alkyloxypropionate and an ethyl 3-alkyloxypropionate (for example, methyl 3-methoxypropionate, ethyl 3-methoxypropionate, methyl 3-ethoxypropionate, and ethyl 3-ethoxypropionate)), 2-alkyloxypropionic acid alkyl esters (example: a methyl 2-alkyloxypropionate, an ethyl 2-alkyloxypropionate, and a propyl 2-alkyloxypropionate (for example, methyl 2-methoxypropionate, ethyl 2-methoxypropionate, propyl 2-methoxypropionate, methyl 2-ethoxypropionate, and ethyl 2-ethoxypropionate)), a methyl 2-alkyloxy-2-methylpropionate and an ethyl 2-alkyloxy-2-methylpropionate (for example, methyl 2-methoxy-2-methylpropionate and ethyl 2-ethoxy-2-methylpropionate), methyl pyruvate, ethyl pyruvate, propyl pyruvate, methyl acetoacetate, ethyl acetoacetate, methyl 2-oxobutanoate, and ethyl 2-oxobutanoate; ethers such as diethylene glycol dimethyl ether, tetrahydrofuran, ethylene glycol monomethyl ether, ethylene glycol monoethyl ether, methyl cellosolve acetate, ethyl cellosolve acetate, diethylene glycol monomethyl ether, diethylene glycol monoethyl ether, diethylene glycol monobutyl ether, propylene glycol monomethyl ether (PGME), propylene glycol monomethyl ether acetate (PGMEA), propylene glycol monoethyl ether acetate, and propylene glycol monopropyl ether acetate; ketones such as methyl ethyl ketone, cyclohexanone, cyclopentanone, 2-heptanone, 3-heptanone, and N-methyl-2-pyrrolidone; cyclic hydrocarbons, for example, aromatic hydrocarbons such as toluene, xylene, and anisole, and cyclic terpenes such as limonene; sulfoxides such as dimethyl sulfoxide; and alcohols such as methanol, ethanol, propanol, isopropanol, butanol, pentanol, octanol, diethylene glycol, propylene glycol, methylisobutyl carbinol, and triethylene glycol; and amides such as N-methylpyrrolidone, N-ethylpyrrolidone, and dimethylformamide.

In a case where the rinsing liquid contains an organic solvent, one kind of organic solvent can be used, or two or more kinds thereof can be mixedly used. In the present invention, cyclopentanone, γ-butyrolactone, dimethyl sulfoxide, N-methylpyrrolidone, cyclohexanone, PGMEA, or PGME is particularly preferable, cyclopentanone, γ-butyrolactone, dimethyl sulfoxide, PGMEA, or PGME is more preferable, and cyclohexanone or PGMEA is still more preferable.

In a case where the rinsing liquid contains an organic solvent, the content of the organic solvent in the rinsing liquid is preferably 50% by mass or more, the content of the organic solvent is more preferably 70% by mass or more, and the content of the organic solvent is still more preferably 90% by mass or more. In addition, 100% by mass of the rinsing liquid may be an organic solvent.

The rinsing liquid may further contain another component.

Examples of the other component include a known surfactant and a known anti-foaming agent.

[Method of supplying rinsing liquid]

The method of supplying a rinsing liquid is not particularly limited as long as a desired pattern can be formed and includes a method of immersing a base material in a rinsing liquid, puddle development on a base material, a method of supplying a rinsing liquid to a base material with a shower, and a method of continuously supplying a developer onto a base material by means such as a straight nozzle.

From the viewpoint of the permeability of the rinsing liquid, the removability of non-image area, and the manufacturing efficiency, there is a method of supplying a rinsing liquid with a shower nozzle, a straight nozzle, a spray nozzle, or the like, and a method of continuously supplying a rinsing liquid with a spray nozzle is preferable. From the viewpoint of the permeability of the rinsing liquid into the image area, a method of supplying a rinsing liquid with a spray nozzle is more preferable. The kind of nozzle is not particularly limited, and examples thereof include a straight nozzle, a shower nozzle, and a spray nozzle.

That is, the rinsing step is preferably a step of supplying, with a straight nozzle, or continuously supplying a

rinsing liquid to the film after the exposure, and it is more preferably a step of supplying a rinsing liquid with a spray nozzle.
In addition, in the method of supplying a rinsing liquid in the rinsing step, a step of continuously supplying a rinsing liquid to a base material, a step of keeping a rinsing liquid in a substantially stationary state on a base material, a step of vibrating a rinsing liquid on the base material by ultrasonic waves or the like, and a step obtained by combining these steps can be adopted.
The rinsing time is preferably 10 seconds to 10 minutes and more preferably 20 seconds to 5 minutes. The temperature of the rinsing liquid during rinsing is not particularly specified; however, rinsing can be preferably carried out at 10°C to 45°C and more preferably 18°C to 30°C.

<Heating step>

The pattern obtained by the development step (a pattern after the rinsing in a case where the rinsing step is carried out) may be subjected to a heating step of heating the pattern obtained by the development.
That is, the manufacturing method for a cured substance according to the embodiment of the present invention may include a heating step of heating the pattern obtained by the development step.
In addition, the manufacturing method for a cured substance according to the embodiment of the present invention may include a pattern obtained by another method without carrying out the development step, or a heating step of heating a film obtained by the film forming step.
In the heating step, the resin such as the polyimide precursor is cyclized to become a resin such as polyimide.
In addition, the crosslinking of unreacted crosslinkable groups in the specific resin or a crosslinking agent other than the specific resin also proceeds.
The heating temperature (the maximum heating temperature) in the heating step is preferably 50°C to 450°C, more preferably 150°C to 350°C, still more preferably 150°C to 250°C, even still more preferably 160°C to 250°C, and particularly preferably 160°C to 230°C.
The heating step is preferably a step of accelerating the cyclization reaction of the polyimide precursor in the pattern under the action of the base or the like generated from the base generator by heating.
The heating in the heating step is preferably carried out at a temperature rising rate of 1 to 12°C/min from the temperature at the start of heating to the maximum heating temperature. The temperature rising rate is more preferably 2 to 10 °C/min and still more preferably 3 to 10 °C/min. In a case where the above temperature rising rate is set to 1 °C/min or higher, the excessive volatilization of the acid or solvent can be prevented while securing productivity, and in a case where the above temperature rising rate is to 12 °C/min or lower, the residual stress of the cured substance can be relaxed.
In addition, in a case of an oven that enables rapid heating, the heating is preferably carried out at a temperature rising rate of 1 to 8°C/sec from the temperature at the start of heating to the maximum heating temperature, more preferably 2 to 7 °C/sec, and still more preferably 3 to 6 °C/sec.
The temperature at the start of heating is preferably 20°C to 150°C, more preferably 20°C to 130°C, and still more preferably 25°C to 120°C. The temperature at the start of heating refers to a temperature at which the step of heating to the maximum heating temperature is started. For example, in a case where the resin composition according to the embodiment of the present invention is applied on a base material and then dried, the temperature at the start of heating is the temperature of the film (the layer) after drying, and for example, it is preferable to raise the temperature from a temperature lower by 30°C to 200°C than the boiling point of the solvent contained in the resin composition according to the embodiment of the present invention.
The heating time (the heating time at the maximum heating temperature) is preferably 5 to 360 minutes, more preferably 10 to 300 minutes, and still more preferably 15 to 240 minutes.
In particular, in a case of forming a multilayered laminate, the heating temperature is preferably 30°C or higher, more preferably 80°C or higher, still more preferably 100°C or higher, and particularly preferably 120°C or higher, from the viewpoint of adhesiveness between layers.
The upper limit of the heating temperature is preferably 350°C or lower, more preferably 250°C or lower, and still more preferably 240°C or lower.
The heating may be carried out stepwise. For example, a step in which the temperature is raised from 25°C to 120°C at 3 °C/min, held at 120°C for 60 minutes, raised from 120°C to 180°C at 2 °C/min, and held at 180°C for 120 minutes, may be carried out. In addition, it is also preferable to carry out the treatment while carrying out irradiation with ultraviolet rays as described in US9159547B. By such a pretreatment step, it is possible to improve the properties of the film. The pretreatment step may be carried out for a short time of about 10 seconds to 2 hours and more preferably 15 seconds to 30 minutes. The pretreatment may be carried out as a step of two or more stages, for example, a first stage pretreatment step may be carried out in a range of 100°C to 150°C, and then a second stage pretreatment step may be carried out in a range of 150°C to 200°C.
Further, cooling may be carried out after heating, and the cooling rate, in this case, is preferably 1 to 5 °C/min.

From the viewpoint of preventing the decomposition of the specific resin, it is preferable that the heating step is carried out in an atmosphere of a low oxygen concentration, for example, by allowing an inert gas such as nitrogen, helium, argon, or the like to flow, or carrying out heating under reduced pressure. The oxygen concentration is preferably 50 ppm (volume ratio) or lower, and more preferably 20 ppm (volume ratio) or lower.
The heating means in the heating step is not particularly limited; however, examples thereof include a hot plate, an infrared furnace, an electric heating oven, a hot air oven, and an infrared oven.

<Post-development exposure step>

The pattern obtained by the development step (a pattern after the rinsing in a case where the rinsing step is carried out) may be subjected to a post-development exposure step of exposing the pattern after the development step, instead of the heating step or in addition to the heating step.
That is, the manufacturing method for a cured substance according to the embodiment of the present invention may include a post-development exposure step of exposing the pattern obtained by the development step. The manufacturing method for a cured substance according to the embodiment of the present invention may include the heating step and the post-development exposure step or may include only one of the heating step and the post-development exposure step.
In the post-development exposure step, it is possible to accelerate, for example, a reaction in which the cyclization of a polyimide precursor or the like proceeds by photosensitization of a photobase generator.
In the post-development exposure step, it is sufficient that at least a part of the pattern obtained in the development step is exposed; however, it is preferable that the whole of the above pattern is exposed.
The exposure amount in the post-development exposure step is preferably 50 to 20,000 $mJ/cm^2$ and more preferably 100 to 15,000 $mJ/cm^2$ in terms of conversion of exposure energy at the wavelength at which the photosensitive compound has a sensitivity.
The post-development exposure step can be carried out using, for example, the light source in the above-described exposure step, and it is preferable to use broadband light.

<Metal layer forming step>

The pattern (preferably a pattern that has been subjected to at least one of the heating step or the post-development exposure step) obtained by the development step may be subjected to a metal layer forming step of forming a metal layer on the pattern.
That is, it is preferable that the manufacturing method for a cured substance according to the embodiment of the present invention includes a metal layer forming step of forming a metal layer on the pattern (preferably a pattern that has been subjected to at least one of the heating step or the post-development exposure step) obtained by the development step.
For the metal layer, existing metal kinds can be used without particular limitations. Examples thereof include copper, aluminum, nickel, vanadium, titanium, chromium, cobalt, gold, tungsten, tin, silver, and an alloy including these metals, preferred examples thereof are copper and aluminum, and a more preferred example thereof is copper.
The forming method for the metal layer is not particularly limited, and the existing method can be applied. For example, the methods described in JP2007-157879A, JP2001-521288A, JP2004-214501A, JP2004-101850A, US7888181B2, and US9177926B2 can be used. For example, photolithography, physical vapor deposition method (PVD), chemical vapor phase growth method (CVD), lift-off, electrolytic plating, electroless plating, etching, printing, and a method obtained by combining these may be conceivable. More specific examples of the forming method for the metal layer include a patterning method obtained by combining sputtering, photolithography, and etching, and a patterning method combining photolithography and electrolytic plating. Examples of the preferred aspect of the plating include electrolytic plating using a copper sulfate plating liquid or a copper cyanide plating liquid.
The thickness of the metal layer at the thickest portion is preferably 0.01 to 50 μm and more preferably 1 to 10 μm.

<Use application>

As a field to which the manufacturing method for a cured substance according to the embodiment of the present invention or the cured substance according to the embodiment of the present invention can be applied, an insulating film of an electronic device, an interlayer insulating film for a re-distribution layer, a stress buffer film, and the like are mentioned. In addition, a sealing film, a substrate material (a base film or cover lay of a flexible print substrate, an interlayer insulating film), or an insulating film applicable for mounting as described above, which is patterned by etching is mentioned. For these use applications, for example, Science & Technology Co., Ltd., "High functionality and applied technology of polyimide" April 2008, CMC Technical library "Basics and development of polyimide materials" supervised

by Masaaki Kakimoto, published in November 2011, "Latest Polyimide Basics and Applications" edited by Japan Polyimide & Aromatic Polymers Study Group, NTS Inc., August 2010, or the like can be referred to.

In addition, the manufacturing method for a cured substance according to the embodiment of the present invention and the cured substance according to the embodiment of the present invention can also be used for the production of board surfaces such as an offset board surface or a screen board surface, for etching of molded parts, for the production of protective lacquers and dielectric layers in electronics, in particular, microelectronics.

(Laminate and manufacturing method for laminate)

A laminate according to the embodiment of the present invention refers to a structure having a plurality of layers consisting of the cured substance according to the embodiment of the present invention.

The laminate according to the embodiment of the present invention is a laminate including two or more layers consisting of a cured substance, and it may be a laminate in which three or more layers are laminated.

At least one of the two or more layers consisting of a cured substance which are included in the laminate is a layer consisting of the cured substance according to the embodiment of the present invention, and from the viewpoint of suppressing the shrinkage of the cured substance or the deformation of the cured substance due to the shrinkage, it is also preferable that all the layers consisting of a cured substance which are included in the laminate are layers consisting of the cured substance according to the embodiment of the present invention.

That is, it is preferable that the manufacturing method for a laminate according to the embodiment of the present invention includes the manufacturing method for a cured substance according to the embodiment of the present invention, and it is more preferable to include repeating, a plurality of times, the manufacturing method for a laminate according to the embodiment of the present invention.

In the laminate according to the aspect of the present invention, an aspect in which two or more layers of layers consisting of a cured substance are included and a metal layer is provided between any layers consisting of the cured substance is preferable. The metal layer is preferably formed in the metal layer forming step.

That is, it is preferable that the manufacturing method for a laminate according to the embodiment of the present invention further includes a metal layer forming step of forming a metal layer on a layer consisting of the cured substance, between the manufacturing methods for a cured substance which are carried out a plurality of times. The preferred aspect of the metal layer forming step is as described above.

Examples of the preferred laminate include a laminate including at least a layer structure in which three layers of a layer consisting of a first cured substance, a metal layer, and a layer consisting of a second cured substance are laminated in order.

It is preferable that both the layer consisting of the first cured substance and the layer consisting of the second cured substance are layers consisting of the cured substance according to the embodiment of the present invention. The resin composition according to the embodiment of the present invention which is used for forming a layer consisting of the first cured substance and the resin composition according to the embodiment of the present invention which is used for forming a layer consisting of the second cured substance may have the same composition or may have compositions different from each other. The metal layer in the laminate according to the embodiment of the present invention is preferably used as the metal wire of the re-distribution layer or the like.

<Laminating step>

The manufacturing method for a laminate according to the embodiment of the present invention preferably further includes a laminating step.

The laminating step is a series of steps including carrying out again, in the following order on the surface of the pattern (the resin layer) or the metal layer, at least one of (a) the film forming step (the layer forming step), (b) the exposure step, (c) the development step, or (d) the heating step and the post-development exposure step. However, the aspect thereof may be such that at least one of (a) the film forming step or (d) the heating step and the post-development exposure step is repeated. In addition, (e) the metal layer forming step may be included after at least one of the heating step or the post-development exposure step of (d). It is needless to say that the laminating step may further include appropriately the above-described drying step.

In a case where another laminating step is further carried out after the laminating step, a surface activation treatment step may be further carried out after the exposure step, the heating step, or the metal layer forming step. Examples of the surface activation treatment include plasma treatment. Details of the surface activation treatment will be described later.

The laminating step is preferably carried out 2 to 20 times and more preferably 2 to 9 times.

For example, a configuration having resin layers of 2 or more layers and 20 or less layers, such as a resin layer/a metal layer/a resin layer/a metal layer/a resin layer/a metal layer, is preferable, and a configuration having resin

layers of 2 or more layers and 9 or less layers is more preferable.

In the above layers, the compositions, shapes, film thicknesses, and the likes may be the same or may be different from each other.

In the present invention, an aspect in which a metal layer is provided, and then furthermore, a cured substance (a resin layer) of the resin composition according to the aspect of the present invention is formed to cover the metal layer is particularly preferable. Specific examples thereof include an aspect in which (a) the film forming step, (b) the exposure step, (c) the development step, (d) at least one of the heating step or the post-development exposure step, (e) the metal layer forming step are repeated in order, and an aspect in which (a) the film forming step, (d) at least one of the heating step or the post-development exposure step, and (e) the metal layer forming step are repeated in order. By alternately carrying out the laminating step of laminating the resin composition layer (the resin layer) of the present invention and the metal layer forming step, the resin composition layer (the resin layer) according to the embodiment of the present invention and the metal layer can be alternately laminated.

(Surface activation treatment step)

The manufacturing method for a laminate according to the embodiment of the present invention preferably includes a surface activation treatment step of subjecting at least a part of the metal layer or a part of the resin composition layer to surface activation treatment.

The surface activation treatment step is usually carried out after the metal layer forming step (preferably, after at least one of the heating step or the post-development exposure step). However, after the development step, the metal layer forming step may be carried out after the resin composition layer is subjected to the surface activation treatment step.

At least a part of the metal layer may be subjected to the surface activation treatment, at least a part of the resin composition layer after the exposure may be subjected to the surface activation treatment, or both at least a part of the metal layer and at least a part of the resin composition layer after the exposure may be subjected to the surface activation treatment. It is preferable to carry out the surface activation treatment on at least a part of the metal layer, and it is more preferable to carry out the surface activation treatment on a part or whole of the region of the metal layer having a surface on which the resin composition layer is formed. In a case where a surface of the metal layer is subjected to the surface activation treatment in this manner, it is possible to improve the adhesiveness to the resin composition layer (film) to be provided on the surface thereof.

In addition, it is preferable that the surface activation treatment is carried out on a part or whole of the resin composition layer (the resin layer) after the exposure. In a case where a surface of the resin composition layer is subjected to the surface activation treatment in this manner, it is possible to improve the adhesiveness to a metal layer or a resin layer to be provided on the surface that has been subjected to the surface activation treatment. In particular, in a case where the resin composition layer is cured, such as in a case where negative tone development is carried out, it is less likely to be damaged by the surface treatment, and thus the adhesiveness is likely to be improved.

Specifically, the surface activation treatment is selected from plasma treatment of various raw material gases (oxygen, hydrogen, argon, nitrogen, nitrogen/hydrogen mixed gas, argon/oxygen mixed gas, and the like), corona discharge treatment, etching treatment with $CF_4/O_2$, $NF_3/O_2$, $SF_6$, $NF_3$, or $NF_3/O_2$, surface treatment with an ultraviolet ray (UV) ozone method, immersion treatment in an organic surface treating agent including a compound having at least one of an amino group or a thiol group after immersion in an aqueous hydrochloric acid solution to remove the oxide film, and mechanical roughening treatment using a brush. It is preferably plasma treatment and particularly preferably oxygen plasma treatment using oxygen as the raw material gas. In a case of corona discharge treatment, the energy is preferably 500 to 200,000 $J/m^2$, more preferably 1,000 to 100,000 $J/m^2$, and most preferably 10,000 to 50,000 $J/m^2$.

(Manufacturing method for semiconductor device)

The present invention also discloses a semiconductor device, which includes the cured substance according to the embodiment of the present invention or the laminate according to the embodiment of the present invention.

The present invention also discloses a manufacturing method for a semiconductor device, which includes the manufacturing method for a cured substance according to the embodiment of the present invention or the manufacturing method for a laminate according to the embodiment of the present invention. As the specific example of the semiconductor device using the resin composition according to the embodiment of the present invention for forming an interlayer insulating film for a re-distribution layer, the description in paragraphs 0213 to 0218 and the description of Fig. 1 of JP2016-027357A can be referred to, the content of which is incorporated in the present specification.

## Examples

Hereinafter, the present invention will be described in detail using examples. Materials, using amounts, proportions, treatment details, treatment content, and the like shown in the following examples can be appropriately changed without departing from the gist of the present invention. Accordingly, the scope of the present invention is not limited to the following specific examples. Unless otherwise specified, "parts" and "%" are based on mass.

<Synthesis Example 1: Synthesis of polymer PE>

For a polymer PE, 0.883 g (3.00 mmol) of 4,4'-biphenyltetracarboxylic acid dianhydride (hereinafter, abbreviated as "BPDA") was added at one time to 8.50 ml of an N,N-dimethylacetamide (DMAc) solution containing 0.600 g (3.00 mmol) of oxydianiline (hereinafter abbreviated as "ODA"), and the resultant mixture was stirred in a room temperature environment for 12 hours to obtain a highly viscous transparent solution of a polymer PE. The intrinsic viscosity of the polymer PE in DMAc was 0.73 dL/g at a concentration of 0.5 g/dL at 30°C. As DMAc, one purified by vacuum distillation was used, and as ODA and BPDA, those respectively recrystallized from tetrahydrofuran (THF) and acetic anhydride were used. As a result of measuring the molecular weight of the polymer PE by gel permeation chromatography (in terms of standard polystyrene equivalent value), the weight-average molecular weight (Mw) was 12,000.

<Synthesis Example 2: Synthesis of polymer PA-1>

155.1 g of 4,4'-oxydiphthalic acid dianhydride (ODPA) was placed in a separable flask, 131.2 g of 2-hydroxyethyl methacrylate (HEMA) and 400 ml of γ-butyrolactone were placed therein, and the resultant mixture was stirred at room temperature, and then 81.5 g of pyridine was added to the mixture with stirring to obtain a reaction mixture. After the heat generation due to the reaction was stopped, the mixture was allowed to cool to room temperature and left to stand for 16 hours.

Next, under ice-cooling, a solution obtained by dissolving 206.3 g of dicyclohexylcarbodiimide (DCC) in 180 ml of γ-butyrolactone was added to the reaction mixture over 40 minutes with stirring, and subsequently a suspension obtained by suspending 93.0 g of 4,4'-diaminodiphenyl ether (DADPE) in 350 ml of γ-butyrolactone was added thereto over 60 minutes with stirring. After further stirring at room temperature for 2 hours, 30 ml of ethyl alcohol was added thereto, the mixture was stirred for 1 hour, and then 400 ml of γ-butyrolactone was added thereto. The precipitate formed in the reaction mixture was removed by filtration to obtain a reaction solution.

The obtained reaction solution was added to 3 liters of ethyl alcohol to form a precipitate consisting of a crude polymer. The produced crude polymer was filtered out and then dissolved in 1.5 liters of tetrahydrofuran to obtain a crude polymer solution. The obtained crude polymer solution was added dropwise to 28 liters of water to precipitate the polymer, and the obtained precipitate was filtered out and then vacuum dried to obtain a powdery polymer PA-1. As a result of measuring the molecular weight of the polymer PA-1 by gel permeation chromatography (in terms of standard polystyrene equivalent value), the weight-average molecular weight (Mw) was 20,000.

<Synthesis Example 3: Synthesis of polymer PB-1>

The reaction was carried out in the same manner as described in Synthesis Example 2 to obtain a polymer PB-1, except that 147.1 g of 3,3',4,4'-biphenyltetracarboxylic acid dianhydride was used instead of 155.1 g of 4,4'-oxydiphthalic acid dianhydride Synthesis Example 2. As a result of measuring the molecular weight of the polymer PB-1 by gel permeation chromatography (in terms of standard polystyrene equivalent value), the weight-average molecular weight (Mw) was 22,000.

<Synthesis Example 4: Synthesis of polymer PA-2>

20.0 g (64.5 mmol) of 4,4'-oxydiphthalic acid dianhydride (dried at 140°C for 12 hours) and 17.12 g (131.58 mmol) of 2-hydroxyethyl methacrylate (HEMA) were suspended in 50 mL of N-methylpyrrolidone and dried with a molecular sieve. The suspension was heated at 100°C for 3 hours. A transparent solution was obtained a few minutes after the start of heating. The reaction mixture was cooled to room temperature, and 21.43 g (270.9 mmol) pyridine and 90 ml N-methylpyrrolidone were added thereto. Then, the reaction mixture was cooled to -10°C, and 16.12 g (135.5 mmol) of $SOCl_2$ was added thereto over 10 minutes while keeping the temperature at -10°C ± 4°C. Viscosity increased while adding $SOCl_2$. After diluting with 50 ml of N-methylpyrrolidone, the reaction mixture was stirred at room temperature for 2 hours. Then, a solution prepared by dissolving 11.75 g (58.7 mmol) of 4,4'-diaminodiphenyl ether in 100 ml of N-methylpyrrolidone was dropwise added to the reaction mixture at 20°C to 23°C over 20 minutes. The reaction mixture was then stirred overnight at room temperature. The polyimide precursor was then precipitated in 5 L of water and the water-polyimide precursor mixture was stirred for 15 minutes at a speed of 5,000 rpm. The polyimide precursor was collected by filtration, put into 4 liters of water again, stirred for 30 minutes, and filtered again. Then, the obtained polyimide precursor was dried under reduced pressure at 45°C for 3 days to obtain polymer PA-2. As a result of measuring the

molecular weight of the polymer PA-2 by gel permeation chromatography (in terms of standard polystyrene equivalent value), the weight-average molecular weight (Mw) was 20,000.

<Synthesis Example 5: Synthesis of polymer PB-2>

The reaction was carried out in the same manner as described in Synthesis Example 4 to obtain a polymer PB-1, except that in Synthesis Example 4, 19.0 g (64.5 mmol) of 3,3',4,4'-biphenyltetracarboxylic acid dianhydride was instead of 20.0 g (64.5 mmol) of 4,4'-oxydiphthalic acid dianhydride. As a result of measuring the molecular weight of the polymer PB-2 by gel permeation chromatography (in terms of standard polystyrene equivalent value), the weight-average molecular weight (Mw) was 21,000.

<Synthesis Example 6: Synthesis of polymer PC>

In a separable flask, 2,2-bis(3-amino-4-hydroxyphenyl) -hexafluoropropane 183.1 g (0.5 mol), N,N-dimethylacetamide (DMAc) 640.9 g, pyridine 63.3 g (0.8 mol) was mixed and stirred at room temperature (25°C) to prepare a uniform solution. To this solution, a solution obtained by dissolving 118.0 g (0.4 mol) of 4,4'-diphenyl ether dicarbonyl chloride in 354 g of diethylene glycol dimethyl ether (DMDG) was added dropwise with a dropping funnel. In this case, the separable flask was cooled in a water bath at 15°C to 20°C. The time required for the dropwise addition was 40 minutes, and the maximum temperature of the reaction solution was 30°C.

After 3 hours from the completion of the dropwise addition, 30.8 g (0.2 mol) of 1,2-cyclohexyldicarboxylic acid anhydride was added to the reaction solution, and the resultant mixture was left to stand with stirring at room temperature for 15 hours to block 99% of all amine terminal groups of the polymer chain with a carboxycyclohexylamide group. It is noted that the reaction rate in this case can be easily calculated by tracking the remaining amount of the charged 1,2-cyclohexyldicarboxylic acid anhydride with high performance liquid chromatography (HPLC). Thereafter, the above reaction solution was added dropwise to 2 L of water with high speed stirring to disperse and precipitate the polymer, which was subsequently recovered, washed with water as appropriate, dehydrated, and vacuum dried, thereby obtaining a crude polybenzoxazole precursor having a weight-average molecular weight of 9,000 (in terms of polystyrene equivalent value) measured according to gel permeation chromatography (GPC).

The crude polybenzoxazole precursor obtained as described above was redissolved in γ-butyrolactone (GBL) and then treated with a cation exchange resin and an anion exchange resin. The resultant solution was put into ion exchange water, the precipitated polymer was filtered out, washed with water, and vacuum dried to obtain a purified polybenzoxazole precursor (a polymer PC). As a result of measuring the molecular weight of the polymer PB-2 by gel permeation chromatography (in terms of standard polystyrene equivalent value), the weight-average molecular weight (Mw) was 18,000.

<Synthesis Example 7: Synthesis of polymer PD>

A polymer PD was synthesized from pyromellitic acid dianhydride, 3,3',4,4'-biphenyltetracarboxylic acid dianhydride, and 2,2'-bis(trifluoromethyl)benzidine, according to the same method as the synthesis method for PFAA described, in H Seino et al., J. Polym. Sci., Part A: Polym. Chem., 36, 2261 (1998). As a result of measuring the molecular weight of the polymer PD by gel permeation chromatography (in terms of standard polystyrene equivalent value), the weight-average molecular weight (Mw) was 15,000.

<Examples and Comparative Examples>

In each of Examples, the components shown in the table below were mixed to obtain each of the negative-tone photosensitive resin compositions. Further, in each Comparative Example, components shown in the following table were mixed to obtain each of the comparative compositions.

Specifically, the content (blending amount) of each component described in the table other than the solvent was set to the amount (in terms of parts by mass) described in the column of "Adding amount" of "Concentration in solid content [part by mass]" in the table.

The content (blending amount) of the solvent was such that the concentration of solid contents of the composition was set to the value of "Concentration of solid contents [% by mass]" in the table, and the content of each solvent with respect to the total mass of the solvent was set to be the amount (in terms of parts by mass) described in the column of "Adding amount" in the table.

The obtained negative-tone photosensitive resin composition and the comparative composition were filtered under pressure using a filter made of polytetrafluoroethylene, having a micropore width of 0.45 μm.

In addition, in the table, the description of "-" indicates that the corresponding component is not contained in

the composition.

[Table 1]

| | Concentration of solid contents [% by mass] | Concentration in solid content [part by mass] | | | | | | | | | | | | | | | | | | | | | | Solvent | | | |
|---|---|---|---|---|---|---|---|---|---|---|---|---|---|---|---|---|---|---|---|---|---|---|---|---|---|---|---|
| | | Resin | | Compound A | | Photopolymerization initiator | | Nitrogen-containing cyclic compound | | Polymerizable compound | | Silane coupling agent | | Polymerization inhibitor | | Base generator | | Other additives | | | | | | | | | |
| | | Kind | Adding amount | Kind | Adding amount | Kind | Adding amount | Kind | Adding amount | Kind | Adding amount | Kind | Adding amount | Kind | Adding amount | Kind | Adding amount | Kind | Adding amount | Kind | Adding amount | | | Kind | Adding amount | Kind | Adding amount |
| Example 1 | 38.60 | PE | 75.20 | A-1 | 3.00 | I-3 | 3.00 | N-1 | 0.20 | F-1 | 15.00 | G-1 | 1.50 | H-1 | 0.10 | K-1 | 2.00 | - | - | - | - | | | S-1 | 100 | - | - |
| 2 | 38.20 | PA-1 | 76.00 | A-1 | 2.50 | I-3 | 2.80 | N-1 | 0.50 | F-2 | 14.60 | G-2 | 1.50 | H-1 | 0.10 | K-1 | 2.00 | - | -- | -- | - | | | S-1 | 80 | S-2 | 20 |
| 3 | 37.10 | PB-1 | 78.10 | A-1 | 2.20 | I-3 | 1.90 | N-1 | 0.20 | F-3 | 13.80 | G-3 | 1.50 | H-1 | 0.30 | K-1 | 2.00 | - | - | - | - | | | S-1 | 80 | S-2 | 20 |
| 4 | 37.00 | PB-2 | 78.40 | A-1 | 2.40 | I-3 | 2.60 | N-1 | 0.40 | F-4 | 12.50 | G-1 | 1.60 | H-1 | 0.10 | K-1 | 2.00 | - | - | - | - | | | S-1 | 80 | S-2 | 20 |
| 5 | 36.60 | PA-2 | 79.30 | A-1 | 2.30 | I-3 | 2.30 | N-1 | 0.30 | F-5 | 12.20 | G-2 | 1.60 | H-1 | 0.10 | K-1 | 1.90 | - | - | - | - | | | S-3 | 80 | S-4 | 20 |
| 6 | 38.50 | PC | 75.40 | A-1 | 1.20 | I-3 | 2.80 | N-1 | 0.10 | F-6 | 16.80 | G-3 | 1.60 | H-1 | 0.10 | K-1 | 2.00 | - | - | - | - | | | S-3 | 80 | S-4 | 20 |
| 7 | 41.10 | PD | 70.60 | A-1 | 2.60 | I-3 | 2.80 | N-1 | 0.30 | F-1 | 20.00 | G-4 | 1.60 | H-1 | 0.10 | K-1 | 2.00 | - | - | - | - | | | S-3 | 80 | S-4 | 20 |
| 8 | 36.00 | PA-1 | 80.58 | A-1 | 2.00 | I-1 | 2.50 | N-1 | 0.02 | F-1 | 12.70 | G-1 | 2.00 | H-1 | 0.20 | - | - | - | - | - | - | | | S-1 | 90 | S-2 | 10 |
| 9 | 37.50 | PB-1 | 77.30 | A-2 | 2.40 | I-2 | 2.40 | N-1 | 0.30 | F-2 | 15.50 | G-2 | 2.00 | H-1 | 0.10 | - | - | - | - | - | - | | | S-1 | 90 | S-2 | 10 |
| 10 | 37.70 | PB-1 | 77.00 | A-2 | 2.00 | I-3 | 2.20 | B-1 | 0.20 | F-2 | 14.80 | G-5 | 2.00 | H-1 | 0.20 | K-1 | 1.60 | - | - | - | - | | | S-1 | 90 | S-2 | 10 |
| 11 | 38.60 | PB-2 | 75.10 | A-3 | 2.50 | I-3 | 6.50 | N-1 | 0.30 | F-3 | 11.70 | G-3 | 2.00 | H-1 | 0.10 | K-2 | 1.80 | - | - | - | - | | | S-1 | 90 | S-2 | 10 |
| 12 | 37.70 | PA-2 | 77.00 | A-4 | 2.50 | I-4 | 3.10 | N-1 | 1.00 | F-1 | 13.00 | G-1 | 1.50 | H-2 | 0.10 | K-2 | 1.80 | - | - | - | - | | | S-3 | 90 | S-4 | 10 |
| 13 | 36.20 | PA-1 | 80.10 | A-5 | 2.50 | I-5 | 2.90 | N-1 | 0.30 | F-2 | 10.80 | G-2 | 1.50 | H-2 | 0.10 | K-2 | 1.80 | - | - | - | - | | | S-3 | 90 | S-4 | 10 |
| 14 | 36.00 | PB-1 | 80.60 | A-6 | 2.50 | I-1 | 2.70 | N-2 | 0.30 | F-3 | 10.10 | G-3 | 1.50 | H-2 | 0.30 | K-1 | 2.00 | - | - | - | - | | | S-3 | 90 | S-4 | 10 |
| 15 | 36.10 | PB-2 | 80.40 | A-1 | 1.80 | I-2 | 2.40 | N-2 | 0.30 | F-4 | 11.50 | G-1 | 1.50 | H-2 | 0.10 | K-1 | 2.00 | - | - | - | - | | | S-1 | 80 | S-2 | 20 |
| 16 | 36.60 | PA-2 | 79.20 | A-2 | 2.30 | I-3 | 2.30 | N-2 | 0.40 | F-5 | 12.20 | G-2 | 1.60 | H-2 | 0.10 | K-1 | 1.90 | - | - | - | - | | | S-3 | 80 | S-4 | 20 |
| 17 | 32.80 | PA-1 | 88.30 | A-3 | 2.70 | I-4 | 5.10 | N-2 | 0.30 | - | - | G-4 | 1.50 | H-2 | 0.10 | K-1 | 2.00 | - | - | - | - | | | S-1 | 70 | S-2 | 30 |
| 18 | 36.10 | PB-1 | 80.30 | A-4 | 2.00 | I-5 | 2.60 | N-2 | 0.30 | F-1 | 11.20 | G-1 | 1.50 | H-2 | 0.10 | K-1 | 2.00 | - | - | - | - | | | S-3 | 70 | S-4 | 30 |
| 19 | 36.60 | PB-2 | 79.30 | A-2 | 2.50 | I-4 | 2.40 | N-2 | 0.40 | F-1 | 12.00 | G-2 | 1.70 | H-2 | 0.10 | K-2 | 1.60 | - | - | - | - | | | S-3 | 80 | S-4 | 20 |
| 20 | 36.40 | PA-2 | 79.70 | A-2 | 1.90 | I-4 | 2.70 | N-2 | 0.30 | F-1 | 13.50 | - | - | H-2 | 0.10 | K-2 | 1.80 | - | - | - | - | | | S-3 | 80 | S-4 | 20 |
| 21 | 37.40 | PA-1 | 77.50 | A-2 | 3.50 | I-4 | 2.90 | N-3 | 0.30 | F-1 | 13.00 | G-1 | 1.00 | - | - | K-2 | 1.80 | - | - | - | - | | | S-3 | 80 | S-4 | 20 |
| 22 | 37.70 | PB-1 | 76.90 | A-2 | 4.60 | I-4 | 2.50 | N-3 | 0.30 | F-2 | 12.80 | G-2 | 1.00 | H-3 | 0.10 | K-2 | 1.80 | - | - | - | - | | | S-3 | 80 | S-4 | 20 |
| 23 | 36.20 | PB-2 | 80.20 | A-2 | 1.10 | I-1 | 2.60 | N-3 | 0.30 | F-2 | 12.60 | G-3 | 1.00 | H-3 | 0.40 | K-2 | 1.80 | - | - | - | - | | | S-3 | 80 | S-4 | 20 |
| 24 | 37.50 | PA-2 | 77.30 | A-2 | 2.00 | I-1 | 2.40 | N-3 | 0.20 | F-2 | 10.50 | G-1 | 3.00 | H-3 | 0.10 | K-3 | 1.50 | M-1 | 1.5 | M-2 | 3 | | | S-1 | 80 | S-2 | 20 |
| 25 | 39.60 | PA-1 | 73.30 | A-2 | 2.60 | I-1 | 2.60 | N-3 | 0.30 | F-3 | 15.90 | G-2 | 3.00 | H-3 | 0.10 | K-4 | 2.20 | - | - | - | - | | | S-1 | 80 | S-2 | 20 |
| 26 | 38.20 | PB-1 | 75.90 | A-2 | 2.50 | I-1 | 2.50 | N-4 | 0.30 | F-3 | 13.80 | G-3 | 3.00 | H-3 | 0.50 | K-3 | 1.50 | - | - | - | - | | | S-1 | 80 | S-2 | 20 |
| 27 | 40.60 | PB-2 | 78.90 | A-3 | 1.60 | I-2 | 2.10 | N-4 | 0.20 | F-3 | 12.40 | G-1 | 2.50 | H-3 | 0.10 | K-4 | 2.20 | - | - | - | - | | | S-1 | 80 | S-2 | 20 |
| 28 | 37.20 | PA-2 | 77.90 | A-3 | 2.20 | I-2 | 3.20 | N-4 | 0.30 | F-4 | 11.80 | G-2 | 2.50 | H-3 | 0.10 | K-1 | 2.00 | - | - | - | - | | | S-1 | 80 | S-2 | 20 |
| 29 | 38.10 | PA-1 | 76.20 | A-3 | 2.60 | I-2 | 2.90 | N-5 | 0.30 | F-4 | 13.40 | G-3 | 2.50 | H-3 | 0.10 | K-1 | 2.00 | - | - | - | - | | | S-1 | 80 | S-2 | 20 |
| 30 | 37.70 | PB-1 | 76.90 | A-3 | 3.40 | I-2 | 2.70 | N-5 | 0.10 | F-5 | 13.00 | G-1 | 1.80 | H-3 | 0.10 | K-1 | 2.00 | - | - | - | - | | | S-3 | 80 | S-4 | 20 |

[Table 2]

| | | Concentration of solid contents [% by mass] | Concentration in solid content [part by mass] | | | | | | | | | | | | | | | | | | | | Solvent | | | |
|---|---|---|---|---|---|---|---|---|---|---|---|---|---|---|---|---|---|---|---|---|---|---|---|---|---|---|
| | | | Resin | | Compound A | | Photopolymerization initiator | | Nitrogen-containing cyclic compound | | Polymerizable compound | | Silane coupling agent | | Polymerization inhibitor | | Base generator | | Other additives | | | | Kind | Adding amount | Kind | Adding amount |
| | | | Kind | Adding amount | Kind | Adding amount | Kind | Adding amount | Kind | Adding amount | Kind | Adding amount | Kind | Adding amount | Kind | Adding amount | Kind | Adding amount | Kind | Adding amount | Kind | Adding amount | | | | |
| Example | 31 | 39.30 | PB-2 | 73.80 | A-3 | 1.80 | I-3 | 4.90 | N-3 | 0.30 | F-5 | 15.50 | G-2 | 1.80 | H-3 | 0.10 | K-2 | 1.80 | - | - | - | - | S-3 | 80 | S-4 | 20 |
| | 32 | 41.20 | PA-2 | 70.40 | A-3 | 6.00 | I-3 | 2.40 | N-4 | 0.30 | F-5 | 17.20 | G-3 | 1.80 | H-1 | 0.10 | K-2 | 1.80 | - | - | - | - | S-1 | 80 | S-2 | 20 |
| | 33 | 37.30 | PA-1 | 77.70 | A-3 | 2.60 | I-3 | 2.60 | N-5 | 0.20 | F-5 | 13.50 | G-1 | 1.50 | H-2 | 0.10 | K-2 | 1.80 | - | - | - | - | S-1 | 80 | S-2 | 20 |
| | 34 | 37.00 | PA-1 | 78.30 | A-7 | 2.50 | I-3 | 2.50 | N-1 | 0.30 | F-1 | 13.00 | G-1 | 1.30 | H-1 | 0.10 | K-1 | 2.00 | - | - | - | - | S-3 | 80 | S-4 | 20 |
| | 35 | 36.30 | PA-2 | 80.00 | A-7 | 2.40 | I-3 | 2.40 | N-2 | 0.40 | F-2 | 11.50 | G-2 | 1.40 | H-2 | 0.10 | K-2 | 1.80 | - | - | - | - | S-3 | 80 | S-4 | 20 |
| | 36 | 36.90 | PB-1 | 78.50 | A-8 | 2.60 | I-3 | 2.60 | N-1 | 0.20 | F-3 | 12.80 | G-3 | 1.50 | H-1 | 0.20 | K-1 | 1.60 | - | - | - | - | S-3 | 80 | S-4 | 20 |
| | 37 | 38.00 | PB-2 | 76.30 | A-8 | 2.90 | I-3 | 2.90 | N-2 | 0.30 | F-4 | 14.00 | G-4 | 1.30 | H-2 | 0.10 | K-2 | 2.20 | - | - | - | - | S-3 | 80 | S-4 | 20 |
| | 38 | 37.00 | PA-1 | 78.30 | A-7 | 2.70 | I-3 | 2.70 | N-3 | 0.30 | F-5 | 12.50 | G-1 | 1.40 | H-1 | 0.10 | K-3 | 2.00 | - | - | - | - | S-1 | 80 | S-2 | 20 |
| | 39 | 38.00 | PA-2 | 76.30 | A-7 | 2.90 | I-3 | 2.90 | N-4 | 0.40 | F-1 | 14.00 | G-2 | 1.50 | H-2 | 0.20 | K-4 | 1.80 | - | - | - | - | S-1 | 80 | S-2 | 20 |
| | 40 | 36.30 | PB-1 | 79.90 | A-8 | 2.60 | I-3 | 2.60 | N-3 | 0.20 | F-3 | 11.70 | G-3 | 1.30 | H-1 | 0.10 | K-3 | 1.60 | - | - | - | - | S-1 | 80 | S-2 | 20 |
| | 41 | 37.00 | PB-2 | 78.40 | A-8 | 2.80 | I-3 | 2.80 | N-4 | 0.30 | F-5 | 12.00 | G-4 | 1.40 | H-2 | 0.10 | K-4 | 2.20 | - | - | - | - | S-1 | 80 | S-2 | 20 |
| | 42 | 38.00 | PB-1 | 76.40 | A-4 | 4.80 | I-3 | 2.70 | N-1 | 0.30 | F-1 | 12.00 | G-2 | 1.50 | H-3 | 0.10 | K-4 | 2.20 | - | - | - | - | S-3 | 80 | S-4 | 20 |
| | 43 | 37.70 | PB-2 | 76.90 | A-4 | 2.70 | I-4 | 2.50 | N-1 | 0.10 | F-1 | 14.00 | G-3 | 1.50 | H-1 | 0.10 | K-4 | 2.20 | - | - | - | - | S-3 | 80 | S-4 | 20 |
| | 44 | 38.00 | PA-2 | 76.30 | A-4 | 3.40 | I-4 | 3.00 | N-1 | 0.30 | F-1 | 13.20 | G-1 | 1.50 | H-2 | 0.10 | K-4 | 2.20 | - | - | - | - | S-3 | 80 | S-4 | 20 |
| | 45 | 38.20 | PA-1 | 76.00 | A-1 | 2.50 | I-3 | 2.80 | N-1 | 0.50 | F-2 | 14.60 | G-2 | 1.50 | H-1 | 0.10 | K-1 | 2.00 | - | - | - | - | S-1 | 80 | S-2 | 20 |
| | 46 | 38.20 | PA-1 | 76.00 | A-1 | 2.50 | I-3 | 2.80 | N-1 | 0.50 | F-2 | 14.60 | G-2 | 1.50 | H-1 | 0.10 | K-1 | 2.00 | - | - | - | - | S-1 | 80 | S-2 | 20 |
| | 47 | 38.20 | PA-1 | 76.00 | A-1 | 2.50 | I-3 | 2.80 | N-1 | 0.50 | F-2 | 14.60 | G-2 | 1.50 | H-1 | 0.10 | K-1 | 2.00 | - | - | - | - | S-1 | 80 | S-2 | 20 |
| | 48 | 38.20 | PA-1 | 76.00 | A-1 | 2.50 | I-3 | 2.80 | N-1 | 0.50 | F-2 | 14.60 | G-2 | 1.50 | H-1 | 0.10 | K-1 | 2.00 | - | - | - | - | S-1 | 80 | S-2 | 20 |
| | 49 | 38.20 | PA-1 | 76.00 | A-1 | 2.50 | I-3 | 2.80 | N-1 | 0.50 | F-2 | 14.60 | G-2 | 1.50 | H-1 | 0.10 | K-1 | 2.00 | - | - | - | - | S-1 | 80 | S-2 | 20 |
| | 50 | 37.00 | PB-2 | 77.00 | A-2 | 4.50 | I-3 | 2.30 | N-2 | 0.30 | F-1 | 12.30 | G-1 | 1.50 | H-2 | 0.10 | K-1 | 2.00 | - | - | - | - | S-3 | 80 | S-4 | 20 |
| | 51 | 37.00 | PA-2 | 77.00 | A-2 | 4.50 | I-3 | 2.30 | N-2 | 0.30 | F-5 | 12.20 | G-2 | 1.60 | H-2 | 0.10 | K-1 | 2.00 | - | - | - | - | S-3 | 80 | S-4 | 20 |
| | 52 | 37.50 | PB-2 | 76.00 | A-1 | 3.50 | I-3 | 2.60 | N-2 | 0.40 | F-5 | 12.90 | G-5 | 1.40 | H-2 | 0.20 | K-2 | 3.00 | - | - | - | - | S-3 | 80 | S-4 | 20 |
| | 53 | 37.00 | PA-2 | 77.00 | A-2 | 4.50 | I-3 | 2.30 | N-2 | 0.30 | F-5 | 12.20 | G-2 | 1.60 | H-2 | 0.10 | K-1 | 2.00 | - | - | - | - | S-3 | 80 | S-4 | 20 |
| | 54 | 37.00 | PB-2 | 77.00 | A-2 | 4.50 | I-3 | 2.30 | N-2 | 0.30 | F-1 | 12.30 | G-1 | 1.50 | H-2 | 0.10 | K-1 | 2.00 | - | - | - | - | S-3 | 80 | S-4 | 20 |
| | 55 | 37.00 | PA-2 | 76.00 | A-2 | 4.50 | I-3 | 2.30 | N-2 | 0.30 | F-5 | 12.20 | G-2 | 1.60 | H-2 | 1.10 | K-1 | 2.00 | - | - | - | - | S-3 | 80 | S-4 | 20 |
| | 56 | 37.20 | PA-1 | 76.50 | A-2 | 4.00 | I-3 | 2.50 | N-2 | 0.30 | F-5 | 12.60 | G-2 | 1.50 | H-2 | 0.60 | K-1 | 2.00 | - | - | - | - | S-1 | 100 | - | - |
| | 57 | 37.00 | PB-2 | 78.40 | A-8 | 2.80 | I-3 | 2.80 | N-4 | 0.30 | F-5 | 12.00 | G-4 | 1.40 | H-2 | 0.10 | K-4 | 2.20 | - | - | - | - | S-1 | 80 | S-2 | 20 |
| | 58 | 37.20 | PA-1<br>PB-1 | 39.30<br>38.60 | A-3 | 2.20 | I-2 | 3.20 | N-4 | 0.30 | F-4 | 11.80 | G-2 | 2.50 | H-3 | 0.10 | K-1 | 2.00 | - | - | - | - | S-1 | 80 | S-2 | 20 |

[Table 3]

| | | Concentration of solid contents [% by mass] | Concentration in solid content [part by mass] | | | | | | | | | | | | | | | | | | | | Solvent | | | |
|---|---|---|---|---|---|---|---|---|---|---|---|---|---|---|---|---|---|---|---|---|---|---|---|---|---|---|
| | | | Resin | | Compound A | | Photopolymerization initiator | | Nitrogen-containing cyclic compound | | Polymerizable compound | | Silane coupling agent | | Polymerization inhibitor | | Base generator | | Other additives | | | | Kind | Adding amount | Kind | Adding amount |
| | | | Kind | Adding amount | Kind | Adding amount | Kind | Adding amount | Kind | Adding amount | Kind | Adding amount | Kind | Adding amount | Kind | Adding amount | Kind | Adding amount | Kind | Adding amount | Kind | Adding amount | | | | |
| Example | 59 | 37.20 | PA-2<br>PB-2 | 39.30<br>38.60 | A-3 | 2.20 | I-2 | 3.20 | N-4 | 0.30 | F-4 | 11.80 | G-2 | 2.50 | H-3 | 0.10 | K-1 | 2.00 | - | - | - | - | S-1 | 80 | S-2 | 20 |
| | 60 | 36.30 | PA-2 | 78.00 | A-2<br>A-3 | 2.40<br>2.00 | I-3 | 2.40 | N-2 | 0.40 | F-2 | 11.50 | G-2 | 1.40 | H-2 | 0.10 | K-2 | 1.80 | - | - | - | - | S-3 | 80 | S-4 | 20 |
| | 61 | 36.90 | PA-2 | 78.40 | A-8 | 2.60 | I-3 | 2.60 | N-1<br>N-2 | 0.20<br>0.10 | F-1 | 12.80 | G-3 | 1.50 | H-1 | 0.20 | K-1 | 1.60 | - | - | - | - | S-3 | 80 | S-4 | 20 |
| | 62 | 37.00 | PB-2 | 77.00 | A-2 | 4.50 | I-3 | 2.30 | N-2 | 0.30 | F-1<br>F-5 | 6.30<br>6.00 | G-1 | 1.50 | H-2 | 0.10 | K-1 | 2.00 | - | - | - | - | S-3 | 80 | S-4 | 20 |
| Comparative Example | 1 | 36.90 | PA-1 | 78.50 | - | - | I-3 | 2.80 | N-1 | 0.50 | F-2 | 14.60 | G-2 | 1.50 | H-1 | 0.10 | K-1 | 2.00 | - | - | - | - | S-1 | 80 | S-2 | 20 |
| | 2 | 38.00 | PA-1 | 76.30 | CA-1 | 2.20 | I-3 | 2.80 | N-1 | 0.50 | F-2 | 14.60 | G-2 | 1.50 | H-1 | 0.10 | K-1 | 2.00 | - | - | - | - | S-1 | 80 | S-2 | 20 |
| | 3 | 37.80 | PA-1 | 76.80 | A-1 | 2.20 | I-3 | 2.80 | - | | F-2 | 14.60 | G-2 | 1.50 | H-1 | 0.10 | K-1 | 2.00 | - | - | - | - | S-1 | 80 | S-2 | 20 |
| | 4 | 37.80 | PA-1 | 76.80 | CA-1 | 2.20 | I-3 | 2.80 | - | - | F-2 | 14.60 | G-2 | 1.50 | H-1 | 0.10 | K-1 | 2.00 | - | - | - | - | S-1 | 80 | S-2 | 20 |
| | 5 | 36.70 | PA-1 | 79.00 | - | - | I-3 | 2.80 | - | - | F-2 | 14.60 | G-2 | 1.50 | H-1 | 0.10 | K-1 | 2.00 | - | - | - | - | S-1 | 80 | S-2 | 20 |

[Table 4]

| | | Process | | | | | | | | Evaluation result | | |
|---|---|---|---|---|---|---|---|---|---|---|---|---|
| | | Drying condition | | Coating film thickness | Exposure | Post-exposure heating condition | | Curing condition | | Resolution | Residual film ratio after development | Chemical resistance |
| | | Temperature | Time | | | Temperature | Time | Temperature | Time | | | |
| Example | 1 | 100°C | 5 minutes | 5 μm | M | - | - | 200°C | 2 hours | A | A | B |
| | 2 | 100°C | 5 minutes | 5 μm | M | - | - | 200°C | 2 hours | A | A | A |
| | 3 | 100°C | 5 minutes | 5 μm | M | - | - | 200°C | 2 hours | A | A | A |
| | 4 | 100°C | 5 minutes | 5 μm | M | - | - | 200°C | 2 hours | A | A | A |
| | 5 | 100°C | 5 minutes | 5 μm | M | - | - | 200°C | 2 hours | A | A | A |
| | 6 | 100°C | 5 minutes | 5 μm | M | - | - | 200°C | 2 hours | A | A | B |
| | 7 | 100°C | 5 minutes | 5 μm | M | - | - | 200°C | 2 hours | A | A | B |
| | 8 | 100°C | 4 minutes | 5 μm | M | - | - | 200°C | 2 hours | B | B | B |
| | 9 | 100°C | 5 minutes | 5 μm | M | - | - | 200°C | 2 hours | A | A | A |
| | 10 | 100°C | 5 minutes | 5 μm | M | - | - | 200°C | 2 hours | A | A | A |
| | 11 | 100°C | 5 minutes | 5 μm | M | - | - | 200°C | 2 hours | A | A | A |
| | 12 | 100°C | 5 minutes | 5 μm | M | - | - | 200°C | 2 hours | A | B | B |
| | 13 | 90°C | 5 minutes | 5 μm | D | - | - | 200°C | 2 hours | B | B | B |
| | 14 | 100°C | 5 minutes | 5 μm | M | - | - | 200°C | 2 hours | A | B | B |
| | 15 | 100°C | 5 minutes | 5 μm | M | - | - | 220°C | 2 hours | A | A | A |
| | 16 | 100°C | 5 minutes | 5 μm | M | - | - | 200°C | 2 hours | A | A | A |
| | 17 | 100°C | 5 minutes | 5 μm | M | - | - | 200°C | 2 hours | A | A | B |
| | 18 | 100°C | 5 minutes | 5 μm | D | - | - | 200°C | 2 hours | A | B | B |
| | 19 | 100°C | 5 minutes | 13 μm | M | - | - | 200°C | 2 hours | A | A | A |
| | 20 | 100°C | 5 minutes | 5 μm | M | - | - | 200°C | 2 hours | A | A | A |
| | 21 | 100°C | 5 minutes | 5 μm | M | - | - | 200°C | 2 hours | B | A | A |
| | 22 | 100°C | 5 minutes | 5 μm | M | - | - | 200°C | 2 hours | A | A | A |
| | 23 | 100°C | 5 minutes | 5 μm | M | - | - | 200°C | 2 hours | A | A | A |
| | 24 | 100°C | 5 minutes | 5 μm | M | - | - | 200°C | 2 hours | A | A | A |
| | 25 | 100°C | 5 minutes | 5 μm | M | - | - | 230°C | 3 hours | A | A | A |
| | 26 | 100°C | 5 minutes | 5 μm | M | - | - | 200°C | 2 hours | A | A | A |
| | 27 | 110°C | 5 minutes | 13 μm | M | - | - | 200°C | 2 hours | A | A | A |
| | 28 | 100°C | 5 minutes | 5 μm | M | - | - | 200°C | 2 hours | A | A | A |
| | 29 | 100°C | 6 minutes | 5 μm | M | - | - | 200°C | 2 hours | B | B | B |
| | 30 | 100°C | 5 minutes | 5 μm | M | - | - | 200°C | 2 hours | B | B | B |
| | 31 | 100°C | 5 minutes | 5 μm | M | - | - | 230°C | 2 hours | A | A | A |
| | 32 | 100°C | 5 minutes | 5 μm | M | - | - | 200°C | 2 hours | A | A | A |
| | 33 | 100°C | 5 minutes | 5 μm | M | - | - | 200°C | 2 hours | B | B | B |
| | 34 | 100°C | 5 minutes | 5 μm | M | - | - | 200°C | 2 hours | A | A | A |
| | 35 | 100°C | 5 minutes | 5 μm | M | - | - | 200°C | 2 hours | A | A | A |
| | 36 | 100°C | 5 minutes | 5 μm | M | - | - | 200°C | 2 hours | A | A | A |
| | 37 | 100°C | 5 minutes | 5 μm | M | - | - | 200°C | 2 hours | A | A | A |
| | 38 | 100°C | 5 minutes | 5 μm | M | - | - | 200°C | 2 hours | A | A | A |
| | 39 | 100°C | 5 minutes | 5 μm | M | - | - | 200°C | 2 hours | A | A | A |
| | 40 | 100°C | 5 minutes | 5 μm | M | - | - | 200°C | 2 hours | A | A | A |
| | 41 | 100°C | 5 minutes | 5 μm | M | - | - | 200°C | 2 hours | A | A | A |
| | 42 | 100°C | 5 minutes | 5 μm | M | - | - | 200°C | 2 hours | A | B | B |
| | 43 | 100°C | 5 minutes | 5 μm | M | - | - | 200°C | 2 hours | A | B | B |
| | 44 | 100°C | 5 minutes | 5 μm | M | - | - | 200°C | 2 hours | A | B | B |

[Table 5]

| | | Process | | | | | | | | Evaluation result | | |
|---|---|---|---|---|---|---|---|---|---|---|---|---|
| | | Drying condition | | Coating film thickness | Exposure | Post-exposure heating condition | | Curing condition | | Resolution | Residual film ratio after development | Chemical resistance |
| | | Temperature | Time | | | Temperature | Time | Temperature | Time | | | |
| Example | 45 | 100°C | 5 minutes | 5 µm | M | 120°C | 1 minute | 200°C | 2 hours | A | A | A |
| | 46 | 100°C | 5 minutes | 5 µm | M | 120°C | 5 minutes | 200°C | 2 hours | A | A | A |
| | 47 | 100°C | 5 minutes | 5 µm | M | 120°C | 10 minutes | 200°C | 2 hours | A | A | A |
| | 48 | 100°C | 5 minutes | 5 µm | M | 100°C | 5 minutes | 200°C | 2 hours | A | A | A |
| | 49 | 100°C | 5 minutes | 5 µm | M | 80°C | 5 minutes | 200°C | 2 hours | A | A | A |
| | 50 | 100°C | 5 minutes | 5 µm | M | - | - | 200°C | 2 hours | A | A | A |
| | 51 | 100°C | 5 minutes | 5 µm | M | - | - | 200°C | 2 hours | A | A | A |
| | 52 | 100°C | 5 minutes | 5 µm | M | - | - | 200°C | 2 hours | A | A | A |
| | 53 | 100°C | 5 minutes | 5 µm | M | 120°C | 1 minute | 200°C | 2 hours | A | A | A |
| | 54 | 100°C | 5 minutes | 5 µm | M | 120°C | 3 minutes | 200°C | 2 hours | A | A | A |
| | 55 | 100°C | 5 minutes | 5 µm | M | 120°C | 1 minute | 200°C | 2 hours | A | A | A |
| | 56 | 100°C | 5 minutes | 5 µm | M | 110°C | 2 minutes | 200°C | 2 hours | A | A | A |
| | 57 | 100°C | 5 minutes | 5 µm | M | - | - | 190°C | 2 hours | A | A | A |
| | 58 | 100°C | 5 minutes | 5 µm | M | - | - | 200°C | 2 hours | A | A | A |
| | 59 | 100°C | 5 minutes | 5 µm | M | - | - | 200°C | 2 hours | A | A | A |
| | 60 | 100°C | 5 minutes | 5 µm | M | - | - | 200°C | 2 hours | A | A | A |
| | 61 | 100°C | 5 minutes | 5 µm | M | - | - | 200°C | 2 hours | A | A | A |
| | 62 | 100°C | 5 minutes | 5 µm | M | 120°C | 2 minutes | 200°C | 2 hours | A | A | A |
| Comparative Example | 1 | 100°C | 5 minutes | 5 µm | M | - | - | 200°C | 2 hours | C | B | C |
| | 2 | 100°C | 5 minutes | 5 µm | M | - | - | 200°C | 2 hours | B | D | C |
| | 3 | 100°C | 5 minutes | 5 µm | M | - | - | 200°C | 2 hours | C | C | C |
| | 4 | 100°C | 5 minutes | 5 µm | M | - | - | 200°C | 2 hours | C | D | D |
| | 5 | 100°C | 5 minutes | 5 µm | M | - | - | 200°C | 2 hours | D | C | C |

Details of each of the components listed in the table are as follows.

[Resin]

- Resins PA-1, PA-2, PB-1, PB-2, PC, PD, and PE: Resins respectively obtained according to Synthesis Examples described above

[Compound A]

- A-1: An ester between 2,6-bis(2,3,4-trihydroxybenzyl)-p-cresol and 6-diazo5,6-dihydro-5-oxo-1-naphthalenesulfonic acid
- A-2: An ester of 2,2',3,3'-tetrahydro-3,3,3',3'-tetramethyl-1,1'-spiro-bi(1H-indene)-5,5',6,6',7,7'-hexanol and 1,2-naphthoquinone-(2)-diazo-5-sulfonic acid
- A-3: An ester between bis(4-hydroxy-3,5-dimethylphenyl)-(4-hydroxy-3-methoxyphenyl)methane and 6-diazo-5,6-dihydro-5-oxonaphthalene-1-sulfonic acid
- A-4: Victoria Pure Blue NAPS (a leuco coloring agent, manufactured by HODOGAYA CHEMICAL CO., LTD.)
- A-5: The following oxime compound

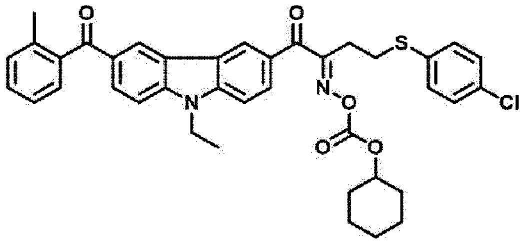

· A-6: The following diarylethene coloring agent

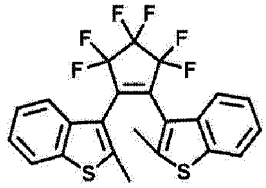

· A-7: An ester between 4-[bis(4-hydroxy-3,5-dimethylphenyl)methyl] 1,2-benzenediol and 6-diazo-5,6-dihydro-5-oxonaphthalene-1-sulfonic acid
· A-8: An ester between 4,4'-(menthan-1,8-diyl) bis[2-(4-hydroxybenzyl)-6-methylphenol and 6-diazo-5-oxo-5,6-dihydronaphthalene-1-sulfonic acid
· CA-1: The following coumarin coloring agent

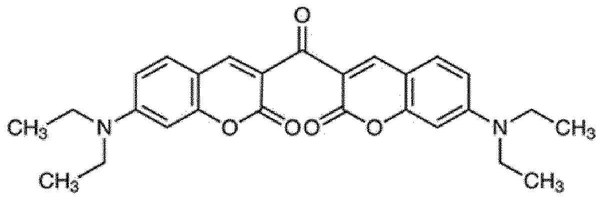

Among the above compounds, A-1 to A-8 are compounds of which an absorbance is reduced at an exposure wavelength upon exposure, and they correspond to the compound A.

In addition, A-1 to A-4 and A-6 to A-8 are compounds that do not generate a radical polymerization initiation species in a case of being exposed, and A-5 is a compound that generates a radical polymerization initiation species in a case of being exposed.

CA-1 is not a compound of which an absorbance is reduced at an exposure wavelength upon exposure, and it does not correspond to the compound A.

[Photopolymerization initiator (photosensitive compound)]

· I-1: 1-phenyl-1,2-propanedione-2-(O-ethoxycarbonyl)-oxime (maximal absorption wavelength: 365 nm)
· I-2: NCI 831 (maximal absorption wavelength: 365 nm) (manufactured by ADEKA CORPORATION)
· I-3: IRGACURE OXE01 (maximal absorption wavelength: 365 nm) (manufactured by BASF SE)
· I-4: IRGACURE OXE02 (maximal absorption wavelength: 365 nm) (manufactured by BASF SE)
· I-5: IRGACURE 784 (maximal absorption wavelength: 405 nm) (manufactured by

BASF SE)

[Nitrogen-containing cyclic compound]

· N-1: 1H-tetrazole

· N-2: 5-aminotetrazole
· N-3: 3-aminotriazole
· N-4: Benzotriazole
· N-5: The following compound

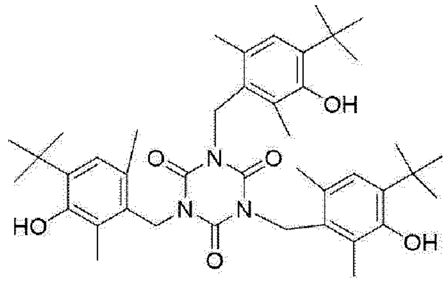

[Polymerizable compound]

· F-1: Tetraethylene glycol dimethacrylate
· F-2: LIGHT ESTER BP-6EM (manufactured by Kyoeisha Chemical Co., Ltd.)
· F-3: LIGHT ESTER NP (manufactured by Kyoeisha Chemical Co., Ltd.)
· F-4: LIGHT ESTER 1.6HX (manufactured by Kyoeisha Chemical Co., Ltd.)
· F-5: KAYARAD DPHA (manufactured by Nippon Kayaku Co., Ltd.)
· F-6: Daicel CELLOXIDE CEL2081 (manufactured by Daicel Corporation)

[Metal adhesiveness improver (silane coupling agent)]

· G-1: N-[3-(triethoxysilyl)propyl]phthalamic acid
· G-2: N-[3-(triethoxysilyl)propyl]maleamic acid
· G-3: 3-methacryloxypropyltrimethoxysilane
· G-4: 2-(3,4-epoxycyclohexyl)ethyltrimethoxysilane
· G-5: The following compound

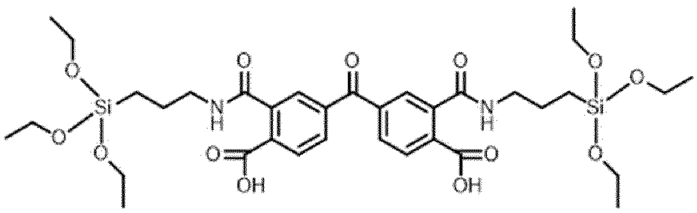

[Polymerization inhibitor]

· H-1: p-benzoquinone
· H-2: 4-methoxyphenol
· H-3: 2-nitroso-1-naphthol

[Base generator]

· K-1: N-cyclohexyl-N,N-dimethyl-N-phenacylammonium maleate

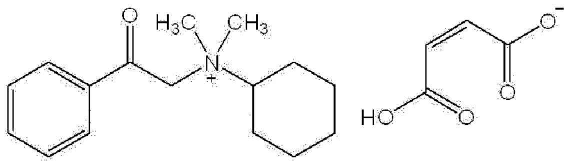

· K-2: The following compound

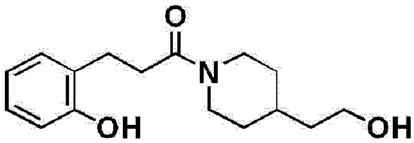

· K-3: The following compound

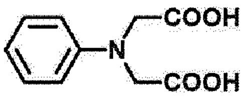

· K-4: The following compound

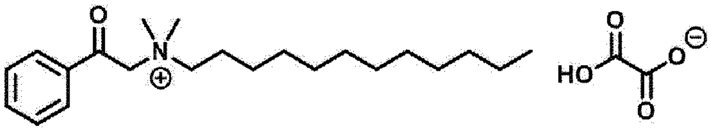

[Other additives]

· M-1: 7-diethylamino-3-ethoxycarbonylcoumarin
· M-2: N-phenyldiethanolamine

[Solvent]

· S-1: N-methylpyrrolidone
· S-2: Ethyl lactate
· S-3: γ-butyrolactone
· S-4: Dimethyl sulfoxide
· S-5: N,N-dimethylacetamide

<Evaluation>

[Evaluation of resolution]

In each Example or Comparative Example, the negative-tone photosensitive resin composition or the comparative composition was applied onto a copper wafer by a spin coating method. The wafer was dried on a hot plate at the temperature and time shown in the table to form, on the copper wafer, a curable resin composition layer having a uniform thickness, which is the thickness shown in the column of "Coating film thickness" in the table.

In the example in which "M" was described in the column of "Exposure", the curable resin composition layer on the copper substrate was exposed at an exposure wavelength of 365 nm by using a stepper and using a photo mask for contact holes having an interval of 1 μm from 5 μm to 20 μm. The exposure amount was changed in a range of 250

to 650 mJ/cm$^2$ in increments of 50 mJ/cm$^2$.

In the example in which "D" was described in the column of "Exposure", a direct exposure device (Adtech DE-6UH III) was used to carry out laser direct imaging exposure so that contact holes were obtained to have an interval of 1 $\mu$m from 5 $\mu$m to 20 $\mu$m. The exposure wavelength was set to 405 nm, and the exposure amount was changed in a range of 250 to 650 mJ/cm$^2$ in increments of 50 mJ/cm$^2$.

For Examples in which the numerical values were described in the column of "Post-exposure heating step" in the table, the heating treatment of the wafer was carried out after the exposure at the described temperature/time. The heating was carried out on a hot plate in the atmospheric air.

The exposed curable resin composition layer was developed with cyclopentanone for 40 seconds and then rinsed with propylene glycol monomethyl ether acetate (PGMEA).

The line width of the pattern obtained after the development, having the smallest contact hole pattern size, was denoted as the "minimum hole diameter" and evaluated according to the following evaluation standards. It can be said that the smaller the minimum hole diameter is, the more excellent the resolution is. This indicates that, for example, the width of the metal wire to be formed in the subsequent plating step can be made finer, which is a preferred result. The measurement limit is 5 $\mu$m. The evaluation results are described in the column of "Resolution" in the table. A or B is preferable, and A is more preferable.

- Evaluation standards -

In a case where the coating film thickness is 5 $\mu$m:

A: The minimum hole diameter was 5 $\mu$m.
B: The minimum hole diameter was 5 $\mu$m or more and less than 7 $\mu$m.
C: The minimum hole diameter was 7 $\mu$m or more and less than 10 $\mu$m.
D: The minimum hole diameter was 10 $\mu$m or more.

In a case where the coating film thickness is 13 $\mu$m:

A: The minimum hole diameter was less than 10 $\mu$m.
B: The minimum hole diameter was 10 $\mu$m or more and less than 15.$\mu$m.
C: The minimum hole diameter was 15 $\mu$m or more and less than 20 $\mu$m.
D: The minimum hole diameter was 20 $\mu$m or more.

[Residual film ratio after development]

In the evaluation of resolution, the residual film ratio after development at an exposure amount at which the minimum hole diameter can be formed was calculated as a proportion of the film thickness after development to the film thickness before development, by measuring the film thickness before and after development. The evaluation was carried out from the calculated value of the residual film ratio, according to the following evaluation standards, and the evaluation results are described in the column of "Residual film ratio after development" in the table. The higher the residual film ratio, the more preferable the result. A or B is preferable, and A is more preferable.

$$\text{Residual film ratio (\%)} = \text{film thickness after development/film thickness before development} \times 100$$

- Evaluation standards -

A: The residual film ratio was 90% or more.
B: The residual film ratio was 85% or more and less than 90%.
C: The residual film ratio was 80% or more and less than 85%.
D: The residual film ratio was less than 80%.

[Chemical resistance]

In each Example or Comparative Example, a curable resin composition layer was formed on a silicon wafer according to the same method as that for the formation of the curable resin composition layer in the above-described resolution evaluation.
Then, in each Example or Comparative Example, the entire surface of the curable resin composition layer was exposed without using a photo mask, whereby a resin film was obtained.
The exposure method was the same as that for the above-described resolution evaluation, except that a photo mask was not used. The exposure amount was set to 500 $mJ/cm^2$.
In the evaluation of chemical resistance, the post-exposure heating step was carried out.
Next, the temperature of the resin film obtained in each Example or Comparative Example was raised at a temperature rising rate of 10 °C/min under a nitrogen atmosphere, and the temperature was maintained at the temperature and the time, which were shown in the columns of "Temperature" and "Time" of "Curing Condition" in the table, whereby a cured film was formed.
The obtained cured film was immersed in the following chemical under the following conditions, and the dissolution rate was calculated.
Chemical: A 90:10 (mass ratio) mixture of dimethyl sulfoxide (DMSO) and an aqueous solution containing 25% by mass of tetramethylammonium hydroxide (TMAH).
Evaluation conditions: The above-described cured film was immersed in the chemical at 75°C for 15 minutes, the film thicknesses of the cured film before and after immersion were compared, and then the residual film ratio after immersion was calculated.

$$\text{Residual film ratio (\%)} = \text{film thickness after immersion/film thickness before immersion} \times 100$$

The obtained value of the residual film ratio was evaluated according to the following evaluation standards, and the evaluation results are described in the column of "Chemical resistance". It can be said that the larger the residual film ratio, the better the chemical resistance. A or B is preferable, and A is more preferable.

- Evaluation standards -

A: The residual film ratio was 75% or more.
B: The residual film ratio was 70% or more and less than 75%.
C: The residual film ratio was 55% or more and less than 70%.
D: The residual film ratio was less than 55%.

From the above results, it can be seen that the resolution is improved in a case of using the negative-tone photosensitive resin composition according to the embodiment of the present invention.
The comparative composition according to Comparative Example 1 contains a nitrogen-containing cyclic compound but does not contain the compound A. In such an example, it can be seen that the resolution is inferior.
The comparative composition according to Comparative Example 2 contains CA-1 instead of the compound A and contains a nitrogen-containing cyclic compound. In such an example, it can be seen that the residual film ratio after development is inferior.
The comparative compositions according to Comparative Examples 3 to 5 do not contain a nitrogen-containing cyclic compound. In such an example, it can be seen that both the resolution and the residual film ratio after development are inferior.

<Example 101>

The resin composition used in Example 1 was applied in a layer shape onto a surface of a thin copper layer of the resin base material on the surface of which the thin copper layer was formed, by a spin coating method, dried at 100°C for 5 minutes, and after forming a photosensitive film having a thickness of 20 μm, exposure was carried out using a stepper (NSR1505 i6, manufactured by Nikon Corporation). Exposure was carried out through a mask (a binary mask in which the pattern is a pattern of 1:1 line and space and the line width is 10 μm) at a wavelength of 365 nm. After the exposure, development was carried out with cyclohexanone for 2 minutes and rinsing was carried out with

PGMEA for 30 seconds to obtain a layer pattern.

Next, the temperature was raised at a temperature rising rate of 10 °C/min in a nitrogen atmosphere, and after the temperature reached 230°C, the temperature was maintained at 230°C for 180 minutes, thereby forming an interlayer insulating film for a re-distribution layer. This interlayer insulating film for a re-distribution layer was excellent in insulating properties.

In addition, in a case where a semiconductor device was manufactured using this interlayer insulating film for a re-distribution layer, it has been confirmed that the semiconductor device operates without any problem.

## Claims

**1.** A negative-tone photosensitive resin composition comprising:

a resin;
a compound A of which an absorbance is reduced at an exposure wavelength upon exposure; and
a photopolymerization initiator,
wherein the negative-tone photosensitive resin composition satisfies at least one of the following condition i or condition ii,
the condition i: the composition further contains a nitrogen-containing cyclic compound as a component different from the resin, the compound A, and the photopolymerization initiator,
the condition ii: the composition contains, as the resin, a resin having a nitrogen-containing heterocyclic structure that contains two or more nitrogen atoms as ring members.

**2.** The negative-tone photosensitive resin composition according to claim 1, wherein the compound A is a compound that does not generate a radical polymerization initiation species upon exposure.

**3.** The negative-tone photosensitive resin composition according to claim 1 or 2, wherein the compound A includes a naphthoquinone diazide compound.

**4.** The negative-tone photosensitive resin composition according to any one of claims 1 to 3, wherein a content of the nitrogen-containing cyclic compound is 0.5 to 200 parts by mass in a case where a content of the compound A is set to 100 parts by mass.

**5.** A negative-tone photosensitive resin composition comprising:

a resin;
a naphthoquinone diazide compound; and
a photopolymerization initiator,
wherein the negative-tone photosensitive resin composition satisfies at least one of the following condition iii or condition iv,
the condition iii: the composition further contains a nitrogen-containing cyclic compound as a component different from the resin, the naphthoquinone diazide compound, and the photopolymerization initiator,
the condition iv: the composition contains, as the resin, a resin having a nitrogen-containing heterocyclic structure that contains two or more nitrogen atoms as ring members.

**6.** The negative-tone photosensitive resin composition according to any one of claims 1 to 5, wherein the resin is a cyclization resin or a precursor thereof.

**7.** The negative-tone photosensitive resin composition according to any one of claims 1 to 6, further comprising a polymerizable compound.

**8.** The negative-tone photosensitive resin composition according to any one of claims 1 to 7, further comprising a silane coupling agent.

**9.** The negative-tone photosensitive resin composition according to any one of claims 1 to 8, further comprising a polymerization inhibitor.

**10.** The negative-tone photosensitive resin composition according to any one of claims 1 to 9, further comprising a base

generator.

**11.** The negative-tone photosensitive resin composition according to any one of claims 1 to 10, wherein the photopolymerization initiator is a photoradical polymerization initiator.

**12.** The negative-tone photosensitive resin composition according to any one of claims 1 to 11, wherein the negative-tone photosensitive resin composition is used for forming an interlayer insulating film for a re-distribution layer.

**13.** A cured substance that is obtained by curing the negative-tone photosensitive resin composition according to any one of claims 1 to 12.

**14.** A laminate comprising:

two or more layers consisting of the cured substance according to claim 13; and
a metal layer provided between any layers consisting of the cured substance.

**15.** A manufacturing method for a cured substance, comprising:

a film forming step of applying the negative-tone photosensitive resin composition according to any one of claims 1 to 12 onto a substrate to form a film;
an exposure step of selectively exposing the film; and
a development step of developing, by using a developer, the film exposed in the exposure step to form a pattern.

**16.** The manufacturing method for a cured substance according to claim 15, further comprising a heating step of heating the film at 50°C to 450°C.

**17.** A semiconductor device comprising the cured substance according to claim 13 or the laminate according to claim 14.

**INTERNATIONAL SEARCH REPORT**

International application No. **PCT/JP2022/012523**

**A. CLASSIFICATION OF SUBJECT MATTER**

***C08K 5/28***(2006.01)i; ***C08K 5/34***(2006.01)i; ***C08K 5/5415***(2006.01)i; ***C08L 101/02***(2006.01)i; ***G03F 7/004***(2006.01)i; ***G03F 7/031***(2006.01)i; ***G03F 7/20***(2006.01)i
FI: G03F7/004 501; G03F7/031; G03F7/20 521; C08K5/34; C08L101/02; C08K5/28; C08K5/5415

According to International Patent Classification (IPC) or to both national classification and IPC

**B. FIELDS SEARCHED**

Minimum documentation searched (classification system followed by classification symbols)

G03F7/004; G03F7/031; G03F7/20

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

CAplus/REGISTRY (STN)

**C. DOCUMENTS CONSIDERED TO BE RELEVANT**

| Category* | Citation of document, with indication, where appropriate, of the relevant passages | Relevant to claim No. |
|---|---|---|
| X | WO 2021/039782 A1 (FUJIFILM CORP) 04 March 2021 (2021-03-04) claims, example 5 | 1-2, 4, 6-17 |
| A | | 3, 5 |
| X | JP 2006-251009 A (CHISSO CORP) 21 September 2006 (2006-09-21) paragraphs [0044], [0054]-[0072], examples 1-20 | 1-17 |

☐ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **24 May 2022** | **07 June 2022** |
| Name and mailing address of the ISA/JP<br>**Japan Patent Office (ISA/JP)**<br>**3-4-3 Kasumigaseki, Chiyoda-ku, Tokyo 100-8915**<br>**Japan** | Authorized officer<br><br>Telephone No. |

Form PCT/ISA/210 (second sheet) (January 2015)

**INTERNATIONAL SEARCH REPORT**
**Information on patent family members**

International application No.
**PCT/JP2022/012523**

| Patent document cited in search report | Publication date (day/month/year) | Patent family member(s) | Publication date (day/month/year) |
|---|---|---|---|
| WO 2021/039782 A1 | 04 March 2021 | (Family: none) | |
| JP 2006-251009 A | 21 September 2006 | (Family: none) | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 6130664 A
- JP H6130664 A
- JP 2019206689 A
- WO 2017038598 A
- JP 2013256506 A
- JP 4253058 A
- JP H4253058 A
- JP 5224410 A
- JP H5224410 A
- JP 5303200 A
- JP H5303200 A
- EP 530148 A
- JP 2004091638 A
- JP 2016027357 A
- WO 2015199219 A
- JP 2014130173 A
- JP 6301489 B
- WO 2018221177 A
- WO 2018110179 A
- JP 2019043864 A
- JP 2019044030 A
- JP 2019167313 AA
- JP 2015087611 A
- JP 10291969 A
- JP H10291969 A
- JP 4225898 B
- JP 2009191179 A
- JP 2001233842 A
- JP 2000080068 A
- JP 2006342166 A
- JP 2000066385 A
- JP 2004534797 A
- JP 2017019766 A
- JP 6065596 B
- WO 2015152153 A
- WO 2017051680 A
- JP 2017198865 A
- WO 2017164127 A
- WO 2013167515 A
- JP 2012014052 A
- JP 2014137466 A
- JP 06636081 B
- WO 2013083505 A
- JP 2010262028 A
- JP 2014500852 A
- JP 2013164471 A
- JP 2013114249 A
- JP 4223071 B
- WO 2015036910 A
- WO 2019088055 A
- JP 4600600 B
- JP 2007269779 A
- JP 2009191061 A
- WO 2015125469 A
- JP 2010527339 A
- JP 2011524436 A
- WO 2015004565 A
- JP 2016532675 A
- WO 2017033680 A
- JP 2013522445 A
- WO 2016034963 A
- JP 2017523465 A
- JP 2017167399 A
- JP 2017151342 A
- JP 6469669 B
- JP 48041708 B
- JP S48041708 B
- JP 50006034 B
- JP S50006034 B
- JP 51037193 A
- JP S51037193 A
- JP 48064183 A
- JP S48064183 A
- JP 49043191 B
- JP S49043191 B
- JP 52030490 B
- JP S52030490 B
- JP 2008292970 A
- JP 2010160418 A
- JP 2010129825 A
- JP 4364216 B
- JP 46043946 B
- JP S46043946 B
- JP 1040337 B
- JP H01040337 B
- JP 1040336 B
- JP H01040336 B
- JP 2025493 A
- JP H02025493 A
- JP 61022048 A
- JP S61022048 A
- JP 2015034964 A
- JP 10062986 A
- JP H10062986 A
- JP 2015187211 A
- JP 2032293 B
- JP H02032293 B

- JP 2016765 B
- JP H02016765 B
- JP 58049860 B
- JP S58049860 B
- JP 56017654 B
- JP S56017654 B
- JP 62039417 B
- JP S62039417 B
- JP 62039418 B
- JP S62039418 B
- JP 63277653 A
- JP S63277653 A
- JP 63260909 A
- JP S63260909 A
- JP 1105238 A
- JP H01105238 A
- WO 2020066416 A
- WO 2018038002 A
- JP 2014191002 A
- WO 2011080992 A
- JP 2014191252 A
- JP 2014041264 A
- WO 2014097594 A
- JP 2018173573 A
- JP 2011128358 A
- JP 2014186186 A
- JP 2013072935 A
- JP 2013015701 A
- JP 2009283711 A
- JP 2011059656 A
- JP 2012194520 A
- JP 2015127817 A
- JP 2012003225 A
- US 20130034812 A
- JP 2008250074 A
- JP 2015117327 A
- JP 2011132503 A
- JP 2011089090 A
- JP 2010164965 A
- JP 2008063554 A
- JP 6268967 B
- WO 2014021023 A
- WO 2017030005 A
- JP 2017008219 A
- JP 2015123351 A
- JP 2006023696 A
- JP 2006047592 A
- US 9159547 B
- JP 2007157879 A
- JP 2001521288 A
- JP 2004214501 A
- JP 2004101850 A
- US 7888181 B2
- US 9177926 B2

**Non-patent literature cited in the description**

- Handbook of Chemistry, Pure Chemistry
- *MATERIAL STAGE,* 2019, vol. 19 (3), 37-60
- *J. C. S. Perkin,* 1979, vol. II, 1653-1660
- *J. C. S. Perkin,* 1979, vol. II, 156-162
- *Journal of Photopolymer Science and Technology,* 1995, 202-232
- Polymer Dictionary. 2005, 683-684
- *Journal of the Adhesion Society of Japan,* 1984, vol. 20 (7), 300-308
- High functionality and applied technology of polyimide. Science & Technology Co., Ltd, April 2008
- **MASAAKI KAKIMOTO.** Basics and development of polyimide materials. CMC Technical library, November 2011
- Latest Polyimide Basics and Applications. NTS Inc, August 2010
- **H SEINO et al.** *J. Polym. Sci., Part A: Polym. Chem.,* 1998, vol. 36, 2261